# EUROPEAN PATENT APPLICATION

(11) **EP 2 166 591 A1**
(43) Date of publication of application: **24.03.2010**
(21) Application number: 08790875.2
(22) Date of filing: 04.07.2008
(51) Int. Cl.: H01L 51/50, C09K 11/06, H05B 33/12

(54) **ORGANIC EL DEVICE**

(30) Priority: 07.07.2007 JP 2007179122
(71) Applicant: Idemitsu Kosan Co., Ltd., Chiyoda-ku Tokyo 100-8321 (JP)
(72) Inventor: NISHIMURA, Kazuki, Sodegaura-shi Chiba 299-0293 (JP); IWAKUMA, Toshihiro, Sodegaura-shi Chiba 299-0293 (JP); KAWAMURA, Masahiro, Sodegaura-shi Chiba 299-0293 (JP); FUKUOKA, Kenichi, Sodegaura-shi Chiba 299-0293 (JP); HOSOKAWA, Chishio, Sodegaura-shi Chiba 299-0293 (JP); JINDE, Yukitoshi, Sodegaura-shi Chiba 299-0293 (JP)
(74) Representative: Gille Hrabal Struck Neidlein Prop Roos
(86) International application number: PCT/JP2008/062144
(87) International publication number: WO 2009/008356

(57) **Abstract**

An organic EL device includes: an anode (3) for injecting holes; a phosphorescent-emitting layer (5); a fluorescent-emitting layer (6); and a cathode (8) for injecting electrons. The phosphorescent-emitting layer (5) contains a phosphorescent host and a phosphorescent dopant for phosphorescent emission. The fluorescent-emitting layer (6) contains a fluorescent host and a fluorescent dopant for fluorescent emission. The phosphorescent host has a substituted or unsubstituted polycyclic fused aromatic skeleton and has a triplet energy gap of 2.0 eV to 3.0 eV.

## Description

### Technical Field

The present invention relates to an organic EL device. In particular, the invention relates to an organic EL device including a fluorescent-emitting layer and a phosphorescent-emitting layer.

### Background Art

Known organic EL devices include a plurality of emitting layers that each emit light of a different wavelength. Mixture of the light emitted by the emitting layers provides mixed-color light. One of such organic EL devices includes a layered red-emitting layer, green-emitting layer and blue-emitting layer, and provides white light in which emissions from the emitting layers are mixed together.
In recent years, a further progress has been made in the development of phosphorescent materials utilizing the emission from triplet exciton energy, and devices of high luminous efficiency have been realized (e.g., Patent Document 1).
Hence, some expect that devices for mixed-color emission will be obtainable by using phosphorescent materials that provide emission at different wavelengths, in particular, white-emitting devices.
However, phosphorescent materials are of short lifetime.

**Patent Document 1**: US2002/182441

### Disclosure of the Invention

### Problems to Be Solved by the Invention

An object of the invention is to solve the above problems and to provide a practical mixed-emitting organic EL device having long lifetime.

### Means for Solving the Problems

An organic EL device according to an aspect of the invention includes: an anode for injecting holes; a phosphorescent-emitting layer; a fluorescent-emitting layer; and a cathode for injecting electrons, the phosphorescent-emitting layer containing a phosphorescent host and a phosphorescent dopant for phosphorescent emission, the fluorescent-emitting layer containing a fluorescent host and a fluorescent dopant for fluorescent emission, the phosphorescent host having a substituted or unsubstituted polycyclic fused aromatic skeleton and having a triplet energy gap of 2.1 eV to 3.0 eV.
The organic EL device according to the aspect of the invention may include a plurality of fluorescent-emitting layers or a plurality of phosphorescent-emitting layers. When the device includes a plurality of phosphorescent-emitting layers, it is sufficient that at least one layer thereof includes the above structure.

Preferably in the aspect of the invention, the polycyclic fused aromatic skeleton is present in a chemical structure formula as a divalent or multivalent group.

Examples of the substituent for the polycyclic fused aromatic skeleton are halogen atom, hydroxyl group, substituted or unsubstituted amino group, nitro group, cyano group, substituted or unsubstituted alkyl group, substituted or unsubstituted alkenyl group, substituted or unsubstituted cycloalkyl group, substituted or unsubstituted alkoxy group, substituted or unsubstituted aromatic hydrocarbon group, substituted or unsubstituted aromatic heterocyclic group, substituted or unsubstituted aralkyl group, substituted or unsubstituted aryloxy group, substituted or unsubstituted alkoxycarbonyl group, and carboxyl group. When the polycyclic fused aromatic skeleton includes a plurality of substituents, two of the substituents may form a ring.

Examples of the halogen atom are fluorine, chlorine, bromine, iodine and the like.

The substituted or unsubstituted amino group is represented by -NX¹X². X¹ and X² each independently and exemplarily represent hydrogen atom, methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 4-styrylphenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenailthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, and 4-t-butyl-3-indolyl group.

Examples of the substituted or unsubstituted alkyl group are methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, and 1,2,3-trinitropropyl group.

Examples of the substituted or unsubstituted alkenyl group are vinyl group, allyl group, 1-butenyl group, 2-butenyl group, 3-butenyl group, 1,3-butanedienyl group, 1-methylvinyl group, styryl group, 4-diphenylaminostyryl group, 4-di-p-tolylaminostyryl group, 4-di-m-tolylaminostyryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group, and 3-phenyl-1-butenyl group.

Examples of the substituted or unsubstituted cycloalkyl group are cyclopropyl group, cyclobutyl group, cyclopentyl group, cyclohexyl group, and 4-methylcyclohexyl group.

The substituted or unsubstituted alkoxycarbonyl group is represented by -OY. Examples of Y are methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, and 1,2,3-trinitropropyl group.

Examples of the substituted or unsubstituted aromatic hydrocarbon group are phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, and 4"-t-butyl-p-terphenyl-4-yl group.

Examples of the substituted or unsubstituted aromatic heterocyclic group are 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthirolin-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, and 4-t-butyl-3-indolyl group.

Examples of the substituted or unsubstituted aralkyl group are benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group.

The substituted or unsubstituted aryloxy group is represented by -OZ. Examples of Z are phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyffol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, and 4-t-butyl-3-indolyl group.

The substituted or unsubstituted alkoxycarbonyl group is represented by -COOY. Examples of Y are methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, and 1,2,3-trinitropropyl group.

Preferably in the aspect of the invention, the polycyclic fused aromatic skeleton has a substituent, and the substituent is a substituted or unsubstituted aryl group or a heteroaryl group.

Preferably in the aspect of the invention, the polycyclic fused aromatic skeleton is selected from a group consisting of substituted or unsubstituted naphthalene-diyl, phenanthrene-diyl, chrysene-diyl, fluoranthene-diyl and triphenylene-diyl.
Also preferably in the aspect of the invention, the polycyclic fused aromatic skeleton is substituted by a group containing naphthalene, phenanthrene, chrysene, fluoranthene or triphenylene.

Preferably in the aspect of the invention, the polycyclic fused aromatic skeleton is represented by any one of formulae (1) to (4) as follows.

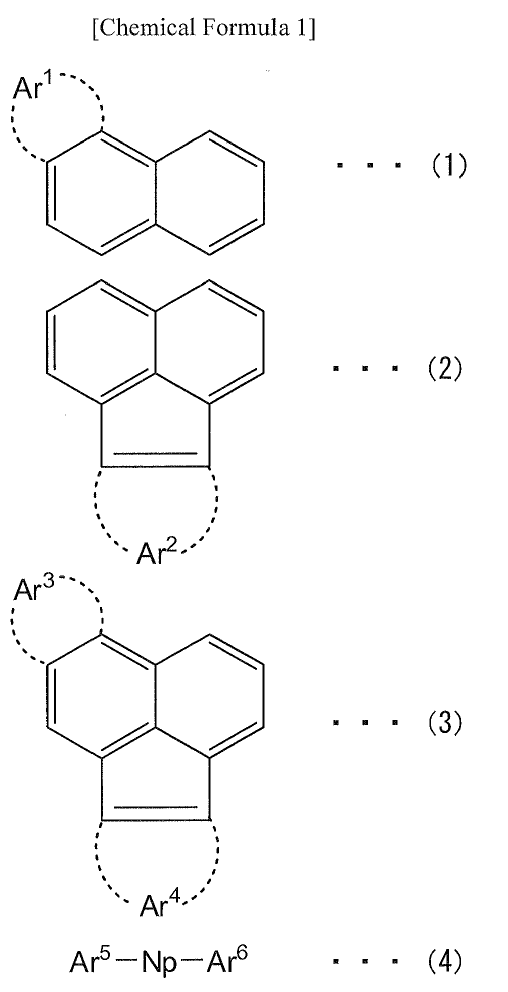

In the formulae (1) to (3), Ar¹ to Ar⁴ each represent a substituted or unsubstituted fused cyclic structure having 4 to 10 ring-forming carbon atoms.
In the formula (4), Np represents substituted or unsubstituted naphthalene, and Ar⁵ and Ar⁶ each independently represent a substituent formed solely of a substituted or unsubstituted aryl group having 5 to 14 carbon atoms or formed of a combination of a plurality thereof. However, Ar⁵ or Ar⁶ is not anthracene.

Examples of the compound represented by the formula (1) are substituted or unsubstituted phenanthrene and chrysene.
Examples of the compound represented by the formula (2) are substituted or unsubstituted acenaphthylene, acenaphthene and fluoranthene.
An example of the compound represented by the formula (3) is substituted or unsubstituted benzofluoranthene.

In the aspect of the invention, the polycyclic fused aromatic skeleton is preferably a phenanthrene derivative represented by the following formula (21).

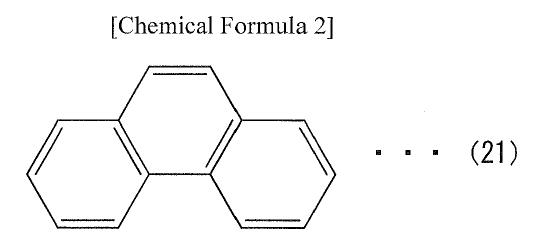

The phenanthrene derivative may be substituted. Examples of the substituent for the phenanthrene derivative are hydrogen, alkyl group, cycloalkyl group, aralkyl group, alkenyl group, cycloalkenyl group, alkynyl group, hydroxyl group, mercapto group, alkoxy group, alkylthio group, arylether group, arylthioether group, aryl group, heterocyclic group, halogen, haloalkane, haloalkene, haloalkyne, cyano group, aldehyde group, carbonyl group, carboxyl group, ester group, amino group, nitro group, silyl group and siloxanyl group.
Examples of the phenanthrene derivative are those represented by the following formulae.

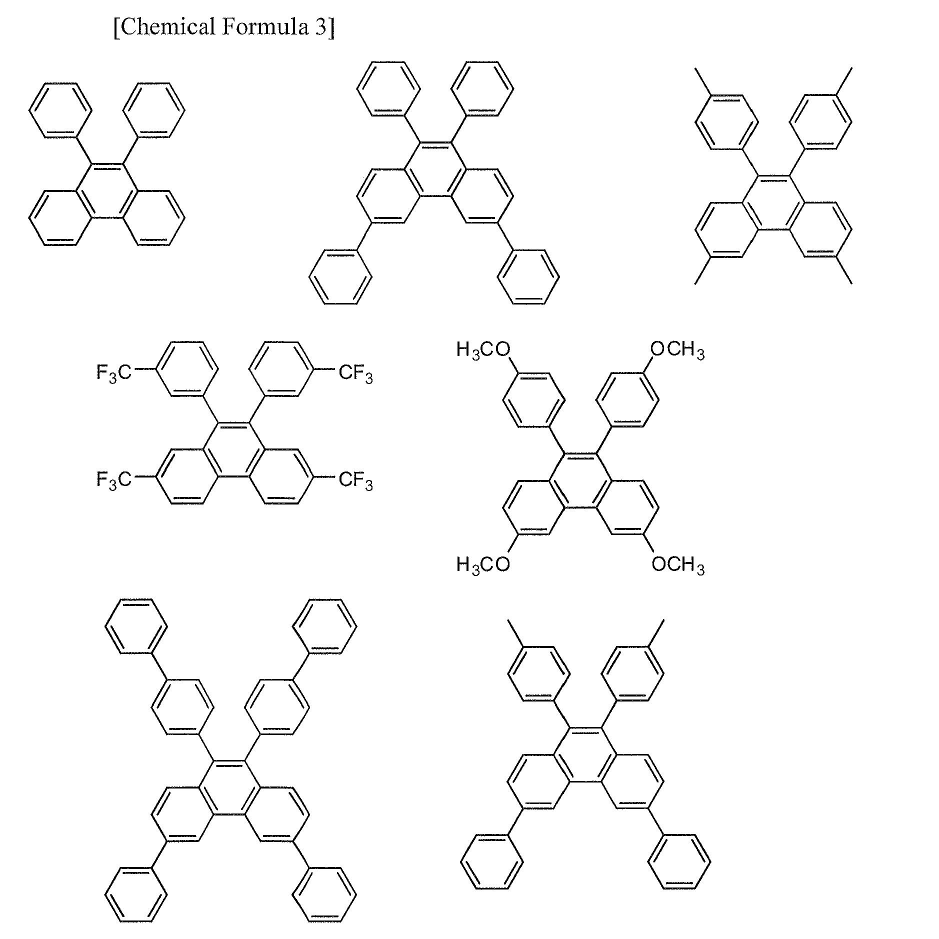

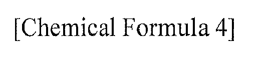

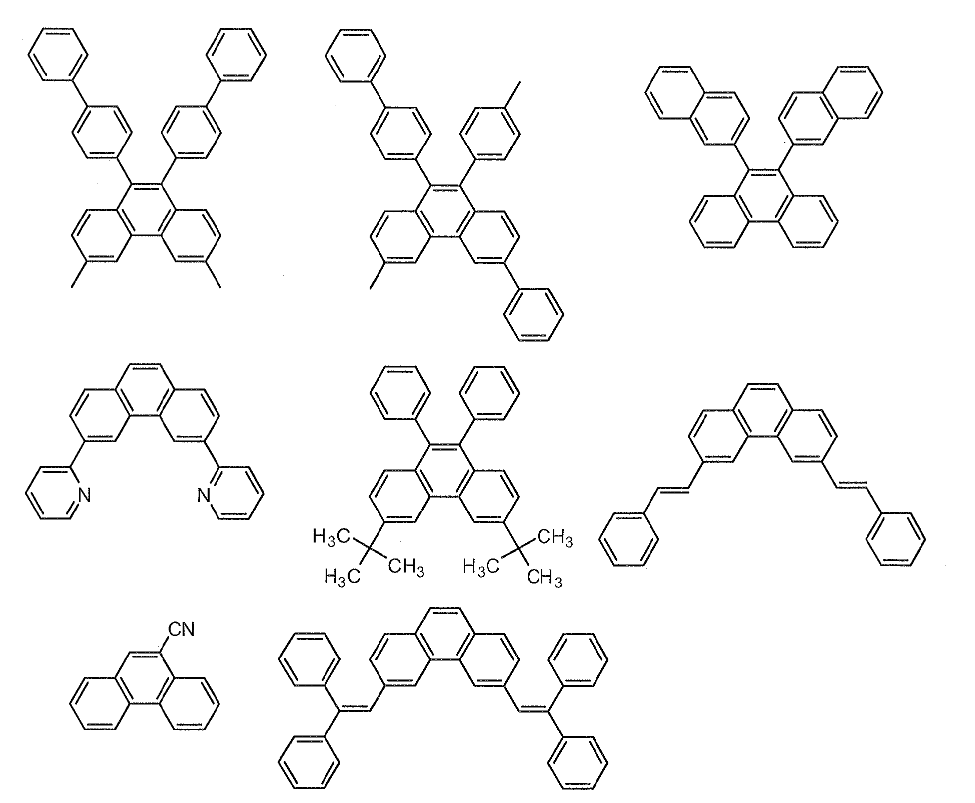

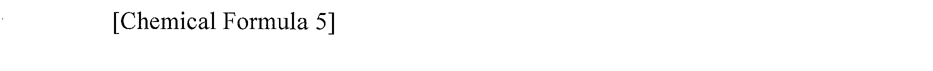

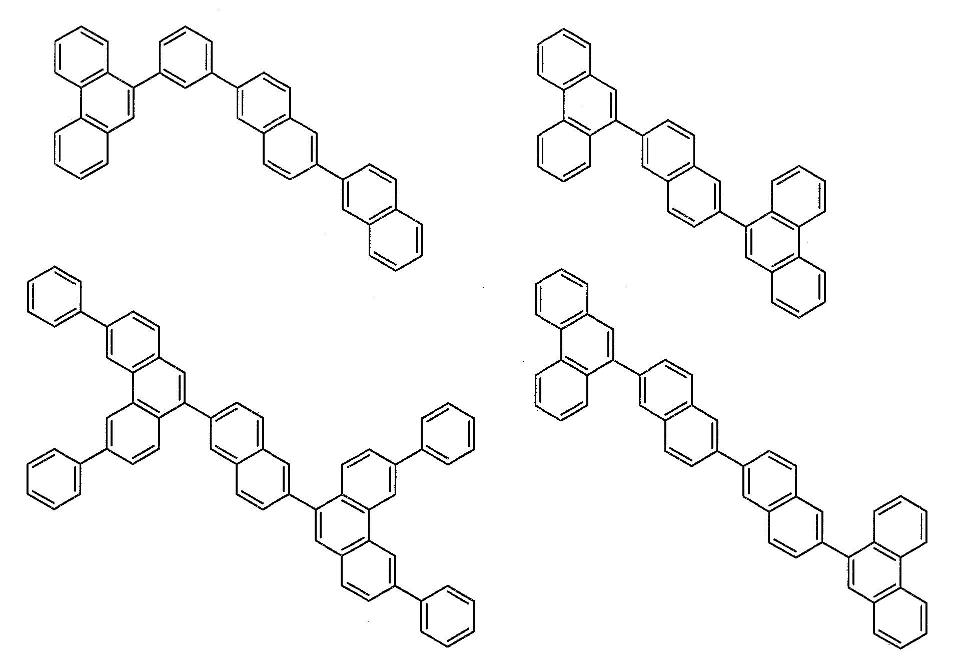

In the aspect of the invention, the polycyclic fused aromatic skeleton is preferably a chrysene derivative represented by the following formula (22).

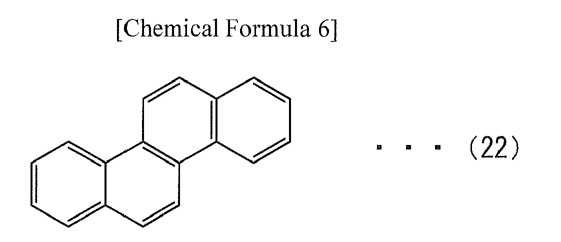

Examples of the chrysene derivative are those represented by the following formulae.

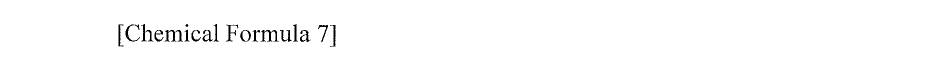

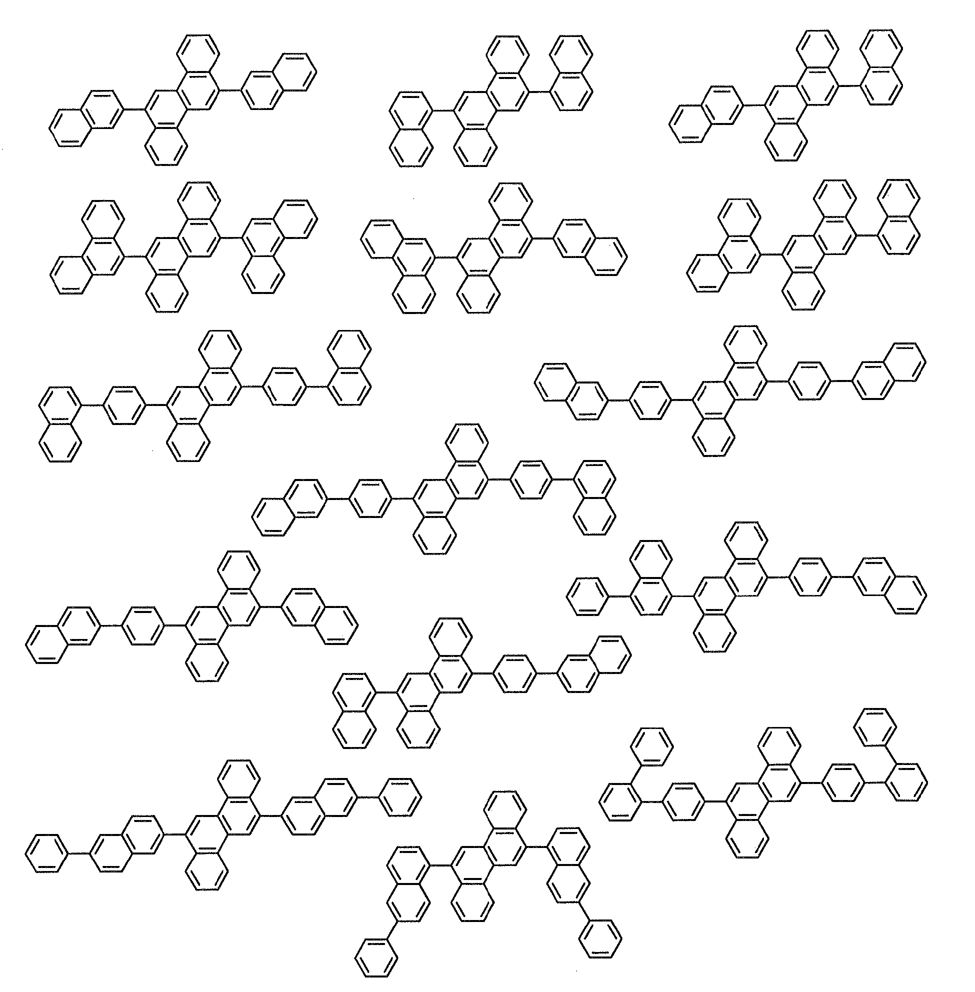

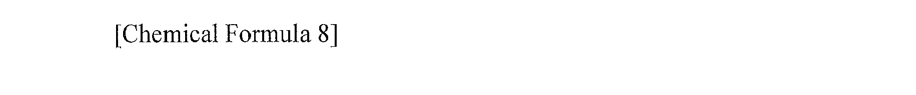

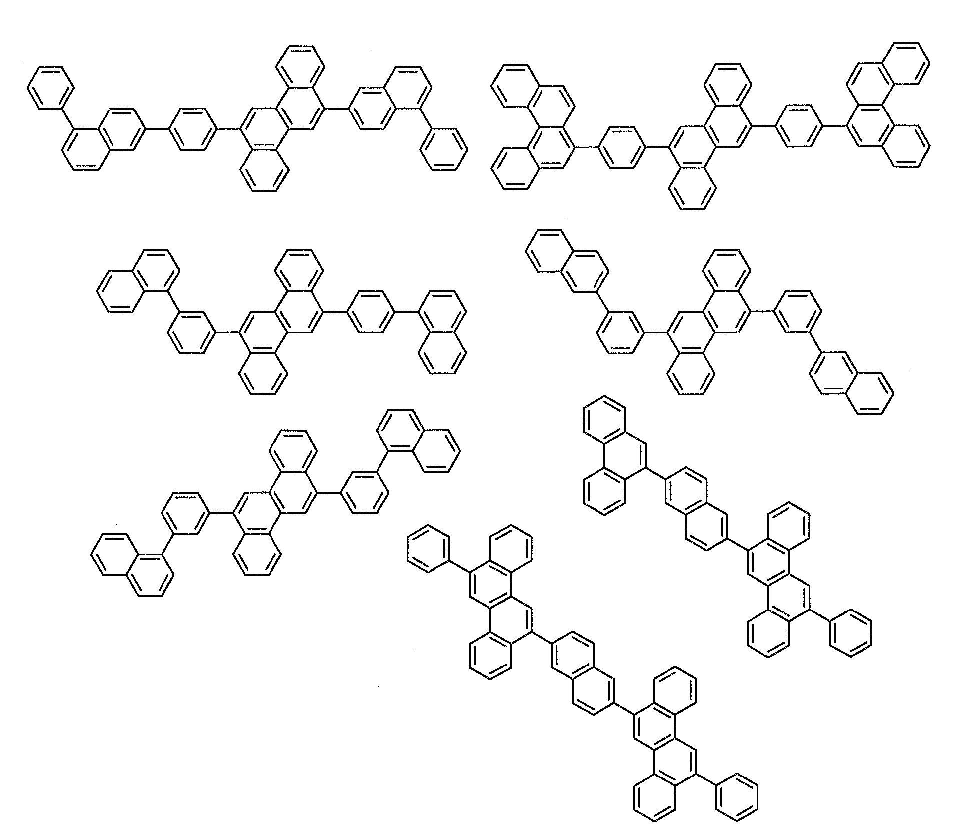

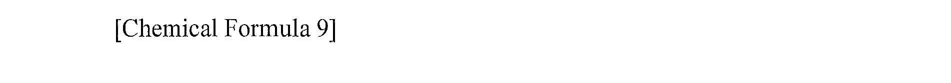

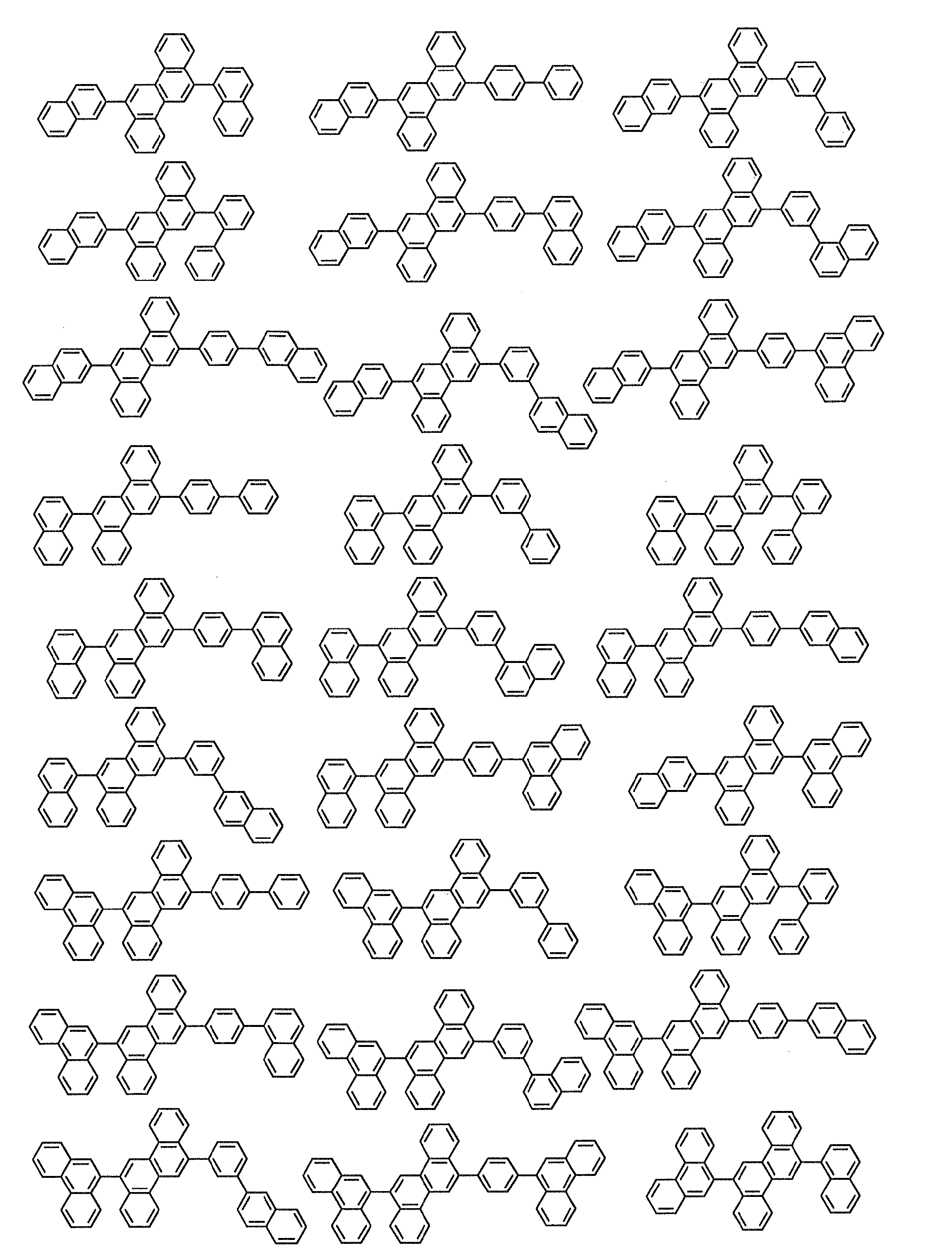

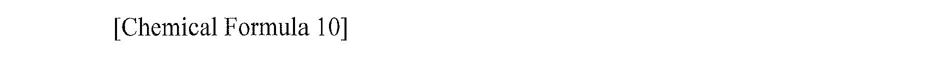

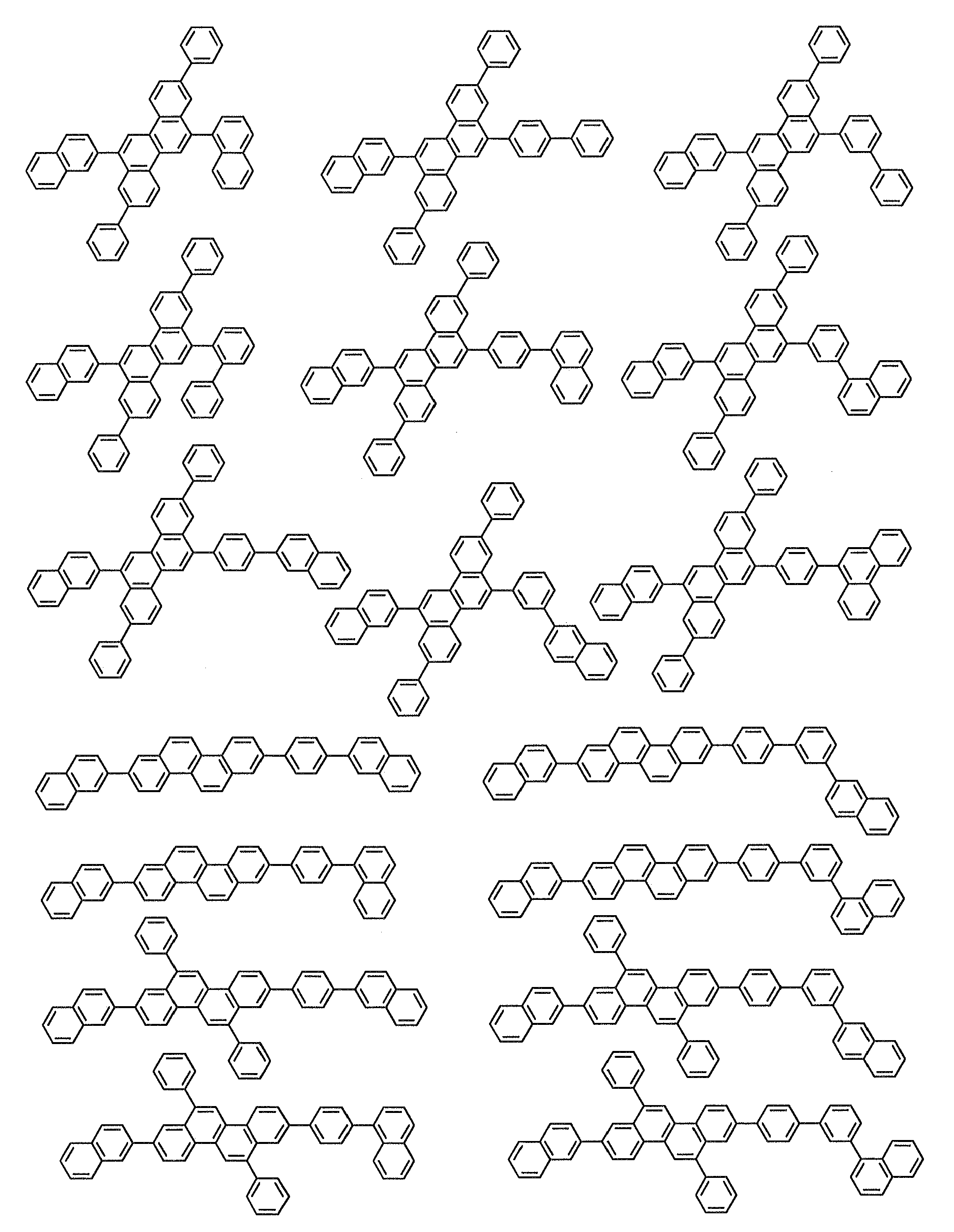

In the aspect of the invention, the polycyclic fused aromatic skeleton is preferably a derivative of a compound represented by the following formula (23) (benzo[c]phenanthrene).

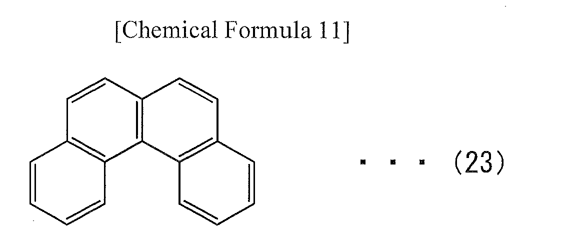

Examples of the derivative of such a compound are as follows.

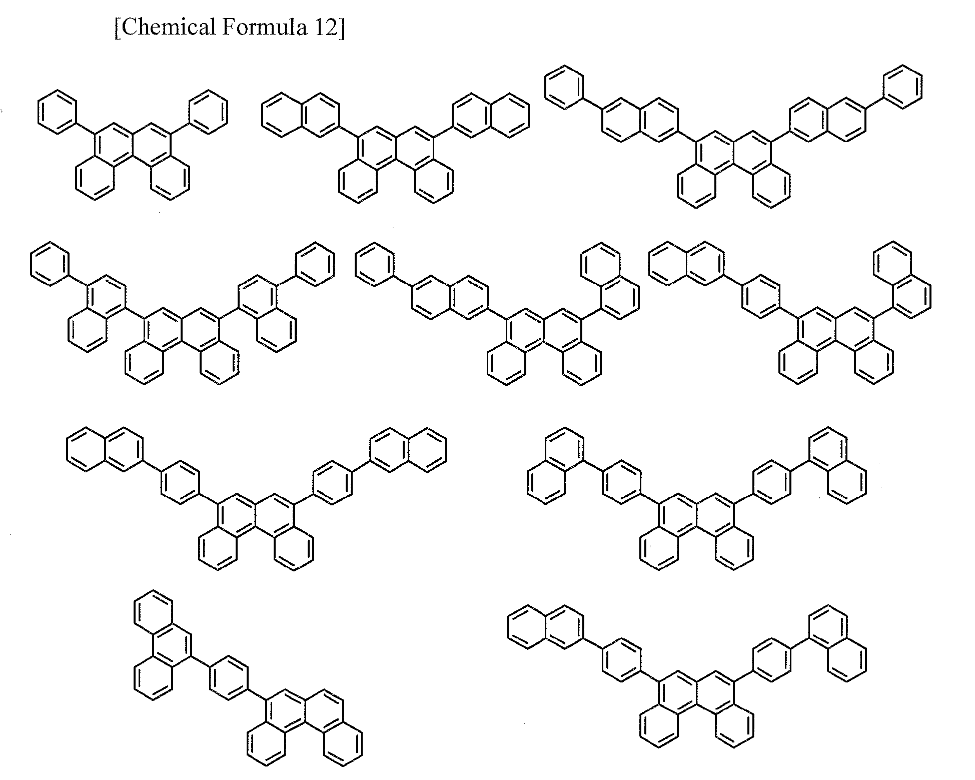

In the aspect of the invention, the polycyclic fused aromatic skeleton is preferably a derivative of a compound represented by the following formula (24) (benzo[c]chrysene).

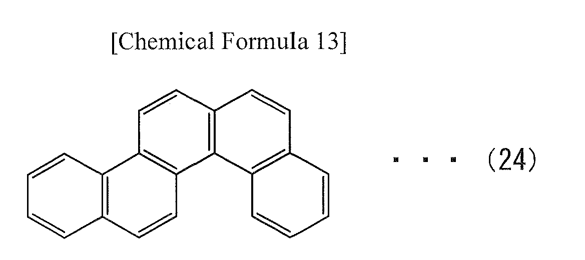

Examples of the derivative of such a compound are as follows.

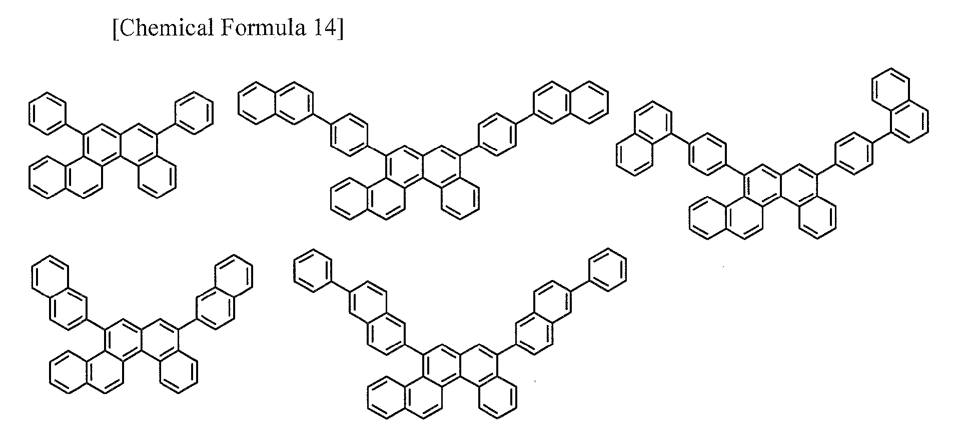

In the aspect of the invention, the polycyclic fused aromatic skeleton is preferably a derivative of a compound represented by the following formula (25) (dibenzo[c,g]phenanthrene).

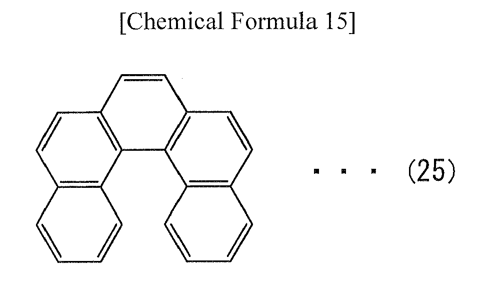

Examples of the derivative of such a compound are as follows.

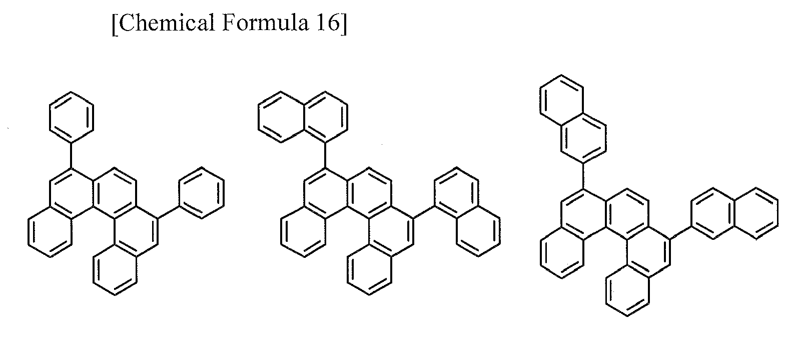

In the aspect of the invention, the polycyclic fused aromatic skeleton is preferably a fluoranthene derivative represented by the following formula (26).

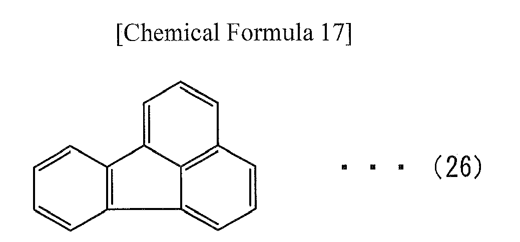

Examples of the fluoranthene derivative are those represented by the following formulae.

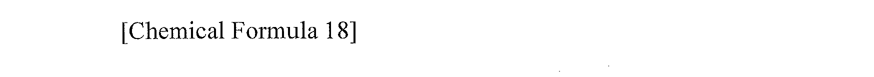

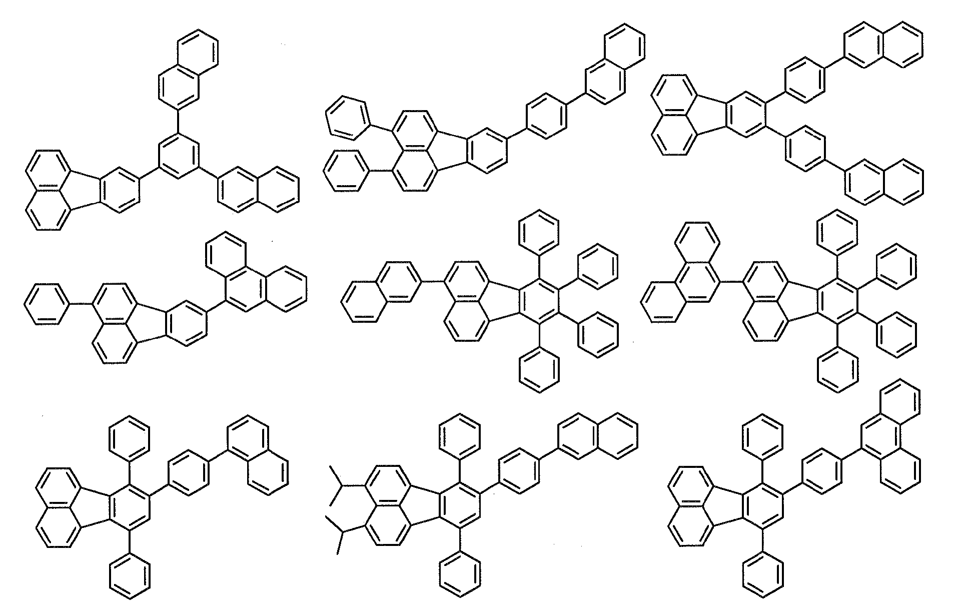

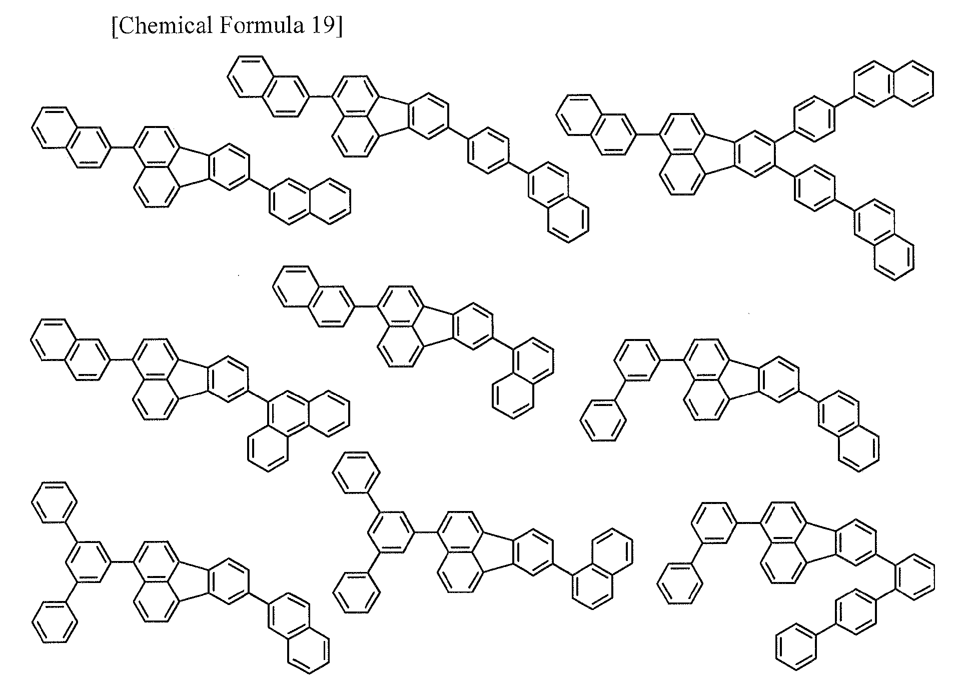

Examples of the substituted or unsubstituted benzofluoranthene are a benzo[b]fluoranthene derivative represented by the following formula (141) and a benzo[k]fluoranthene derivative represented by a formula (142).

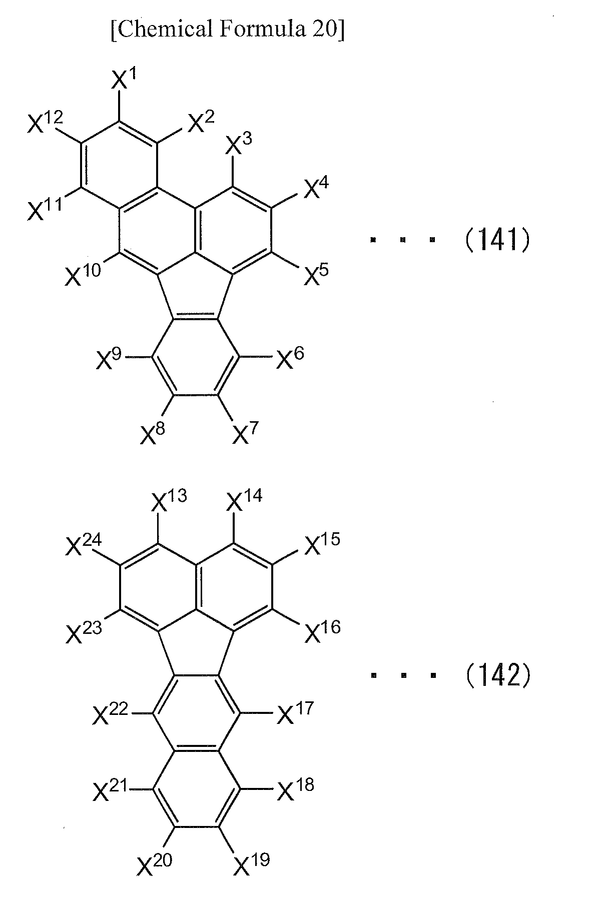

In the formulae (141) and (142), X¹ to X²⁴ each represent a hydrogen atom, a halogen atom, a linear, branched or cyclic alkyl group, a linear, branched or cyclic alkoxy group, or a substituted or unsubstituted aryl group.
The aryl group represents a carbocyclic aromatic group such as a phenyl group and naphthyl group, or a heterocyclic aromatic group such as a furyl group, thienyl group and pyridyl group.

X¹ to X²⁴ each preferably represent hydrogen atom, halogen atom (such as fluorine atom, chlorine atom, or bromine atom), linear, branched or cyclic alkyl group having 1 to 16 carbon atoms (such as methyl group, ethyl group, n-propyl group, isopropyl group, n-butyl group, isobutyl group, sec-butyl group, tert-butyl group, n-pentyl group, isopentyl group, neopentyl group, tert-pentyl group, cyclopentyl group, n-hexyl group, 3,3-dimethylbutyl group, cyclohexyl group, n-heptyl group, cyclohexylmethyl group, n-octyl group, tert-octyl group, 2-ethylhexyl group, n-nonyl group, n-decyl group, n-dodecyl group, n-tetradecyl group, or n-hexadecyl group), linear, branched or cyclic alkoxy group having 1 to 16 carbon atoms (such as methoxy group, ethoxy group, n-propoxy group, isopropoxy group, n-butoxy group, isobutoxy group, sec-butoxy group, n-pentyloxy group, neopentyloxy group, cyclopentyloxy group, n-hexyloxy group, 3,3-dimethylbutyloxy group, cyclohexyloxy group, n-heptyloxy group, n-octyloxy group, 2-ethylhexyloxy group, n-nonyloxy group, n-decyloxy group, n-dodecyloxy group, n-tetradecyloxy group, or n-hexadecyloxy group), or substituted or unsubstituted aryl group having 4 to 16 carbon atoms (such as phenyl group, 2-methylphenyl group, 3-methylphenyl group, 4-methylphenyl group, 4-ethylphenyl group, 4-n-propylphenyl group, 4-isopropylphenyl group, 4-n-butylphenyl group, 4-tert-butylphenyl group, 4-isopentylphenyl group, 4-tert-pentylphenyl group, 4-n-hexylphenyl group, 4-cyclohexylphenyl group, 4-n-octylphenyl group, 4-n-decylphenyl group, 2,3-dimethylphenyl group, 2,4-dimethylphenyl group, 2,5-dimethylphenyl group, 3,4-dimethylphenyl group, 5-indanyl group, 1,2,3,4-tetrahydro-5-naphthyl group, 1,2,3,4-tetrahydro-6-naphthyl group, 2-methoxyphenyl group, 3-methoxyphenyl group, 4-methoxyphenyl group, 3-ethoxyphenyl group, 4-ethoxyphenyl group, 4-n-propoxyphenyl group, 4-isopropoxyphenyl group, 4-n-butoxyphenyl group, 4-n-pentyloxyphenyl group, 4-n-hexyloxyphenyl group, 4-cyclohexyloxyphenyl group, 4-n-heptyloxyphenyl group, 4-n-octyloxyphenyl group, 4-n-decyloxyphenyl group, 2,3-dimethoxyphenyl group, 2,5-dimethoxyphenyl group, 3,4-dimethoxyphenyl group, 2-methoxy-5-methylphenyl group, 3-methyl-4-methoxyphenyl group, 2-fluorophenyl group, 3-fluorophenyl group, 4-fluorophenyl group, 2-chlorophenyl group, 3-chlorophenyl group, 4-chlorophenyl group, 4-bromophenyl group, 4-trifluoromethylphenyl group, 3,4-dichlorophenyl group, 2-methyl-4-chlorophenyl group, 2-chloro-4-methylphenyl group, 3-chloro-4-methylphenyl group, 2-chloro-4-methoxyphenyl group, 4-phenylphenyl group, 3-phenylphenyl group, 4-(4'-methylphenyl)phenyl group, 4-(4'-methoxyphenyl)phenyl group, 1-naphthyl group, 2-naphthyl group, 4-ethoxy-1-naphthyl group, 6-methoxy-2-naphthyl group, 7-ethoxy-2-naphthyl group, 2-furyl group, 2-thienyl group, 3-thienyl group, 2-pyridyl group, 3-pyridyl group, or 4-pyridyl group), more preferably hydrogen atom, fluorine atom, chlorine atom, alkyl group having 1 to 10 carbon atoms, alkoxy group having 1 to 10 carbon atoms or aryl group having 6 to 12 carbon atoms, further more preferably hydrogen atom, fluorine atom, chlorine atom, alkyl group having 1 to 6 carbon atoms, alkoxy group having 1 to 6 carbon atoms or carbocyclic aromatic group having 6 to 10 carbon atoms.

Examples of the benzo[b]fluoranthene derivative represented by the formula (141) are as follows.

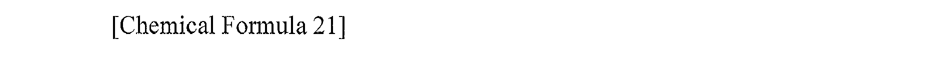

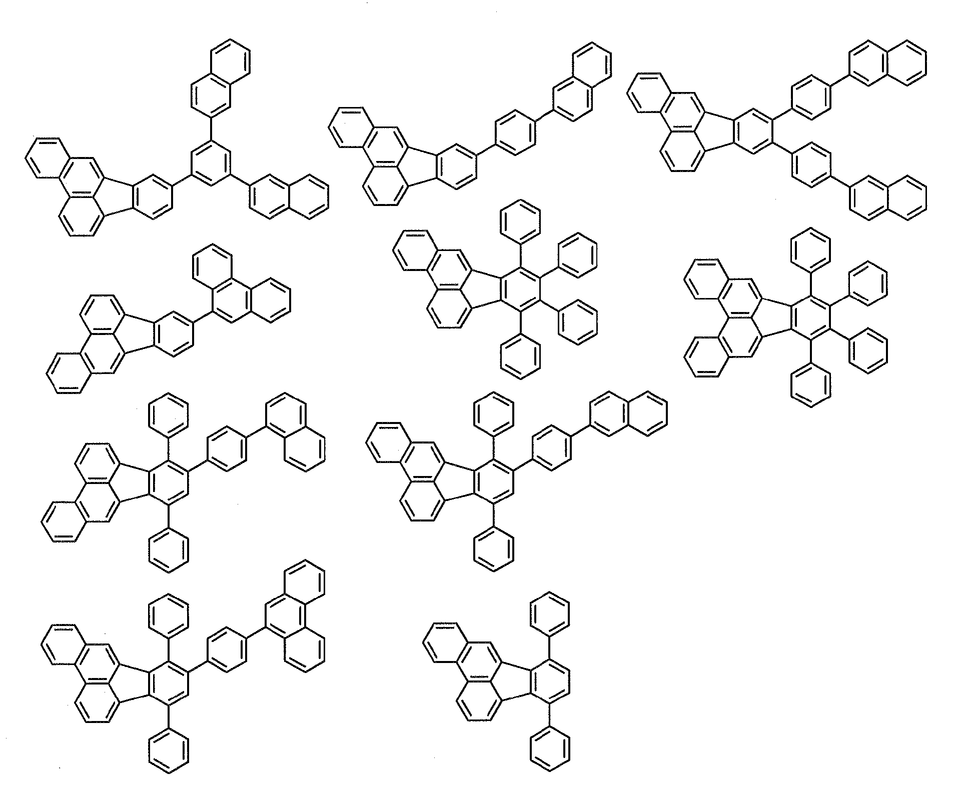

Examples of the benzo[k]fluoranthene derivative represented by the formula (142) are as follows.

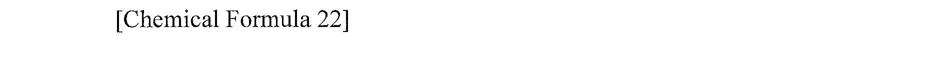

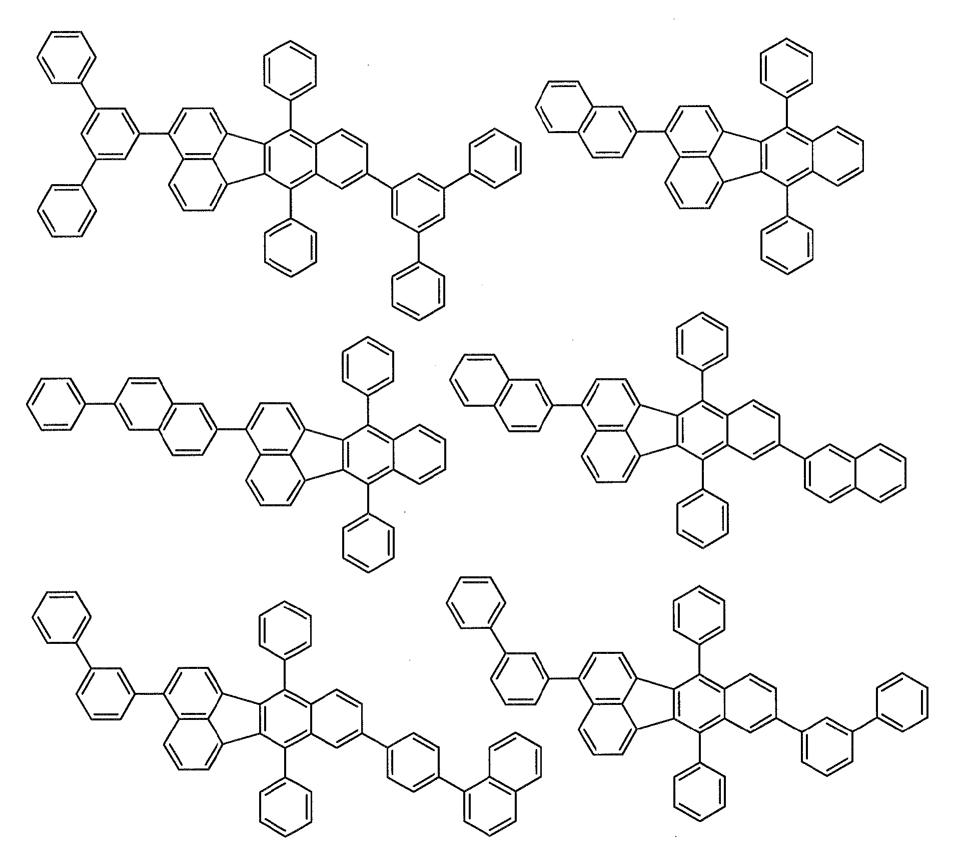

In the aspect of the invention, the polycyclic fused aromatic skeleton is preferably a triphenylene derivative represented by the following formula (27).

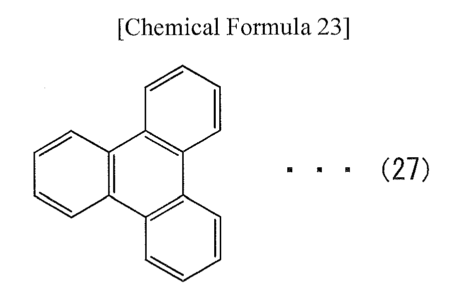

Examples of the triphenylene derivative are those represented by the following formulae.

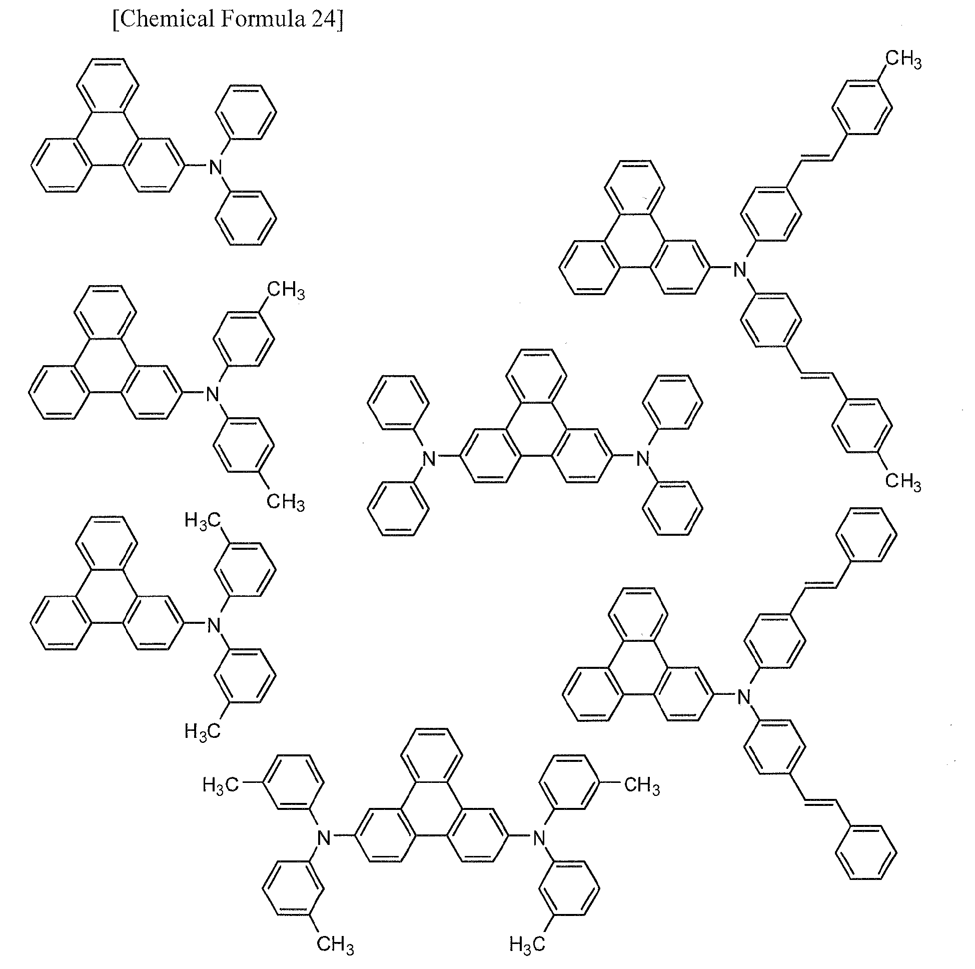

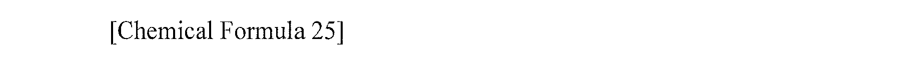

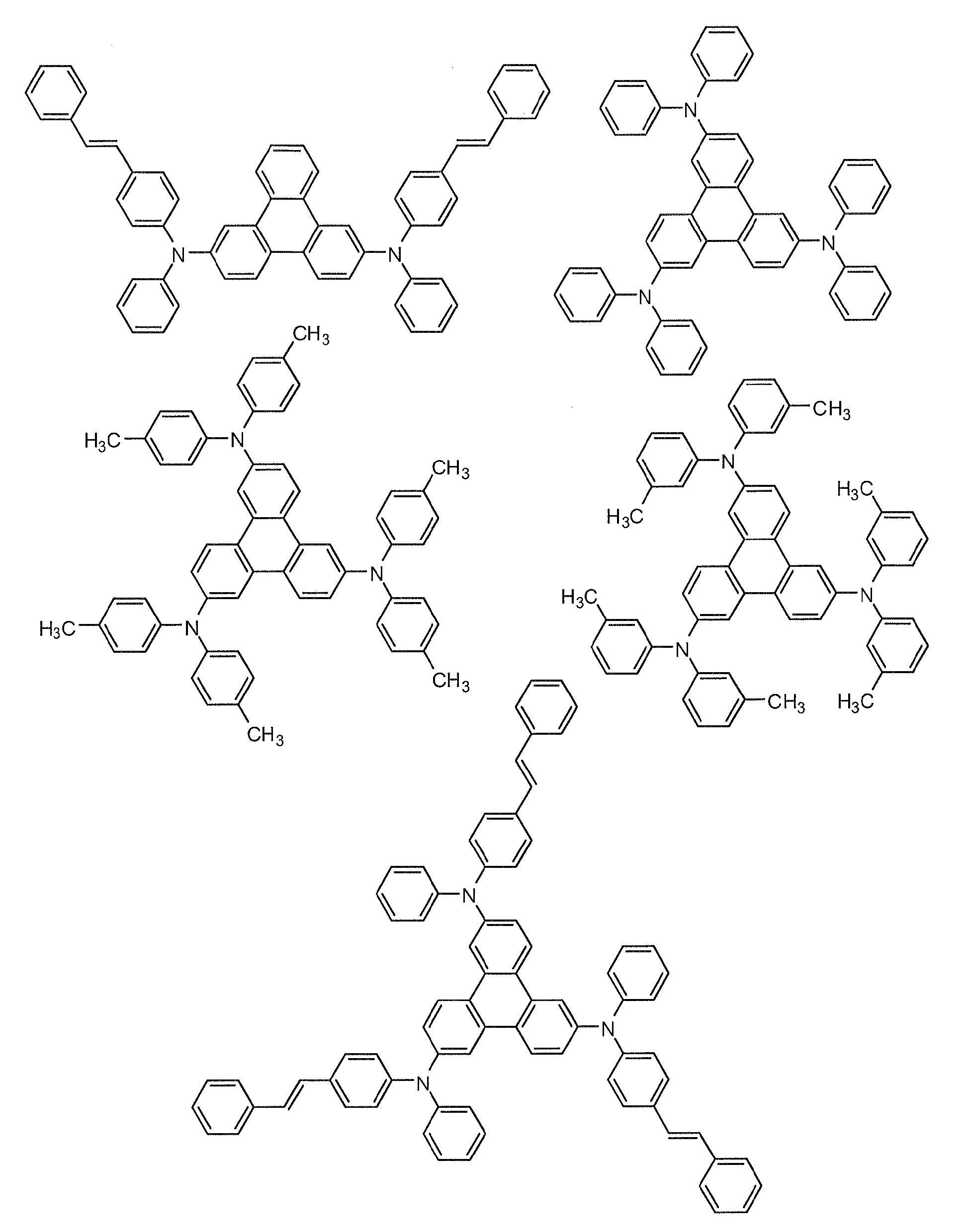

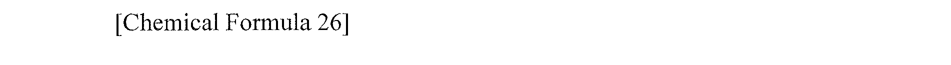

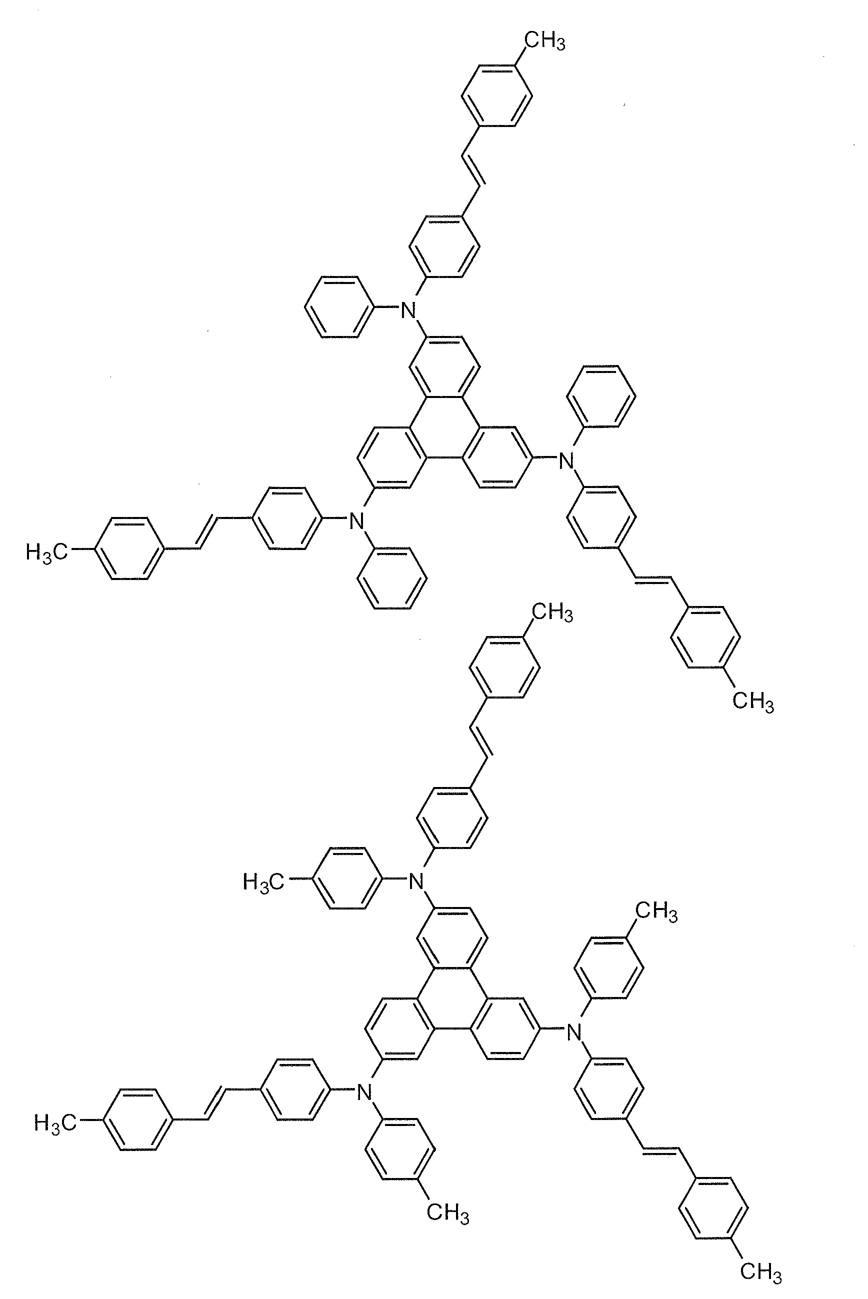

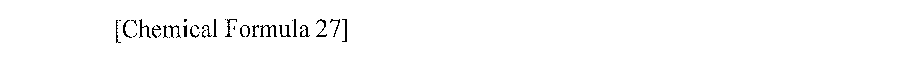

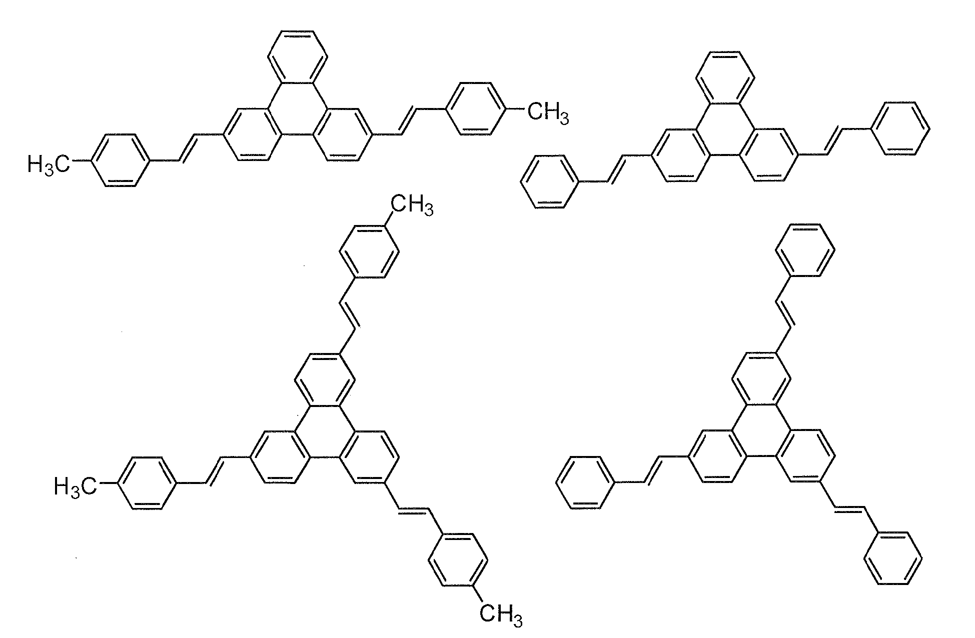

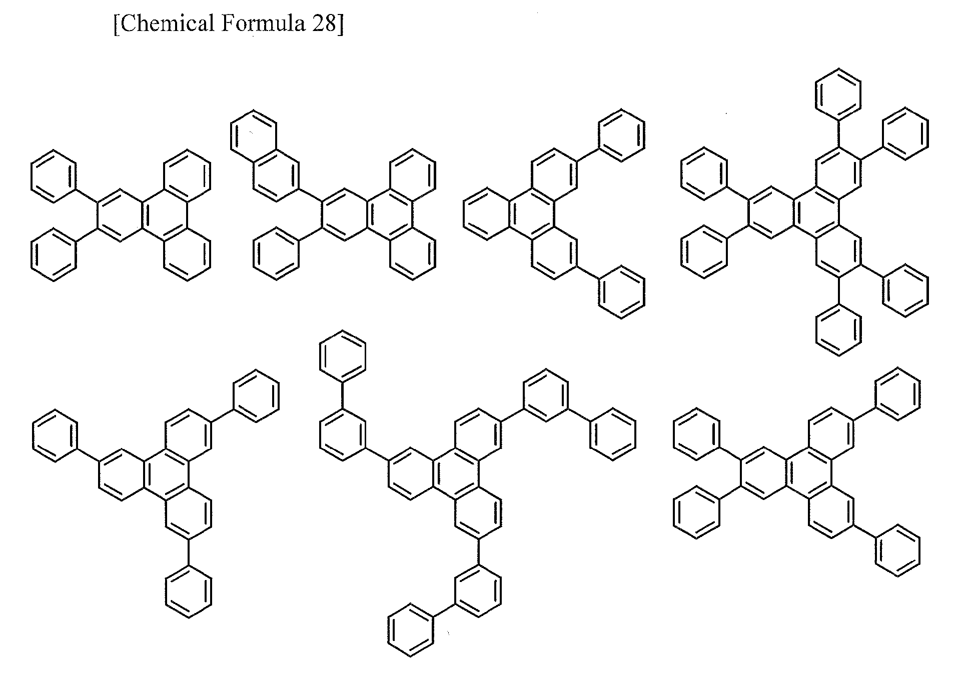

The polycyclic fused aromatic skeleton may contain nitrogen atom, examples of which are shown below.

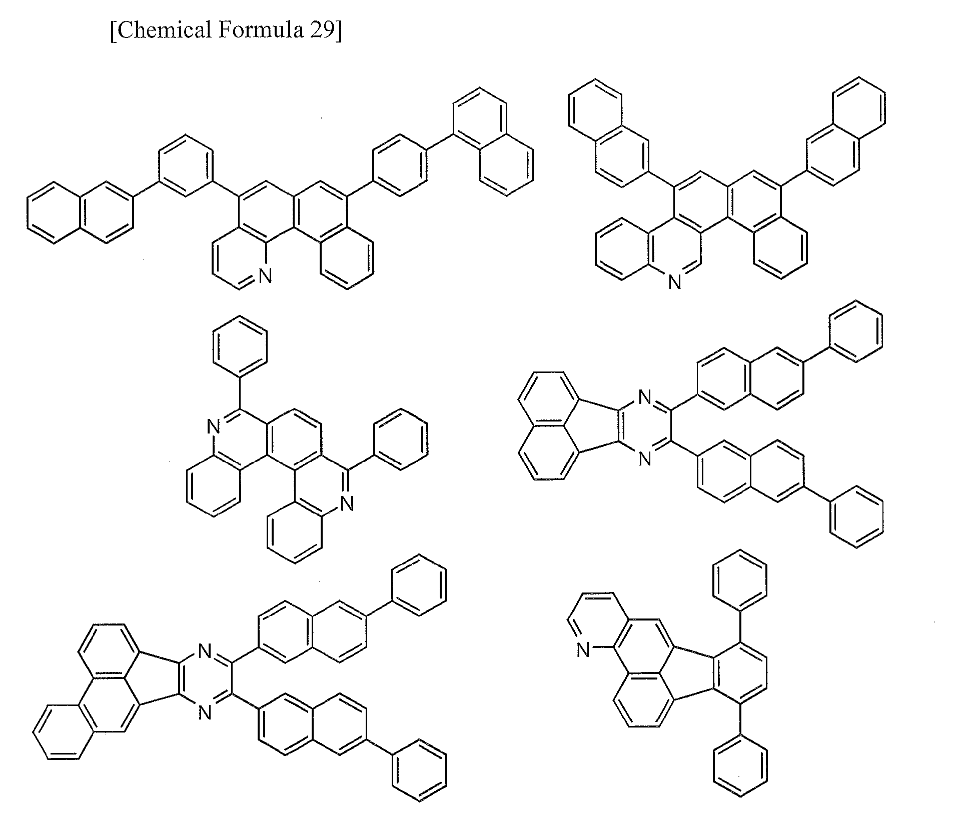

Examples of the compound represented by the formula (4) are compounds represented by the following formulae (41) to (48).

[Chemical Formula 30] Np-(Np)ₙ-Np (41)

In the formula (41), Np represents substituted or unsubstituted naphthalene, and n represents an integer of 0 to 3.

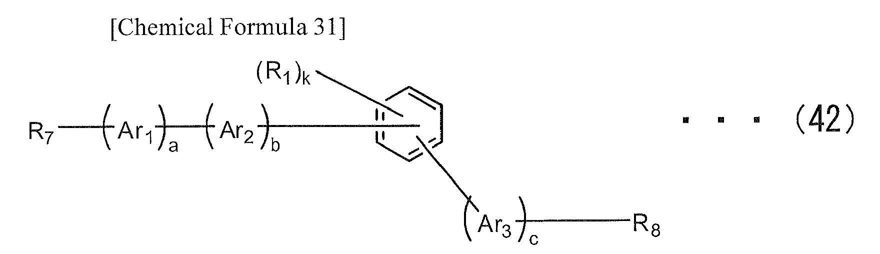

In the formula (42), Ar₁ and Ar₂ each independently represent substituted or unsubstituted naphthalene or substituted or unsubstituted phenanthrene. Ar₃ represents a substituted or unsubstituted aryl group having 6 to 30 ring carbon atoms.
However, at least one of Ar₁, Ar₂ and Ar₃ is naphthalene. R₁, R₇ and R₈ each represent a hydrogen atom or a substituent. a, b and c each represent an integer of 1 to 3.
k represents an integer of 1 to 4. When k is 2 or more, R₁ may be mutually the same or different.

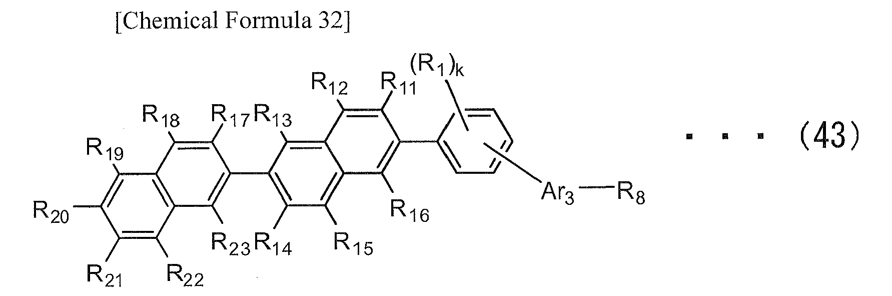

In the formula (43), Ar₃ represents an aryl group having 6 to 30 ring carbon atoms, and R₁, R₈ and R₁₁ to R₂₃ each represent a hydrogen atom or a substituent. k represents an integer of 1 to 4. When k is 2 or more, R₁ may be mutually the same or different.

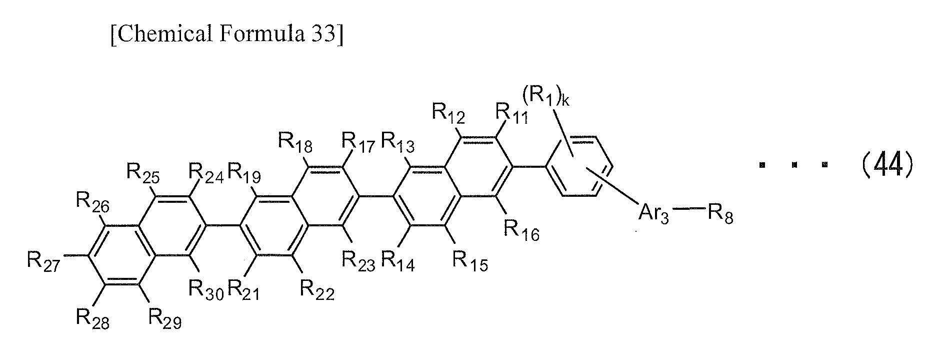

In the formula (44), Ar₃ represents an aryl group having 6 to 30 ring carbon atoms, and R₁, R₈, R₁₁ to R₁₉ and R₂₁ to R₃₀ each represent a hydrogen atom or a substituent. k represents an integer of 1 to 4. When k is 2 or more, R₁ may be mutually the same or different.

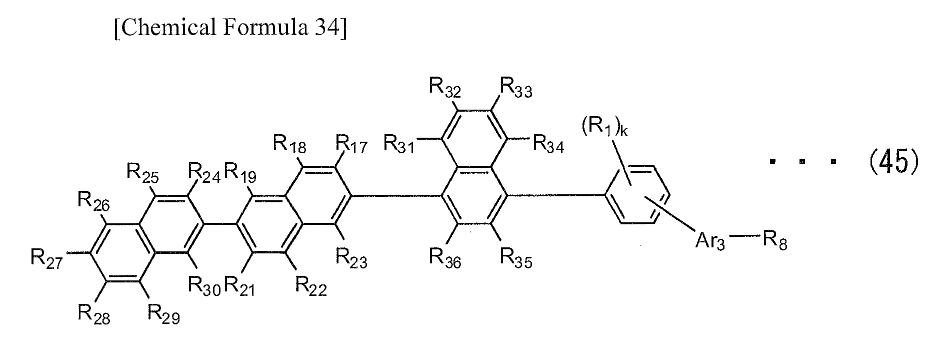

In the formula (45), Ar₃ represents an aryl group having 6 to 30 ring carbon atoms, and R₁, R₈ and R₁₇ to R₃₆ each represent a hydrogen atom or a substituent. k represents an integer of 1 to 4. When k is 2 or more, R₁ may be mutually the same or different.

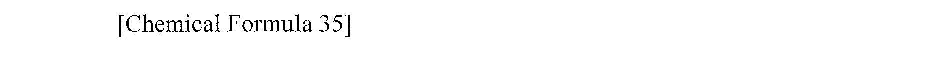

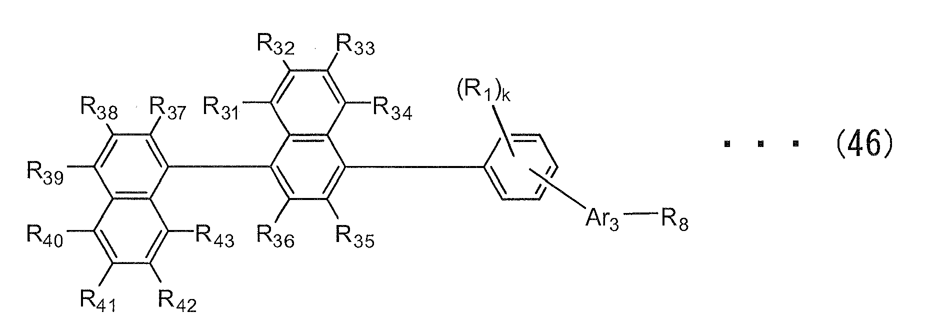

In the formula (46), Ar₃ represents an aryl group having 6 to 30 ring carbon atoms, and R₁, R₈ and R₃₁ to R₄₂ each represent a hydrogen atom or a substituent. k represents an integer of 1 to 4. When k is 2 or more, R₁ may be mutually the same or different.

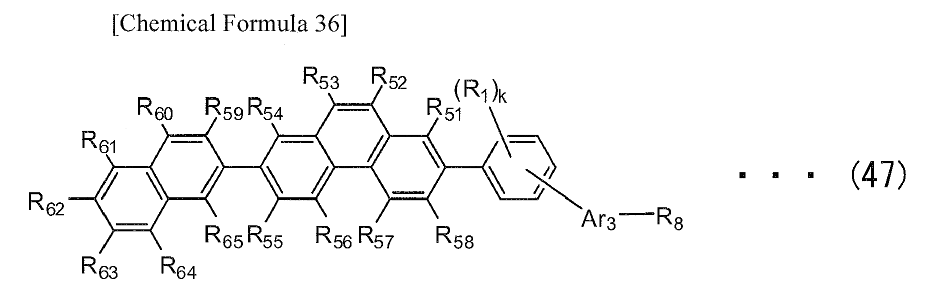

In the formula (47), Ar₃ represents an aryl group having 6 to 30 ring carbon atoms, and R₁, R₈ and R₅₁ to R₆₅ each represent a hydrogen atom or a substituent. k represents an integer of 1 to 4. When k is 2 or more, R₁ may be mutually the same or different.

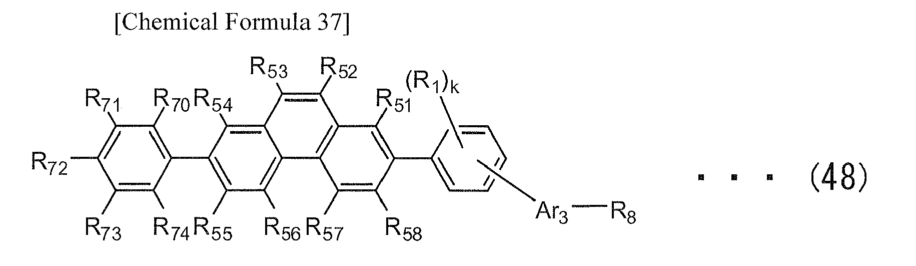

In the formula (48), Ar₃ represents an aryl group having 6 to 30 ring carbon atoms, and R₁, R₈, R₅₁ to R₅₈ and R₇₀ to R₇₄ each represent a hydrogen atom or a substituent. k represents an integer of 1 to 4. When k is 2 or more, R₁ may be mutually the same or different.

Examples of the compounds are as follows.

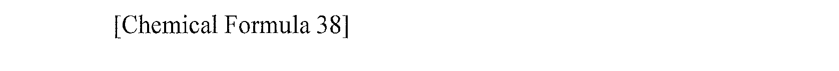

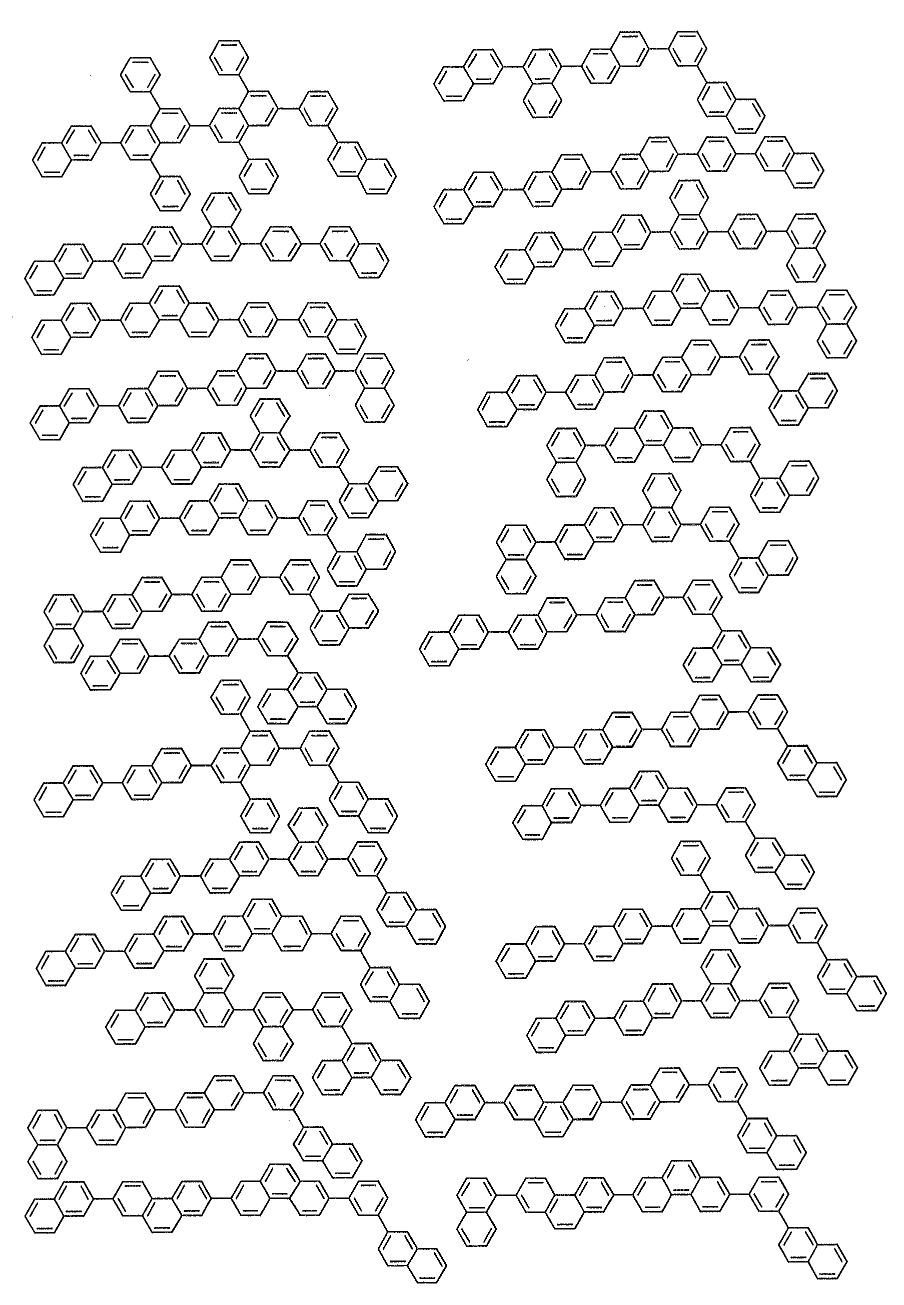

An example of the host material is an oligonaphthalene derivative represented by the following formula (49).

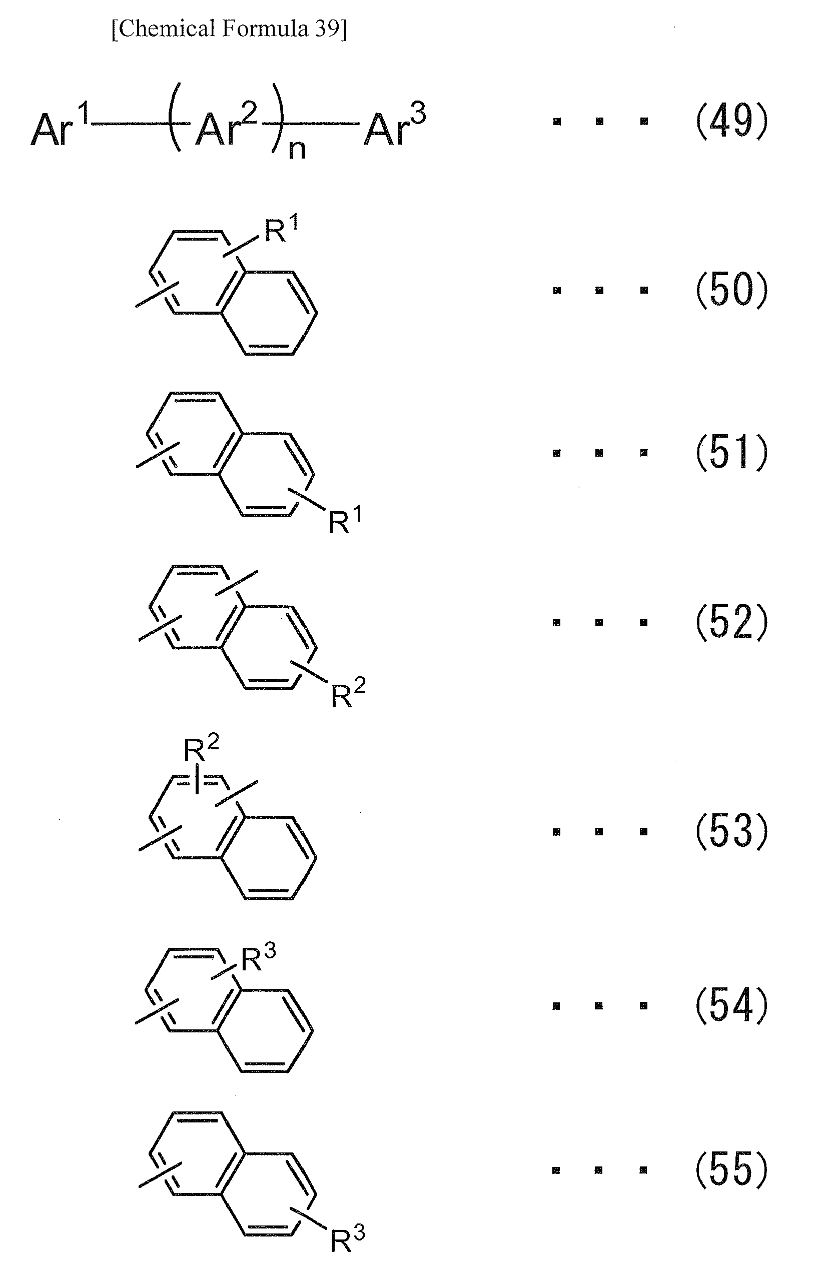

In the formula: n is 1 or 2; Ar¹ is a substituent represented by the general formula (50) or (51); Ar² is a substituent represented by the general formula (52) or (53); Ar³ is a substituent represented by the general formula (54) or (55); and R¹ to R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

The oligonaphthalene derivative may have the structure represented by the general formula (56). 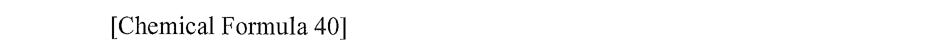 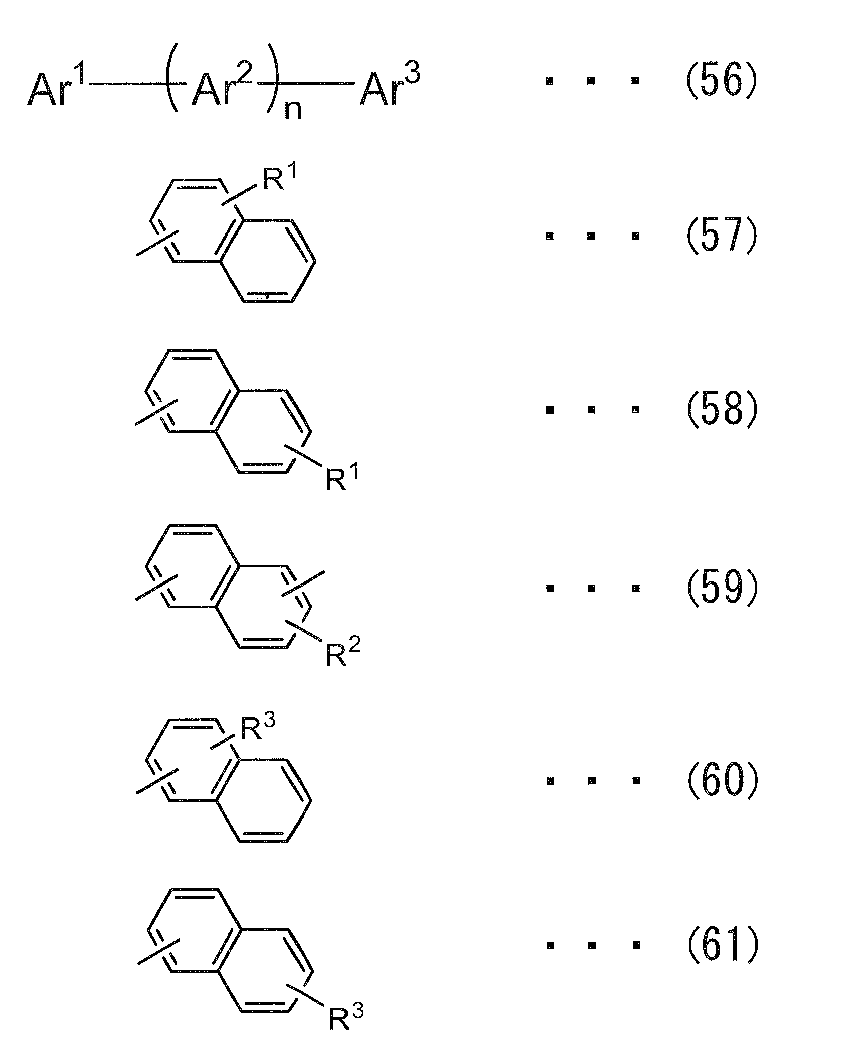 In the formula: n is 1 or 2; Ar¹ is a substituent represented by the general formula (57) or (58); Ar² is a substituent represented by the general formula (59); Ar³ is a substituent represented by the general formula (60) or (61); and R¹ to R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

More specifically, the oligonaphthalene derivative exemplarily have the structure represented by the general formula (62). 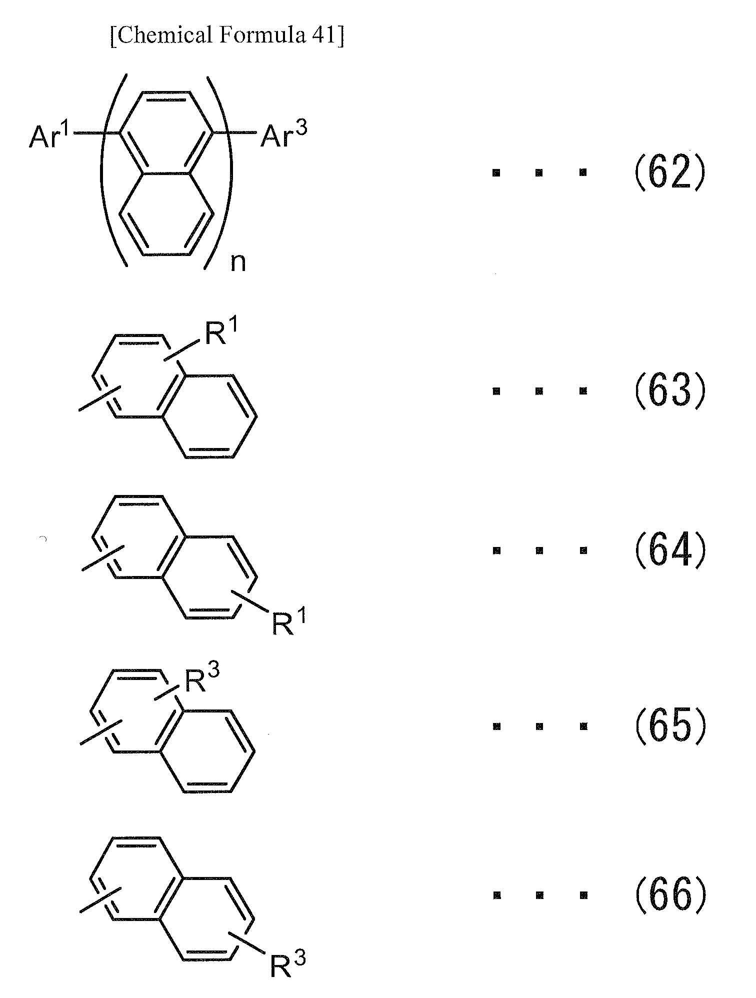 In the formula: n is 1 or 2; Ar¹ is a substituent represented by the general formula (63) or (64); Ar³ is a substituent represented by the general formula (65) or (66); and R¹ and R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

The oligonaphthalene derivative may have the structure represented by the general formula (67). 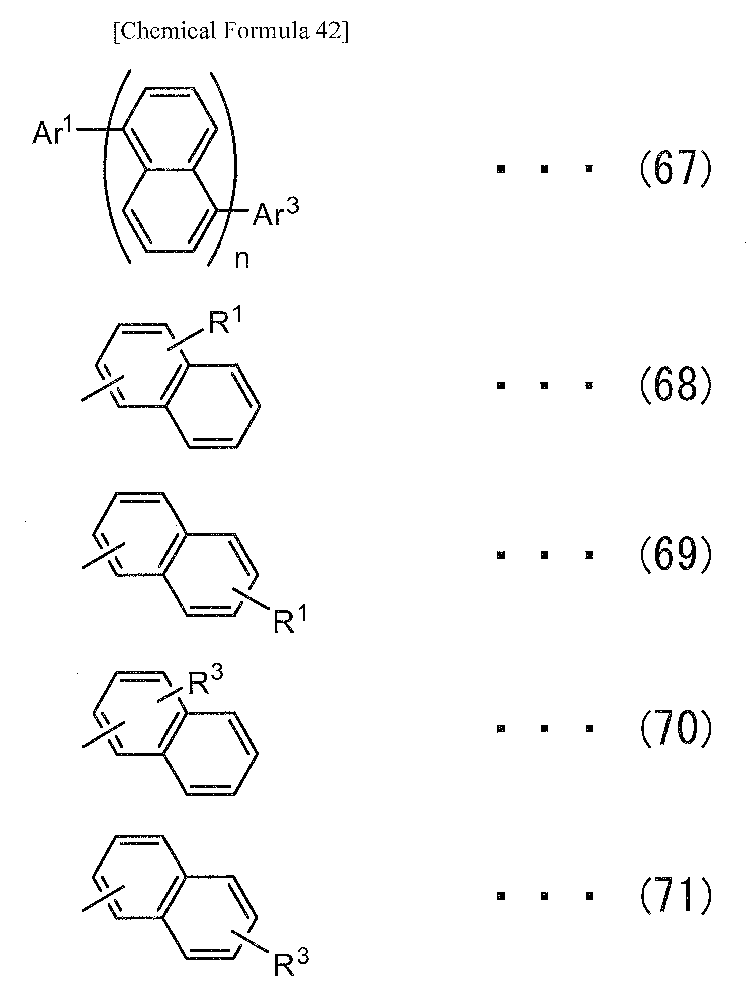 In the formula: n is 1 or 2; Ar¹ is a substituent represented by the general formula (68) or (69); Ar³ is a substituent represented by the general formula (70) or (71); and R¹ and R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

Particularly, the structure represented by the general formula (72) is preferable. 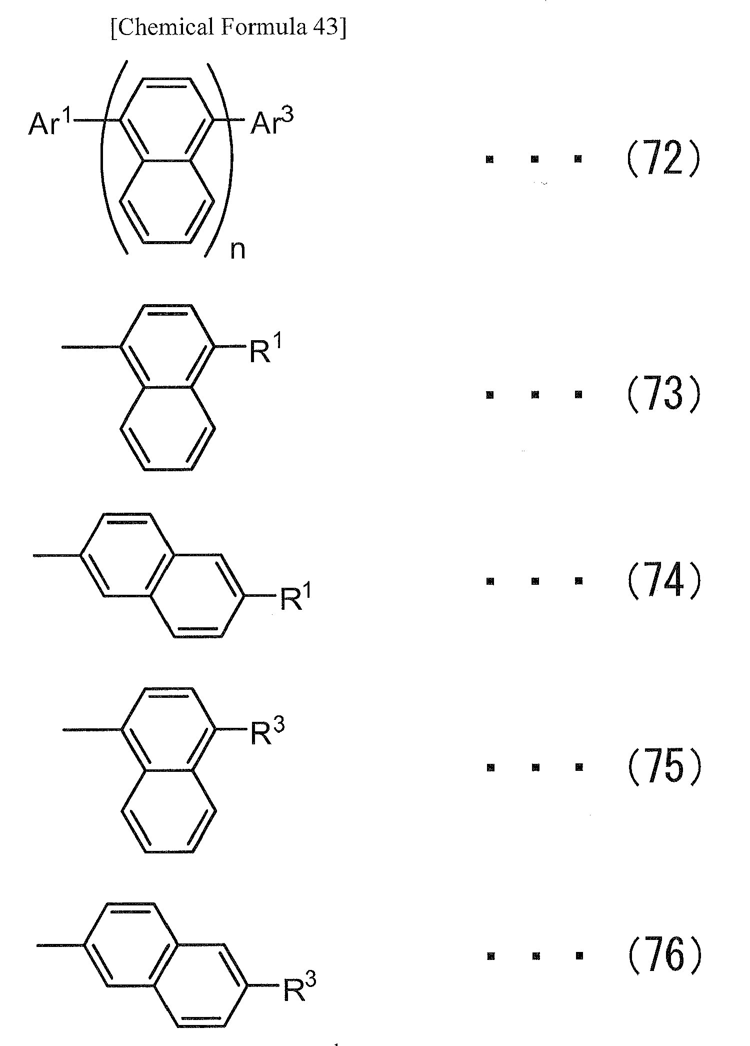 In the formula: n is 1 or 2; Ar¹ is a substituent represented by the general formula (73) or (74); Ar³ is a substituent represented by the general formula (75) or (76); and R¹ and R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

Further, the structure represented by the general formula (77) is preferable. 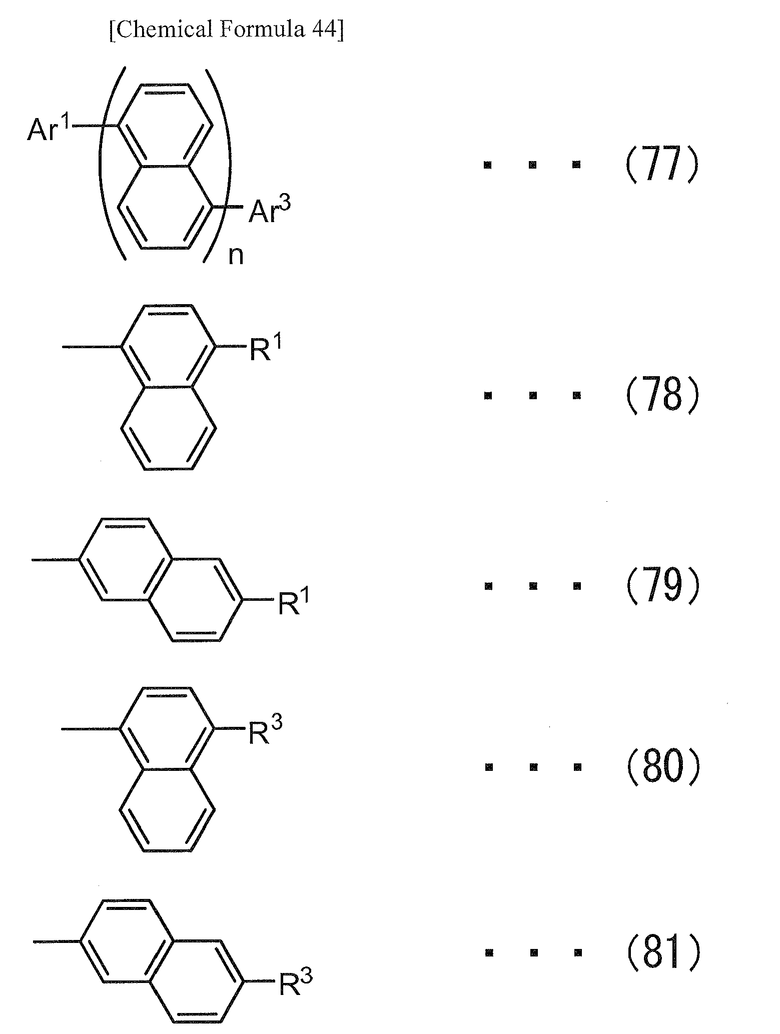 In the formula: n is 1 or 2; Ar¹ is a substituent represented by the general formula (78) or (79); Ar³ is a substituent represented by the general formula (80) or (81); and R¹ and R³ each independently represent a hydrogen atom, linear or branched alkyl group having 6 or less carbon atoms, alicyclic alkyl group, substituted or unsubstituted aromatic ring, substituted or unsubstituted heteroaromatic ring, alkoxy group, amino group, cyano group, silyl group, ester group, carbonyl group or halogen.

Examples of the alkyl group having 6 or less carbon atoms are a methyl group, ethyl group, n-propyl group, i-propyl group, n-butyl group, i-butyl group, sec-butyl group, t-butyl group, n-pentyl group, i-pentyl group and n-hexyl group.

Examples of the alicyclic alkyl group are a cyclopropyl group, cyclobutyl group, cyclopentyl group and cyclohexyl group.

Examples of the substituted or unsubstituted aromatic ring are a phenyl group, naphthyl group, anthranil group, pyrenyl group and spirofluorenyl group.

Examples of the substituted or unsubstituted heteroaromatic ring are a pyridyl group, indolyl group, carbazolyl group, thienyl group and furyl group.
Examples of the oligonaphthalene derivative represented by the general formula (49) are oligonaphthalene derivatives represented by the following structural formulae. However, the invention is not limited to these compounds.

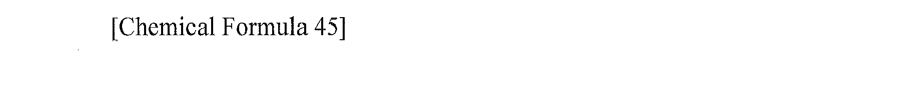

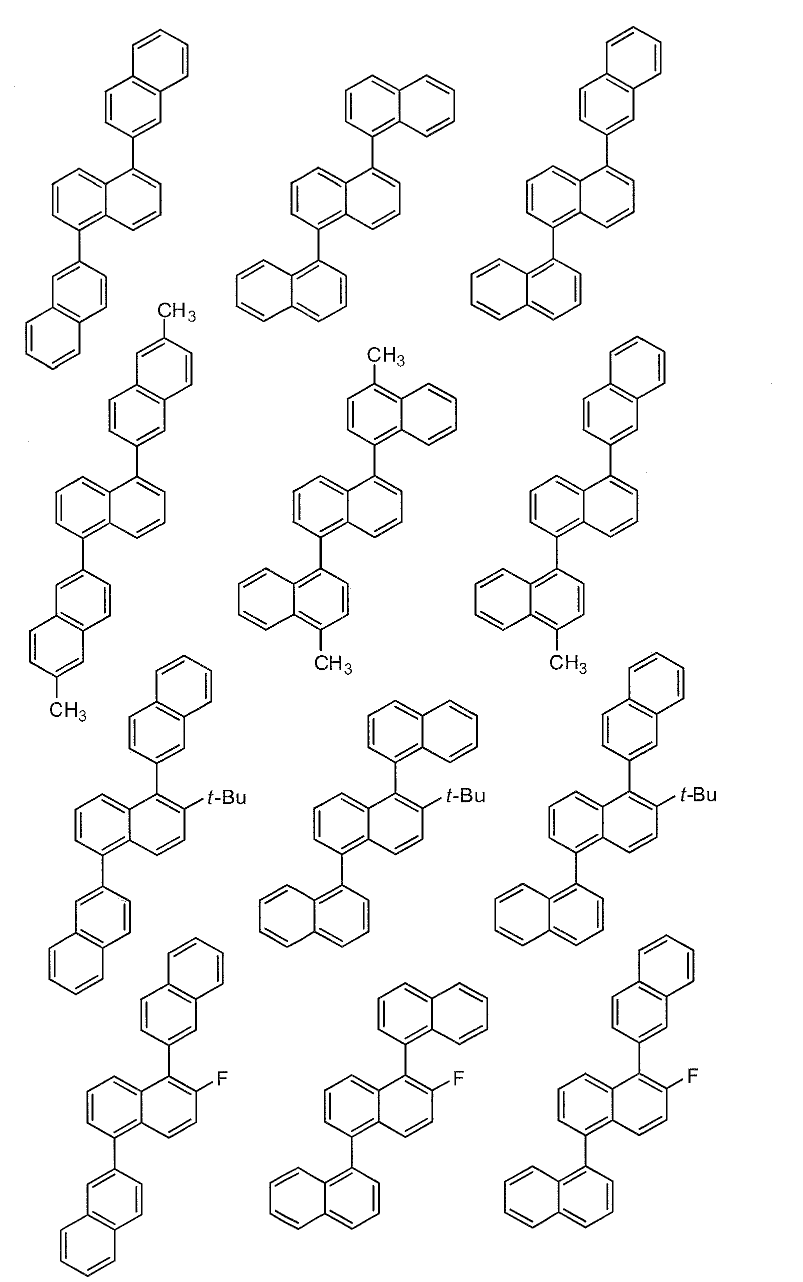

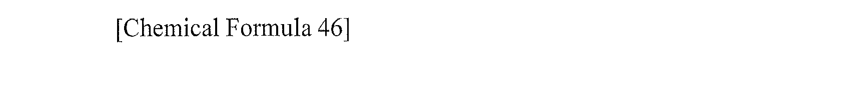

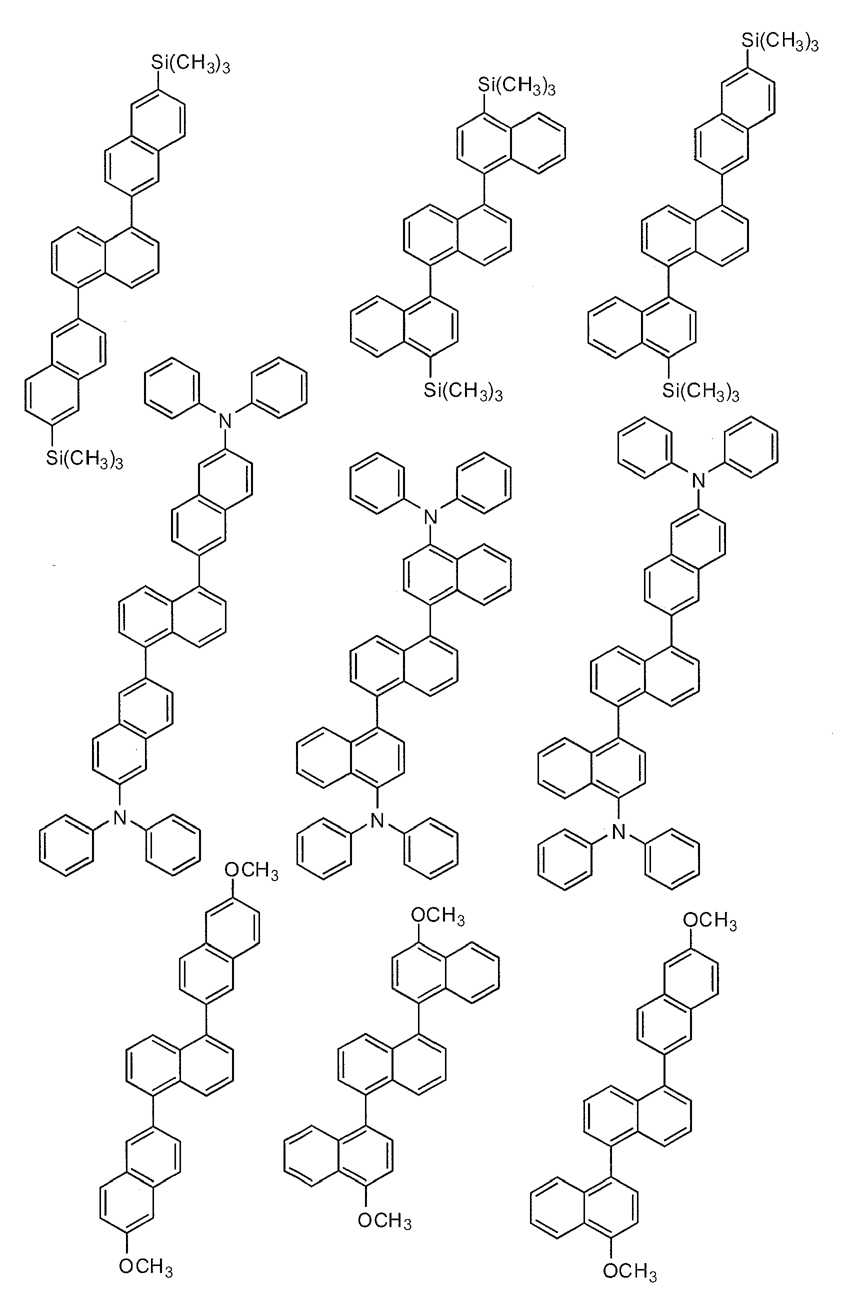

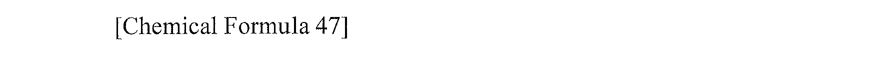

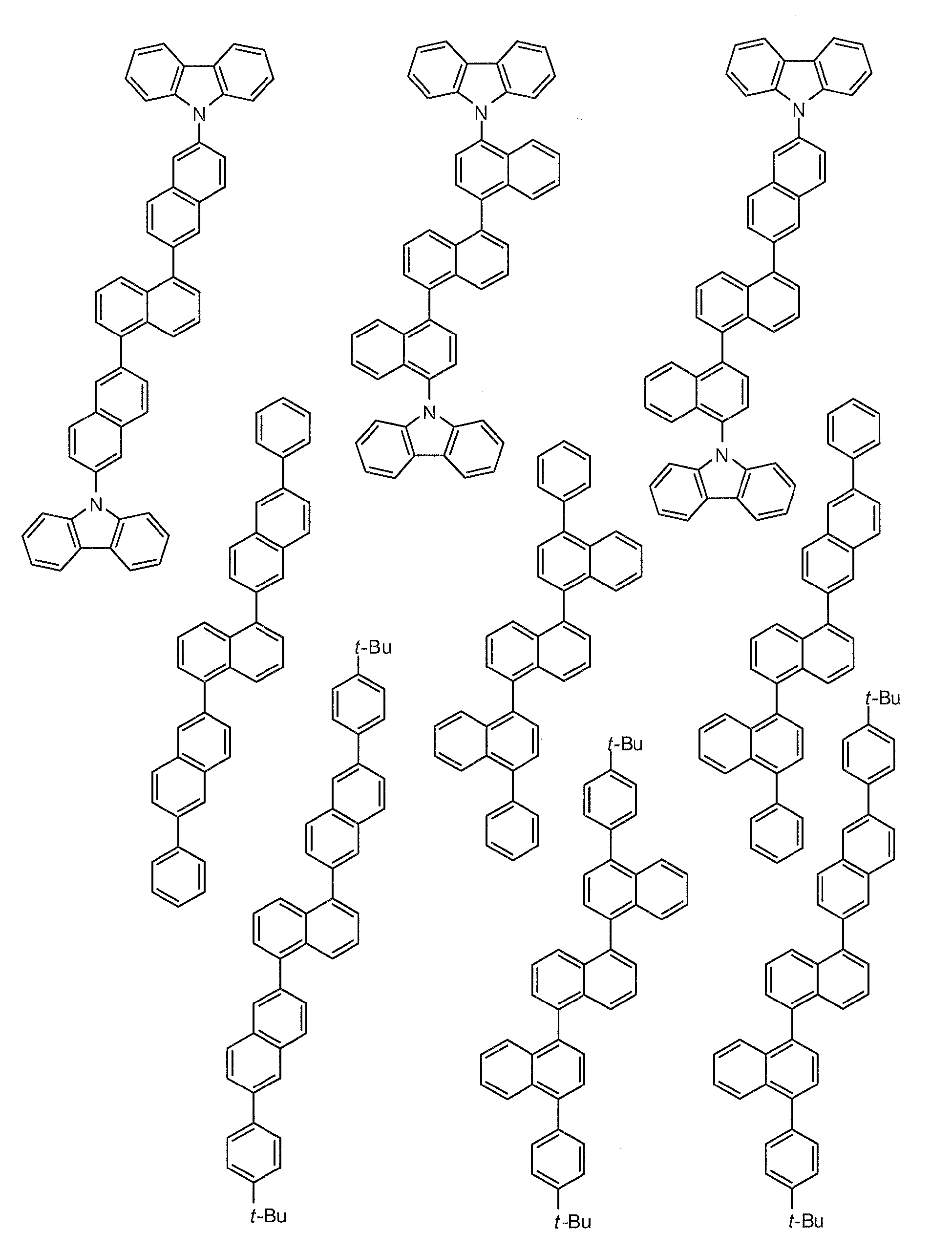

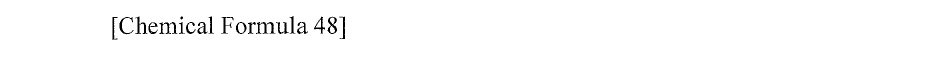

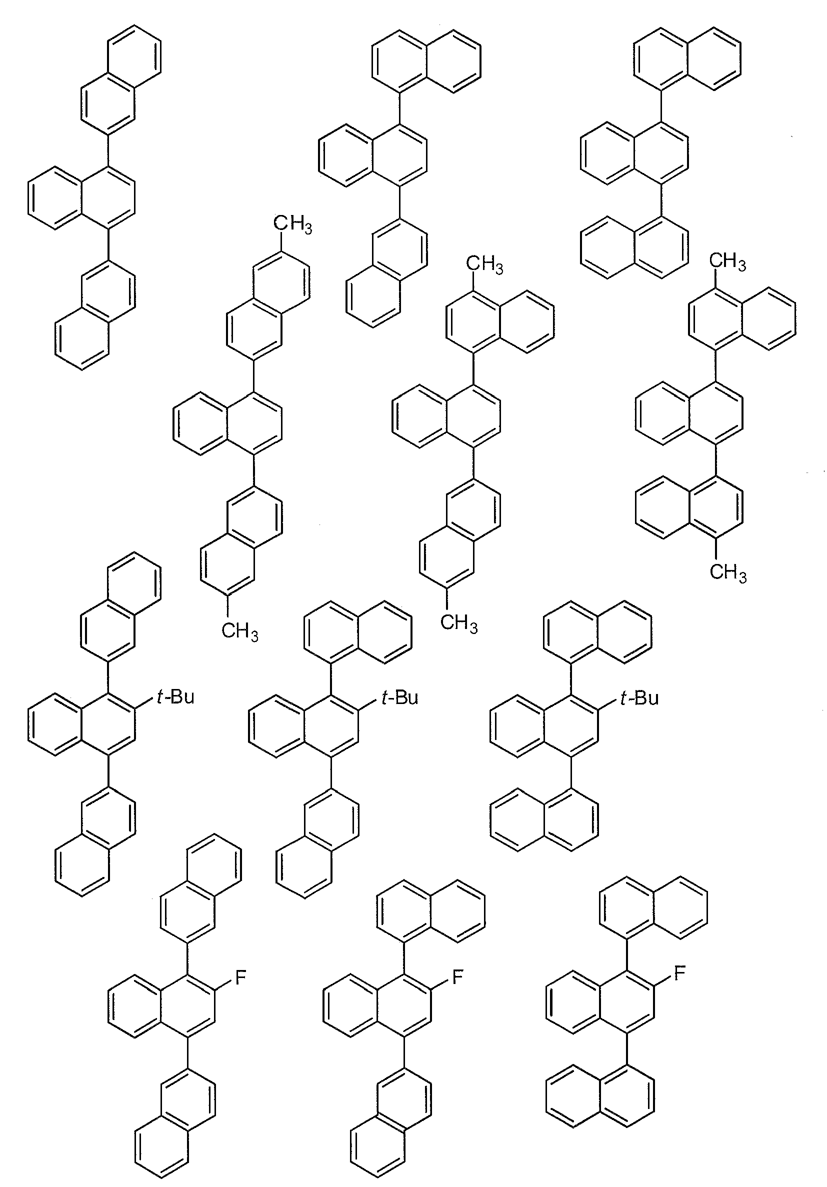

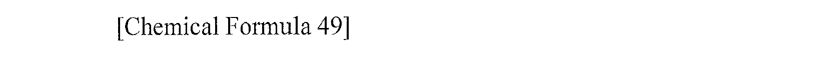

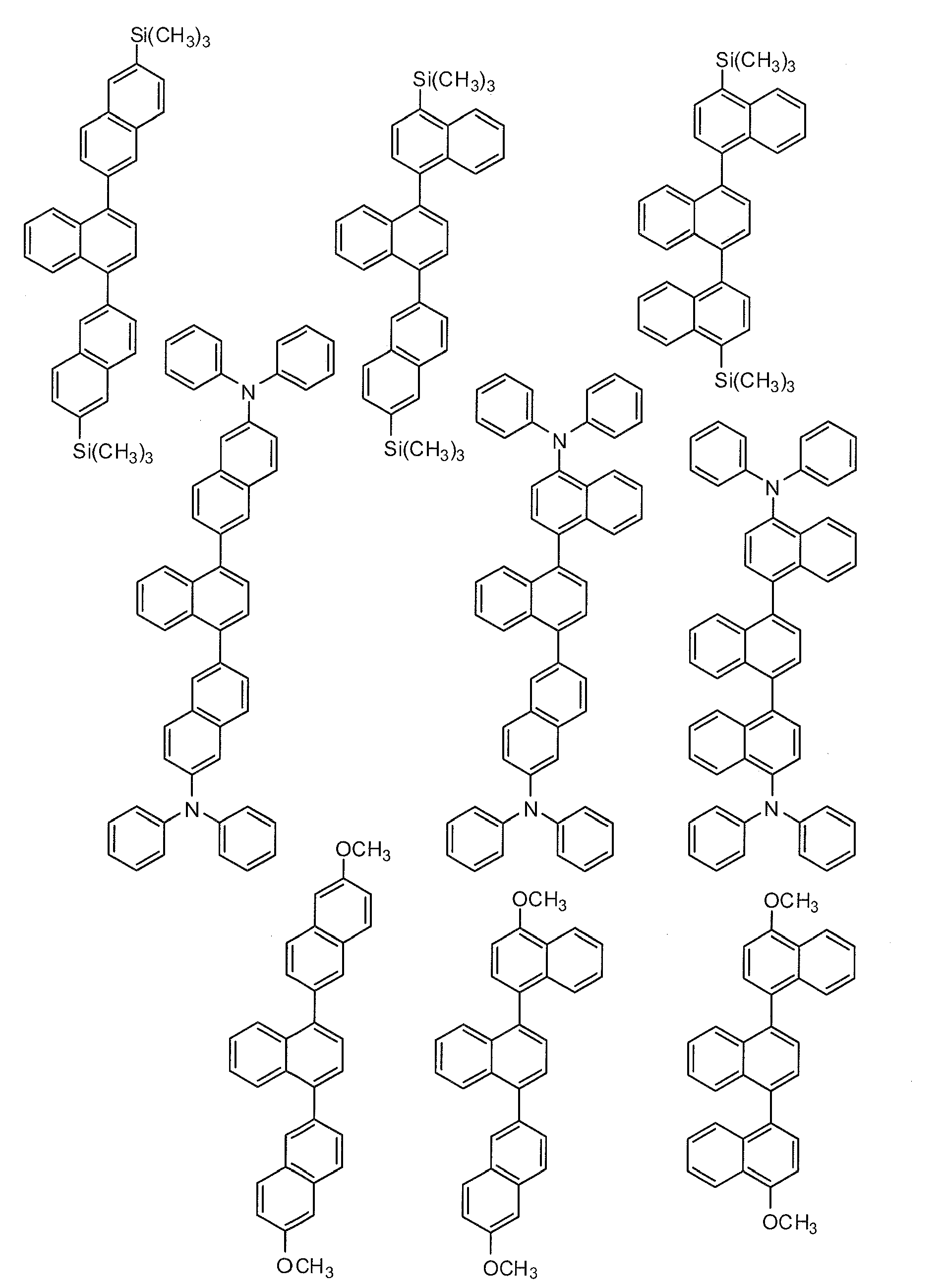

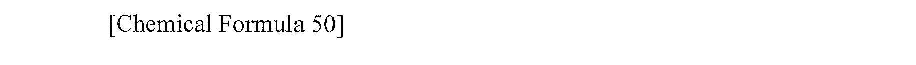

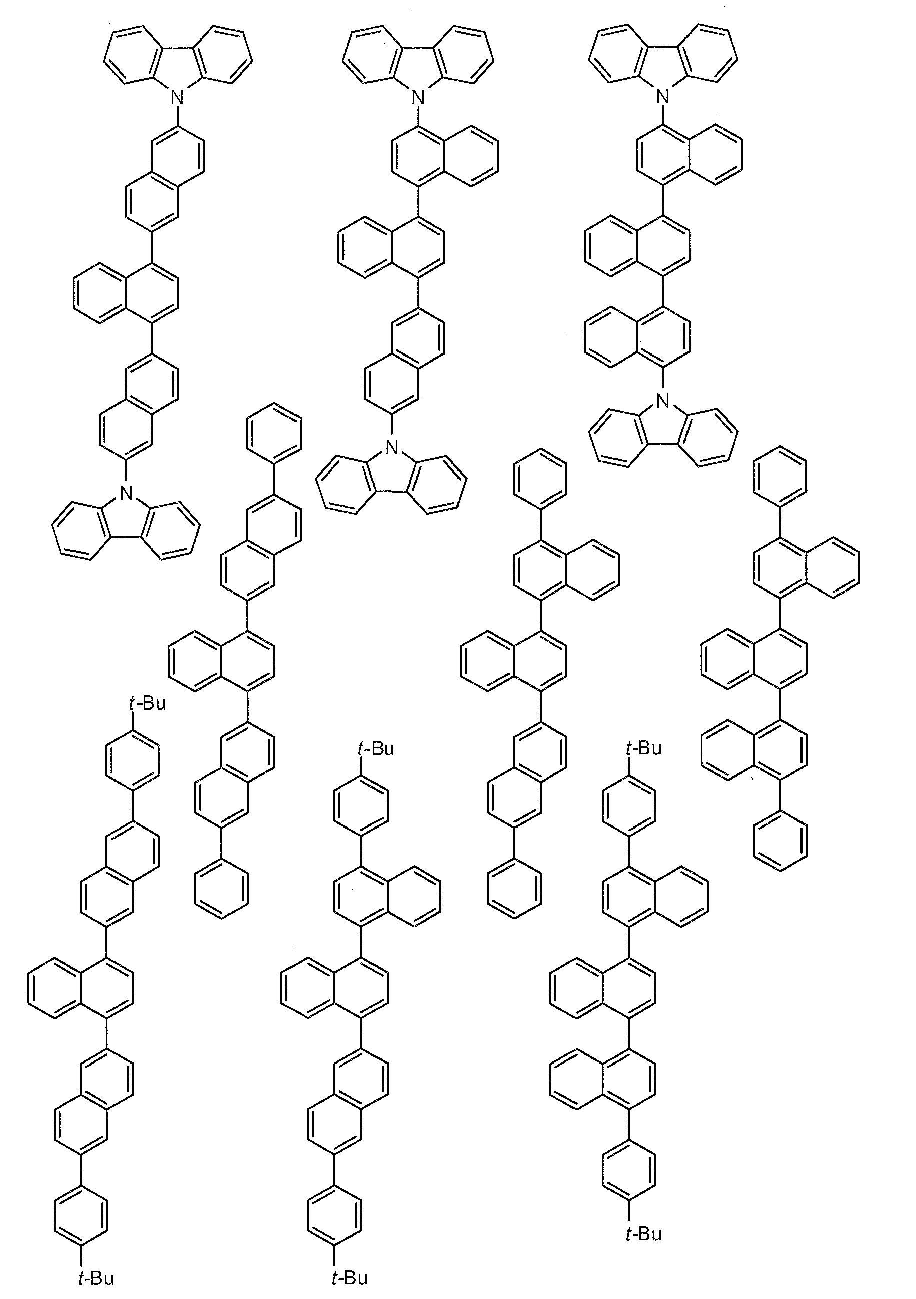

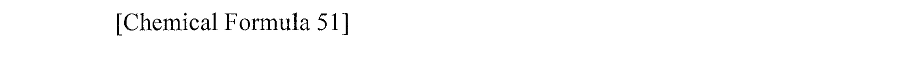

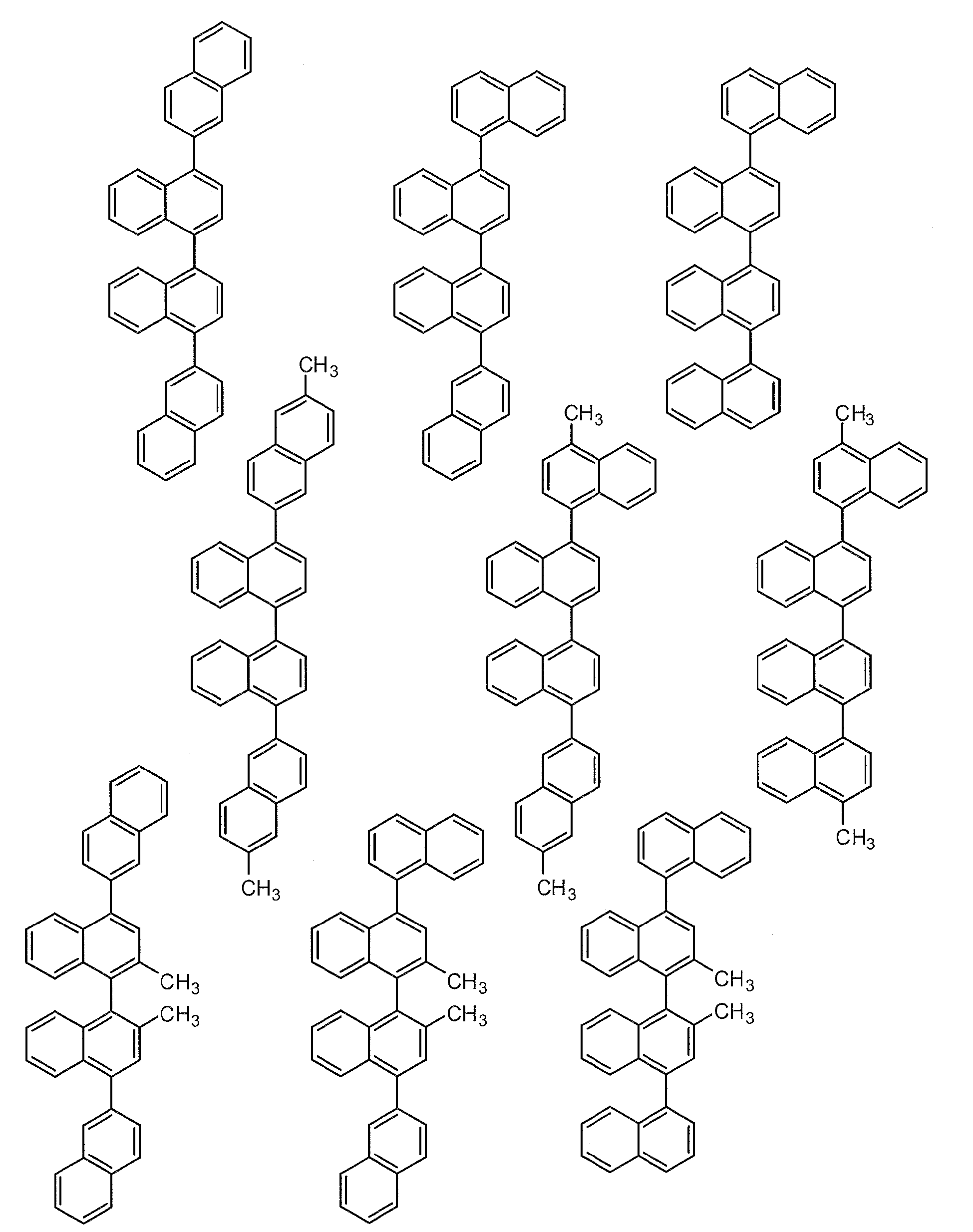

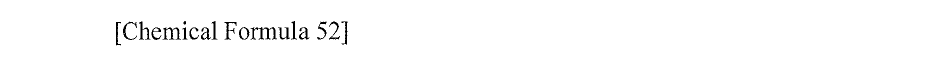

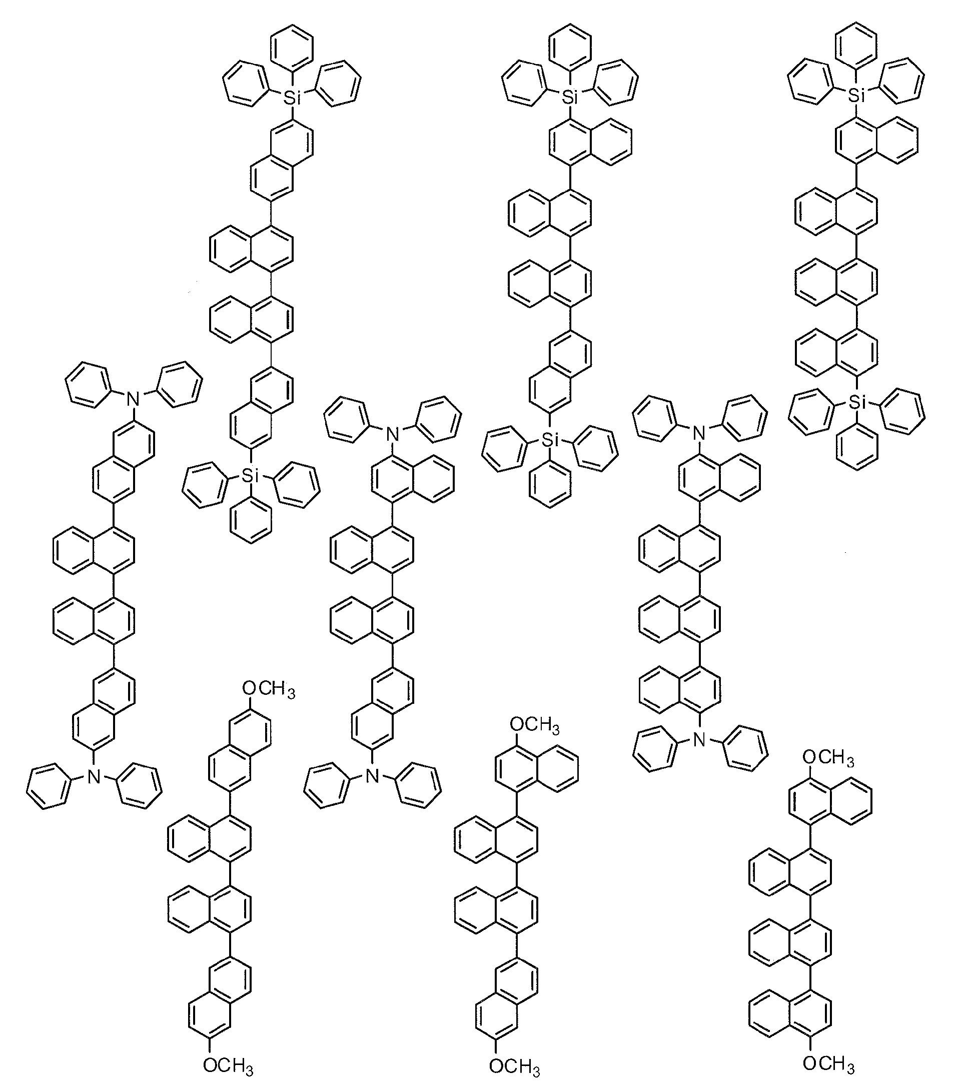

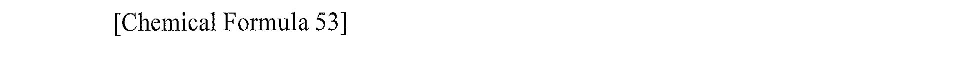

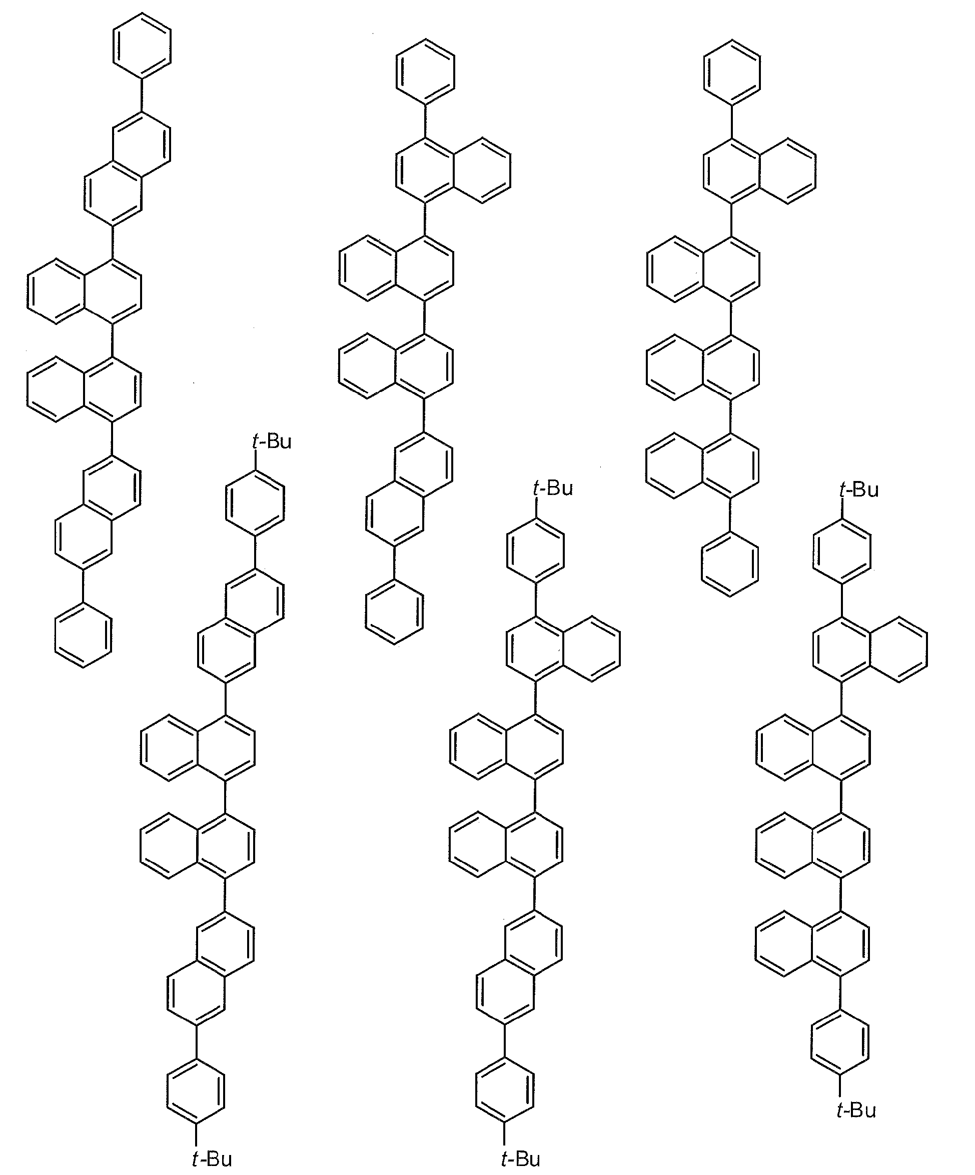

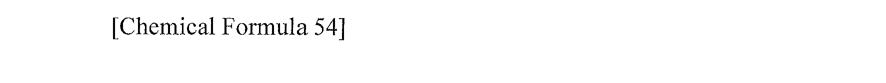

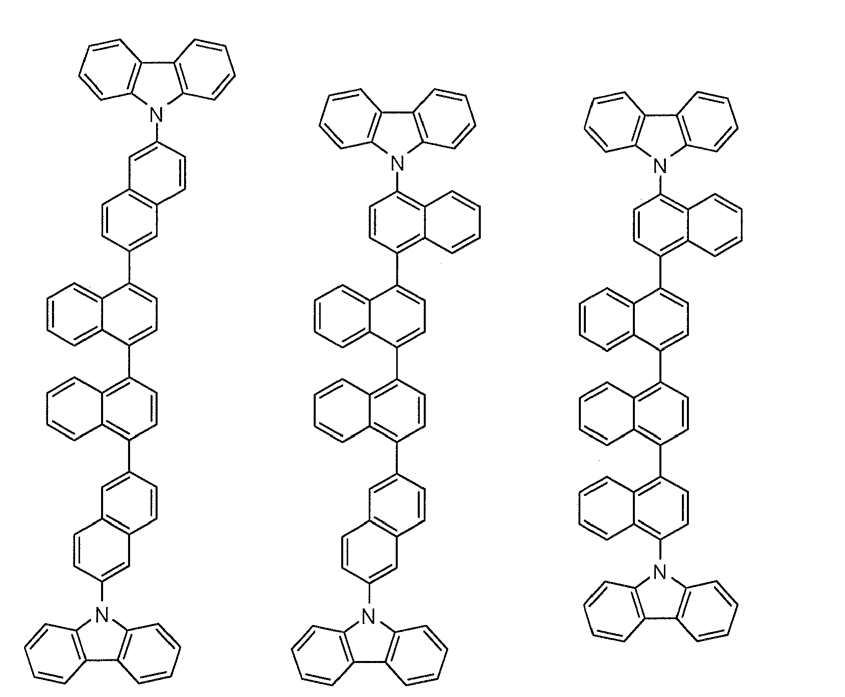

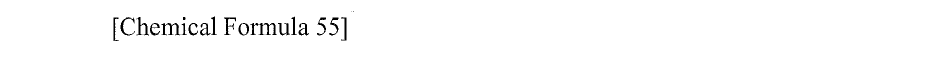

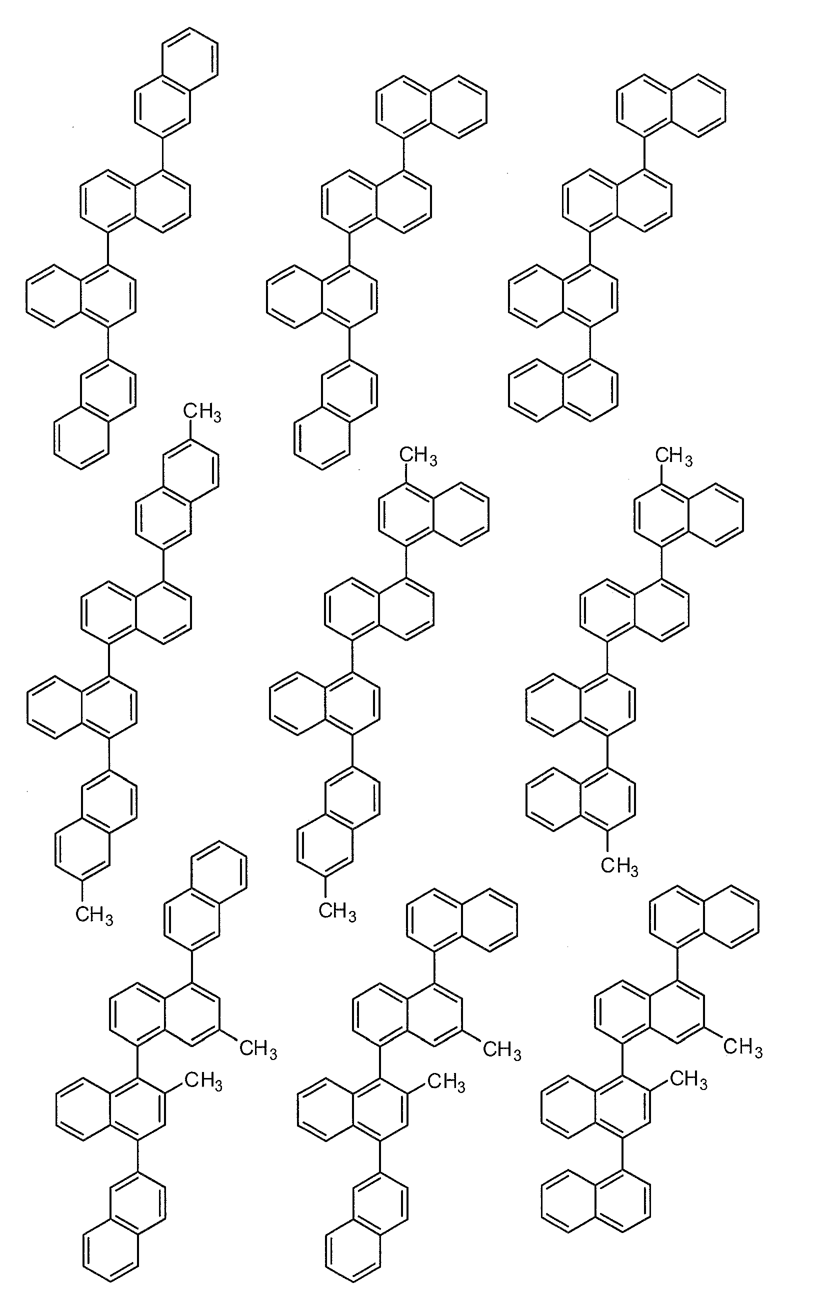

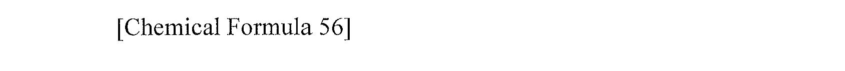

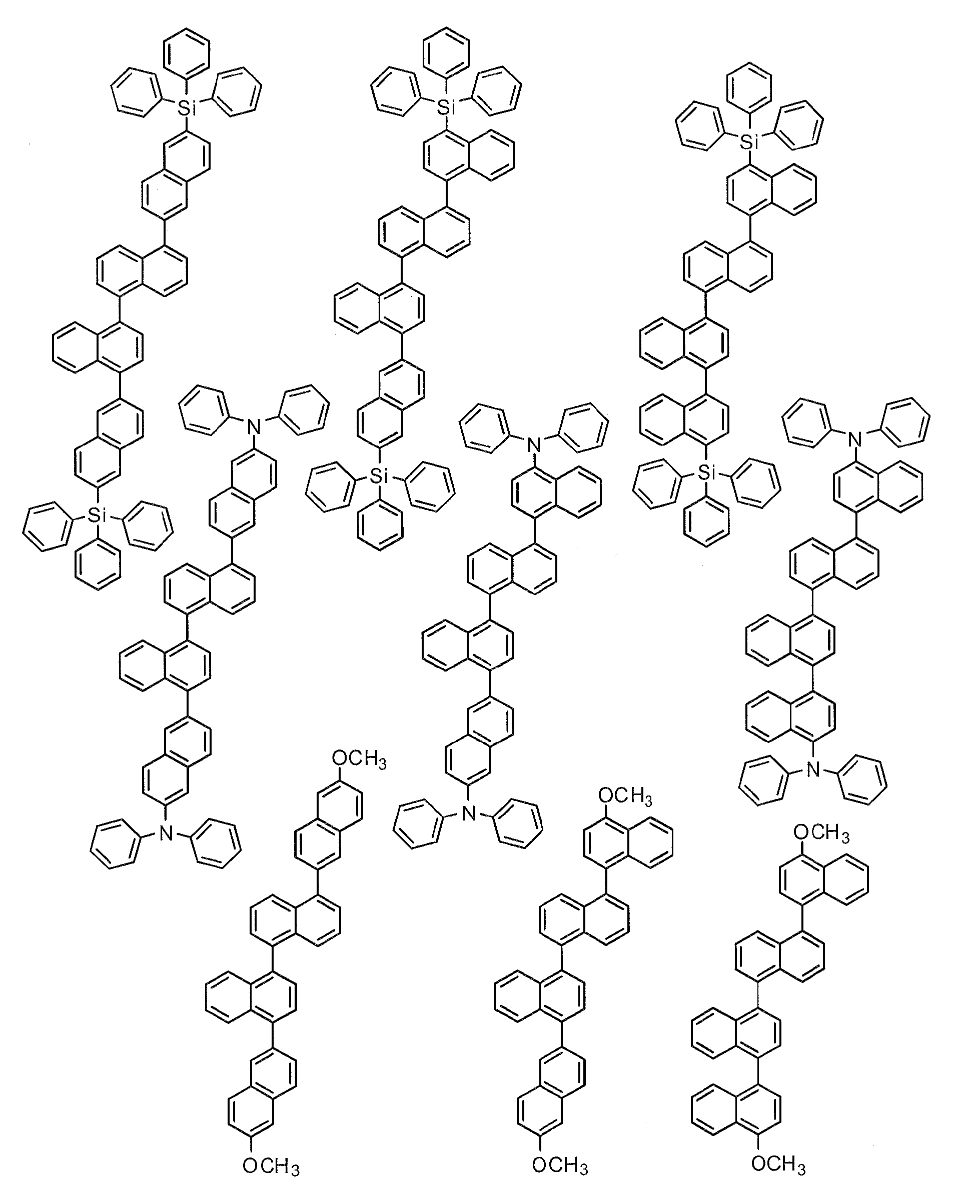

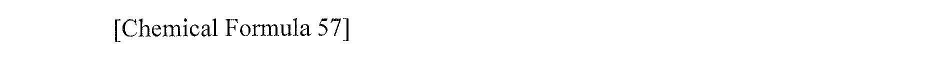

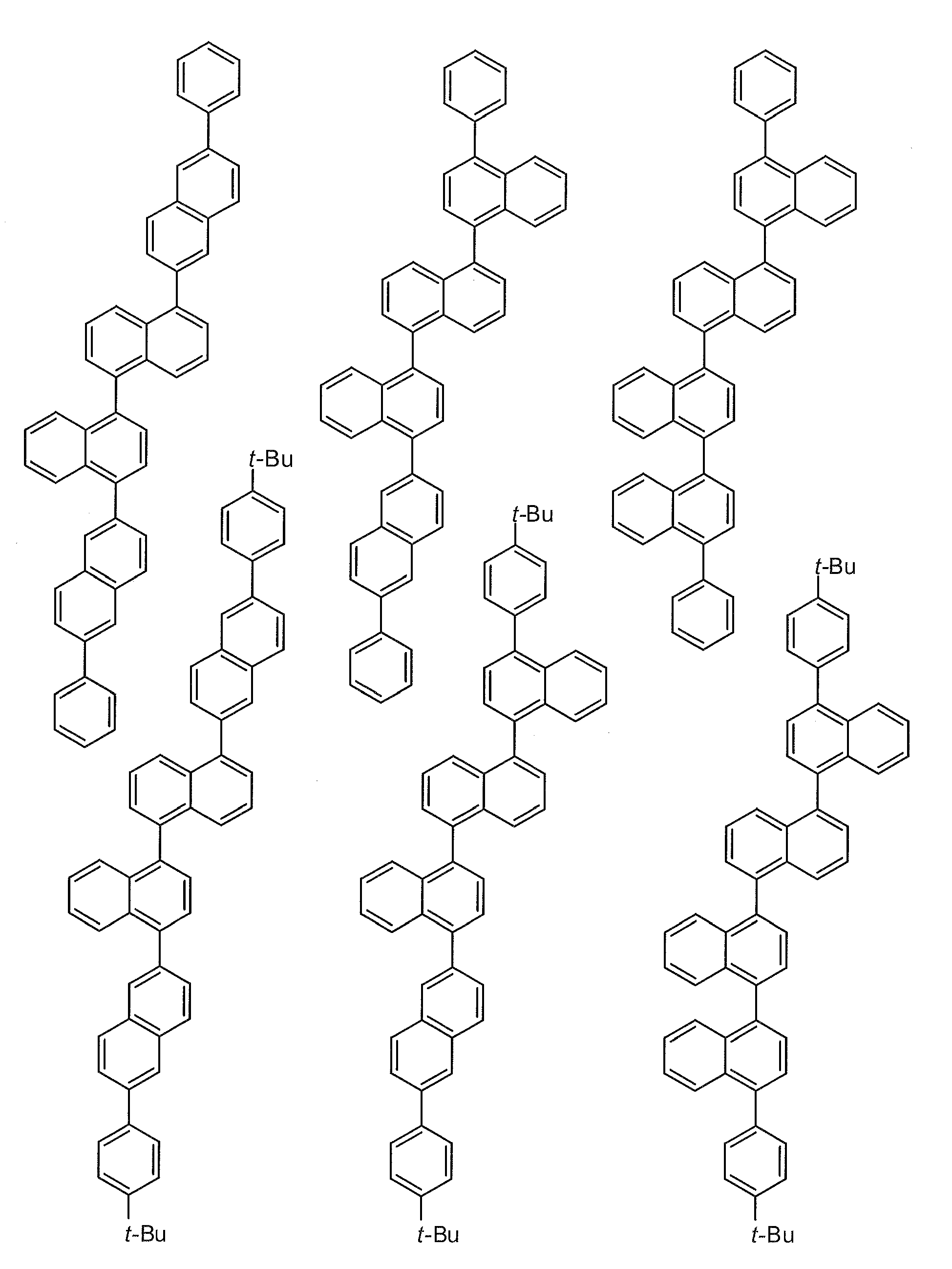

The oligonaphthalene derivative may be represented by the following formula (82). 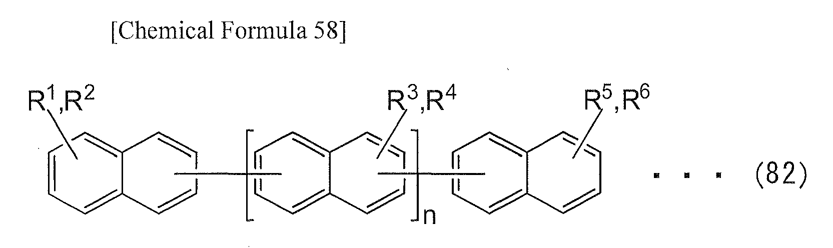 In the formula, R¹ to R⁶ each are an independent group suitably selected from the group consisting of hydrogen, alkoxy group having 1 to 4 carbon atoms, alkyl group having 1 to 4 carbon atoms and substituted or unsubstituted amino group. n is an integer of 2 to 4.

Examples of such an oligonaphthalene compound are those represented by the following formulae.

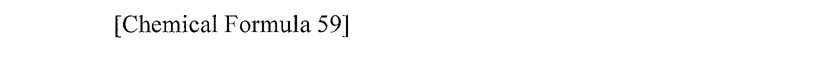

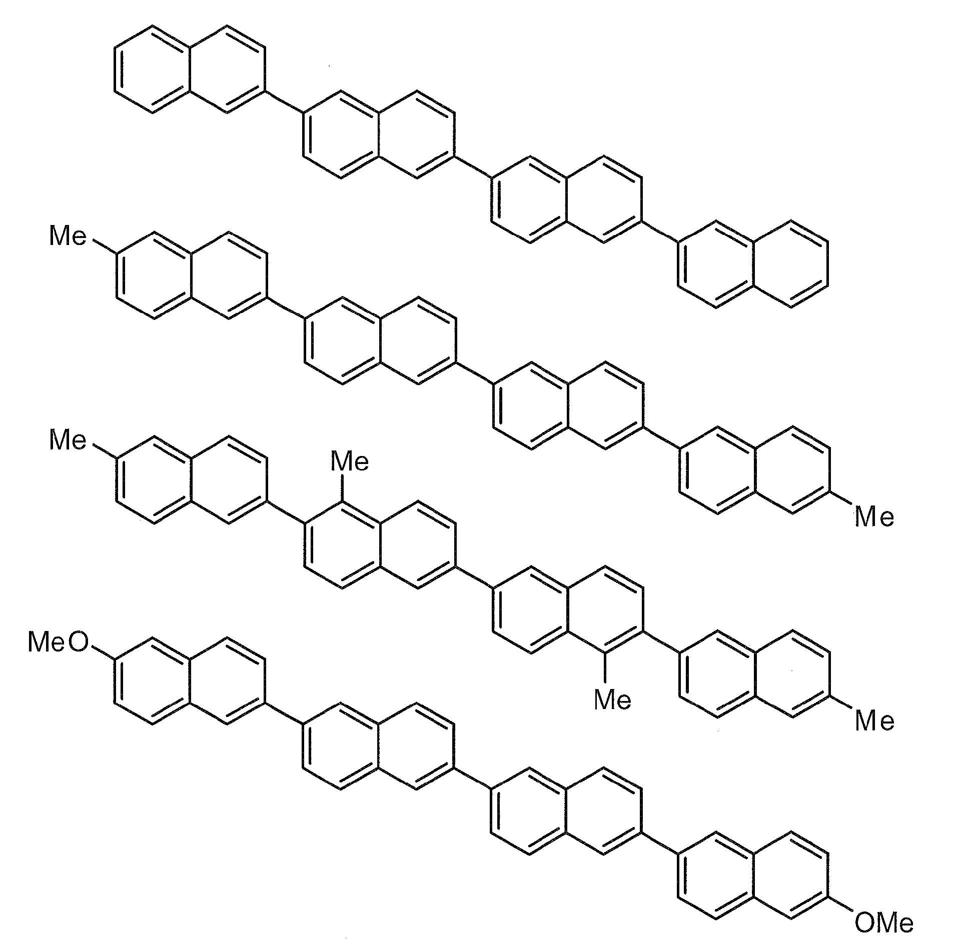

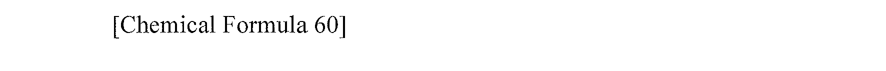

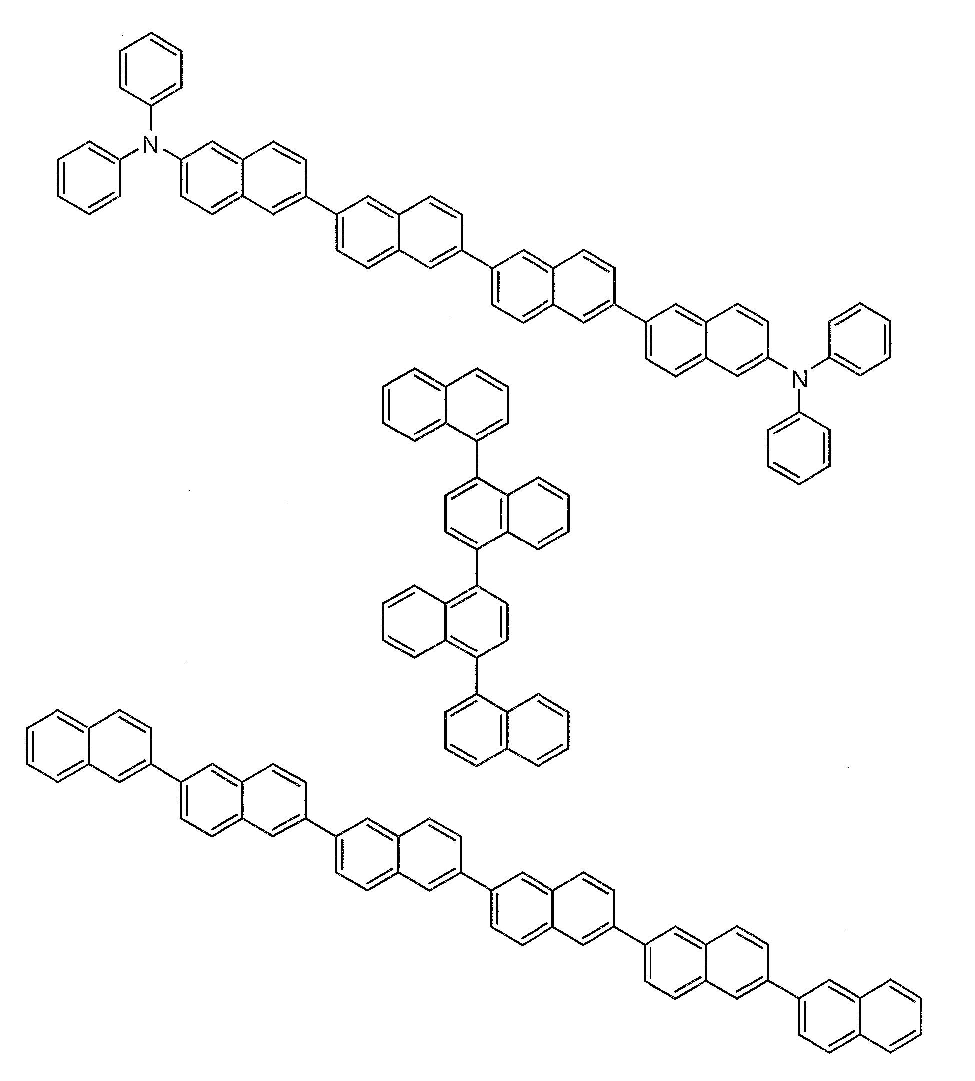

The phosphorescent host may contain a host material represented by the following formula (15).

Ra-Ar¹-Rb (15)

In the formula (15), when Ra, Rb and Ar¹ have a single or plural substituent(s), the substituent(s) is preferably an alkyl group having 1 to 20 carbon atoms, a haloalkyl group having 1 to 20 carbon atoms, a cycloalkyl group having 5 to 18 carbon atoms, a silyl group having 3 to 20 carbon atoms, a cyano group or a halogen atom. A substituent for Ar¹ may also be an aryl group having 6 to 22 carbon atoms.
Since the substituent(s) contains no nitrogen atom, the stability of the host material can be further enhanced, and the lifetime of the device can be prolonged.
The number of plural aryl substituents for Ar¹ is preferably 2 or less, more preferably 1 or less.

Examples of the alkyl group having 1 to 20 carbon atoms are a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, 2-methylpentyl group, a 1-pentylhexyl group, a 1-butylpentyl group, a 1-heptyloctyl group and 3-methylpentyl group.

Examples of the haloalkyl group having 1 to 20 carbon atoms are chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group and 1,2,3-triiodopropyl group.

Examples of the cycloalkyl group having 5 to 18 carbon atoms are cyclopentyl group, cyclohexyl group, cyclooctyl group, and 3,5-tetramethylcyclohexyl group, among which cyclohexyl group, cyclooctyl group and 3,5-tetramethylcyclohexyl group are preferable.

The silyl group having 3 to 20 carbon atoms is preferably an alkylsilyl group, an arylsilyl group or an aralkylsilyl group, examples of which are trimethylsilyl group, triethylsilyl group, tributylsilyl group, trioctylsilyl group, triisobutylsilyl group, dimethylethylsilyl group, dimethylisopropylsilyl group, dimethylpropylsilyl group, dimethylbutylsilyl group, dimethyltertiarybutylsilyl group, diethylisopropylsilyl group, phenyldimethylsilyl group, diphenylmethylsilyl group, diphenyltertiarybutylsilyl group and triphenylsilyl group.
Examples of the halogen atom are a fluorine atom, a chlorine atom, a bromine atom and an iodine atom.

The aryl substituent having 6 to 22 carbon atoms is preferably phenyl group, biphenyl group, terphenyl group, naphthyl group, chrysenyl group, fluoranthenyl group, 9,10-dialkylfluorenyl group, 9,10-diarylfluorenyl group, triphenylenyl group, phenanthrenyl group, benzophenanthrenyl group, dibenzophenanthrenyl group, benzotriphenylenyl group, benzochrysenyl group or dibenzofuranyl group, more preferably phenyl group having 6 to 18 carbon atoms, biphenyl group, terphenyl group, naphthyl group, chrysenyl group, fluoranthenyl group, 9,10-dimethylfluorenyl group, triphenylenyl group, phenanthrenyl group, benzophenanthrenyl group or dibenzofuranyl group, much more preferably a phenyl group having 6 to 14 carbon atoms, biphenyl group, naphthyl group, phenanthrenyl group or dibenzofuranyl group.

The fluorescent host may contain a host material represented by the following formula (16).

Ra-Ar¹-Ar²-Rb (16)

In the formula (16) above, Ra and Ar¹ each represent a substituted or unsubstituted naphthalene ring.
Rb represents a substituted or unsubstituted fused aromatic hydrocarbon group selected from a group consisting of a phenanthrene ring, a triphenylene ring, a benzophenanthrene ring, a dibenzophenanthrene ring, a benzotriphenylene ring, a fluoranthene ring, a benzochrysene ring and a picene ring.
Ar² represents a substituted or unsubstituted fused aromatic hydrocarbon group selected from a group consisting of a benzene ring, a naphthalene ring, a chrysene ring, a fluoranthene ring, a triphenylene ring, a benzophenanthrene ring, a dibenzophenanthrene ring, a benzotriphenylene ring, a benzochrysene ring, a benzo[b]fluoranthene ring and a picene ring.
Substituents for Ra and Rb are not aryl groups. Substituents for Ar¹ and Ar² are not aryl groups when Ar¹ or Ar² represents a naphthalene ring.

The fluorescent host may contain a host material represented by the following formula (17).

Ra-Ar¹-Ar²-Ar³-Rb (17)

In the formula (17), Ra, Rb, Ar¹, Ar² and Ar³ each represent a substituted or unsubstituted benzene ring or a substituted or unsubstituted fused aromatic hydrocarbon ring selected from the group consisting of naphthalene ring, chrysene ring, fluoranthene ring, triphenylene ring, phenanthrene ring, benzophenanthrene ring, dibenzophenanthrene ring, benzotriphenylene ring, benzochrysene ring, benzo[b]fluoranthene ring and picene ring.
When Ar² is a substituted or unsubstituted benzene ring or a substituted or unsubstituted 2,7-phenanthrene-diyl group or triphenylene ring, [Ra-Ar¹-] and [Rb-Ar³-] are differently structured groups.

The fluorescent host may contain a host material represented by the following formula (18).

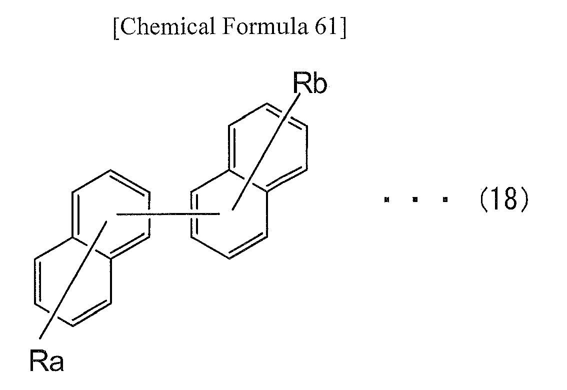

In the formula (18), Ra and Rb each represent a substituted or unsubstituted fused aromatic hydrocarbon group selected from a group consisting of a phenanthrene ring, a triphenylene ring, a benzophenanthrene ring, a dibenzophenanthrene ring, a benzotriphenylene ring, a benzo[b]fluoranthene ring, a fluoranthene ring, a benzochrysene ring and a picene ring.
Substituents for Ra, Rb, Ar¹ and Ar² are not aryl groups.

The fluorescent host may contain a host material represented by the following formula (19).

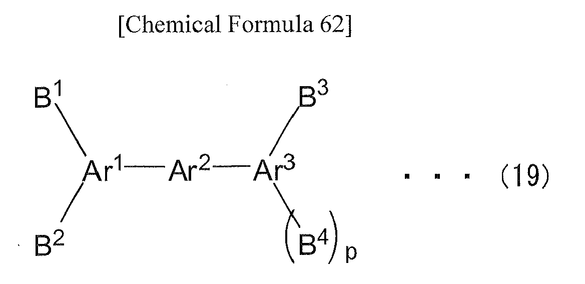

In the formula (19), when Ar¹, Ar², Ar³, B¹, B², B³ and B⁴ have a single or plural substituent(s), the substituent(s) is preferably an alkyl group having 1 to 20 carbon atoms, a haloalkyl group having 1 to 20 carbon atoms, a cycloalkyl group having 5 to 18 carbon atoms, a silyl group having 3 to 20 carbon atoms, a cyano group or a halogen atom. A substituent for Ar² may also be an aryl group having 6 to 22 carbon atoms.
Since the substituent(s) contains no nitrogen atom, the stability of the host material can be further enhanced, and the lifetime of the device can be prolonged.
The number of plural aryl substituents for Ar² is preferably 2 or less, more preferably 1 or less.

Examples of the alkyl group having 1 to 20 carbon atoms are a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, 2-methylpentyl group, a 1-pentylhexyl group, a 1-butylpentyl group, a 1-heptyloctyl group and 3-methylpentyl group.

Examples of the haloalkyl group having 1 to 20 carbon atoms are chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group and 1,2,3-triiodopropyl group.

Examples of the cycloalkyl group having 5 to 18 carbon atoms are cyclopentyl group, cyclohexyl group, cyclooctyl group, and 3,5-tetramethylcyclohexyl group, among which cyclohexyl group, cyclooctyl group and 3,5-tetramethylcyclohexyl group are preferable.

The silyl group having 3 to 20 carbon atoms is preferably an alkylsilyl group, an arylsilyl group or an aralkylsilyl group, examples of which are trimethylsilyl group, triethylsilyl group, tributylsilyl group, trioctylsilyl group, triisobutylsilyl group, dimethylethylsilyl group, dimethylisopropylsilyl group, dimethylpropylsilyl group, dimethylbutylsilyl group, dimethyltertiarybutylsilyl group, diethylisopropylsilyl group, phenyldimethylsilyl group, diphenylmethylsilyl group, diphenyltertiarybutylsilyl group and triphenylsilyl group.
Examples of the halogen atom are a fluorine atom, a chlorine atom, a bromine atom and an iodine atom.

The aryl substituent having 6 to 22 carbon atoms is preferably phenyl group, biphenyl group, terphenyl group, naphthyl group, chrysenyl group, fluoranthenyl group, 9,10-dialkylfluorenyl group, 9,10-diarylfluorenyl group, triphenylenyl group, phenanthrenyl group, benzophenanthrenyl group, dibenzophenanthrenyl group, benzotriphenylenyl group, benzochrysenyl group or dibenzofuranyl group, more preferably phenyl group having 6 to 18 carbon atoms, biphenyl group, terphenyl group, naphthyl group, chrysenyl group, fluoranthenyl group, 9,10-dimethylfluorenyl group, triphenylenyl group, phenanthrenyl group, benzophenanthrenyl group or dibenzofuranyl group, much more preferably a phenyl group having 6 to 14 carbon atoms, biphenyl group, naphthyl group, phenanthrenyl group or dibenzofuranyl group.

In the aspect of the invention, the phosphorescent host preferably has a triplet energy gap of 2.1 eV to 2.7 eV, and the polycyclic fused aromatic skeleton preferably has 14 to 30 ring atoms.

According to the above structure, the phosphorescent host has high stability, so that the singlet energy and triplet energy can be transferred smoothly. Thus, the luminous efficiency can be enhanced and the long lifetime can be obtained.
The molecular stability is not sufficiently enhanced when the number of the ring-forming atoms in the skeleton is too small, and thus the number of the ring-forming atoms is set at 14 or more. On the other hand, when the number of the rings in the polycyclic fused ring is too large, a HOMO-LUMO gap is so much narrowed that the triplet energy gap becomes insufficient for a useful emission wavelength. Thus, the number of the ring-forming atoms is set at 30 or less.
Accordingly, it is possible to obtain a favorable material for exciting the phosphorescent dopant material that exhibits useful emission wavelength.
By using a polycyclic fused aromatic having a triplet energy gap of a predetermined level or more, the phosphorescent dopant can provide emission of a useful wavelength.
The use of the polycyclic fused aromatic ring host restricts the upper limit of the triplet energy, and the host is thus unsuitable for transferring the exciton energy to a phosphorescent dopant for emission of a short wavelength. However, the polycyclic fused aromatic ring host is also favorably applicable as a host for a fluorescent dopant, and thus the use of the polycyclic fused aromatic ring host in the fluorescent material can provide emission of a short wavelength.
Accordingly, the aspect of the invention can realize an organic EL device having long lifetime and capable of providing mixed-color emission at high efficiency.

In the aspect of the invention, the polycyclic fused aromatic skeleton preferably has no substituent that has a carbazole skeleton.
When a carbazole group is introduced as the substituent, triplet energy gap is widened due to increase in ionization potential, and thus such a material becomes applicable as a host for a phosphorescent dopant for emission of a shorter wavelength. However, introduction of a carbazole group, which is typically vulnerable to oxidation, may unfavorably lead to shorter lifetime.
In this respect, according to the aspect of the invention, by excluding a carbazole group from candidates for the substituent, the lifetime can be prolonged although the energy gap is narrowed.

It is sufficient that, when the organic EL device according to the aspect of the invention includes a plurality of phosphorescent-emitting layers, one of the phosphorescent-emitting layers is arranged as above.
For instance, in an organic EL device including a red phosphorescent-emitting layer and a green phosphorescent-emitting layer, a phosphorescent host having a substituted or unsubstituted polycyclic fused aromatic skeleton and having a triplet energy gap of 2.1 eV to 3.0 eV is usable for the red phosphorescent-emitting layer, while a carbazole-base phosphorescent host such as CBP is usable for the green phosphorescent-emitting layer.
In the above arrangement, the triplet energy gap of the carbazole-base phosphorescent host is not required to be 2.1 eV to 3.0 eV. Particularly in an arrangement where a phosphorescent-emitting layer containing a carbazole-base phosphorescent host is provided between a fluorescent-emitting layer and a phosphorescent-emitting layer containing the phosphorescent host having the polycyclic fused aromatic skeleton, the oxidation of compounds having carbazole groups can be suppressed, and thus the reduction in lifetime can be prevented.
On the other hand, when a phosphorescent host having a wide triplet energy gap (e.g., carbazole) is used for a green emitting layer in the above arrangement, charges can be easily injected into the emitting layer. Thus, the luminous efficiency is enhanced and the lifetime is prolonged.

Examples of the carbazole derivative are compounds represented by the following formulae (101) to (105).

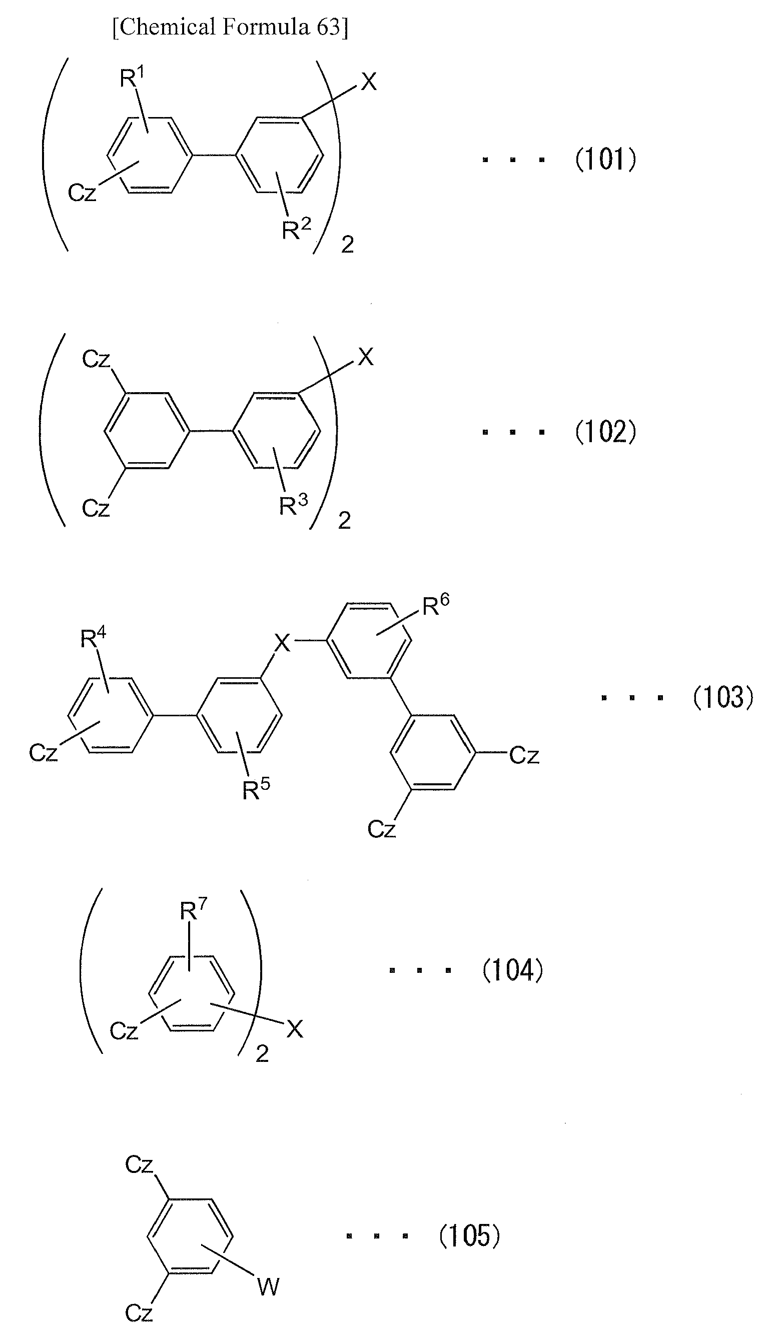

In particular, the compounds represented by the formula (101) or (103) are favorably usable as the phosphorescent host.
The structure of the formula (101) is any one of the following structures.

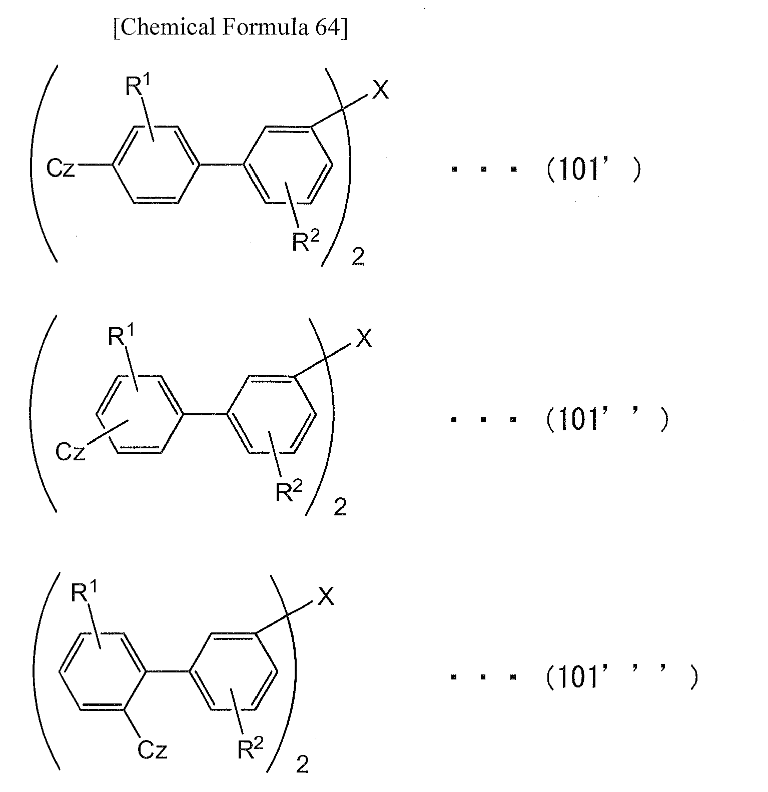

The structure of the formula (103) is any one of the following structures.

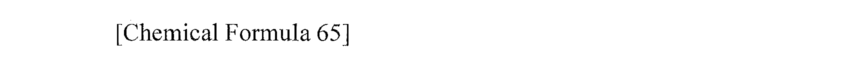

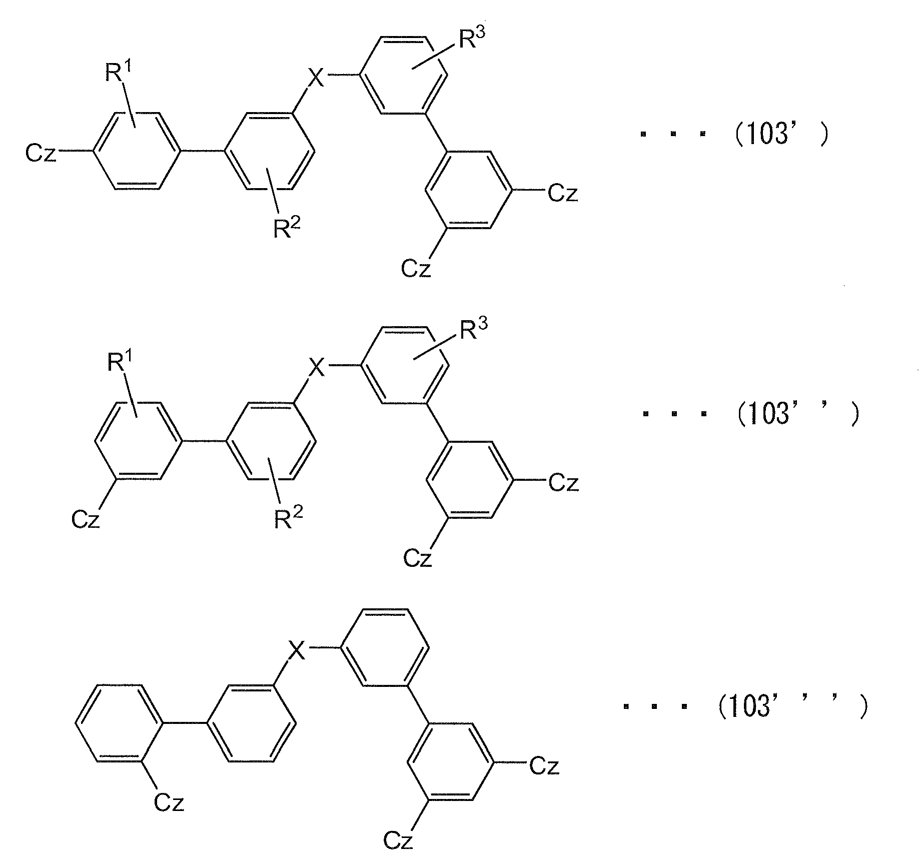

Among the above, materials containing the compounds represented by the general formula (101') or (103') are preferable.

In the formulae (101) to (104), R¹ to R⁷ each independently represent a hydrogen atom, halogen atom, substituted or unsubstituted alkyl group having 1 to 40 carbon atoms (preferably 1 to 30 carbon atoms), substituted or unsubstituted heterocyclic group having 3 to 30 carbon atoms (preferably 3 to 20 carbon atoms), substituted or unsubstituted alkoxy group having 1 to 40 carbon atoms (preferably 1 to 30 carbon atoms), substituted or unsubstituted aryl group having 6 to 40 carbon atoms (preferably 6 to 30 carbon atoms), substituted or unsubstituted aryloxy group having 6 to 40 carbon atoms (preferably 6 to 30 carbon atoms), substituted or unsubstituted aralkyl group having 7 to 40 carbon atoms (preferably 7 to 30 carbon atoms), substituted or unsubstituted alkenyl group having 2 to 40 carbon atoms (preferably 2 to 30 carbon atoms), substituted or unsubstituted alkylamino group having 1 to 80 carbon atoms (preferably 1 to 60 carbon atoms), substituted or unsubstituted arylamino group having 6 to 80 carbon atoms (preferably 6 to 60 carbon atoms), substituted or unsubstituted aralkylamino group having 7 to 80 carbon atoms (preferably 7 to 60 carbon atoms), substituted or unsubstituted alkylsilyl group having 3 to 10 carbon atoms (preferably 3 to 9 carbon atoms), substituted or unsubstituted arylsilyl group having 6 to 30 carbon atoms (preferably 8 to 20 carbon atoms) or cyano group. R¹ to R⁷ each may be plural. An adjacent set thereof may form a saturated or unsaturated cyclic structure.

Examples of the halogen atom represented by R¹ to R⁷ are fluorine, chlorine, bromine, iodine and the like.
Examples of the substituted or unsubstituted alkyl group represented by R¹ to R⁷ are a methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neo-pentyl group, 1-methylpentyl group, 2-methylpentyl group, 1-pentylhexyl group, 1-butylpentyl group, 1-heptyloctyl group, 3-methylpentyl group, hydroxymethyl group, 1-hydroxyethyl group, 2-hydroxyethyl group, 2-hydroxyisobutyl group, 1,2-dihydoroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 1,2-dinitroethyl group, 2,3-dinitro-t-butyl group, 1,2,3-trinitropropyl group, cyclopentyl group, cyclohexyl group, cyclooctyl group and 3,5-tetramethylhexyl group.
Among the above, the alkyl group is preferably a methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neo-pentyl group, 1-methylpentyl group, 1-pentylhexyl group, 1-butylpentyl group, 1-heptyloctyl group, cyclohexyl group, cyclooctyl group and 3,5-tetramethylcyclohexyl group.

Examples of the substituted or unsubstituted heterocyclic group having 3 to 30 carbon atoms represented by R¹ to R⁷ are 1-pyrrolyl group, 2-pyrrolyl group, 3-pyrrolyl group, pyrazinyl group, 2-pyridinyl group, 1-imidazolyl group, 2-imidazolyl group, 1-pyrazolyl group, 1-indolizinyl group, 2-indolizinyl group, 3-indolizinyl group, 5-indolizinyl group, 6-indolizinyl group, 7-indolizinyl group, 8-indolizinyl group, 2-imidazopyridinyl group, 3-imidazopyridinyl group, 5-imidazopyridinyl group, 6-imidazopyridinyl group, 7-imidazopyridinyl group, 8-imidazopyridinyl group, 3-pyridinyl, 4-pyridinyl, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl, 5-quinoxalinyl, 6-quinoxalinyl, 1-carbazolyl group, 2-carbazolyl group, 3-carbazolyl group, 4-carbazolyl group, 9-carbazolyl group, β-carboline-1-yl, β-carboline-3-yl, β-carboline-4-yl, β-carboline-5-yl, β-carboline-6-yl, β-carboline-7-yl, β-carboline-6-yl, β-carboline-9-yl, 1-phenanthrydinyl group, 2-phenanthrydinyl group, 3-phenanthrydinyl group, 4-phenanthrydinyl group, 6-phenanthrydinyl group, 7-phenanthrydinyl group, 8-phenanthrydinyl group, 9-phenanthrydinyl group, 10-phenanthrydinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl, 5-oxadiazolyl, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.
Among the above, the preferable examples are 2-pyridinyl group, 1-indolizinyl group, 2-indolizinyl group, 3-indolizinyl group, 5-indolizinyl group, 6-indolizinyl group, 7-indolizinyl group, 8-indolizinyl group, 2-imidazopyridinyl group, 3-imidazopyridinyl group, 5-imidazopyridinyl group, 6-imidazopyridinyl group, 7-imidazopyridinyl group, 8-imidazopyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 1-carbazolyl group, 2-carbazolyl group, 3-carbazolyl group, 4-carbazolyl group and 9-carbazolyl group.

The substituted or unsubstituted alkoxy group having 1 to 40 carbon atoms represented by R¹ to R⁷ is a group represented by -OY. Examples of Y are the same as those described with respect to the alkyl group. Preferable examples are also the same.
Examples of the substituted or unsubstituted aryl group having 6 to 40 ring carbon atoms represented by R¹ to R⁷ are a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, o-cumenyl group, m-cumenyl group, p-cumenyl group, 2,3-xylyl group, 3,4-xylyl group, 2,5-xylyl group and mesityl group.
Among the above, the preferably examples are a phenyl group, 1-naphthyl group, 2-naphthyl group, 9-phenanthryl group, 2-biphenylyl group, 3-biphenylyl group, 4-biphenylyl group, p-tolyl group and 3,4-xylyl group.

The substituted or unsubstituted aryloxy group having 6 to 40 carbon atoms represented by R¹ to R⁷ is a group represented by -OAr. Examples of Ar are the same as those described with respect to the aryl group. Preferable examples are also the same.
Examples of the substituted or unsubstituted aralkyl group having 7 to 40 carbon atoms represented by R¹ to R⁷ are a benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group.
Among the above, the preferable examples are a benzyl group, p-cyanobenzyl group, m-cyanobenzyl group, o-cyanobenzyl group, 1-phenylethyl group, 2-phenylethyl group, 1-phenylisopropyl group and 2-phenylisopropyl group.

Examples of the substituted or unsubstituted alkenyl group having 2 to 40 carbon atoms represented by R¹ to R⁷ are a vinyl group, allyl group, 1-butenyl group, 2-butenyl group, 3-butenyl group, 1,3-butanedienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group and 3-phenyl-1-butenyl group, among which a styryl group, 2,2-phenylvinyl group and 1,2-diphenylvinyl group are preferable.
The substituted or unsubstituted alkylamino group having 1 to 80 carbon atoms, the substituted or unsubstituted arylamino group having 6 to 80 carbon atoms and the substituted or unsubstituted aralkylamino group having 7 to 80 carbon atoms, which are represented by R¹ to R⁷, are represented by -NQ¹Q². Examples of Q¹ and Q² each are independently the same as those described with respect to the alkyl group, aryl group and aralkyl group. The preferable examples are also the same.
The substituted or unsubstituted alkylsilyl group having 3 to 10 carbon atoms represented by R¹ to R⁷ are a trimethylsilyl group, triethylsilyl group, t-butyldimethylsilyl group, vinyldimethylsilyl group and propyldimethylsilyl group.
The substituted or unsubstituted arylsilyl group having 6 to 30 carbon atoms represented by R¹ to R⁷ are a triphenylsilyl group, phenyldimethylsilyl group and t-butyldiphenylsilyl group.
Examples of the cyclic structure formed when R¹to R⁷ are plural are a unsaturated six-membered ring such as benzene ring, saturated or unsaturated five-membered ring and seven-membered ring.

In the formulae (101) to (104), X is a group represented by any one of the following formulae (111) to (116).

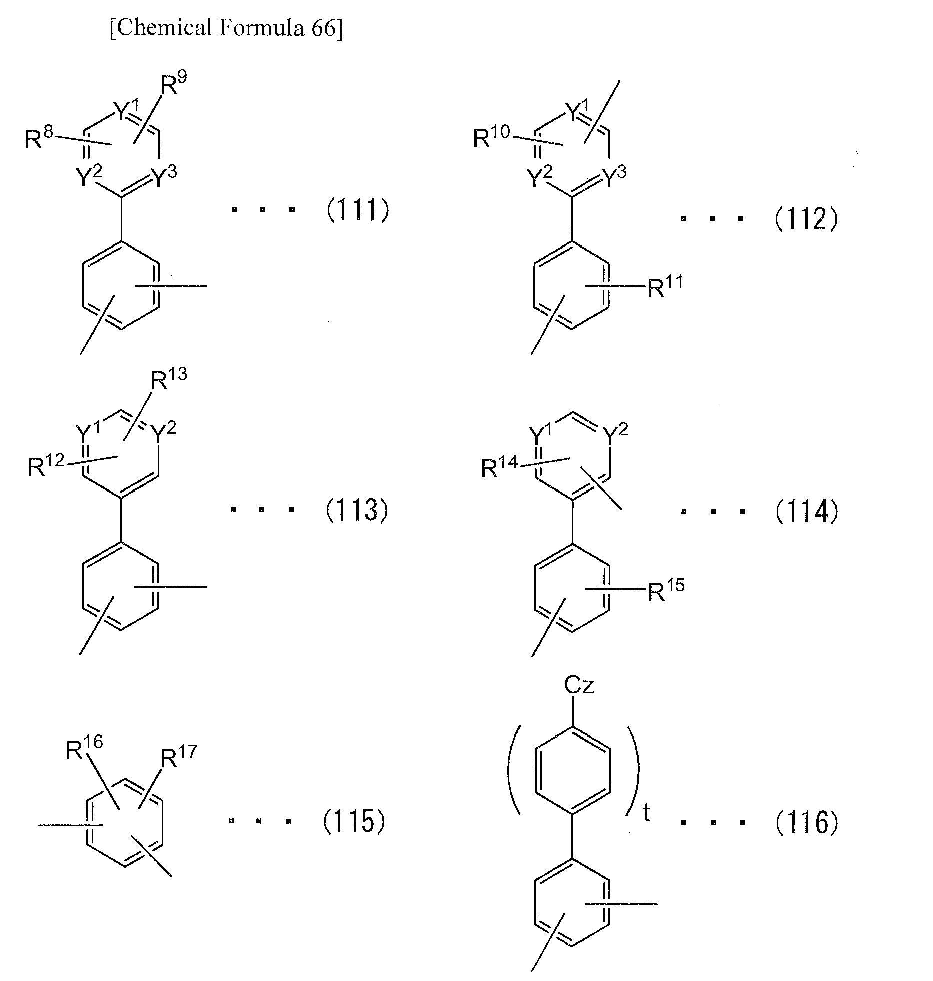

In the formulae (111) to (116), R⁸ to R¹⁷ each independently represent a hydrogen atom, halogen atom, substituted or unsubstituted alkyl group having 1 to 40 carbon atoms (preferably 1 to 30 carbon atoms), substituted or unsubstituted heterocyclic group having 3 to 30 carbon atoms (preferably 3 to 20 carbon atoms), substituted or unsubstituted alkoxy group having 1 to 40 carbon atoms (preferably 1 to 30 carbon atoms), substituted or unsubstituted aryl group having 6 to 40 carbon atoms (preferably 6 to 30 carbon atoms), substituted or unsubstituted aryloxy group having 6 to 40 carbon atoms (preferably 6 to 30 carbon atoms), substituted or unsubstituted aralkyl group having 7 to 40 carbon atoms (preferably 7 to 30 carbon atoms), substituted or unsubstituted alkenyl group having 2 to 40 carbon atoms (preferably 2 to 30 carbon atoms), substituted or unsubstituted alkylamino group having 1 to 80 carbon atoms (preferably 1 to 60 carbon atoms), substituted or unsubstituted arylamino group having 6 to 80 carbon atoms (preferably 6 to 60 carbon atoms), substituted or unsubstituted aralkylamino group having 7 to 80 carbon atoms (preferably 7 to 60 carbon atoms), substituted or unsubstituted alkylsilyl group having 3 to 10 carbon atoms (preferably 3 to 9 carbon atoms), substituted or unsubstituted arylsilyl group having 6 to 30 carbon atoms (preferably 8 to 20 carbon atoms) or cyano group. R⁸ to R¹⁷ each may be plural. An adjacent set thereof may form a saturated or unsaturated cyclic structure.
Examples of the groups represented by R⁸ to R¹⁷ are the same as the examples described in relation to R¹ to R⁷. The preferable examples are also the same.

In the formulae (111) to (114), Y¹ to Y³ each independently represent -CR (R represents a hydrogen atom, group bonded to X in the general formulae (101) to (104) or any one of R⁸, R⁹, R¹⁰, R¹², R¹³ and R¹⁴) or a nitrogen atom. When Y¹ to Y³ represent a nitrogen atom, the number thereof is at least 2 within the same ring. Cz is the same as the following.
In the general formula (116), t is an integer of 0 to 1.

The group represented by the general formula (116) preferably has any one of the following structures.

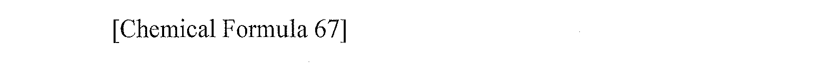

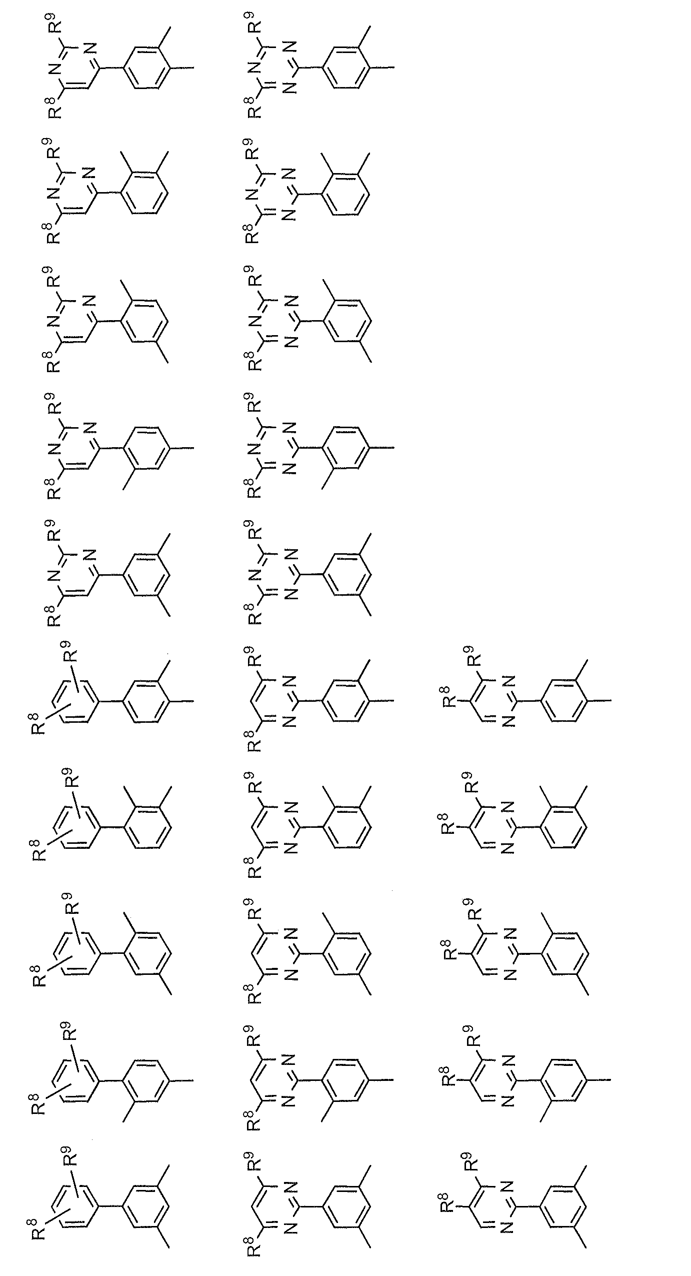

The group represented by the general formula (112) preferably has any one of the following structures.

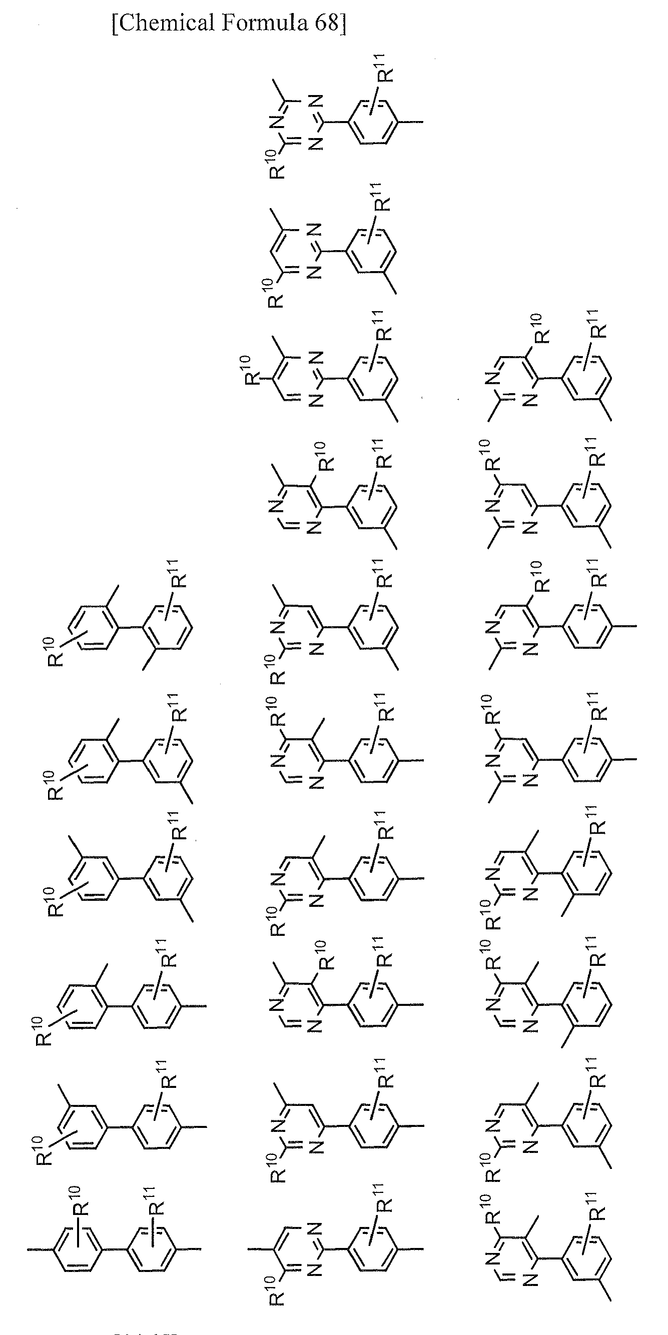

The group represented by the general formula (113) preferably has any one of the following structures.

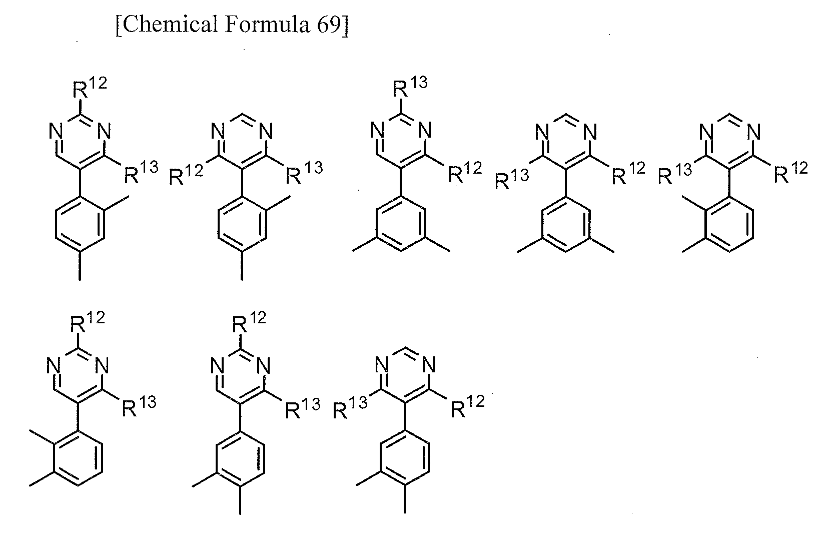

The group represented by the general formula (114) preferably has any one of the following structures.

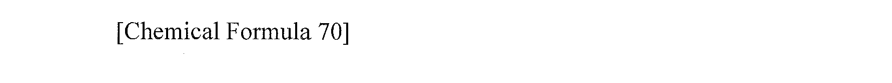

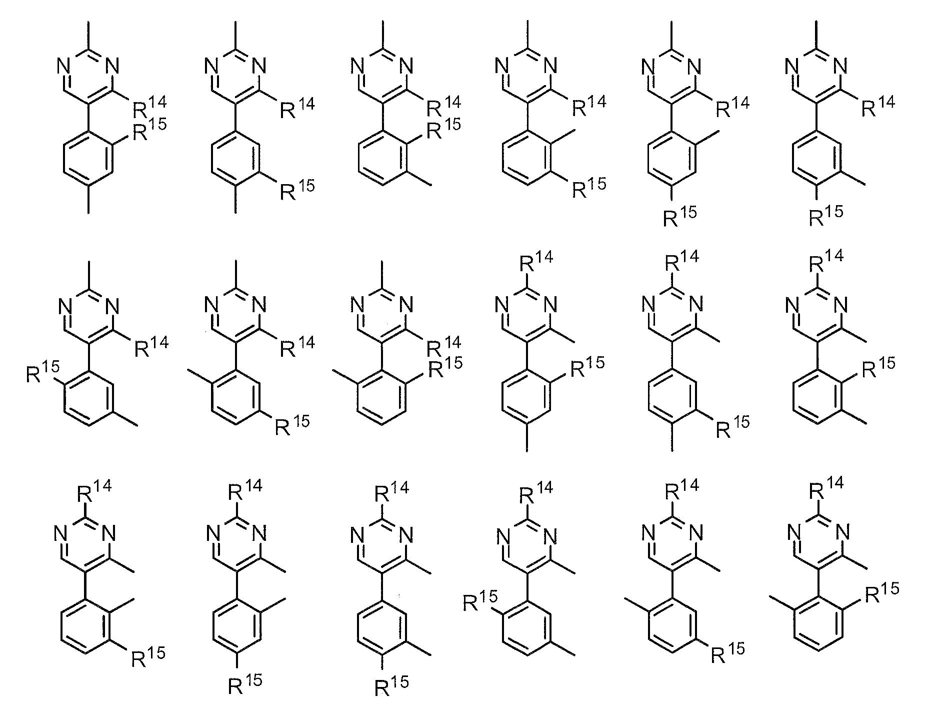

The group represented by the general formula (115) preferably has any one of the following structures.

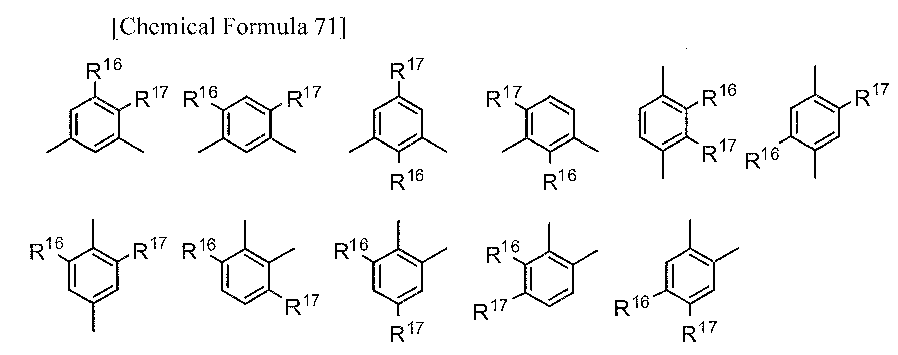

The group represented by the general formula (116) preferably has any one of the following structures.

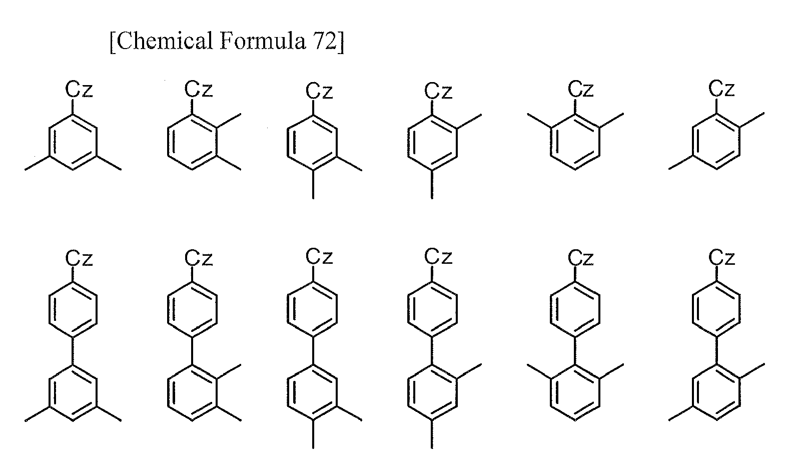

In the formula (105), W is a group represented by any one of the following formulae (121) to (125).

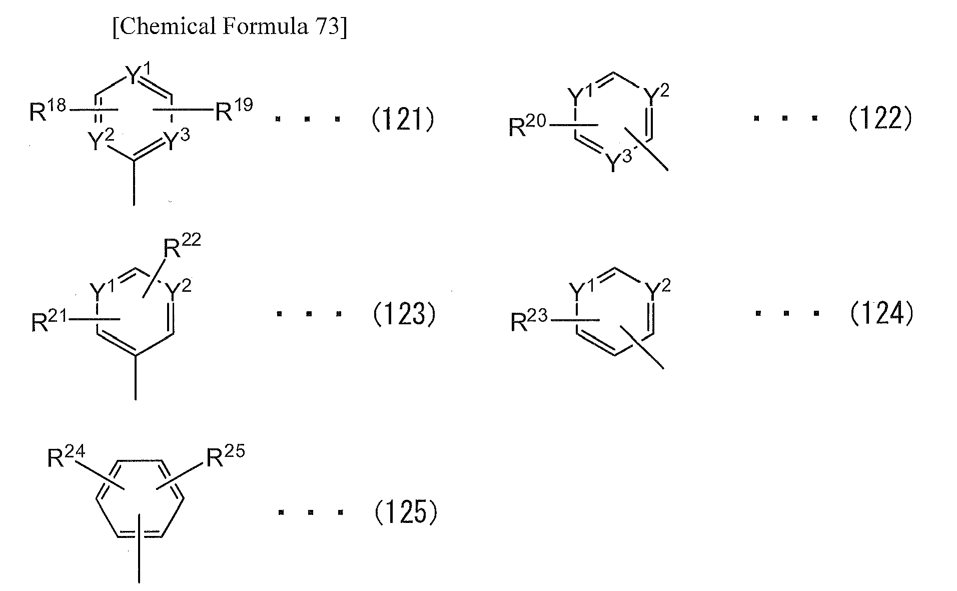

In the formulae (121) to (125), R¹⁸ to R²⁵ represent the same as those represented by R⁸ to R¹⁷. Y¹ to Y³ are the same as Y¹ to Y³ in the formulae (111) to (114).
Examples of the groups represented by R¹⁸ to R²⁵ are the same as the examples described in relation to R¹ to R⁷. The preferable examples are also the same.

In the formulae (101) to (105), Cz is a group represented by either one of the following formulae (131) and (132).

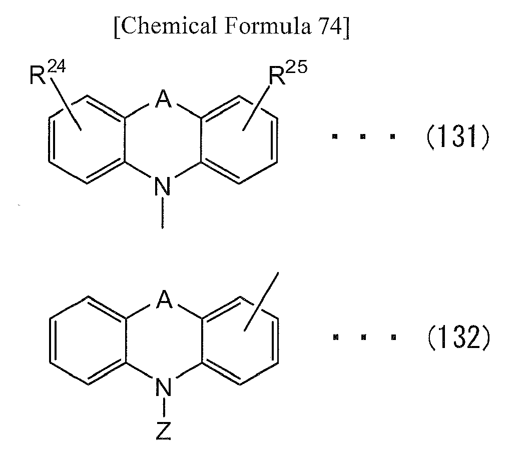

In the formulae (131) and (132), A represents a single bond, -(CR²⁶R²⁷)ₙ- (n is an integer of 1 to 3), -SiR²⁸R²⁹-, -NR³⁰-, -O- or -S-. R²⁶ and R²⁷, and R²⁸ and R²⁹ are may be bonded together to form a saturated or unsaturated cyclic structure. R²⁴ to R³⁰ each independently represent a hydrogen atom, halogen atom, substituted or unsubstituted alkyl group having 1 to 40 carbon atoms, substituted or unsubstituted heterocyclic group having 3 to 30 carbon atoms, substituted or unsubstituted alkoxy group having 1 to 40 carbon atoms, substituted or unsubstituted aryl group having 6 to 40 carbon atoms, substituted or unsubstituted aryloxy group having 6 to 40 carbon atoms, substituted or unsubstituted aralkyl group having 7 to 40 carbon atoms, substituted or unsubstituted alkenyl group having 2 to 40 carbon atoms, substituted or unsubstituted alkylamino group having 1 to 80 carbon atoms, substituted or unsubstituted arylamino group having 6 to 80 carbon atoms, substituted or unsubstituted aralkylamino group having 7 to 80 carbon atoms, substituted or unsubstituted alkylsilyl group having 3 to 10 carbon atoms, substituted or unsubstituted arylsilyl group having 6 to 30 carbon atoms or cyano group. R²⁴ to R²⁵ each may be plural. An adjacent set thereof may form a saturated or unsaturated cyclic structure.

In the formula (132), Z represents a substituted or unsubstituted alkyl group having 1 to 20 carbon atoms, a substituted or unsubstituted aryl group having 6 to 18 carbon atoms, or a substituted or unsubstituted aralkyl group having 7 to 40 carbon atoms.
Examples of the alkyl group having 1 to 20 carbon atoms represented by Z are a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neo-pentyl group, a 1-methylpentyl group, 2-methylpentyl group, a 1-pentylhexyl group, a 1-butylpentyl group, a 1-heptyloctyl group and 3-methylpentyl group. The preferable examples are a methyl group, ethyl group, propyl group, n-hexyl group and n-heptyl group.
Examples of the aryl group represented by Z are a phenyl group, naphthyl group, tolyl group, biphenyl group and terphenyl group. The preferable examples are a phenyl group, biphenyl group and tolyl group.
Examples of the aralkyl group represented by Z are an α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, benzyl group, p-cyanobenzyl group, m-cyanobenzyl group, o-cyanobenzyl group, 1-phenylethyl group, 2-phenylethyl group, 1-phenylisopropyl group and 2-phenylisopropyl group. Preferable examples are a benzyl group and p-cyanobenzyl group.

Cz preferably has any one of the following structures.

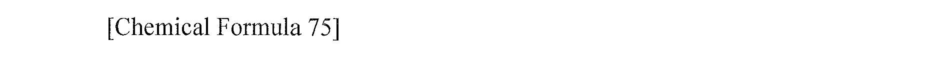

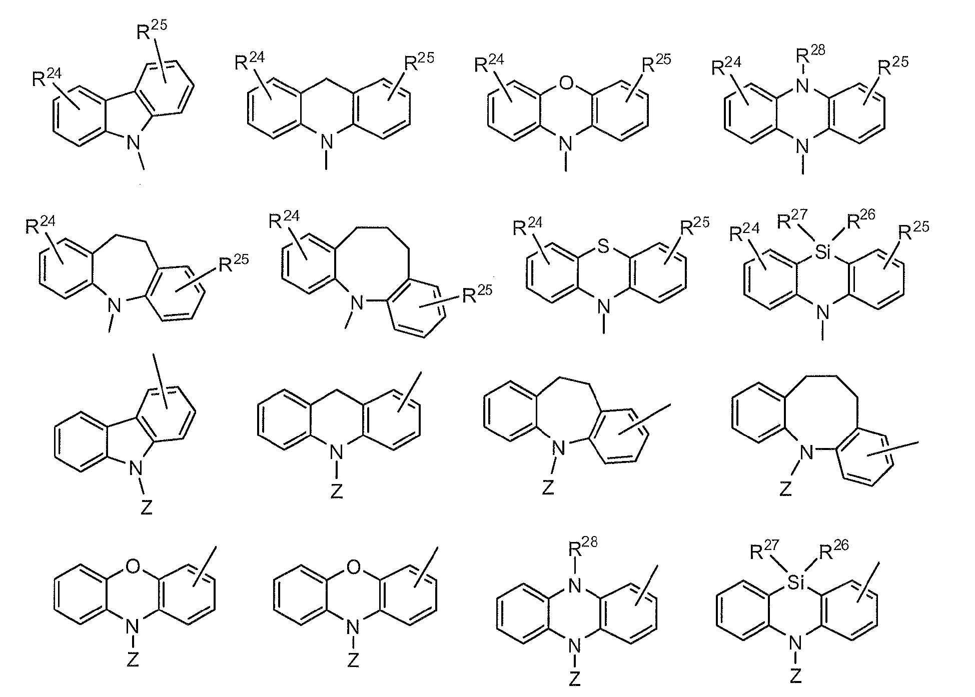

Cz more preferably has any one of the following structures.

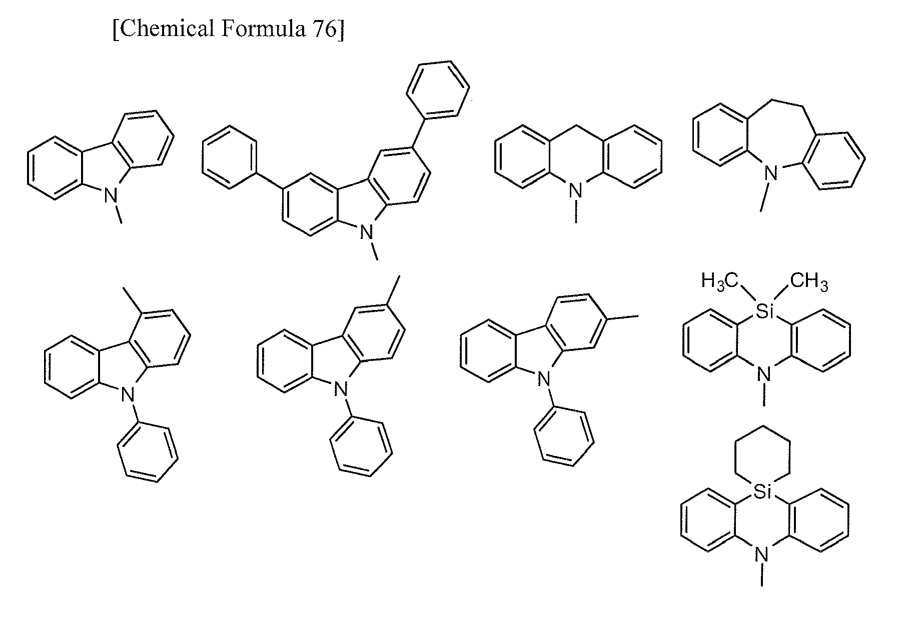

In addition, Cz particularly preferably represents a substituted or unsubstituted carbazolyl group, or substituted or unsubstituted arylcarbazolyl group.

Examples of the substituents for the groups exemplified in the general formulae (101) to (105) are a halogen atom, hydroxyl group, amino group, nitro group, cyano group, alkyl group, alkenyl group, cycloalkyl group, alkoxy group, aromatic hydrocarbon group, aromatic heterocyclic group, aralkyl group, aryloxy group and alkoxycarbonyl group.
Examples of the organic-EL-device material containing the compound represented by any one of the formulae (101) to (105) according to the aspect of the invention will be shown below. However, the invention is not limited to the exemplary compounds shown below.

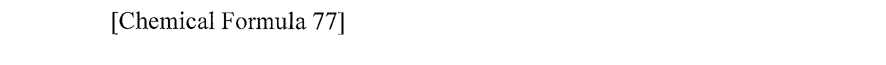

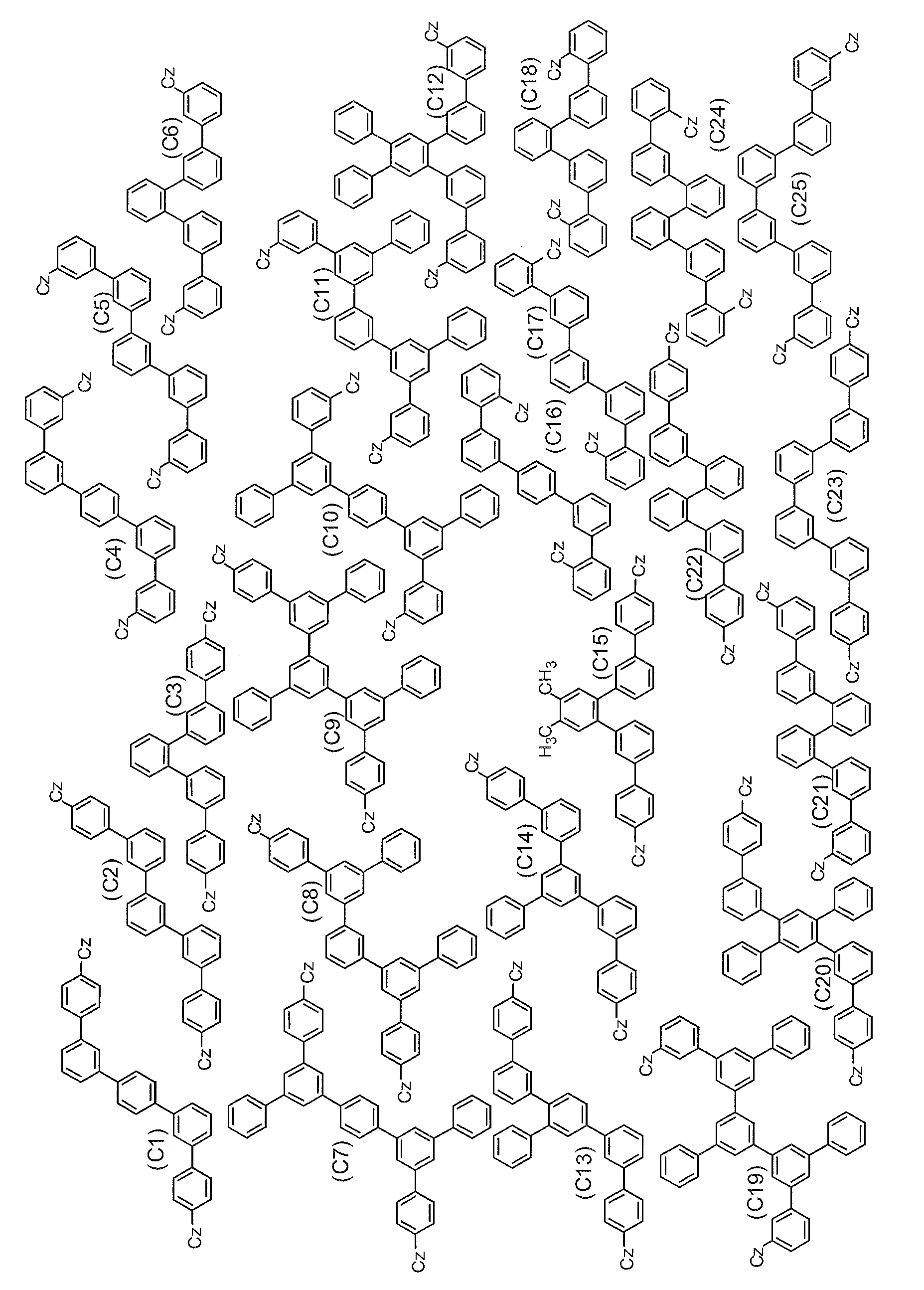

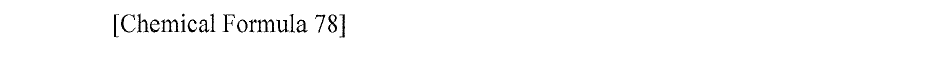

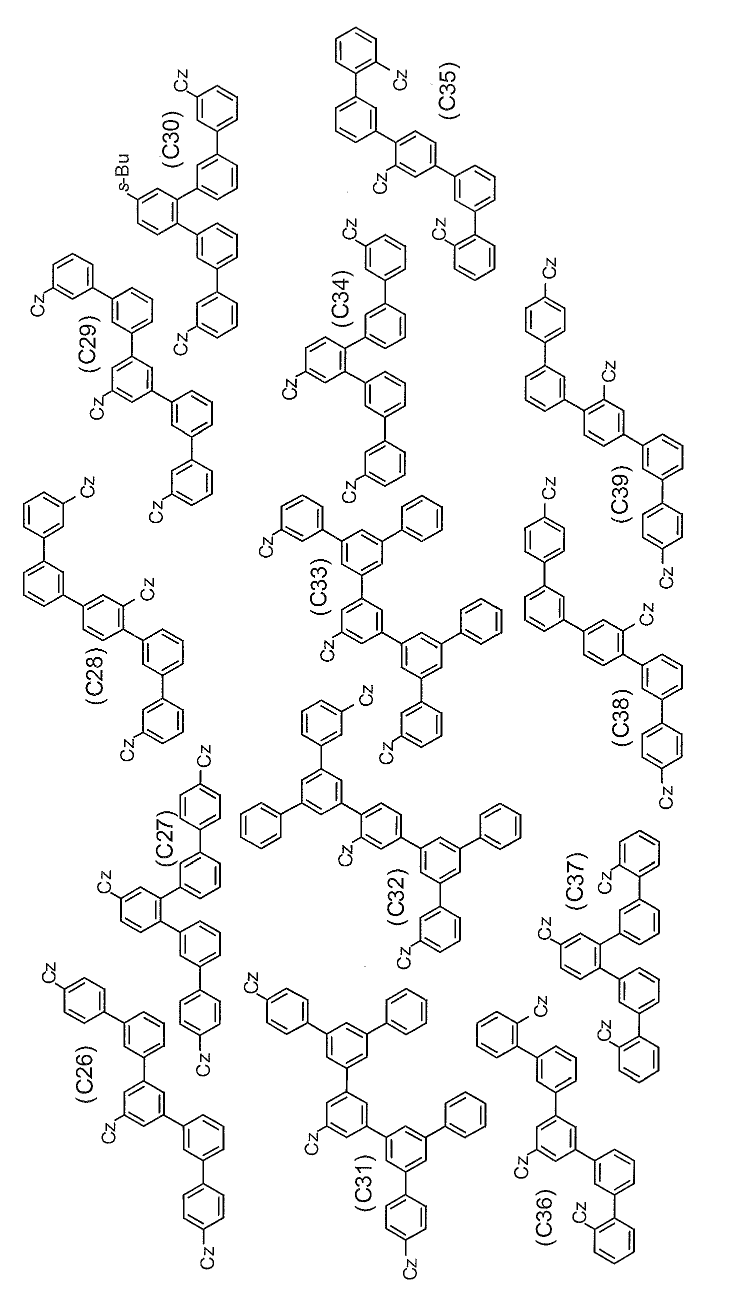

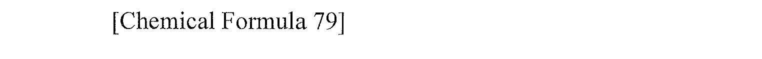

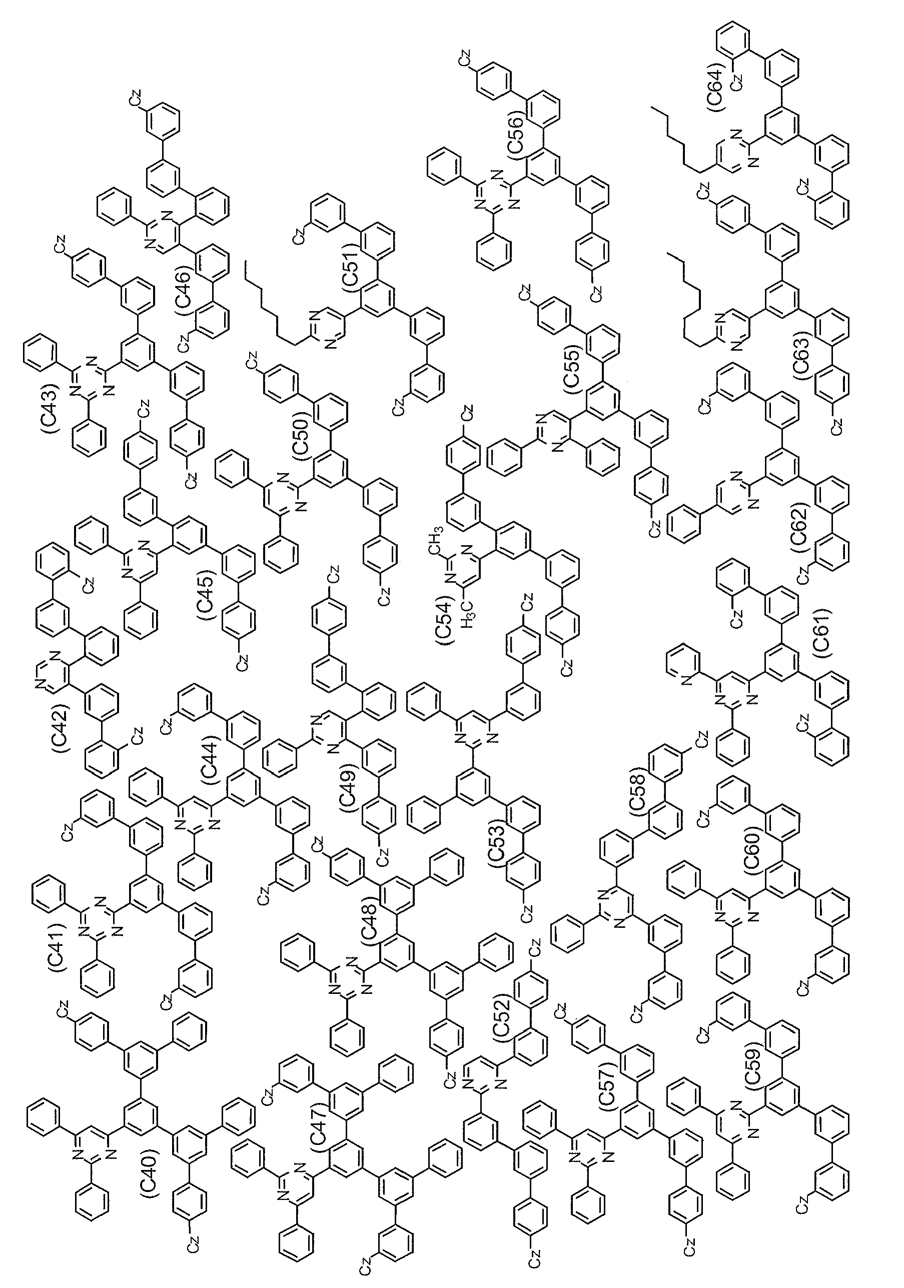

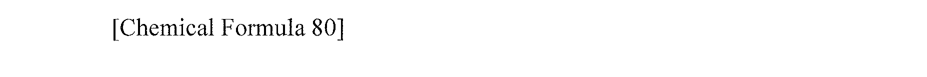

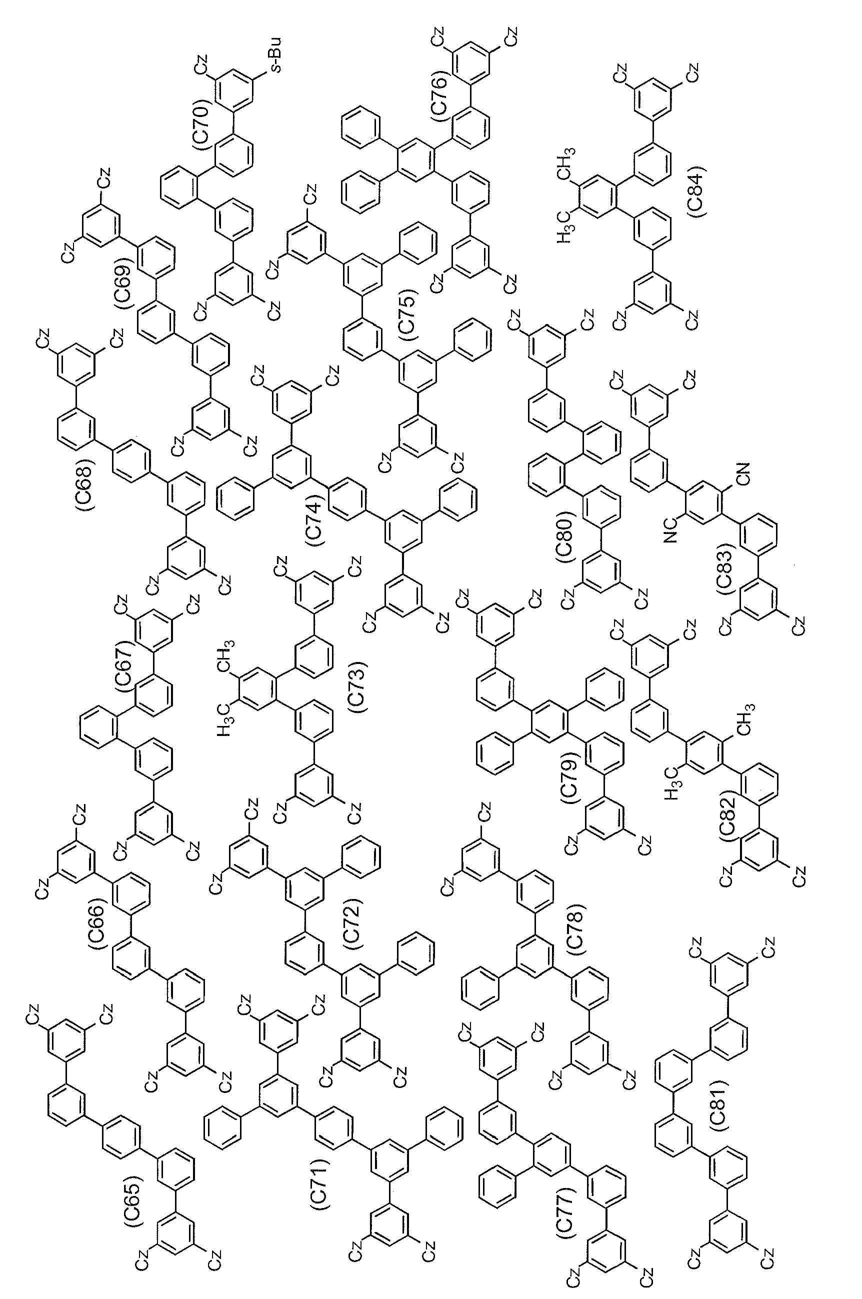

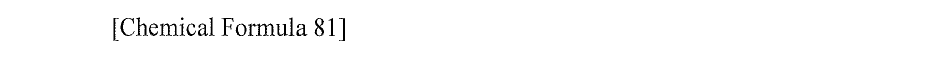

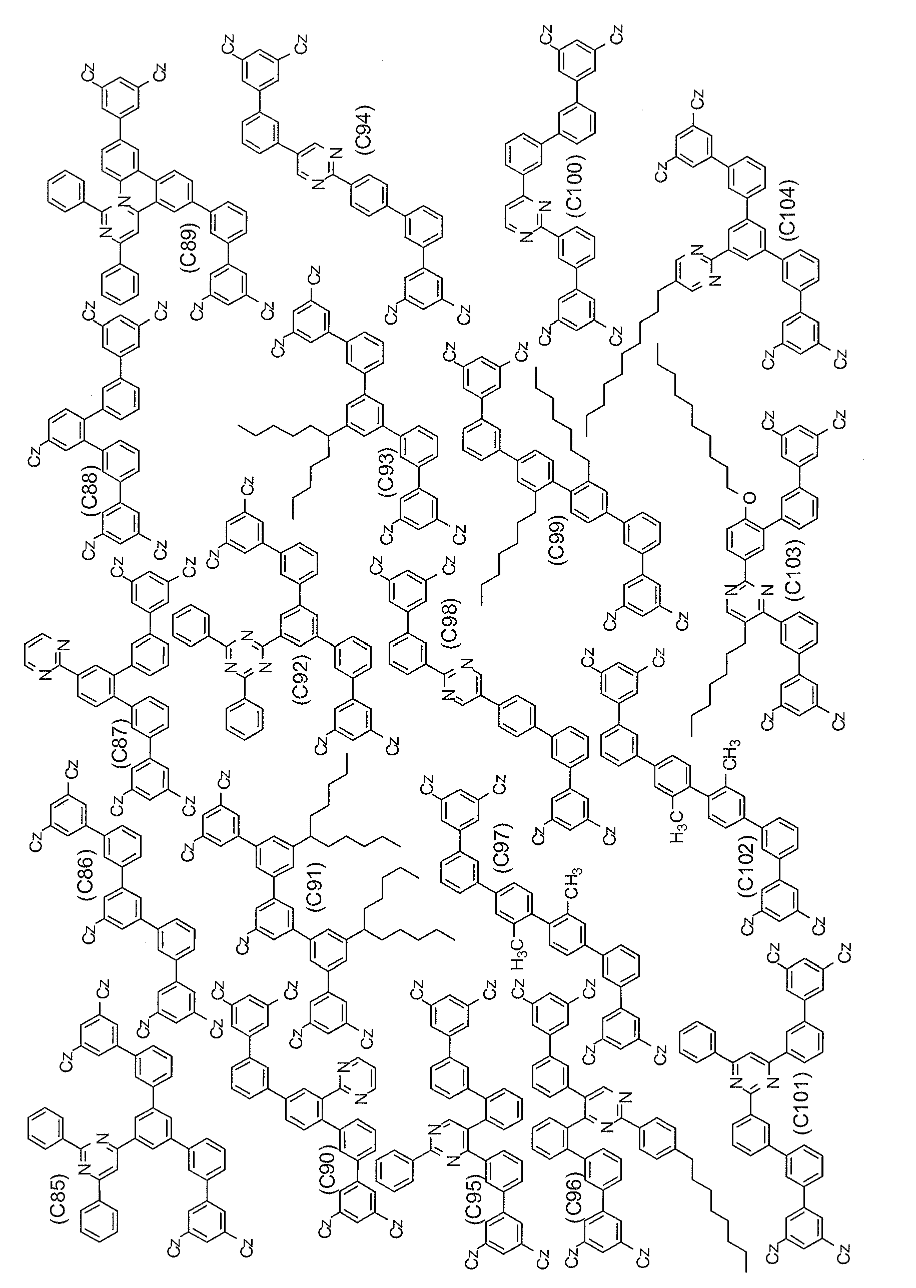

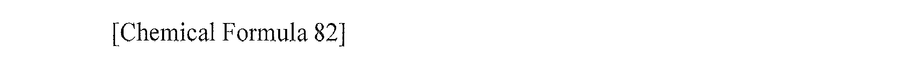

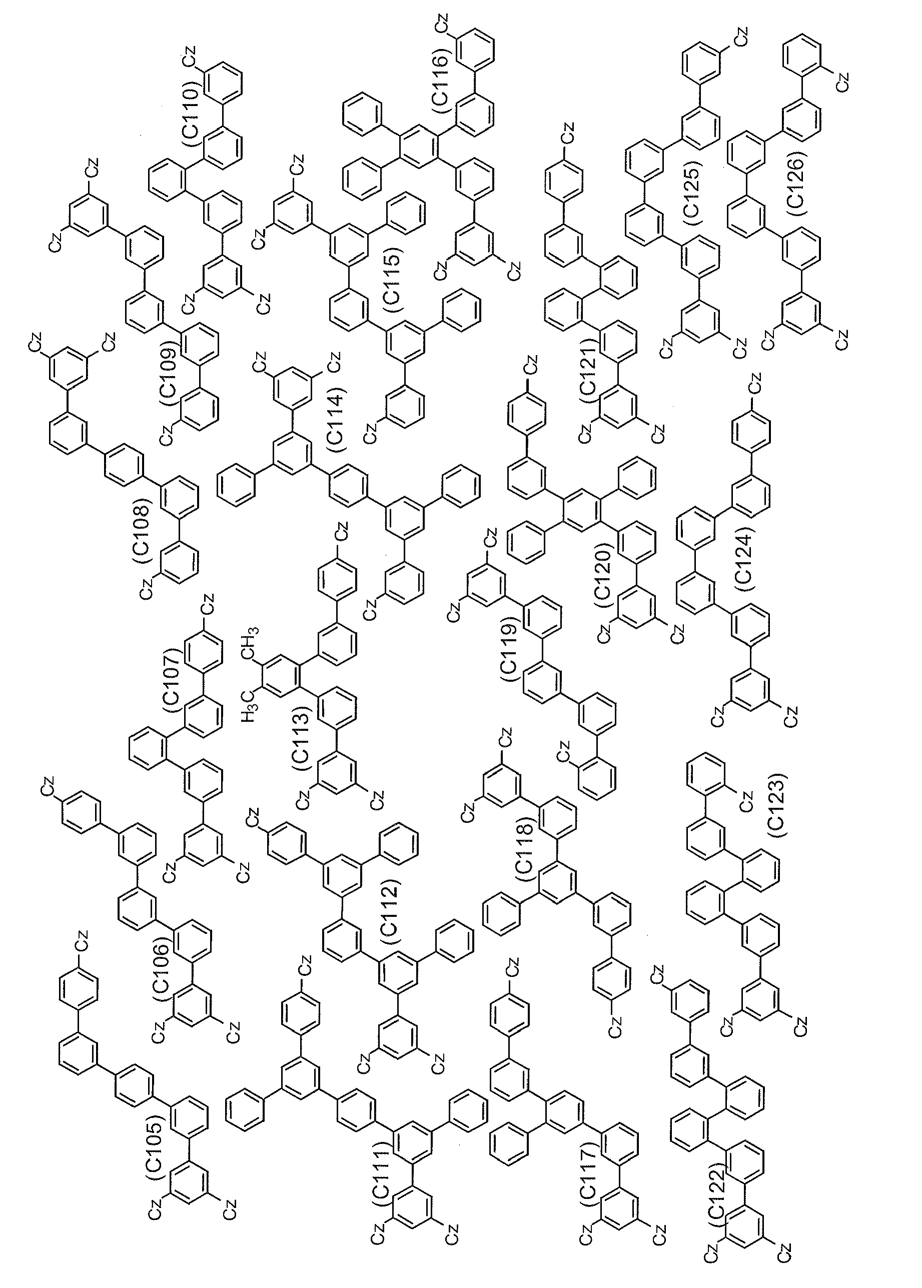

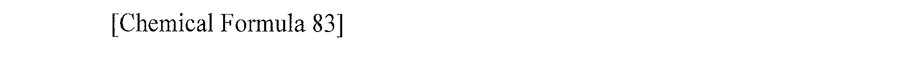

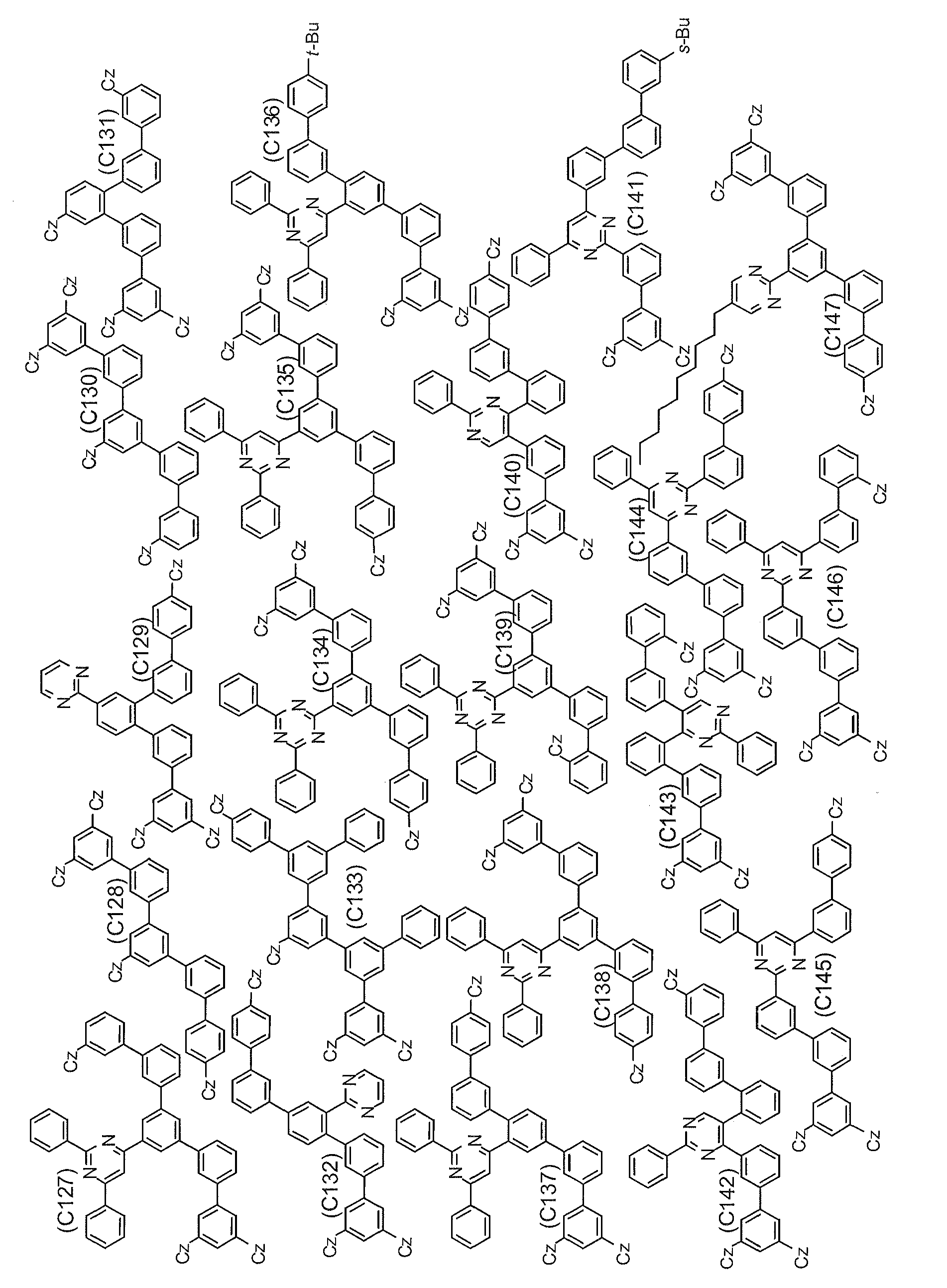

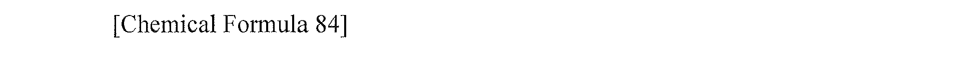

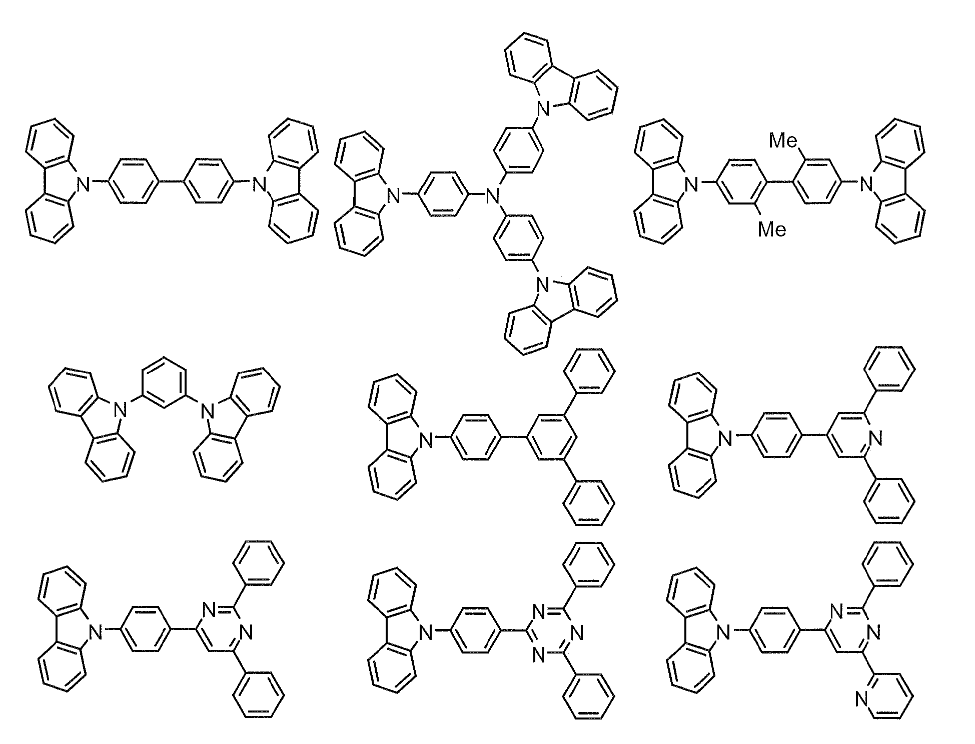

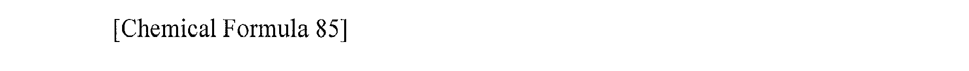

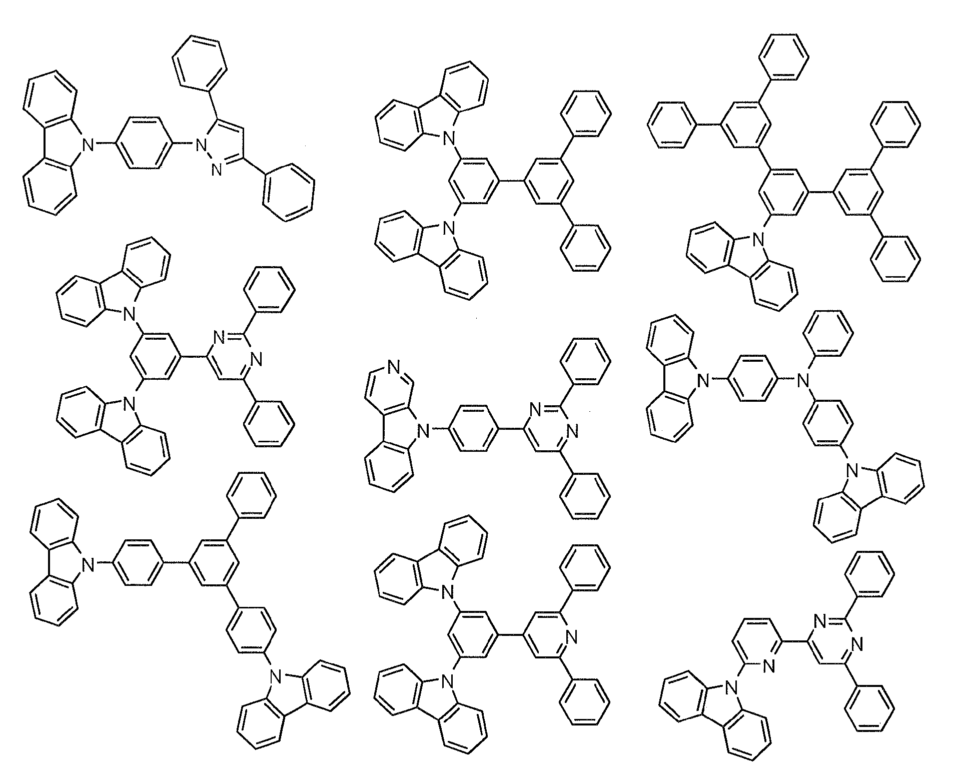

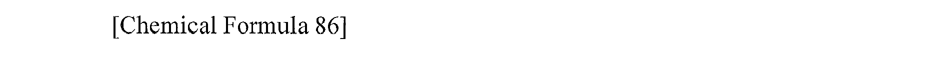

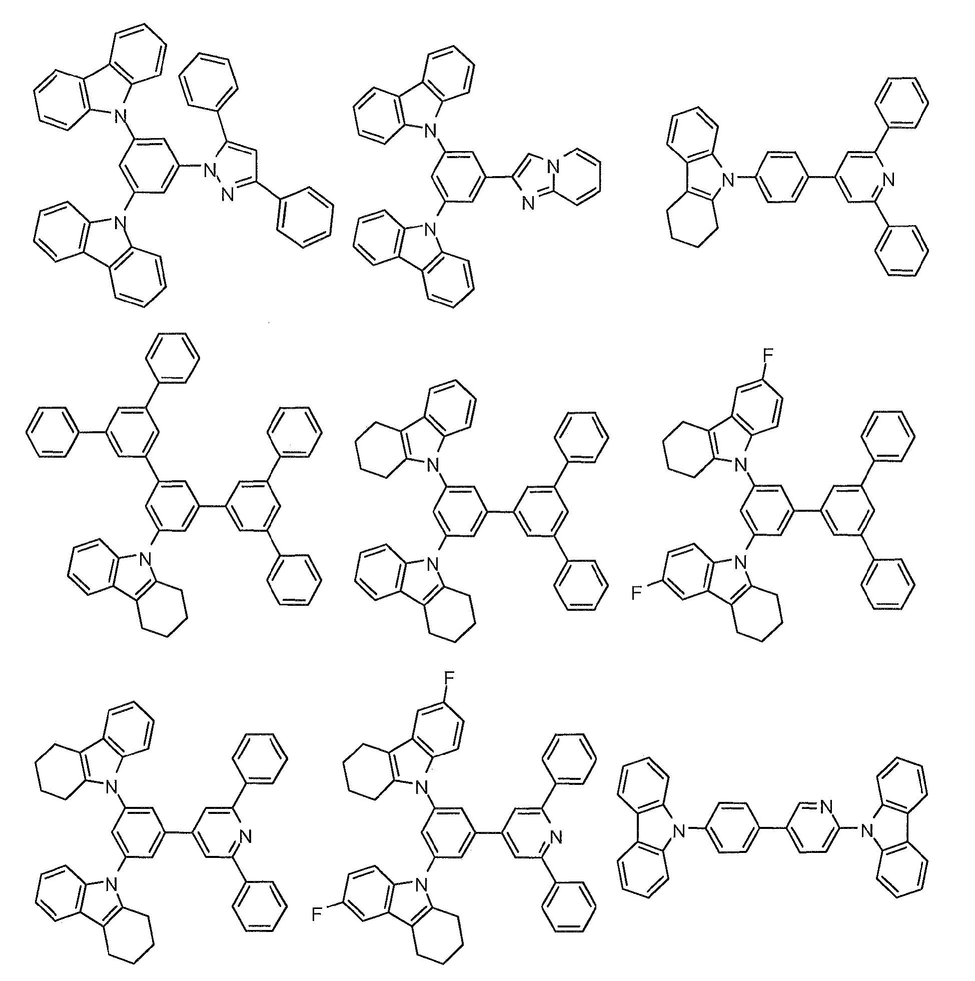

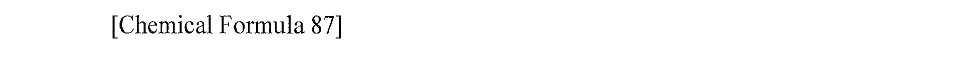

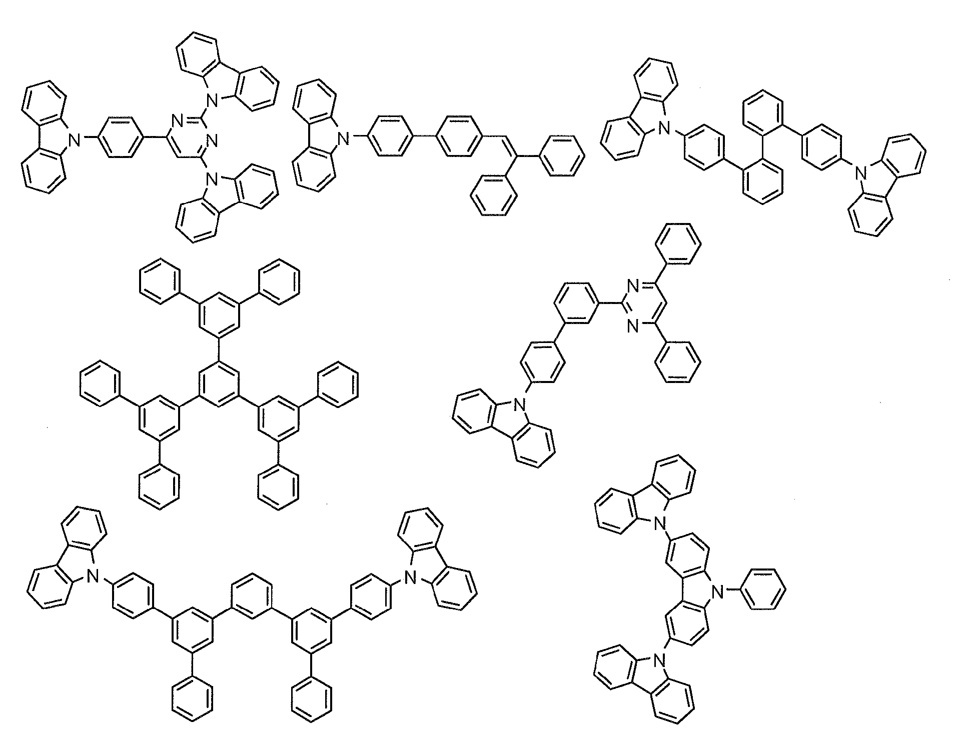

Preferably in the aspect of the invention, the phosphorescent dopant contains a metal complex having: a metal selected from the group consisting of Ir, Pt, Os, Au, Cu, Re and Ru; and a ligand.
According to such a structure, by using the above metal complex as the phosphorescent dopant, red to green phosphorescent emission is obtainable.
Incidentally, the phosphorescent dopant is sometimes called phosphorescent-emitting dopant.

Examples of the red and green phosphorescent dopant are PQIr(iridium(III) bis(2-phenyl quinolyl-N,C^{2'}) acetylacetonate) and Ir(ppy)₃(fac-tris(2-phenylpyridine) iridium). Further examples are compounds shown below.

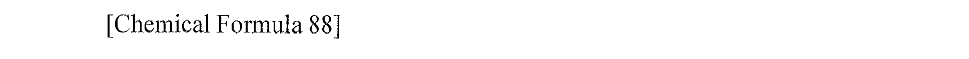

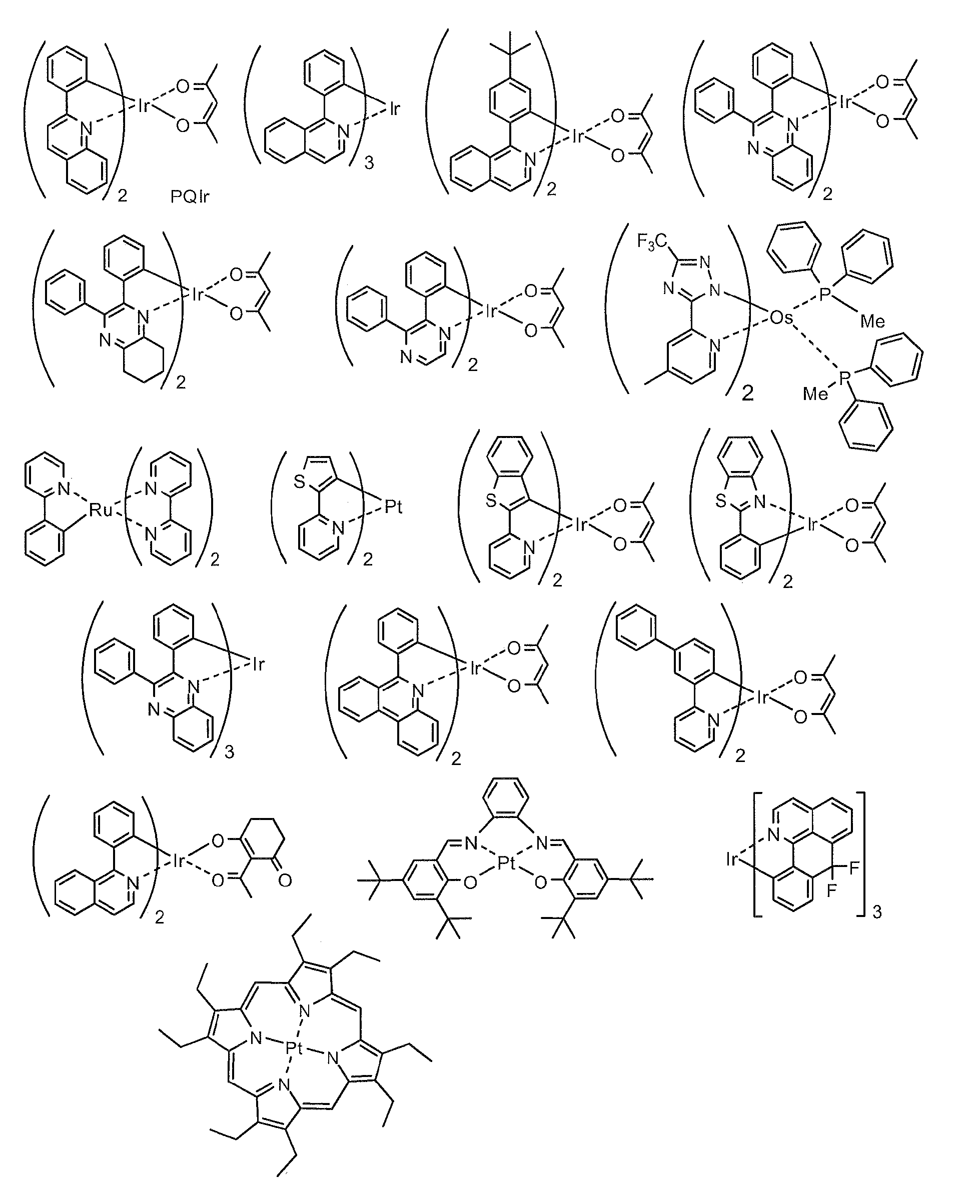

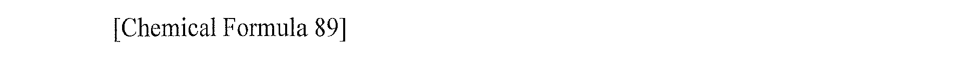

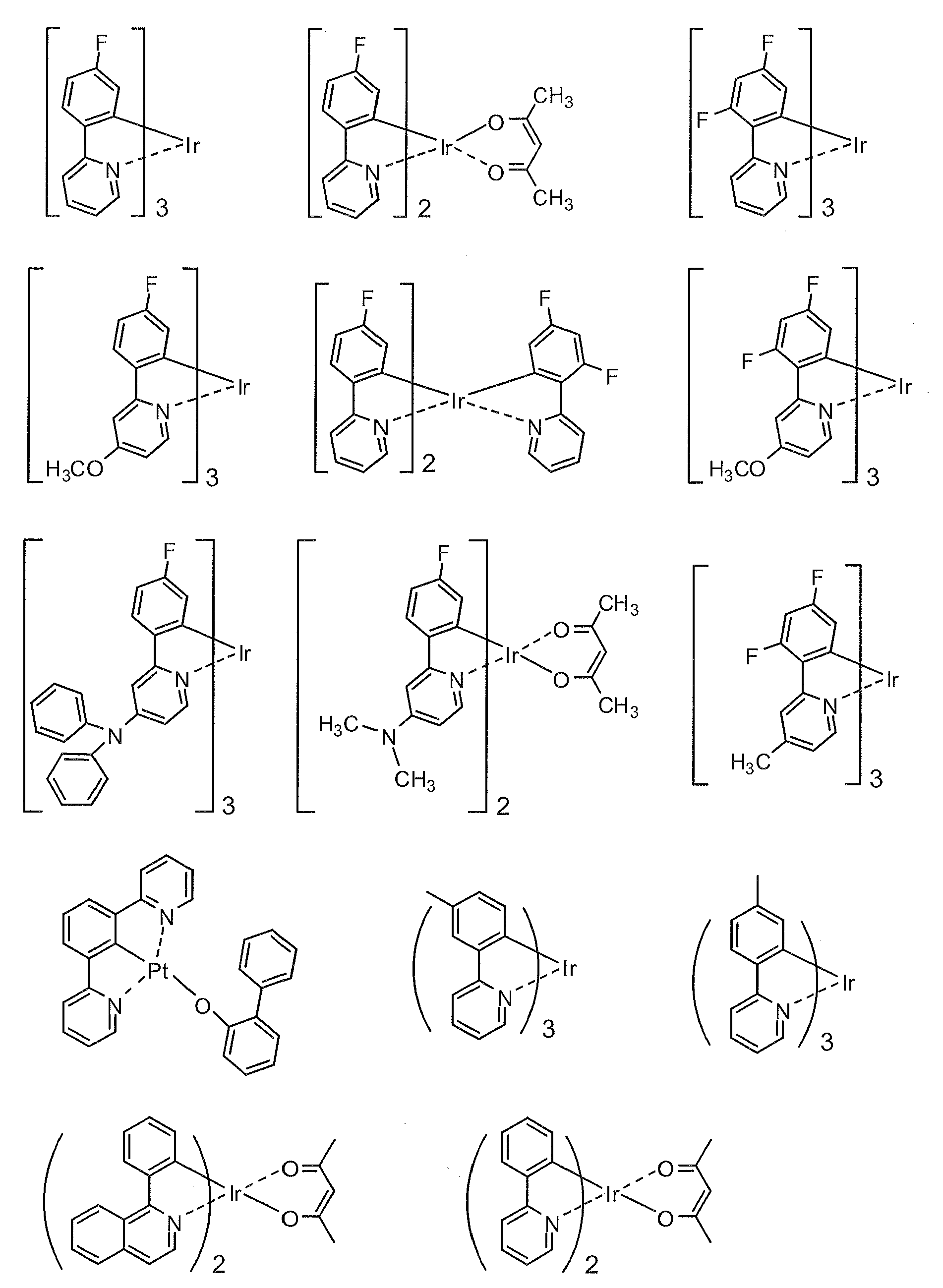

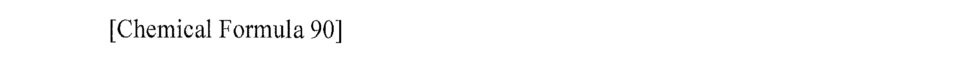

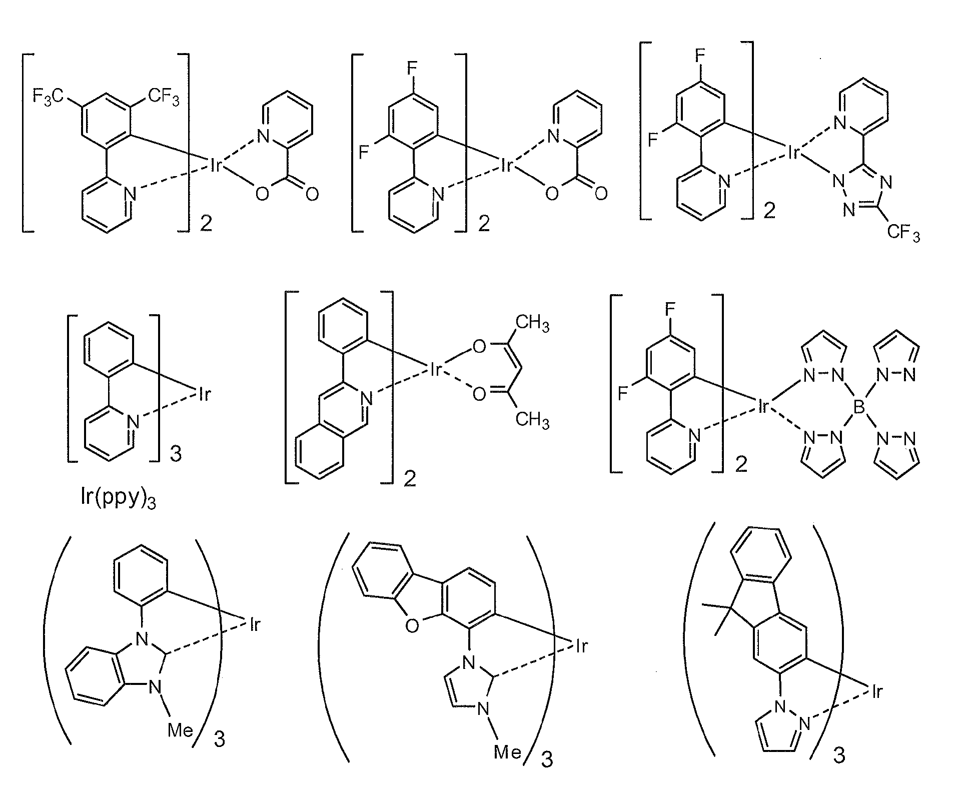

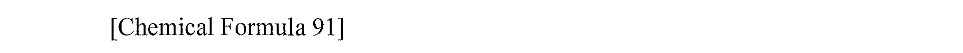

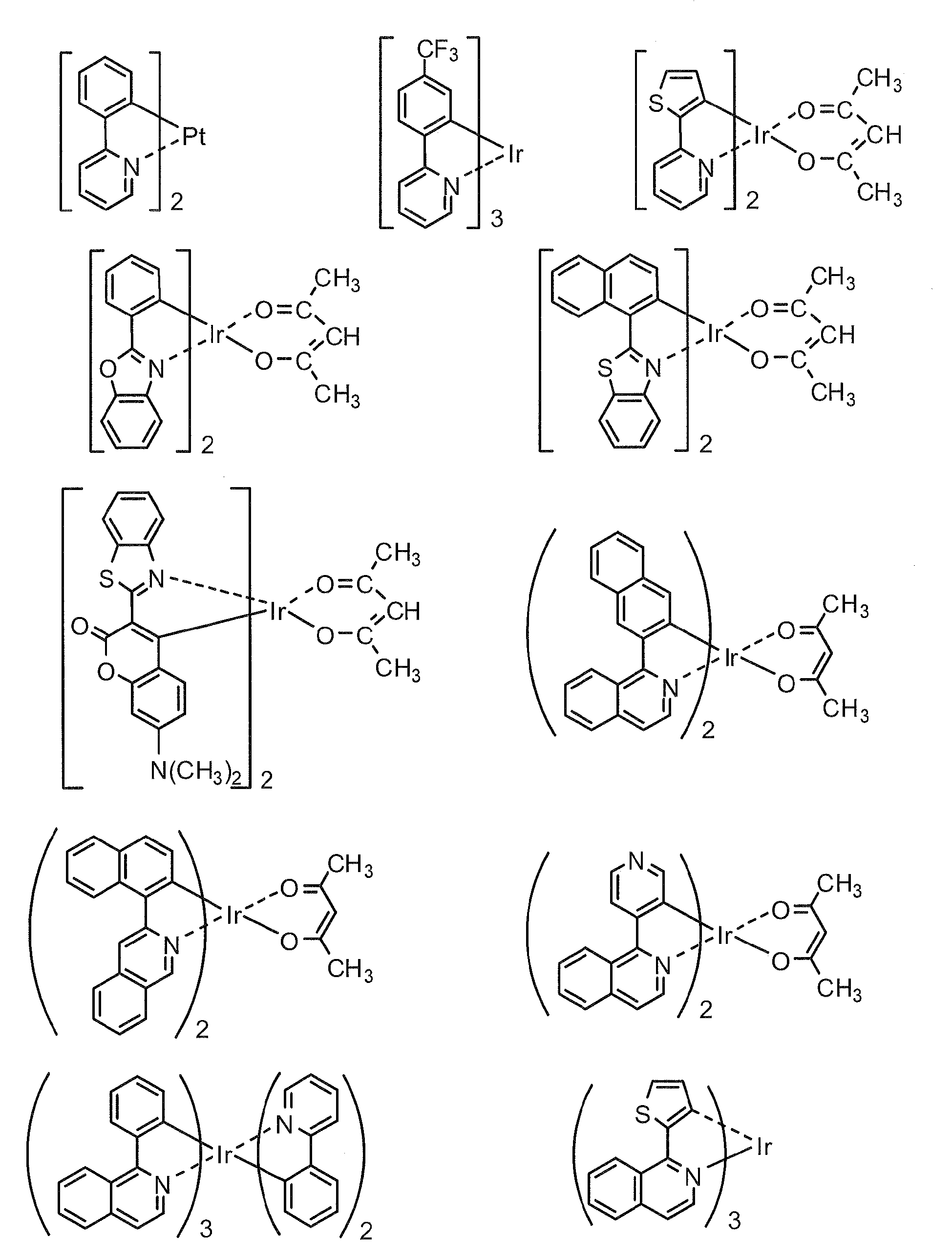

In the organic EL device according to the aspect of the invention, the fluorescent host is preferably at least one of an anthracene derivative represented by the following formula (5) and a pyrene derivative represented by the following formula (6).

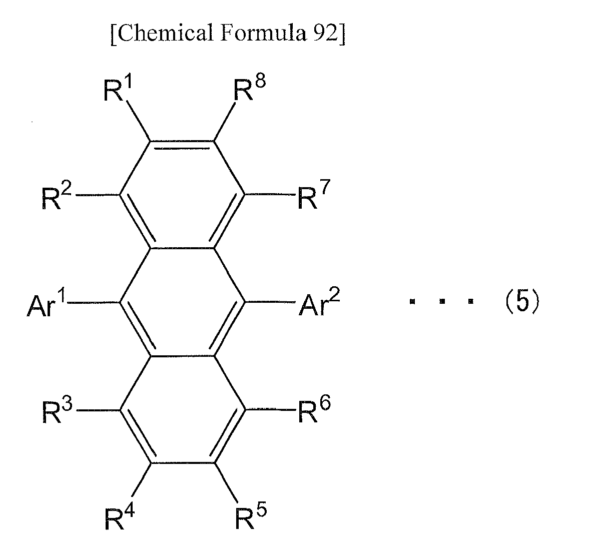

In the formula (5), Ar¹ and Ar² each independently represent a group induced from a substituted or unsubstituted aromatic ring having 6 to 20 ring carbon atoms. The aromatic ring may be substituted by one or more substituent(s). The substituent(s) is selected from the group consisting of a substituted or unsubstituted aryl group having 6 to 50 ring carbon atoms, substituted or unsubstituted alkyl group having 1 to 50 carbon atoms, substituted or unsubstituted cycloalkyl group having 3 to 50 carbon atoms, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group. When the aromatic ring is substituted by two or more substituents, the substituents may be the same or different. The adjacent substituents may be bonded together to form a saturated or unsaturated cyclic structure.
R¹ to R⁸ each are selected from the group consisting of a hydrogen atom, substituted or unsubstituted aryl group having 6 to 50 ring carbon atoms, substituted or unsubstituted heteroaryl group having 5 to 50 ring atoms, substituted or unsubstituted alkyl group having 1 to 50 carbon atoms, substituted or unsubstituted cycloalkyl group having 3 to 50 carbon atoms, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group. The adjacent substituents may be bonded together to form a saturated or unsaturated cyclic structure.

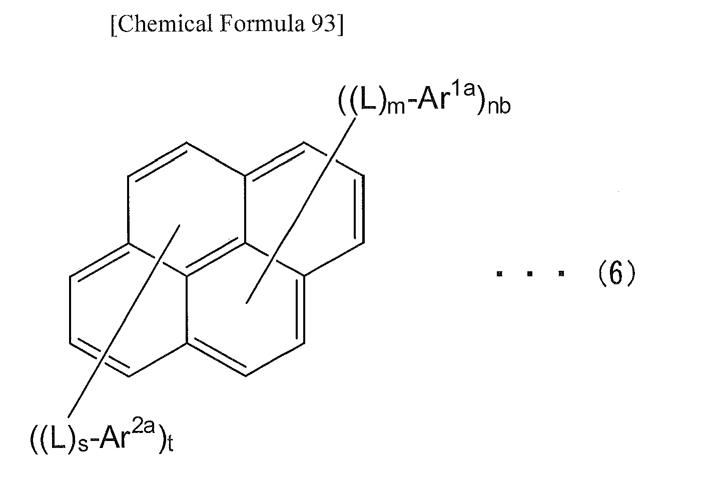

In the formula (6), Ar^{1a} and Ar^{2a} each represent a substituted or unsubstituted aromatic ring group having 6 to 50 ring carbon atoms.
L represents a substituted or unsubstituted phenylene group, substituted or unsubstituted naphthalenylene group, substituted or unsubstituted fluorenylene group or substituted or unsubstituted dibenzo-sylolylene group.
m is an integer of 0 to 2, nb is an integer of 1 to 4, s is an integer of 0 to 2 and t is an integer of 0 to 4.
L or Ar^{1a} is bonded to pyrene in any one of 1st to 5th positions. L or Ar^{2a} is bonded to pyrene in any one of 6th to 10t positions.
However, when nb+t is even, Ar^{1a}, Ar^{2a} and L satisfy the following (1) or (2). (1) Ar^{1a}≠Ar^{2a} (herein "≠" means that they are groups of different structures) or (2) when Ar^{1a}=Ar^{2a}:
(2-1) m≠s and/or nb≠t; or
(2-2) when m=s and nb=t, and
(2-2-1) L or pyrene is bonded in a different bonding position on Ar^{1a} and Ar^{2a} or
(2-2-2) L or pyrene is bonded in the same bonding position on Ar^{1a} and Ar^{2a},
the substituting positions of L or Ar^{1a} and Ar^{2a} in the pyrene are not 1 st and 6th positions or 2nd and 7th positions.

The anthracene derivative is preferably an asymmetric anthracene represented by the following formula (501).

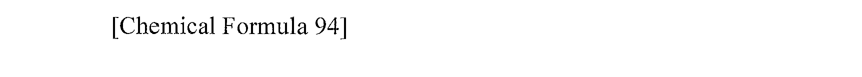

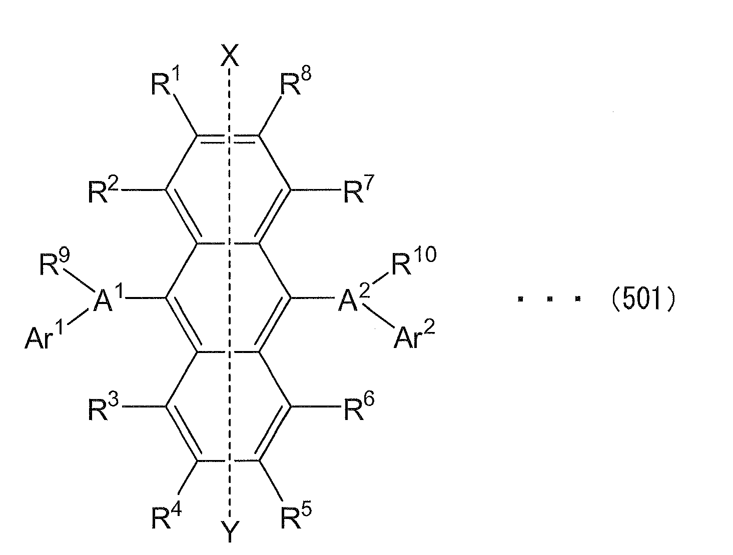

In the formula (501), A¹ and A² each independently represent a hydrogen atom or substituted or unsubstituted aromatic ring group having 6 to 50 ring carbon atoms.
R¹ to R¹⁰ each are independently selected from the group consisting of a hydrogen atom, substituted or unsubstituted aromatic ring group having 6 to 50 ring carbon atoms, substituted or unsubstituted aromatic heterocyclic group having 5 to 50 ring atoms, substituted or unsubstituted alkyl group having 1 to 50 carbon atoms, substituted or unsubstituted cycloalkyl group, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group.
Ar¹, Ar², R⁹ and R¹⁰ each may be plural. An adjacent set thereof may form a saturated or unsaturated cyclic structure.
However, groups symmetric with respect to X-Y axis shown over the anthracene do not bond to the central anthracene in 9th and 10^{th} positions.

Examples of the anthracene derivative are those represented by the following formulae, specifically, those denoted by 2a-1 to 2a-16 and 2a-49 to 2a-51.

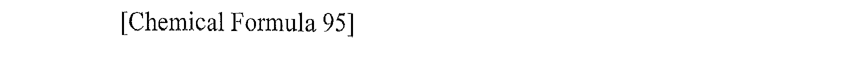

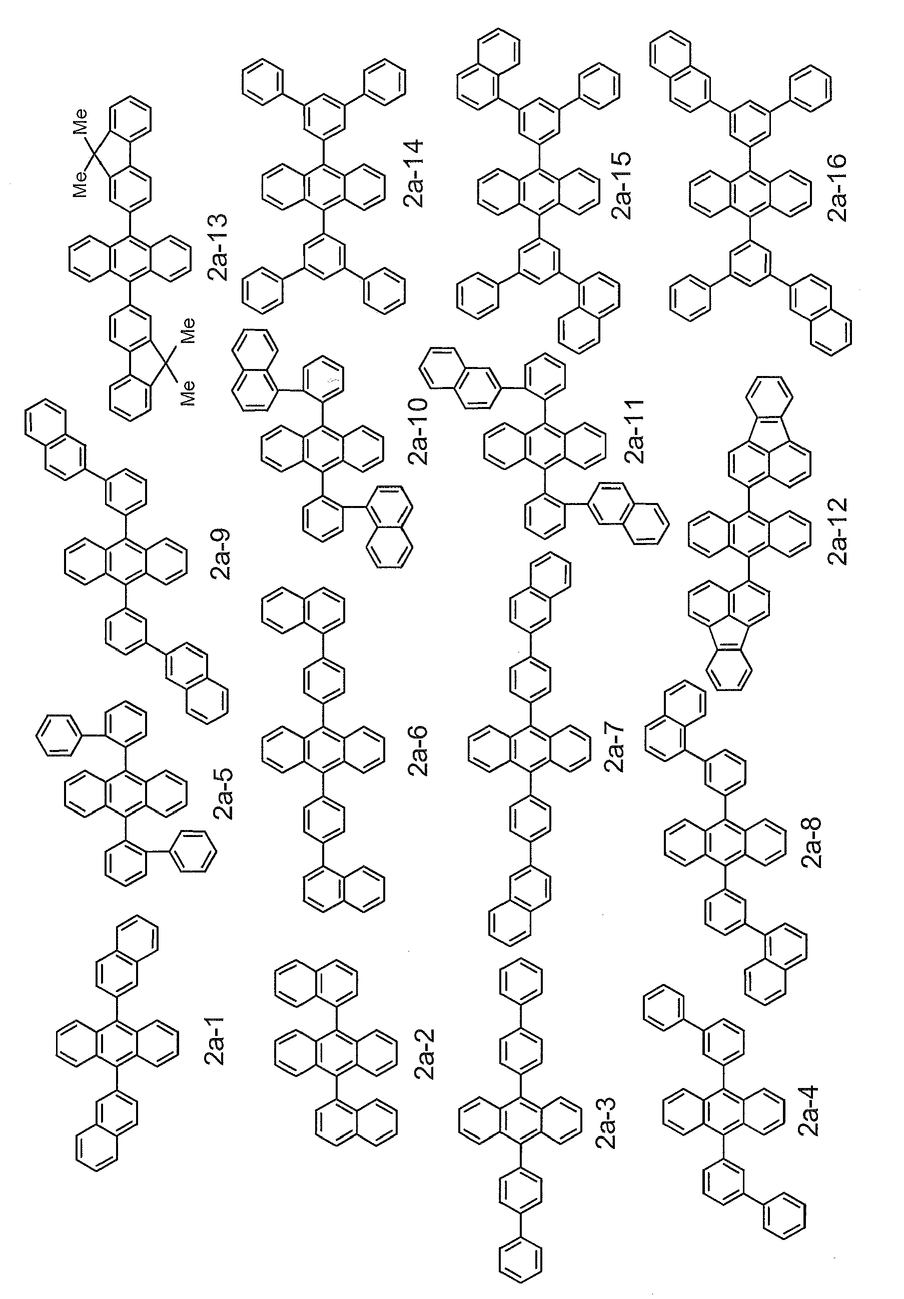

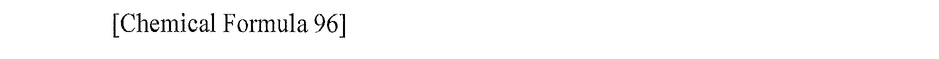

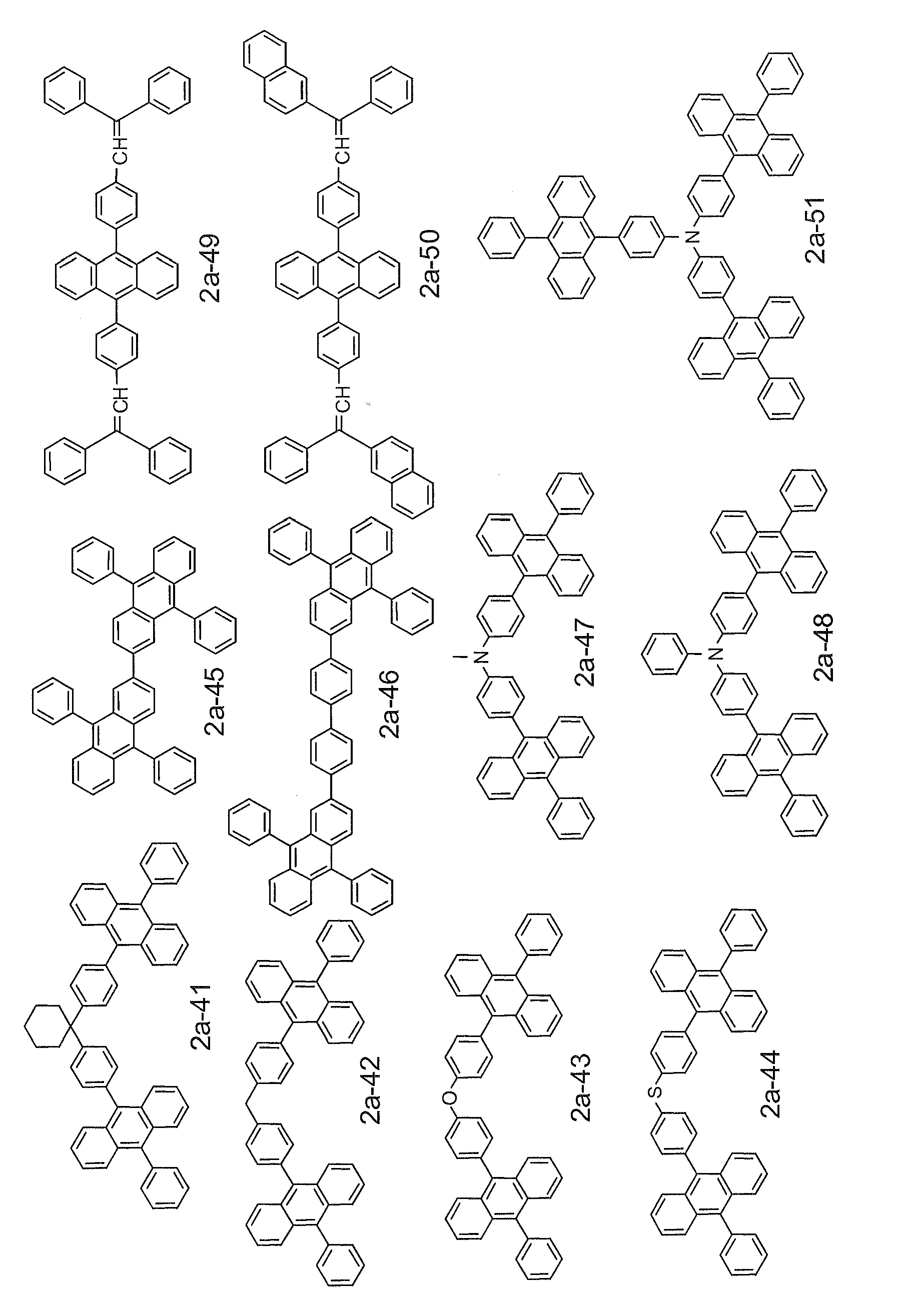

The anthracene derivative may be a bis anthracene derivative represented by a formula (502) below. 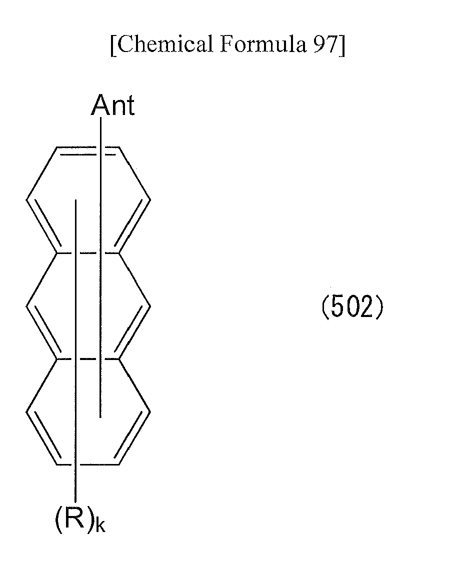 In the formula (502), Ant is a substituted or unsubstituted anthracene derivative.
R is selected from the group consisting of a hydrogen atom, substituted or unsubstituted aryl group having 6 to 50 ring carbon atoms, substituted or unsubstituted heteroaryl group having 5 to 50 ring atoms, substituted or unsubstituted alkyl group having 1 to 50 carbon atoms, substituted or unsubstituted cycloalkyl group having 3 to 50 carbon atoms, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group. The adjacent substituents may be bonded together to form a saturated or unsaturated cyclic structure.
k is an integer of 0 to 9.

Examples of the bisanthracene derivative are those represented by the following formulae, specifically, those denoted by 2a-41 to 2a-48.

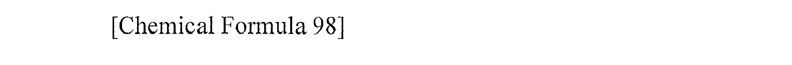

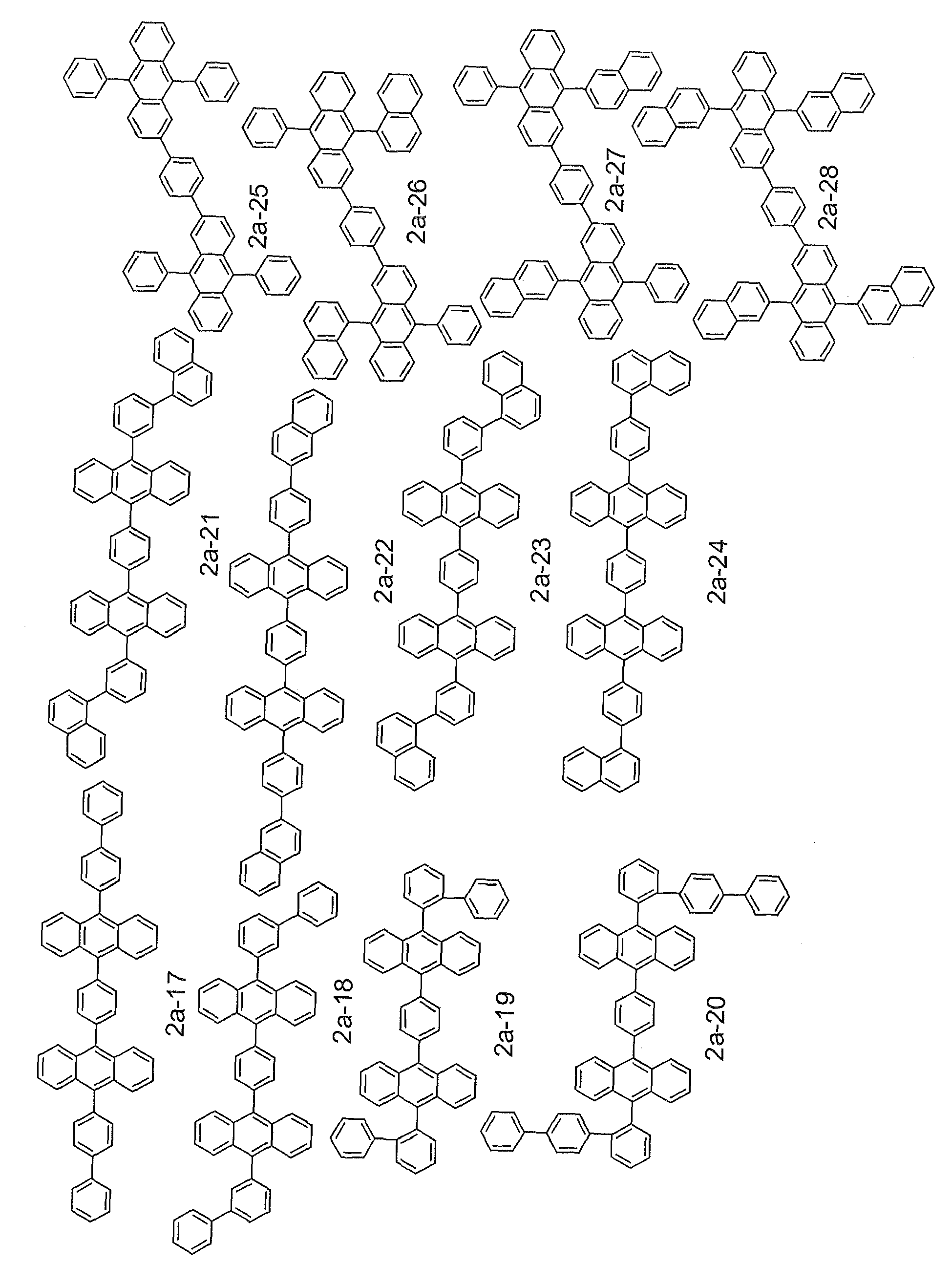

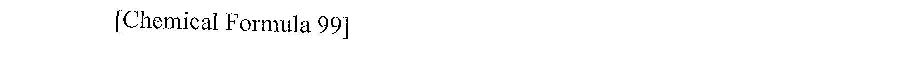

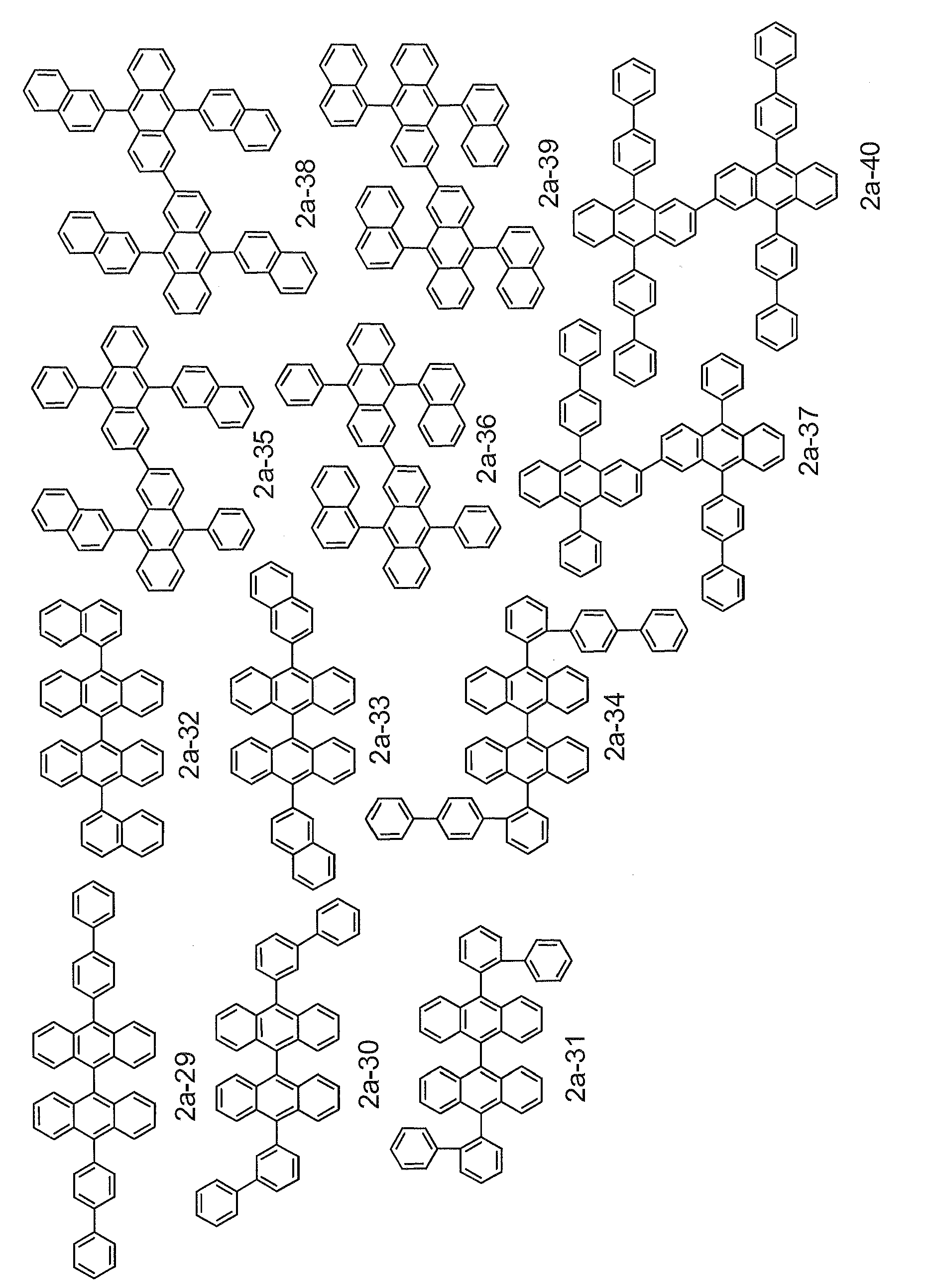

Examples of the asymmetric anthracene derivative are those represented by the following formulae.

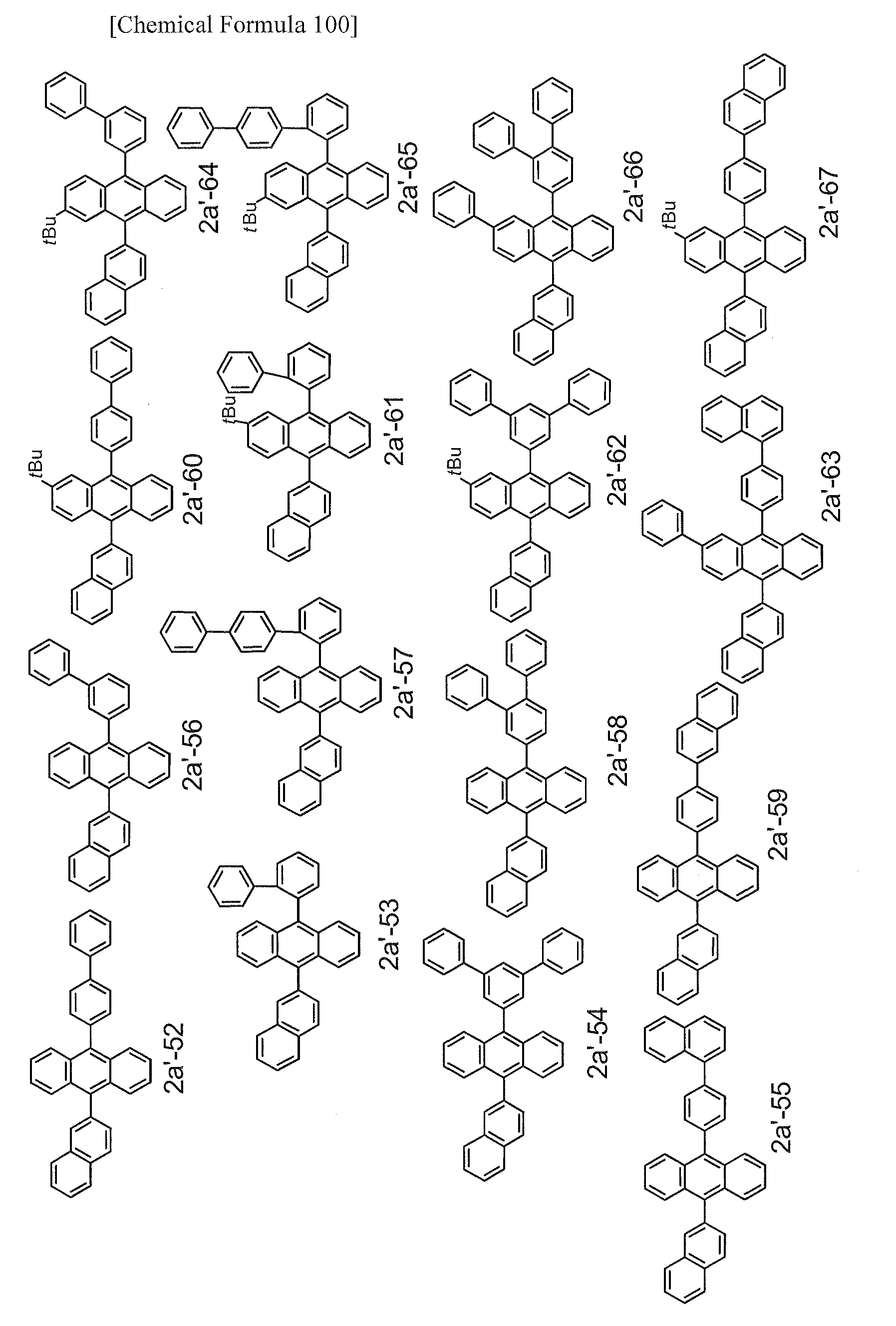

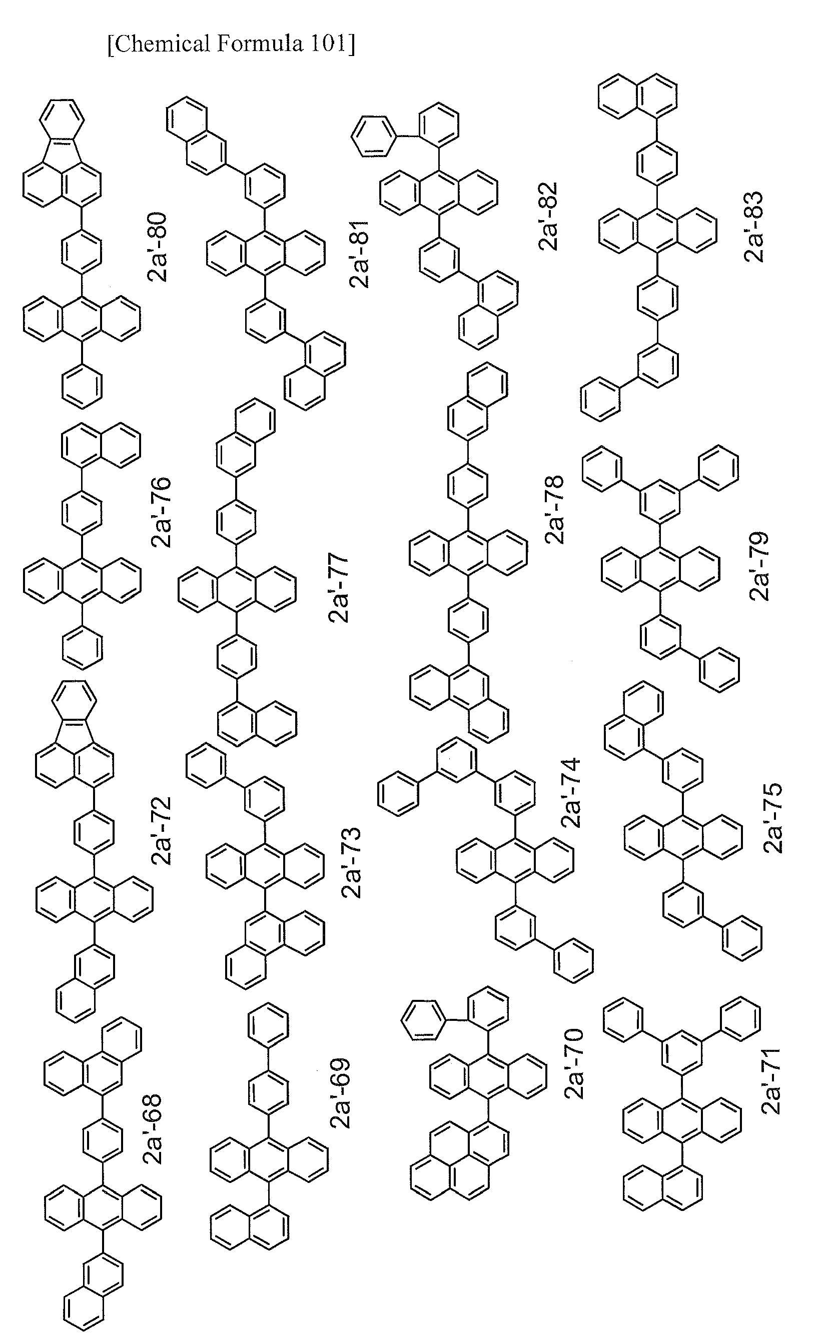

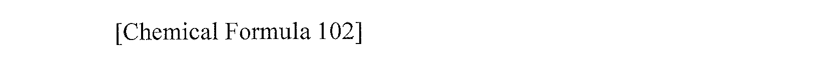

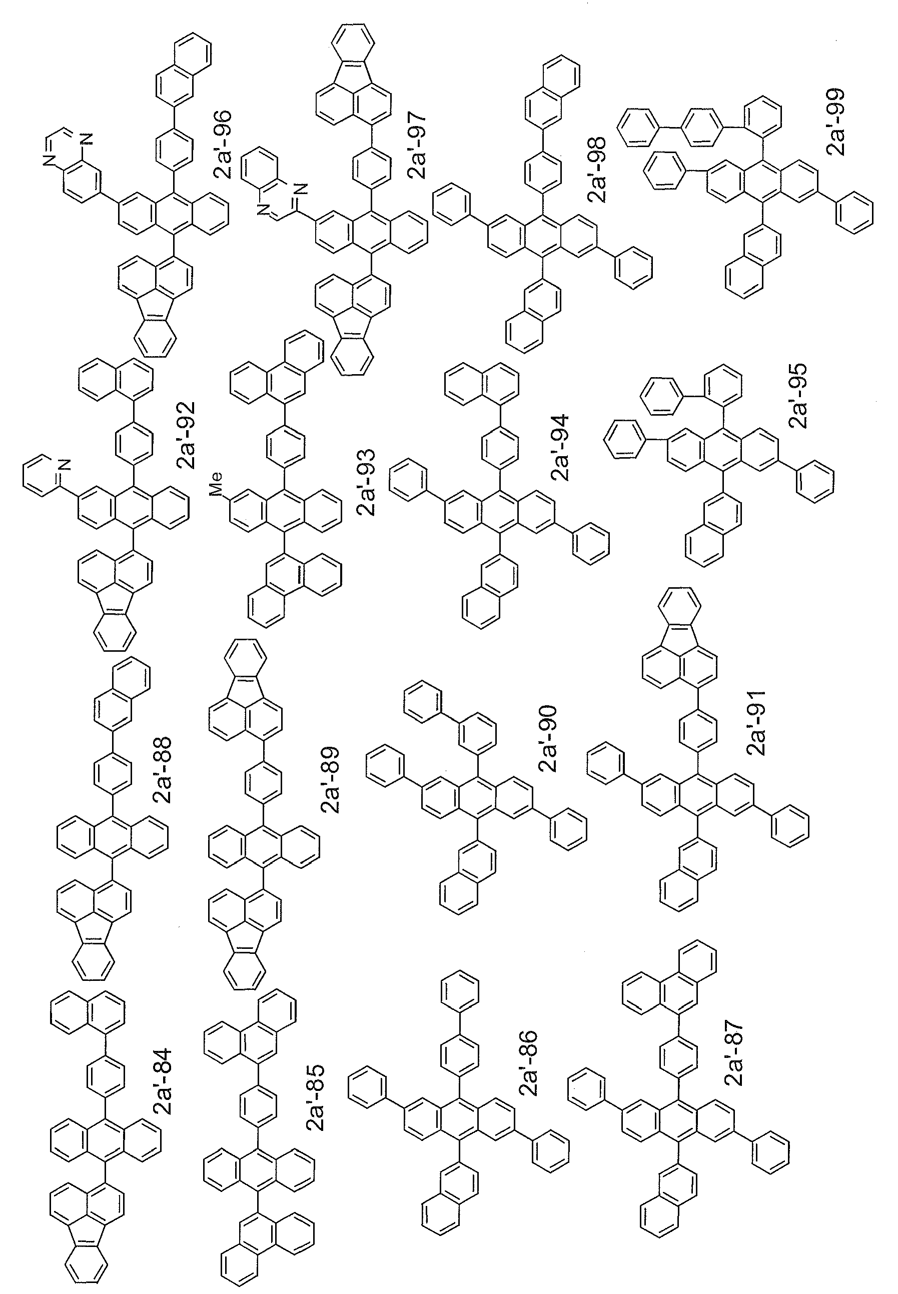

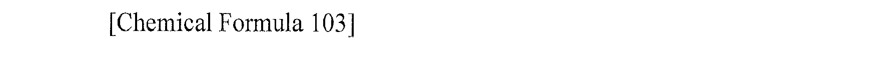

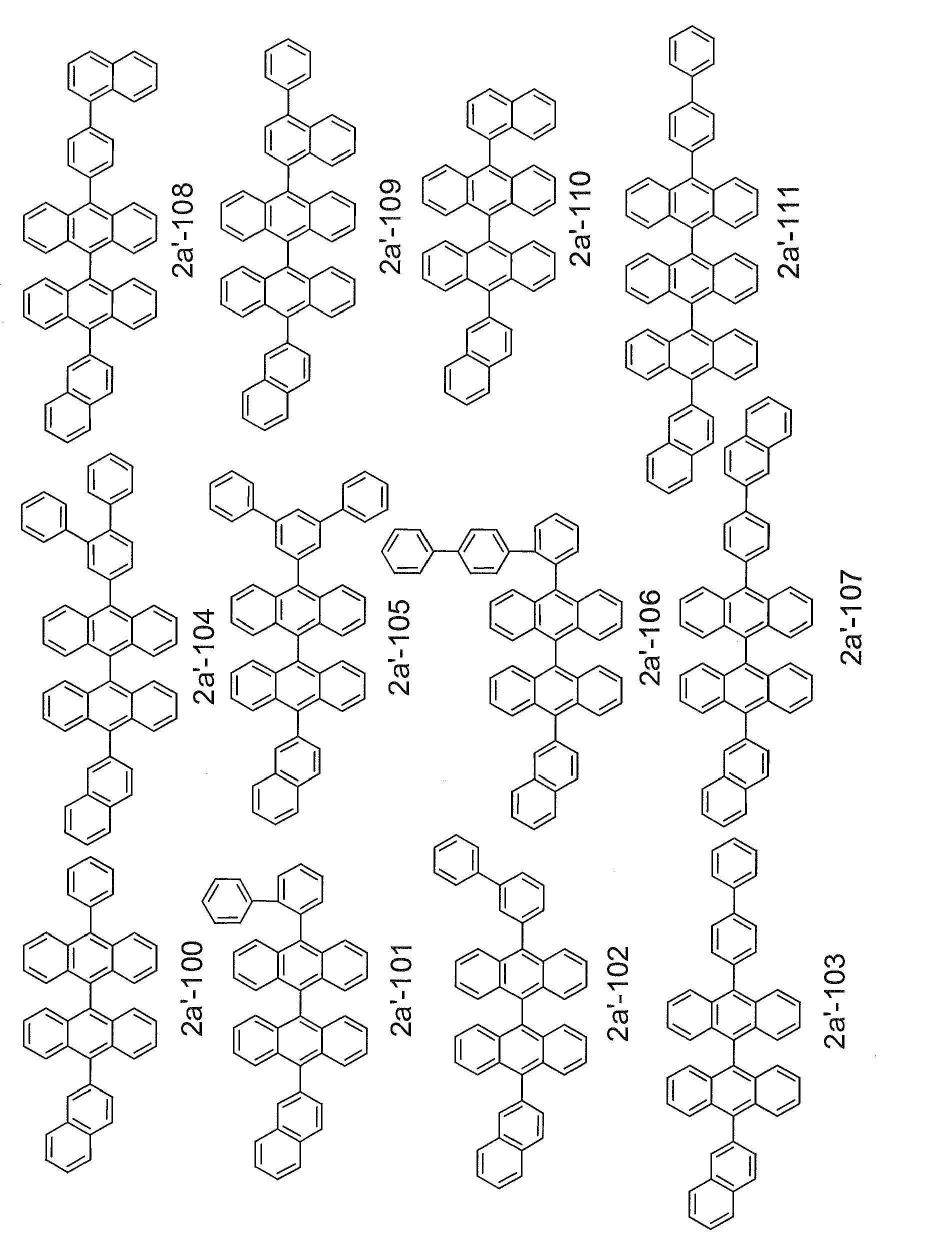

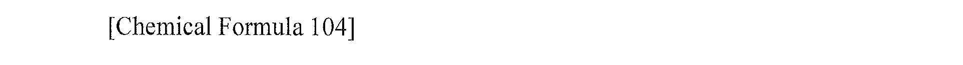

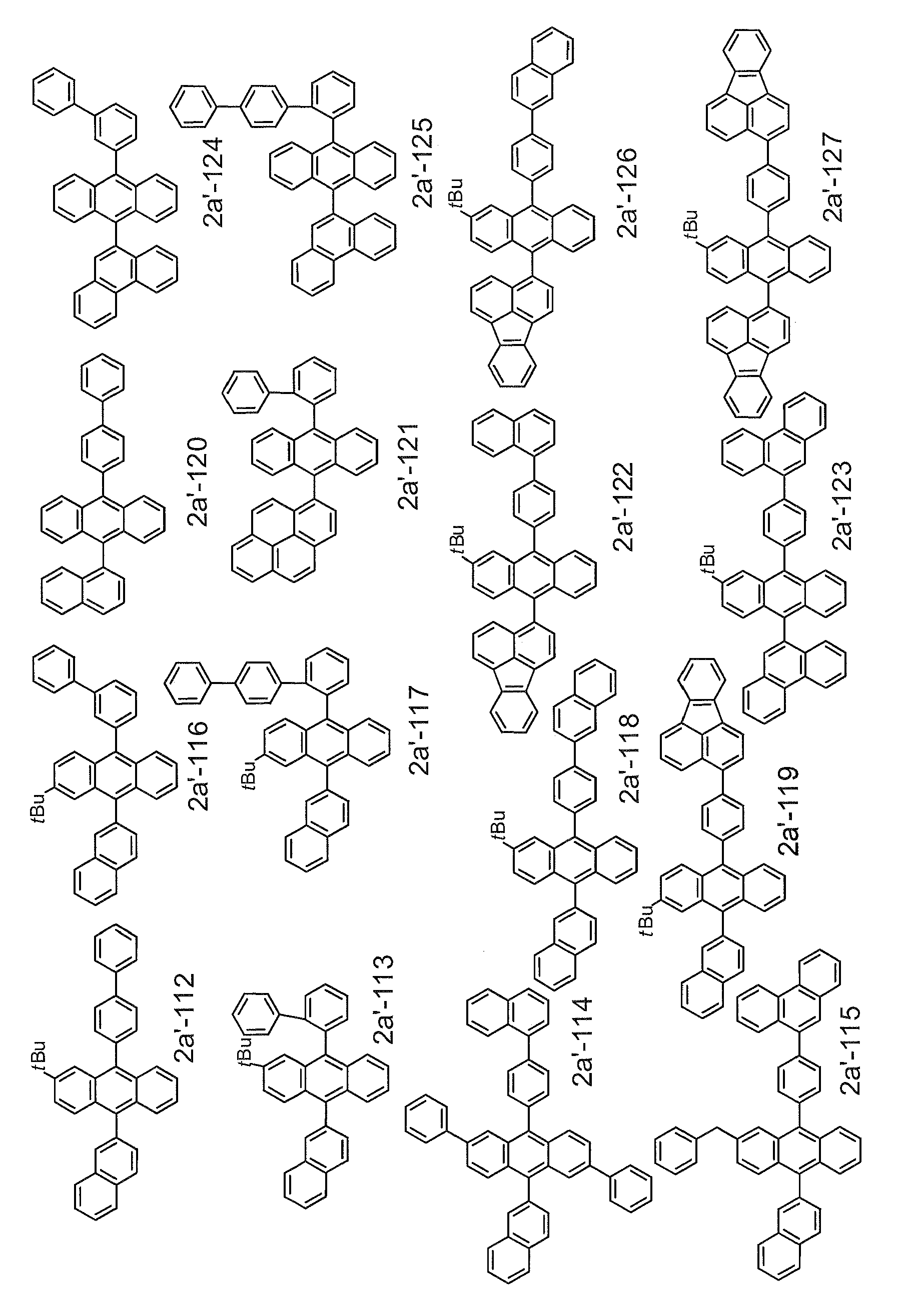

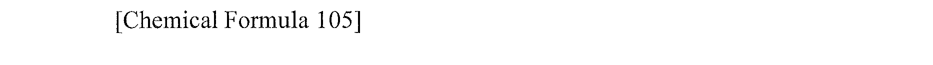

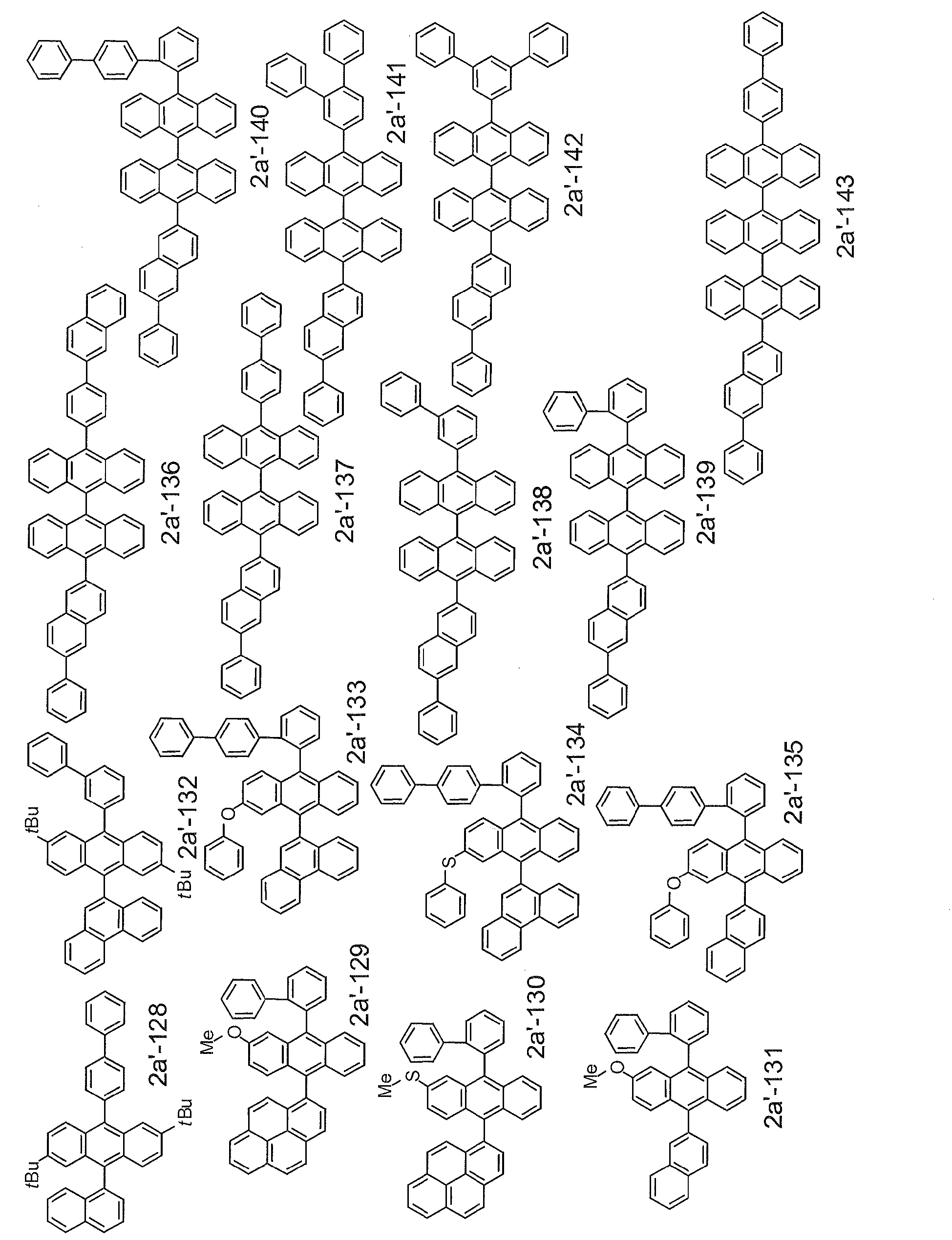

The anthracene derivative may be a benzanthracene derivative represented by the following formula. 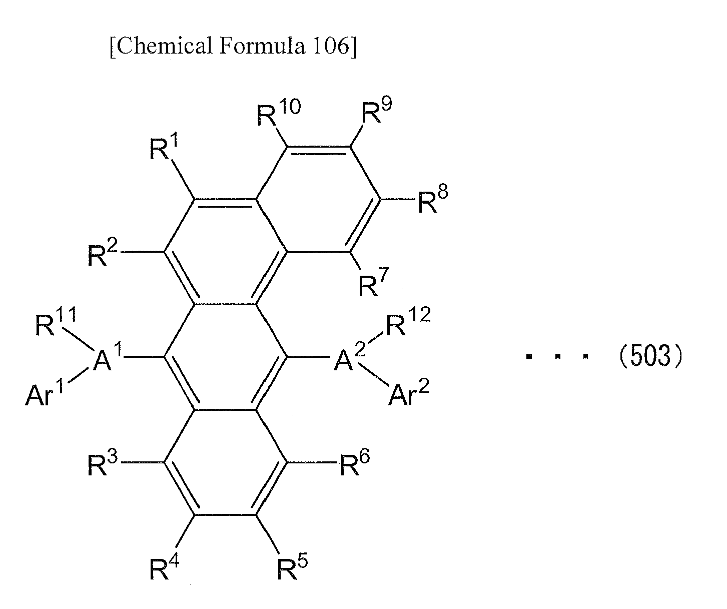 In the formula (503), Ar¹ and Ar² each independently represent a substituted or unsubstituted aromatic ring group having 6 to 50 ring carbon atoms.
R¹ to R¹² each are independently selected from the group consisting of a hydrogen atom, substituted or unsubstituted aromatic ring group having 6 to 50 ring carbon atoms, substituted or unsubstituted aromatic heterocyclic group having 5 to 50 ring atoms, substituted or unsubstituted alkyl group having 1 to 50 carbon atoms, substituted or unsubstituted cycloalkyl group, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group.
Ar¹, Ar², R¹¹ and R¹² each may be plural. An adjacent set thereof may form a saturated or unsaturated cyclic structure.

Examples of the benzanthracene derivative are those represented by the following formulae.

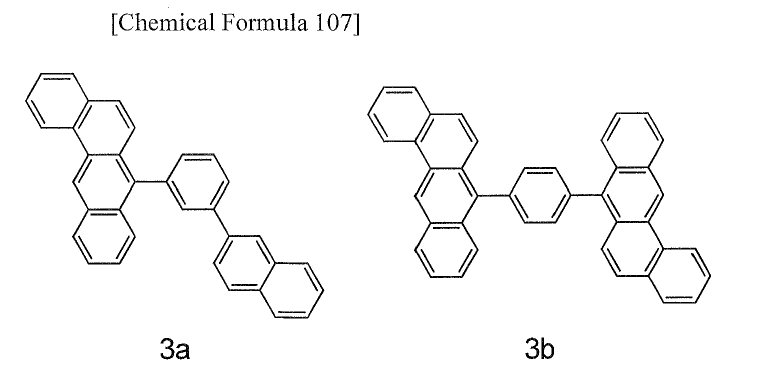

Examples of the pyrene derivative are those represented by the following formulae.

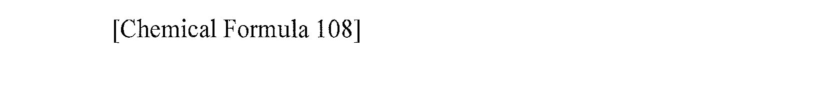

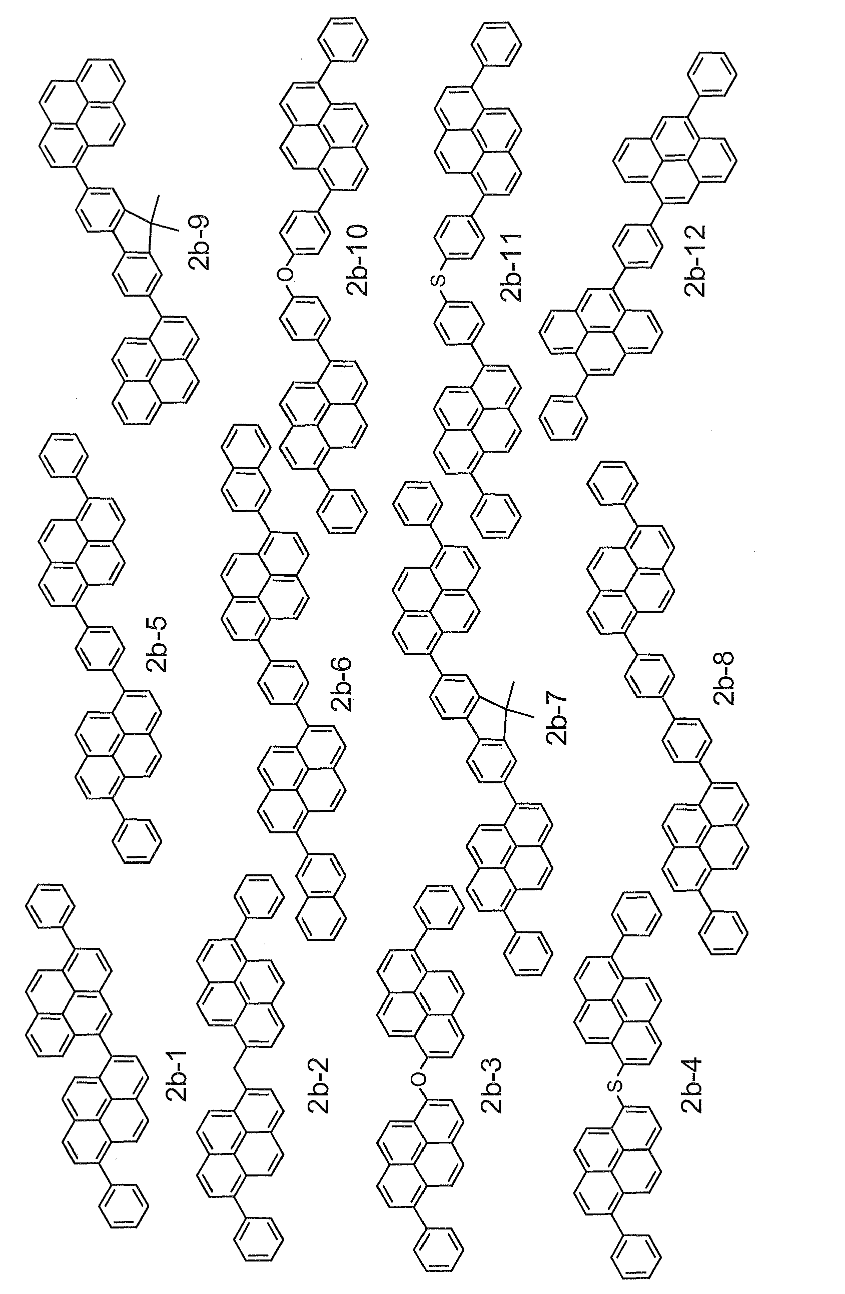

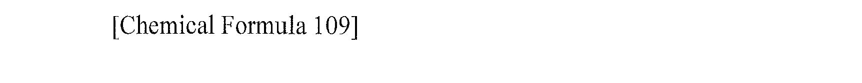

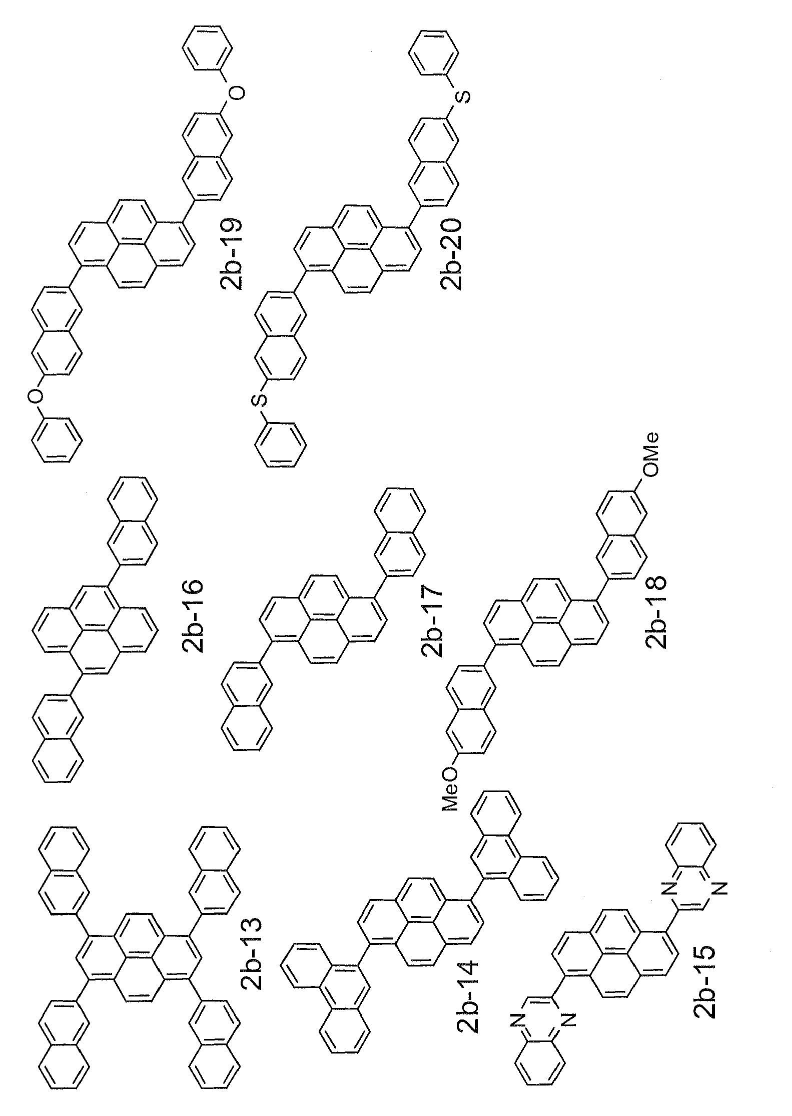

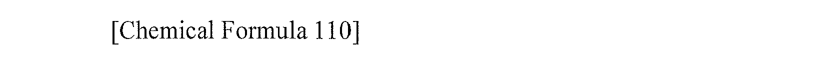

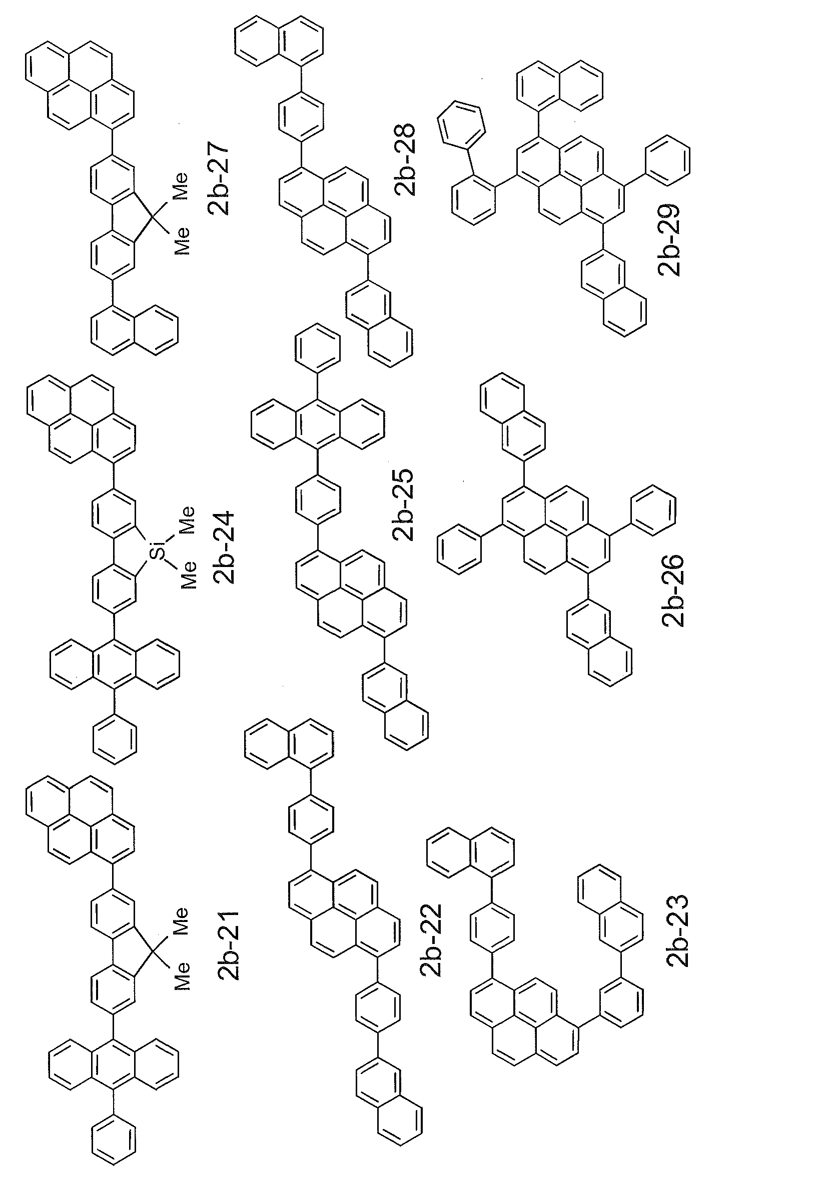

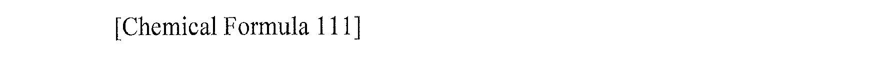

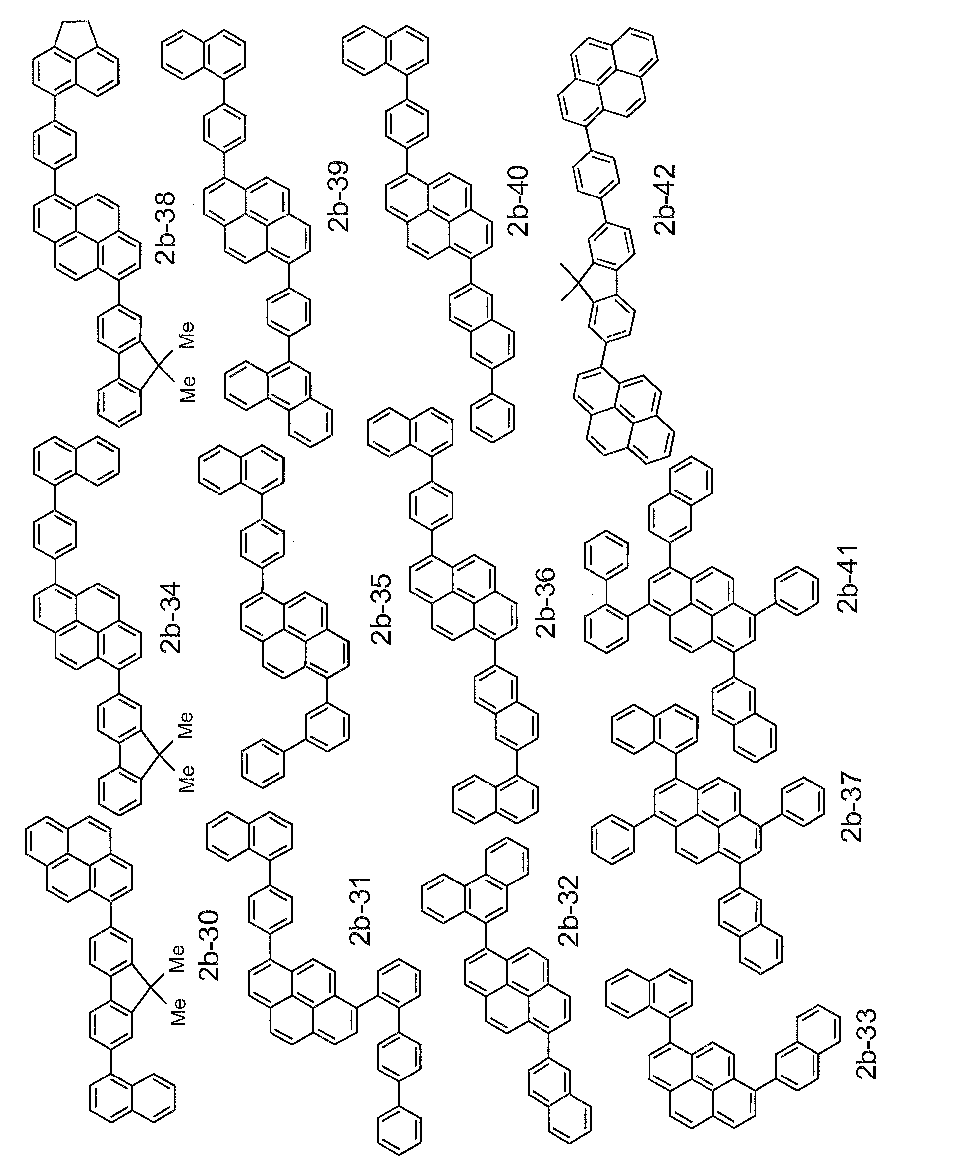

In the organic EL device according to the aspect of the invention, the fluorescent dopant is preferably an amine compound represented by the following formula (7).

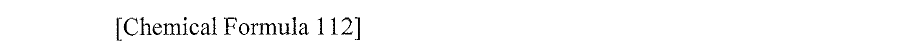

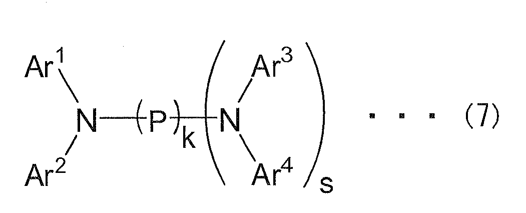

In the above formula (7), P represents a substituted or unsubstituted aromatic hydrocarbon group having 6 to 40 ring carbon atoms, a substituted or unsubstituted heterocyclic group having 3 to 40 ring atoms, or a substituted or unsubstituted styryl group. k is an integer of 1 to 3.
Ar¹ to Ar⁴ each independently represent a substituted or unsubstituted aromatic hydrocarbon group having 6 to 40 ring carbon atoms or a substituted or unsubstituted heterocyclic group having 3 to 40 ring atoms. s is an integer of 0 to 4.
An adjacent set of substituents for suitably-selected two of Ar¹, Ar² and P may be bonded together to form a ring. When k is 2 or more, P may be the same or different.

With such a structure, the organic EL device has excellent heat resistance and long lifetime, and blue fluorescent emission is obtainable at high luminous efficiency.
Incidentally, the fluorescent dopant is sometimes called fluorescent-emitting dopant.

Examples of the aromatic hydrocarbon group and the heterocyclic group represented by P are respectively a substituted or unsubstituted aromatic hydrocarbon group having 6 to 50 ring carbon atoms and a substituted or unsubstituted heterocyclic group having 6 to 50 carbon atoms, such as residues of benzene, biphenyl, terphenyl, naphthalene, phenanthrene, fluoranthene, anthracene, pyrene, perylene, coronene, chrysene, picene, dinaphthyl, trinaphthyl, phenylanthracene, diphenylanthracene, florene, triphenylene, rubicene, benzanthracene, dibenzanthracene, acenaphthofluoranthene, tribenzopentaphene, fluoranthenofluoranthene, benzodifluoranthene, benzofluoranthene and diindenoperylene. In particular, residues of naphthalene, phenanthrene, fluoranthene, anthracene, pyrene, perylene, chrysene, phenylanthracene and diphenylanthracene, and residues of combination of two or more thereof are preferable.

In the formula (7), Ar¹ to Ar⁴ each independently represents a substituted or unsubstituted aromatic hydrocarbon group having 6 to 40 ring carbon atoms or a substituted or unsubstituted heterocyclic group having 6 to 40 ring atoms. s is an integer of 0 to 4.
Examples of the aromatic hydrocarbon group represented by Ar¹ to Ar⁴ are a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, and 4"-t-butyl-p-terphenyl-4-yl group.

Examples of the heterocyclic group represented by Ar¹ to Ar⁴ are a 1-pyroryl group, 2-pyroryl group, 3-pyroryl group, pyrazinyl group, 2-pyridiny group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthrydinyl group, 2-phenanthrydinyl group, 3-phenanthrydinyl group, 4-phenanthrydinyl group, 6-phenanthrydinyl group, 7-phenanthrydinyl group, 8-phenanthrydinyl group, 9-phenanthrydinyl group, 10-phenanthrydinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrole-1-yl group, 2-methylpyrrole-3-yl group, 2-methylpyrrole-4-yl group, 2-methylpyrrole-5-yl group, 3-methylpyrrole-1-yl group, 3-methylpyrrole-2-yl group, 3-methylpyrrole-4-yl group, 3-methylpyrrole-5-yl group, 2-t-butylpyrrole-3-yl group, 3-(2-phenylpropyl)pyrrole-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group and the like.

As examples of the amine compound represented by the formula (7), fused aromatic amine, styryl amine, benzidine and the like are shown below, but the invention is not limited thereto. Me represents a methyl group.

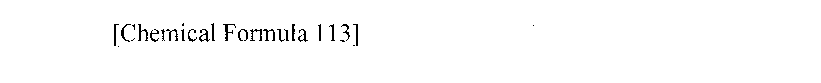

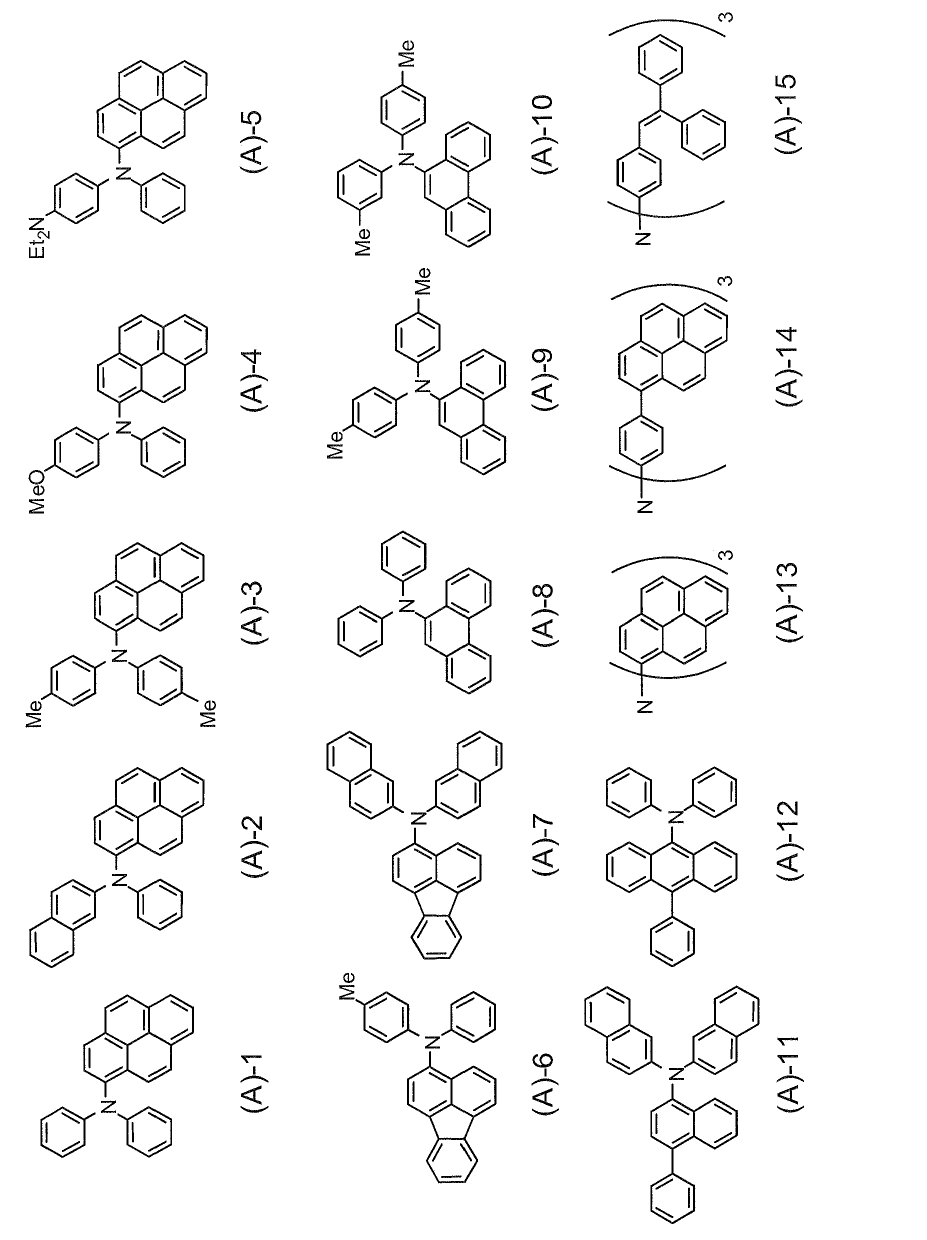

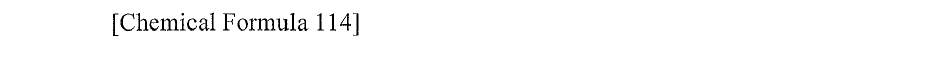

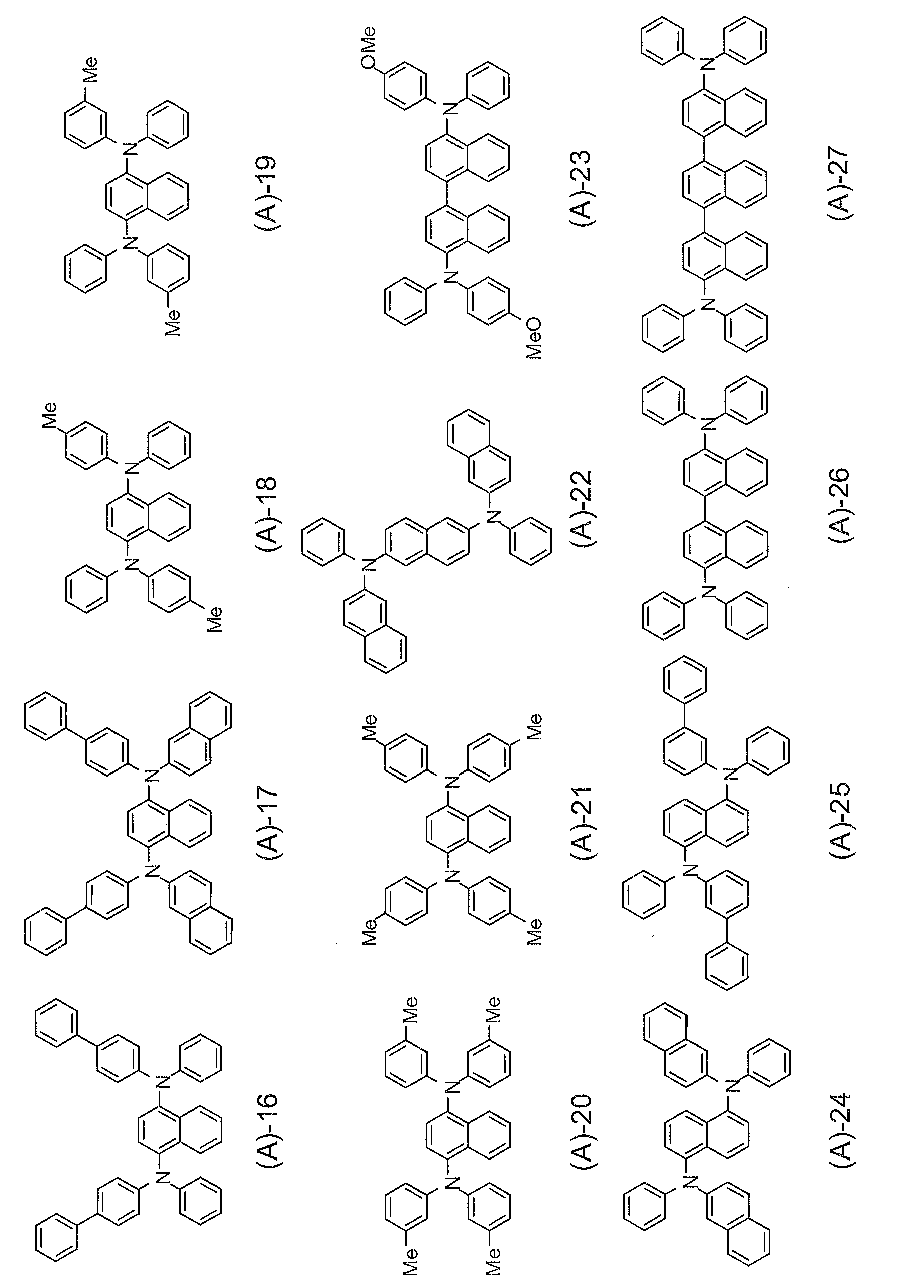

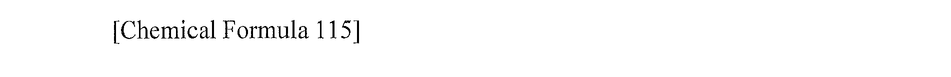

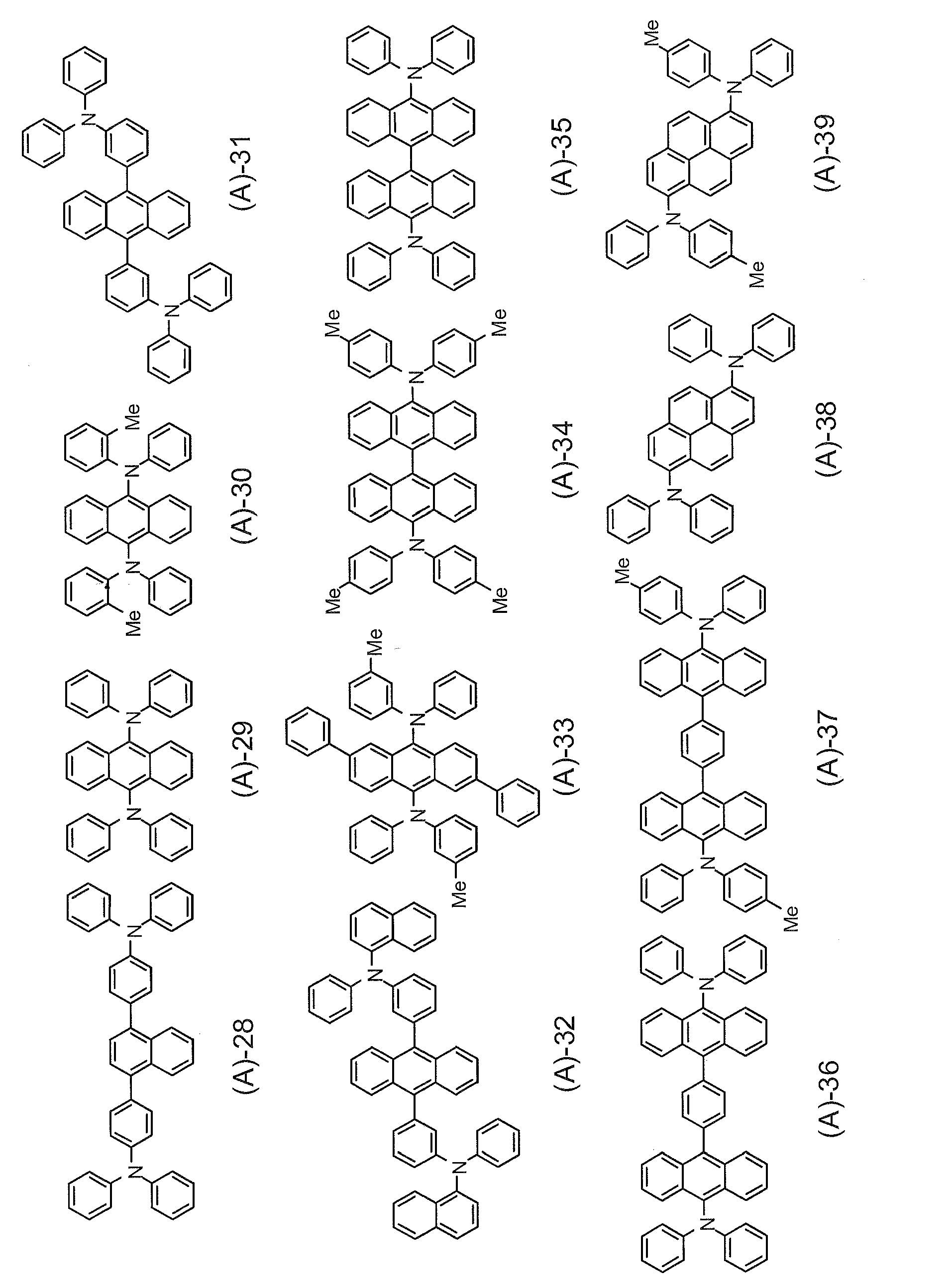

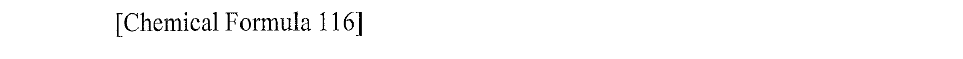

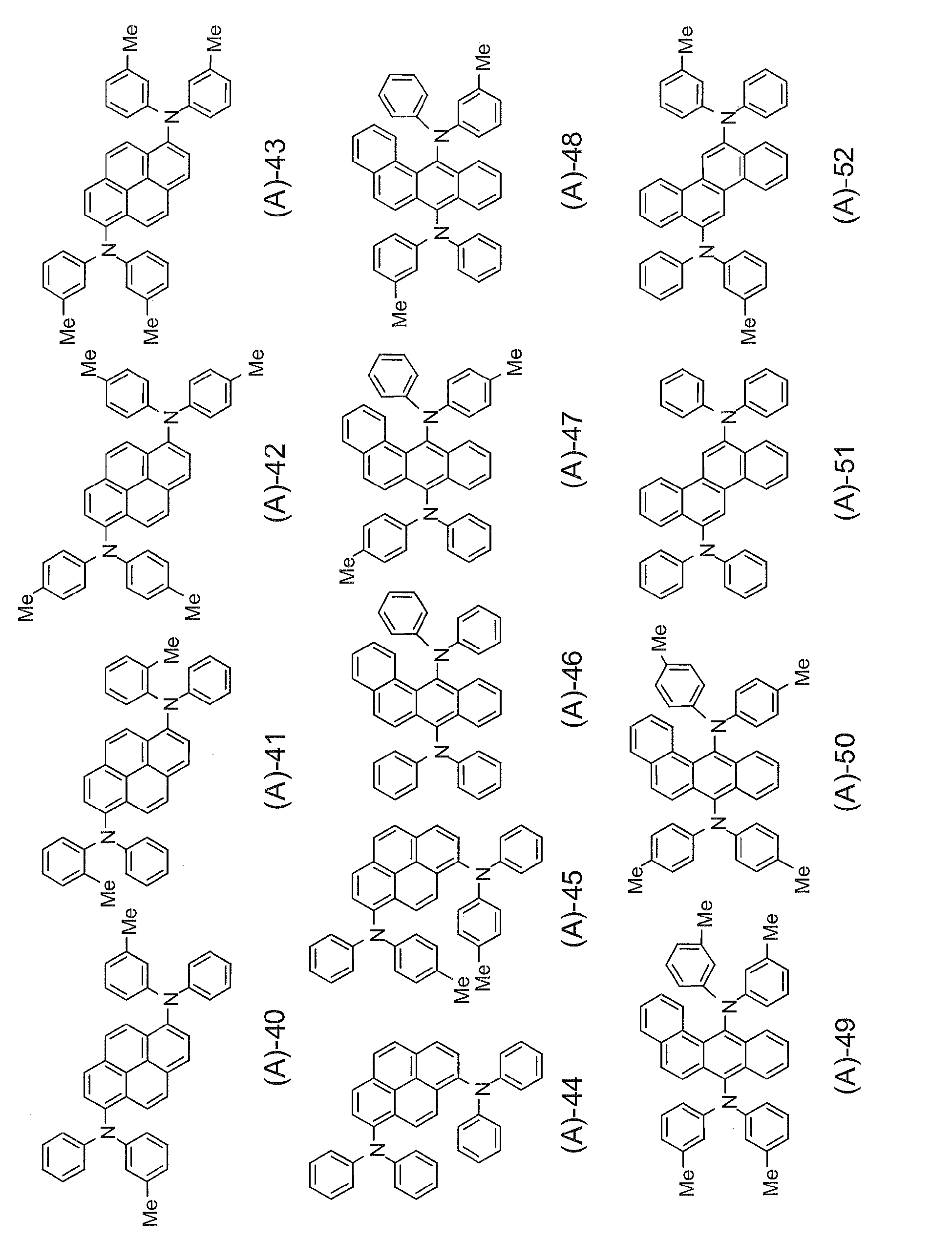

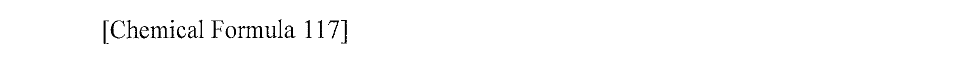

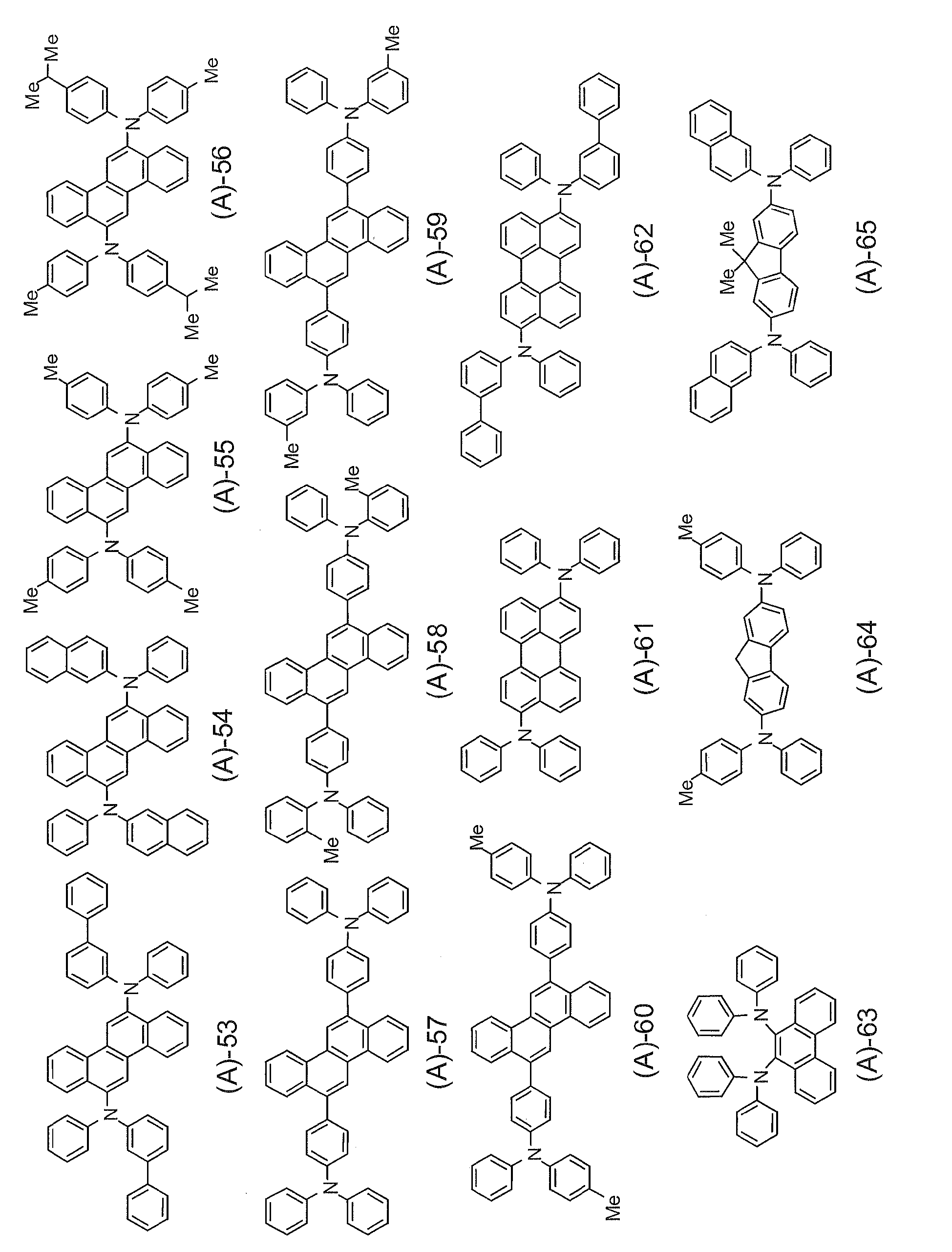

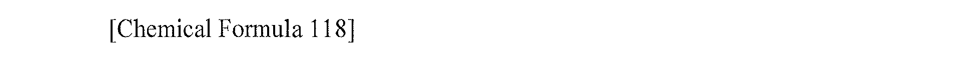

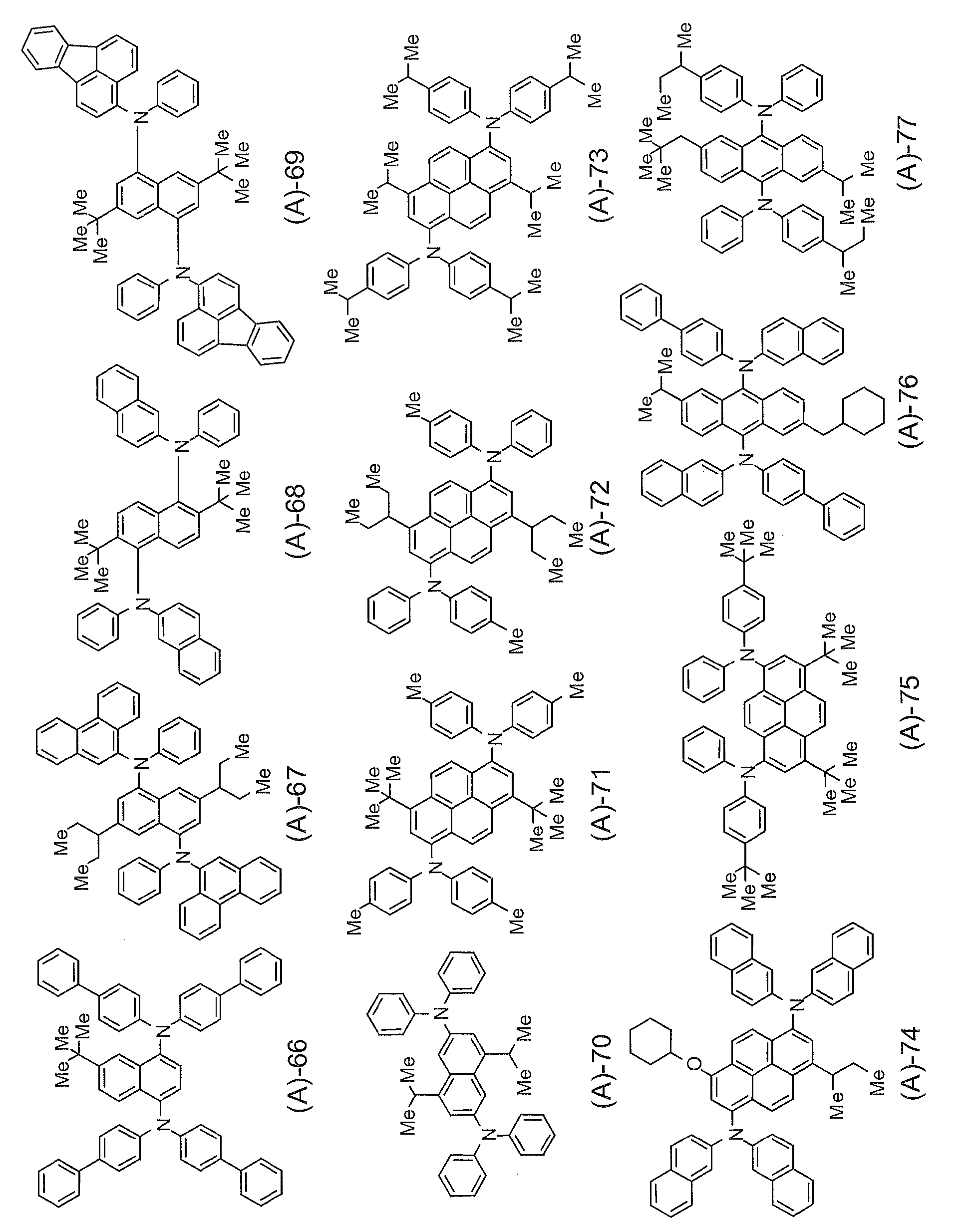

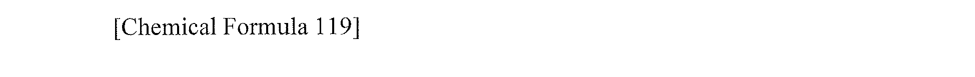

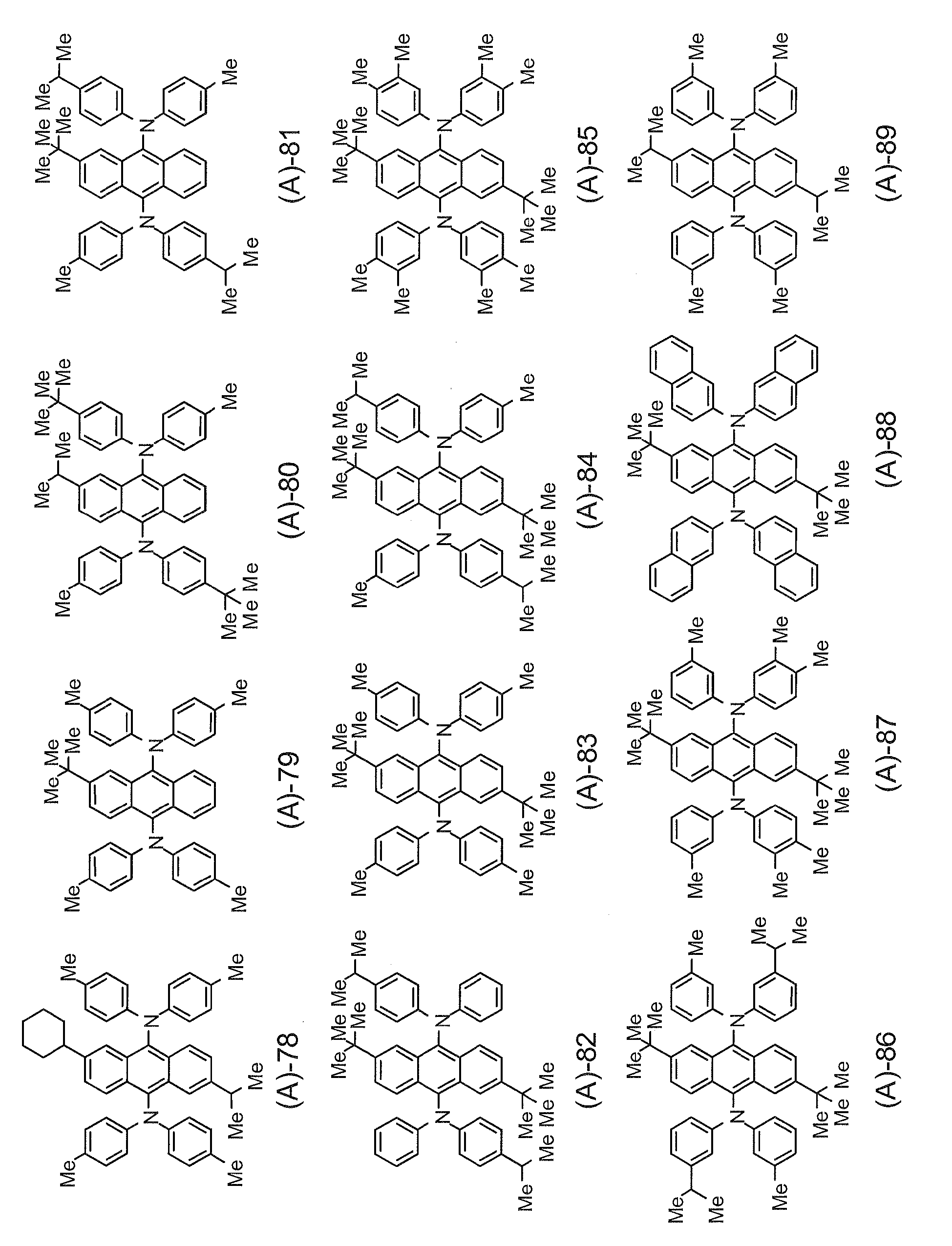

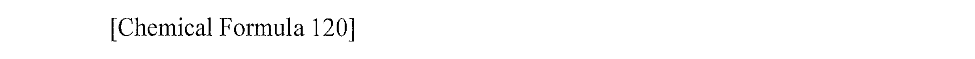

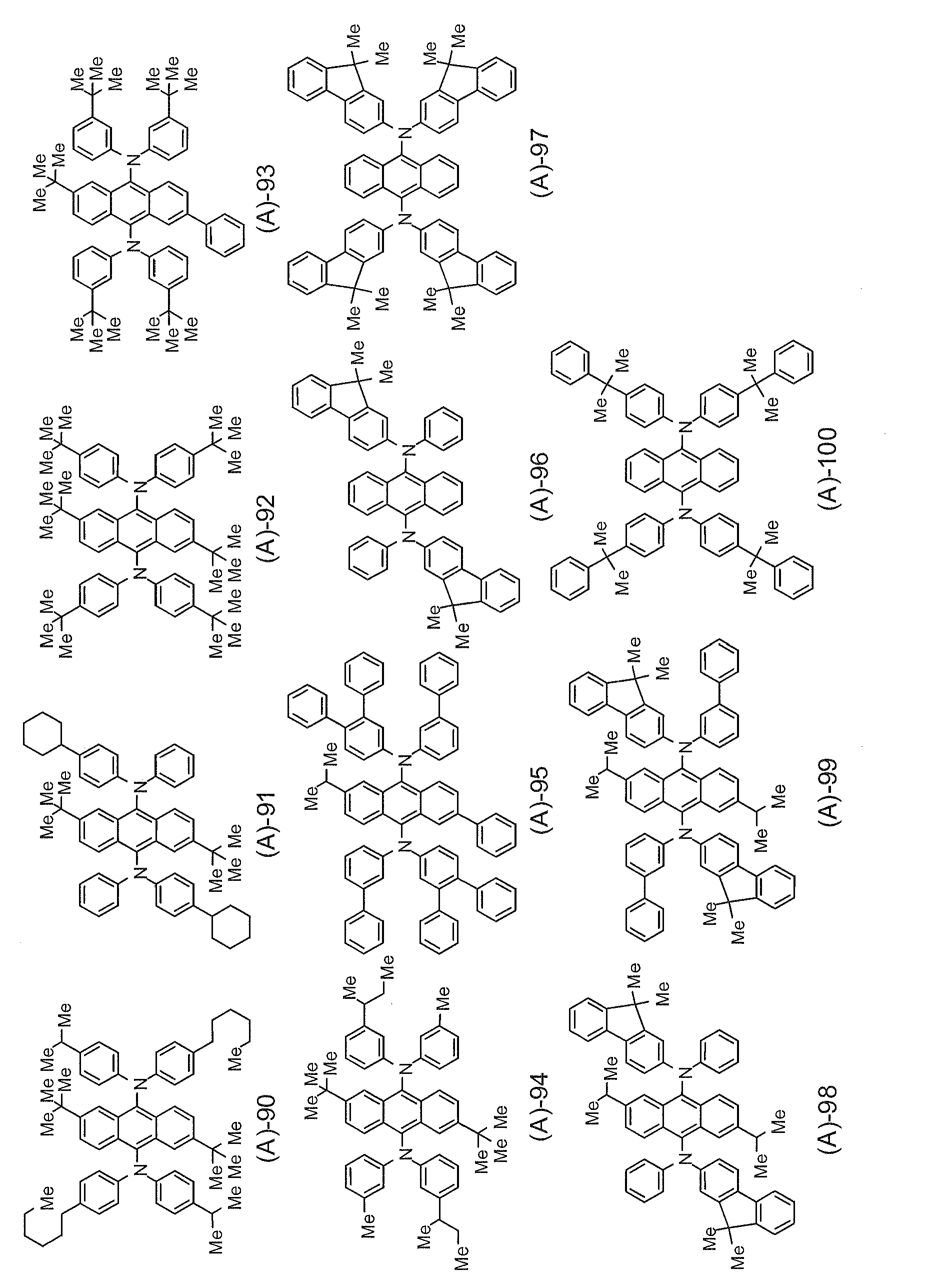

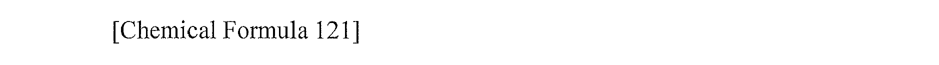

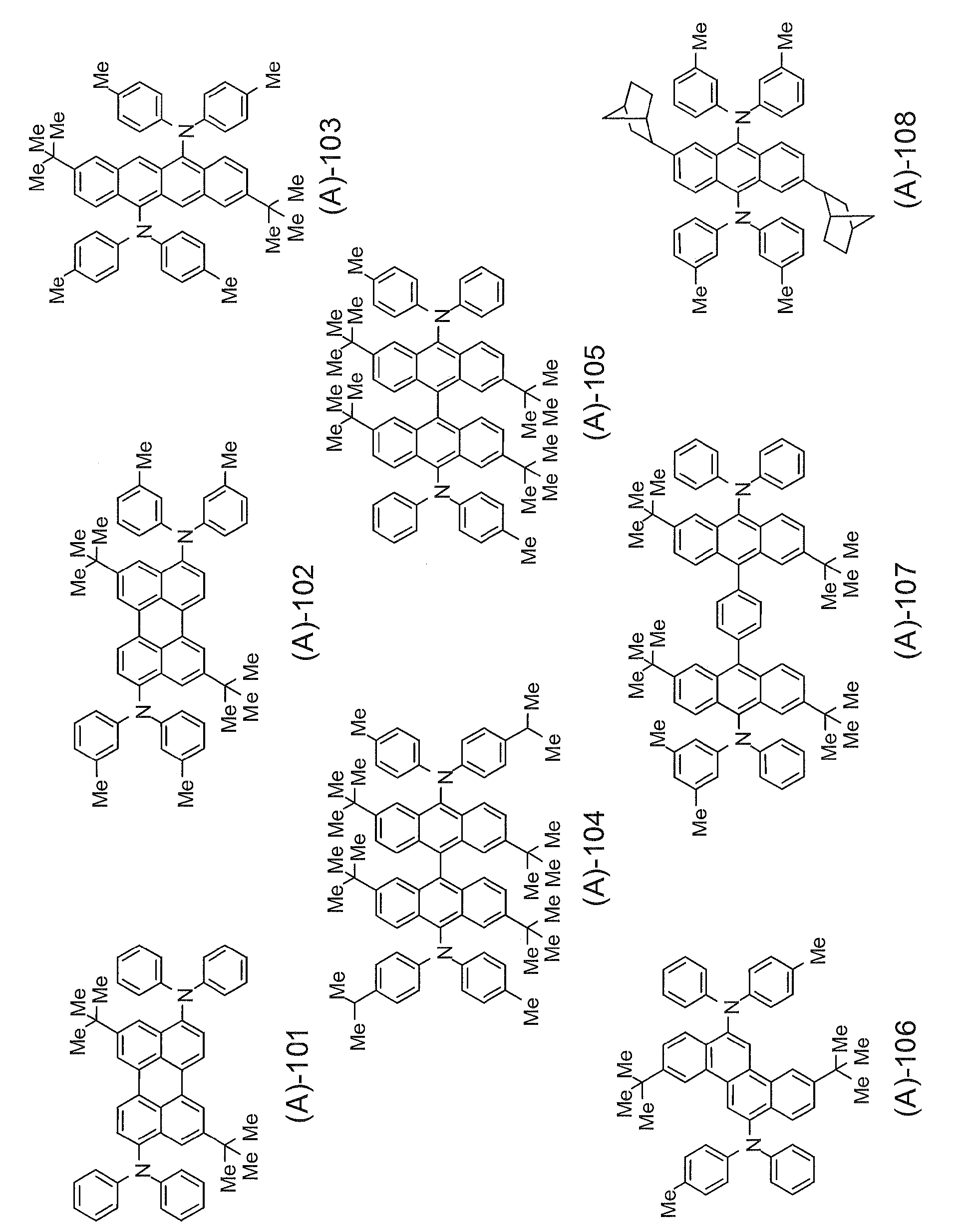

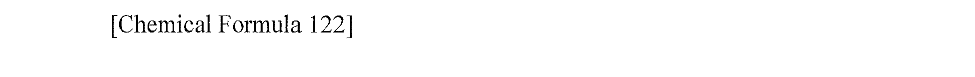

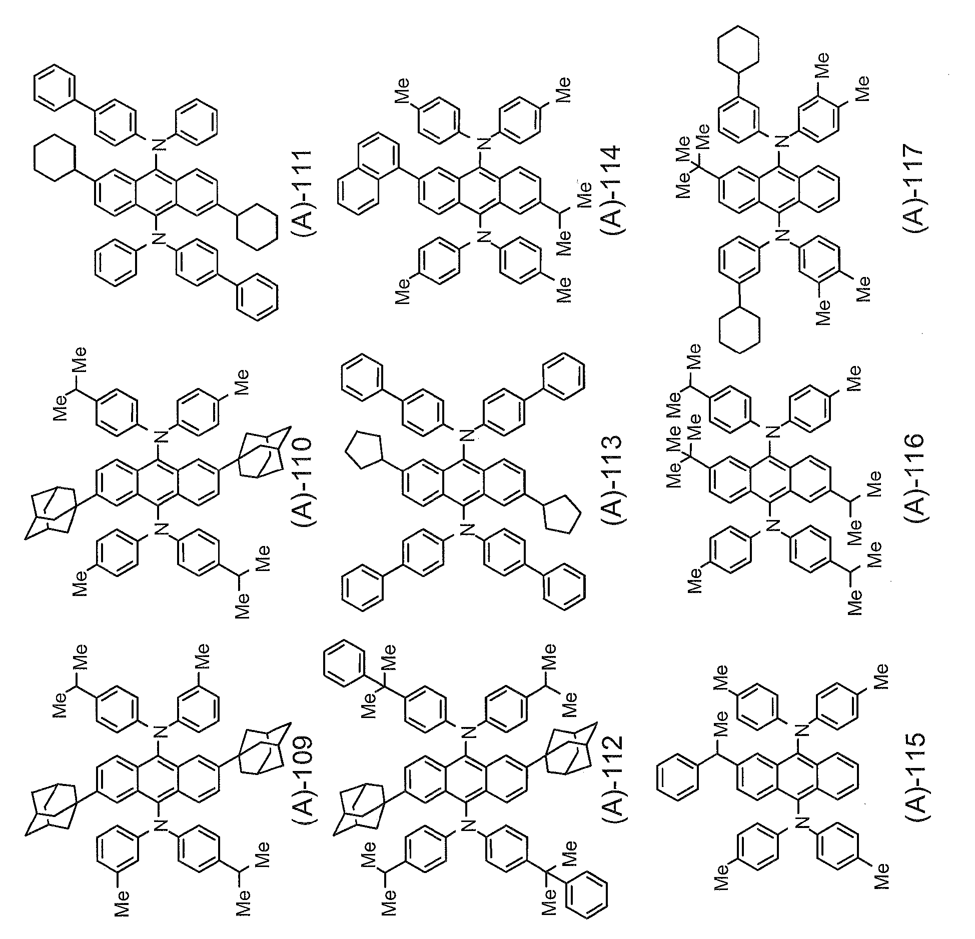

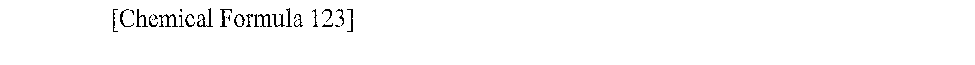

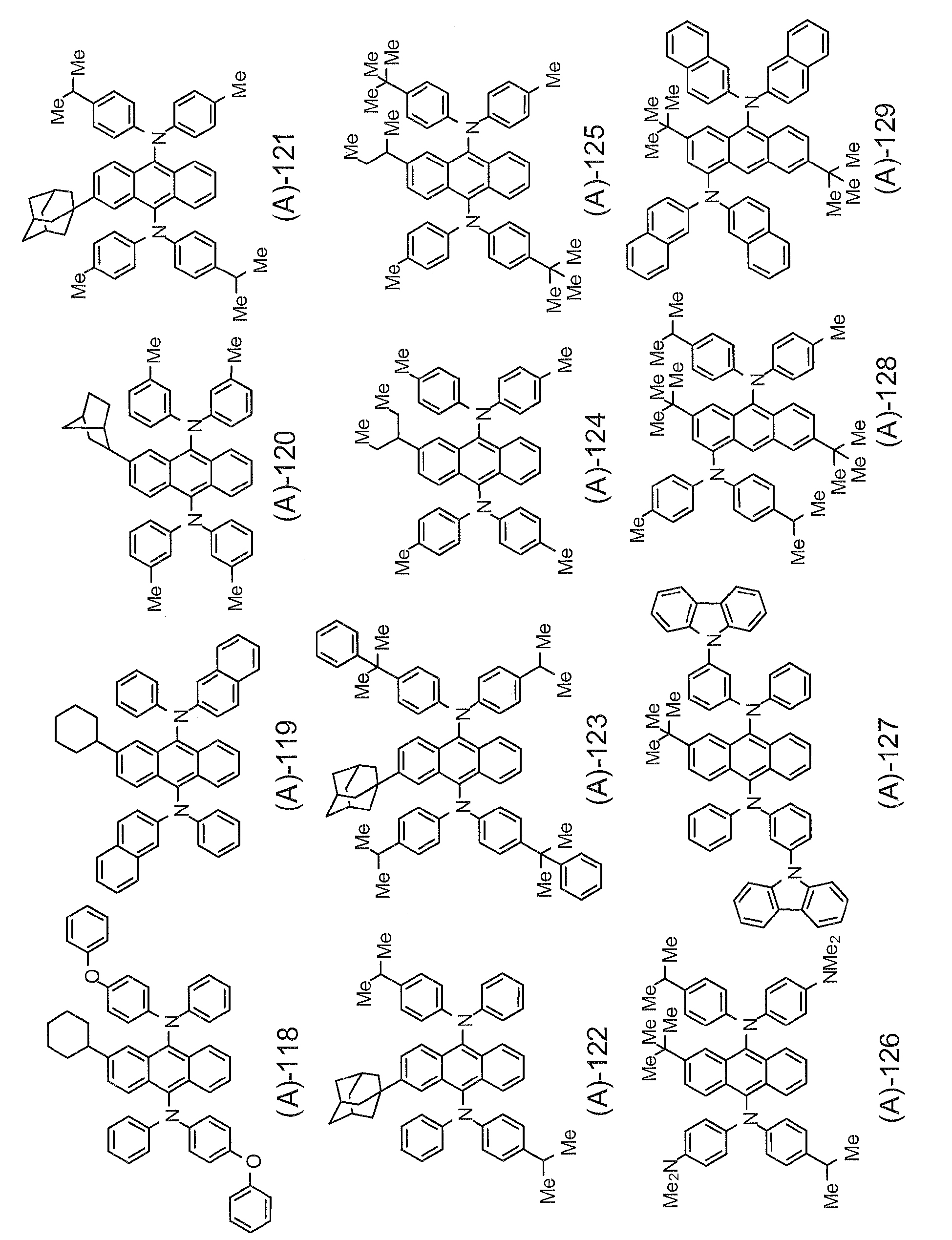

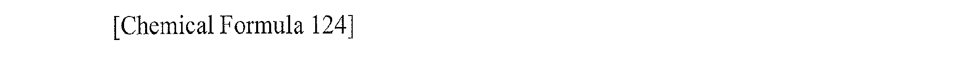

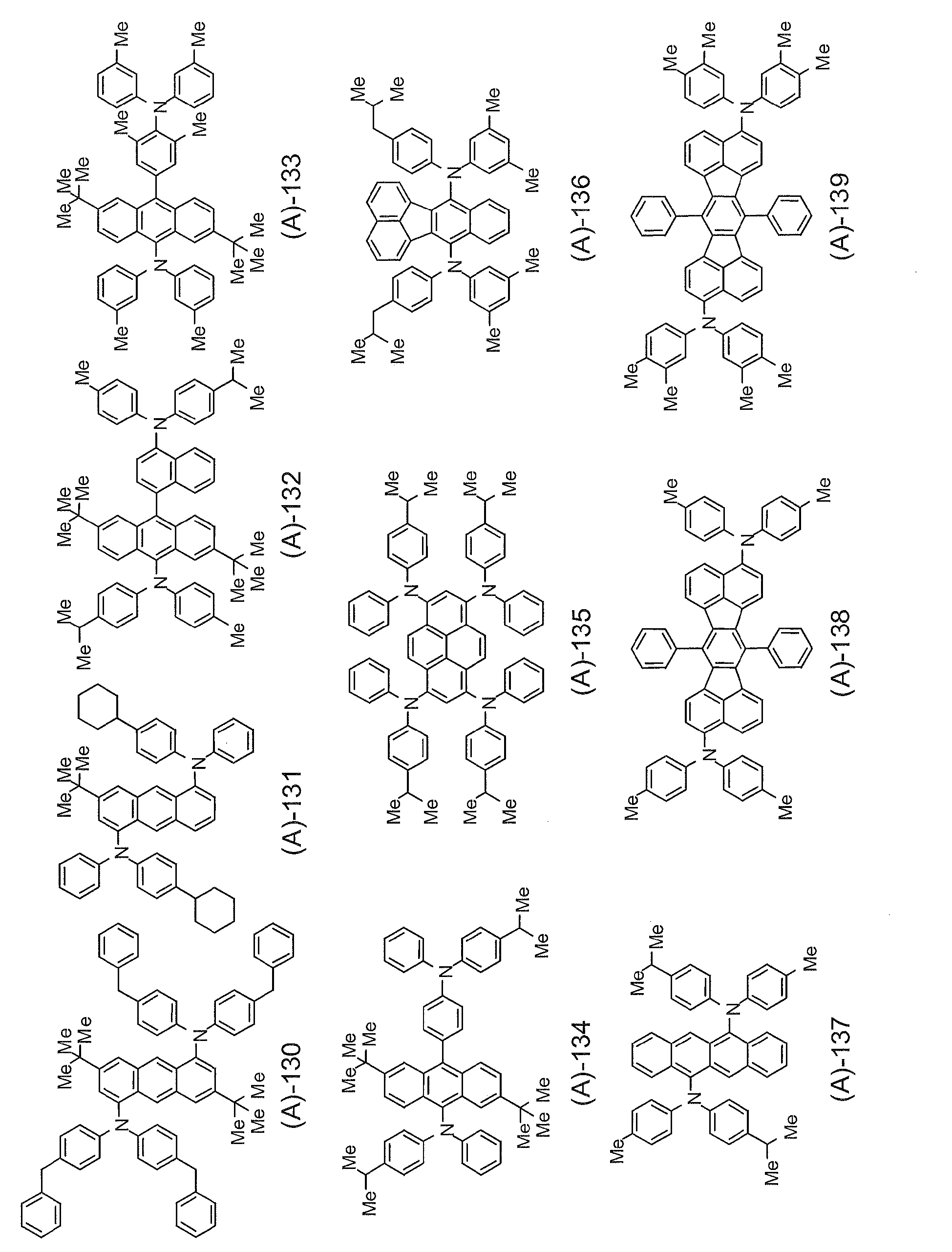

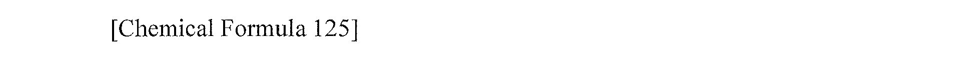

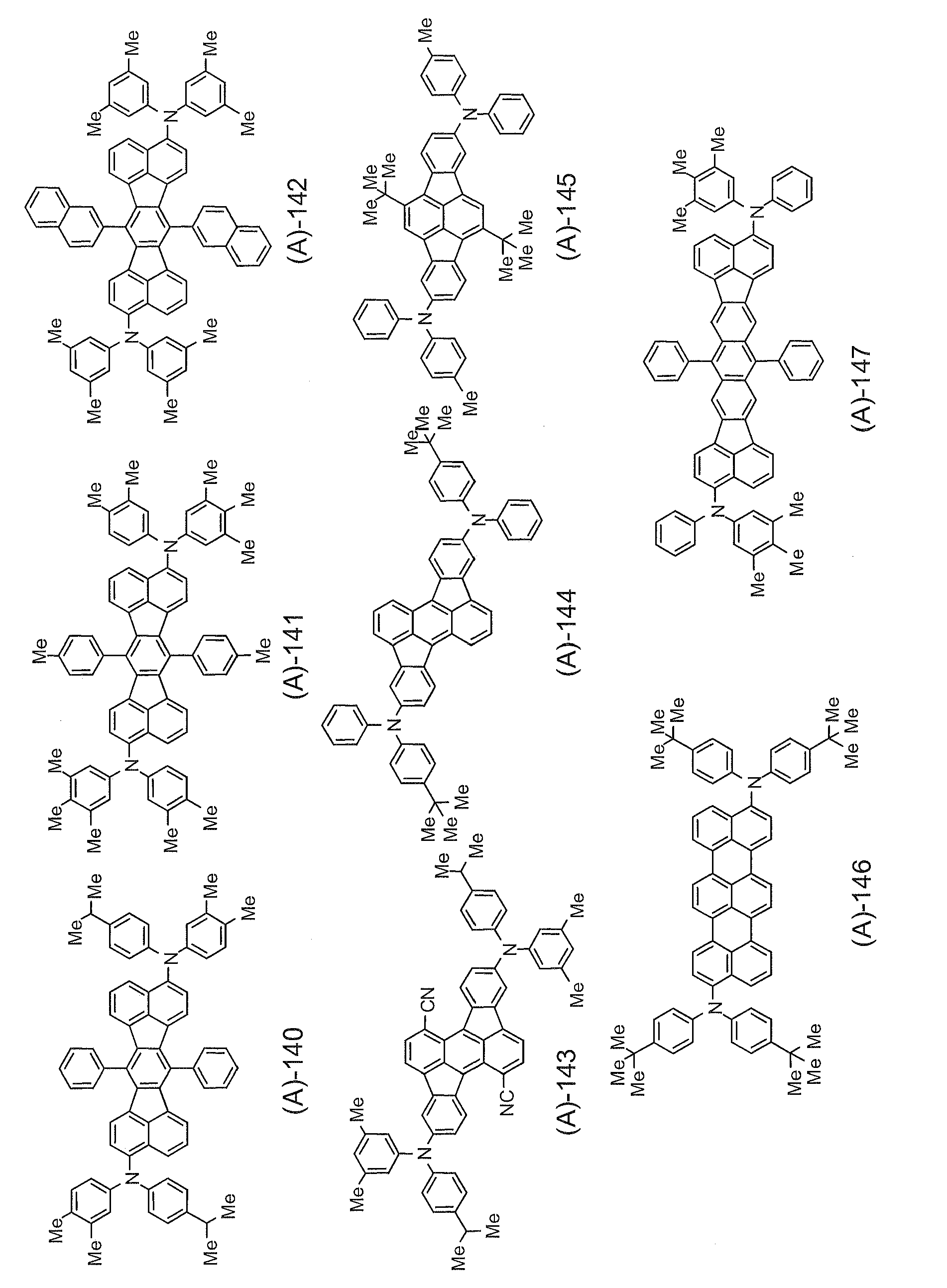

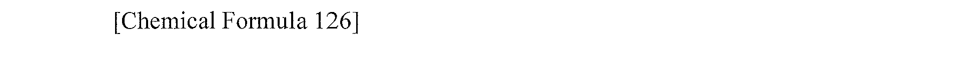

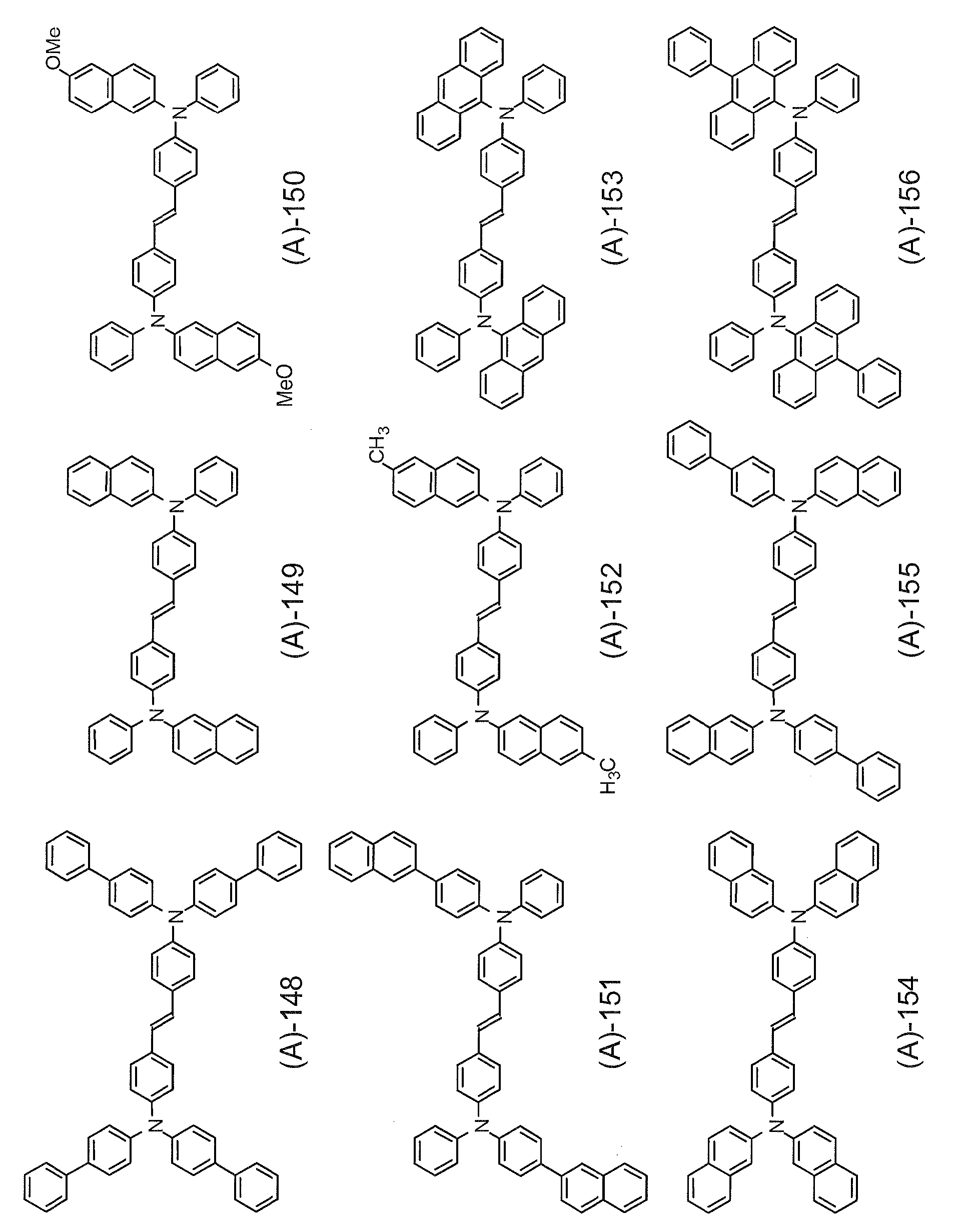

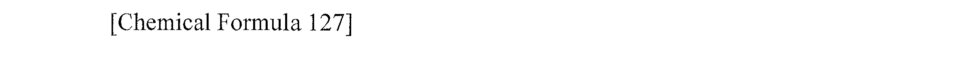

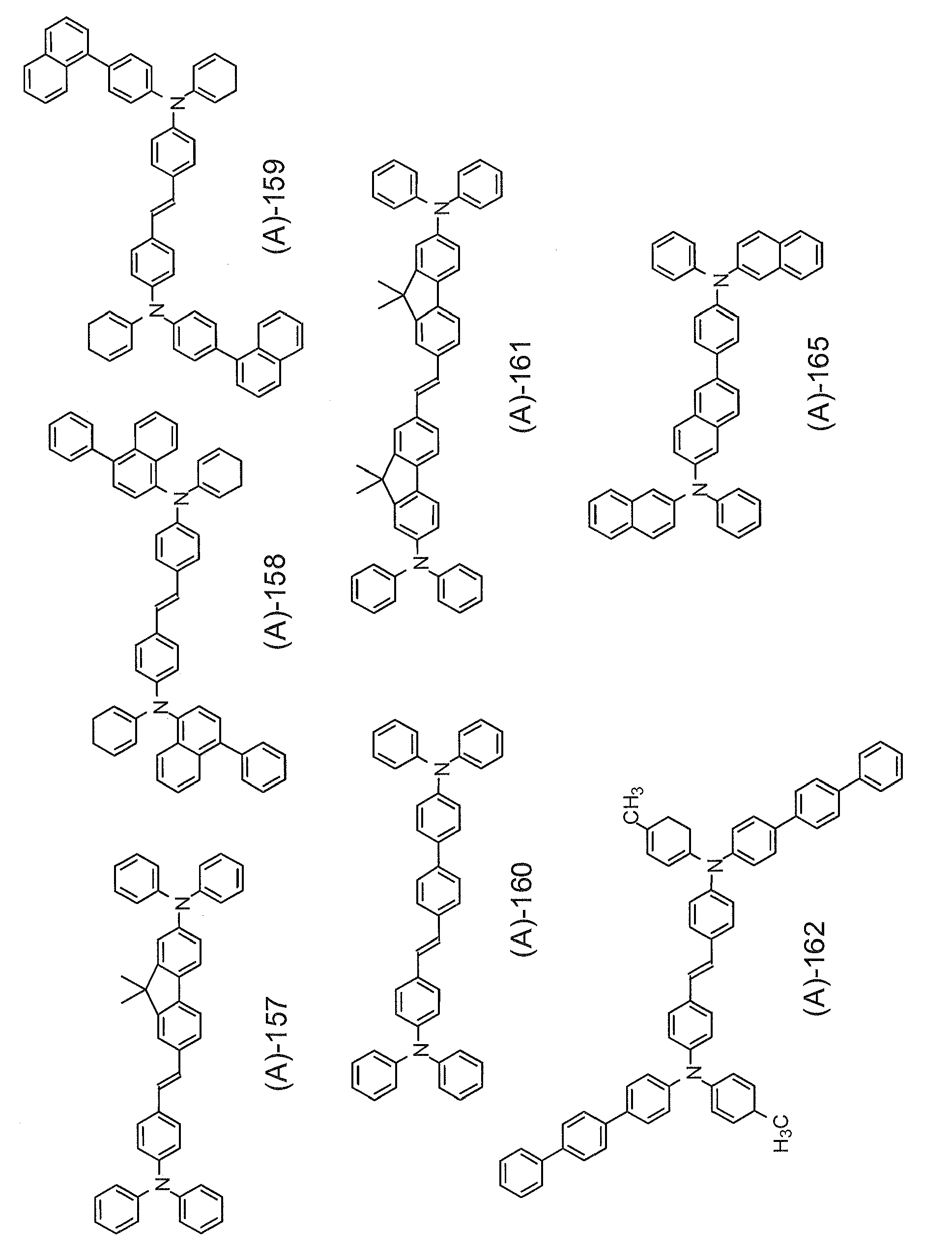

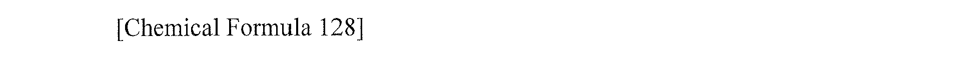

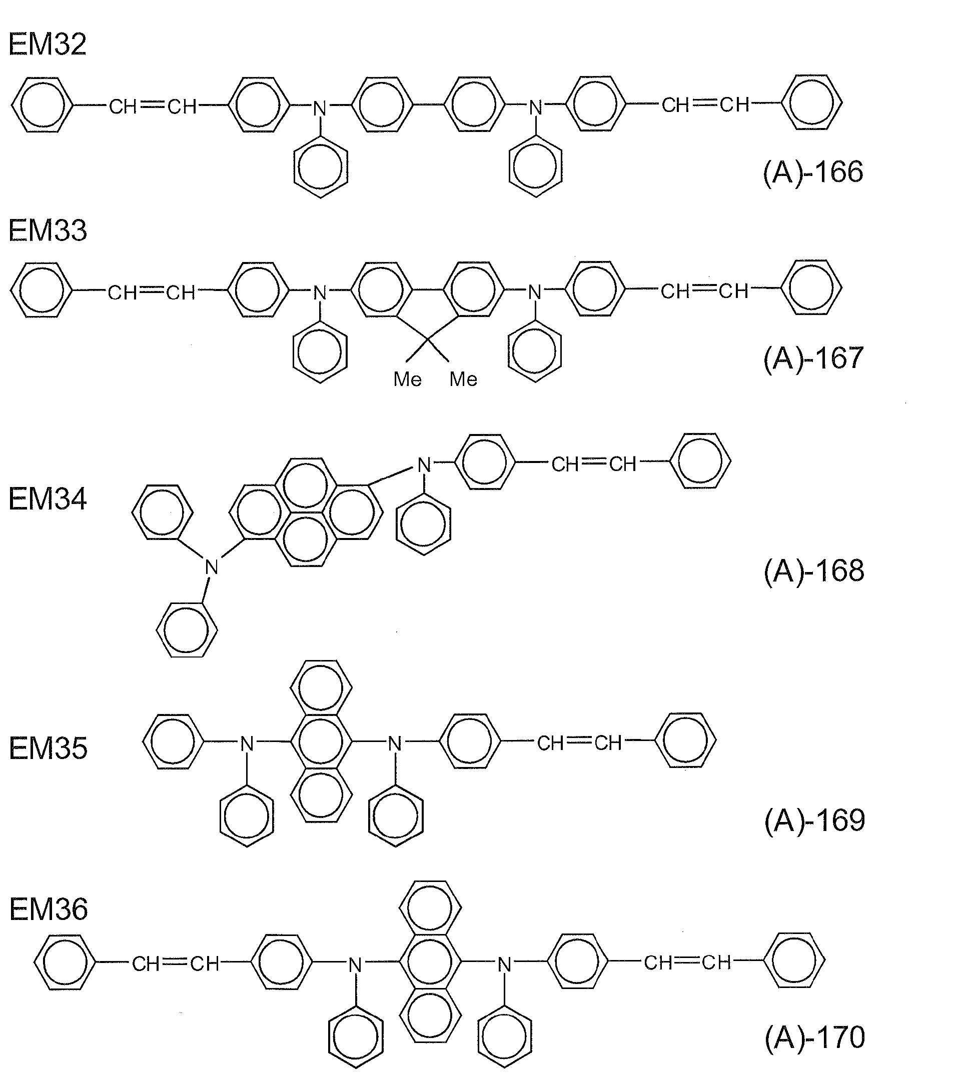

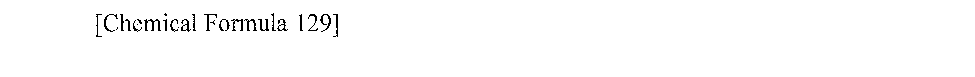

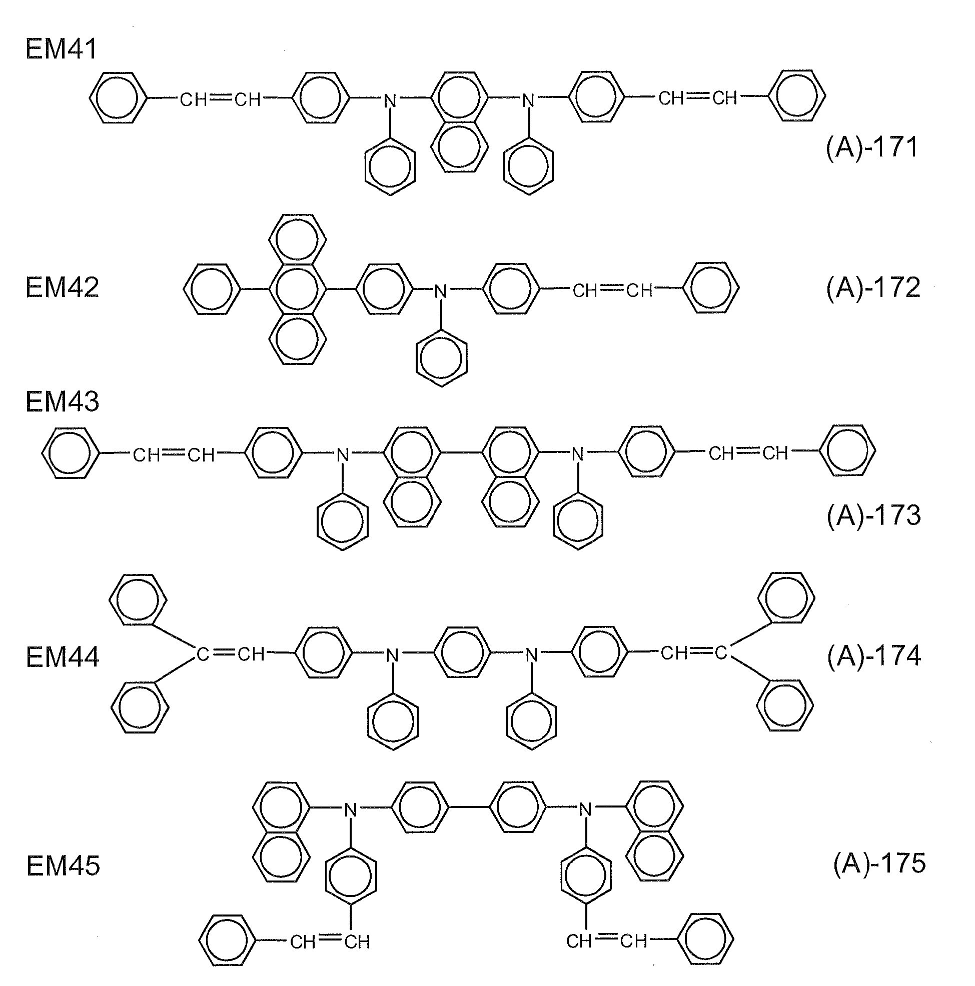

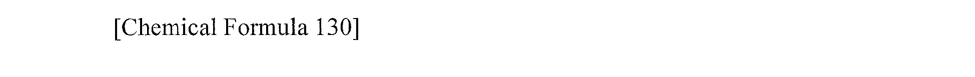

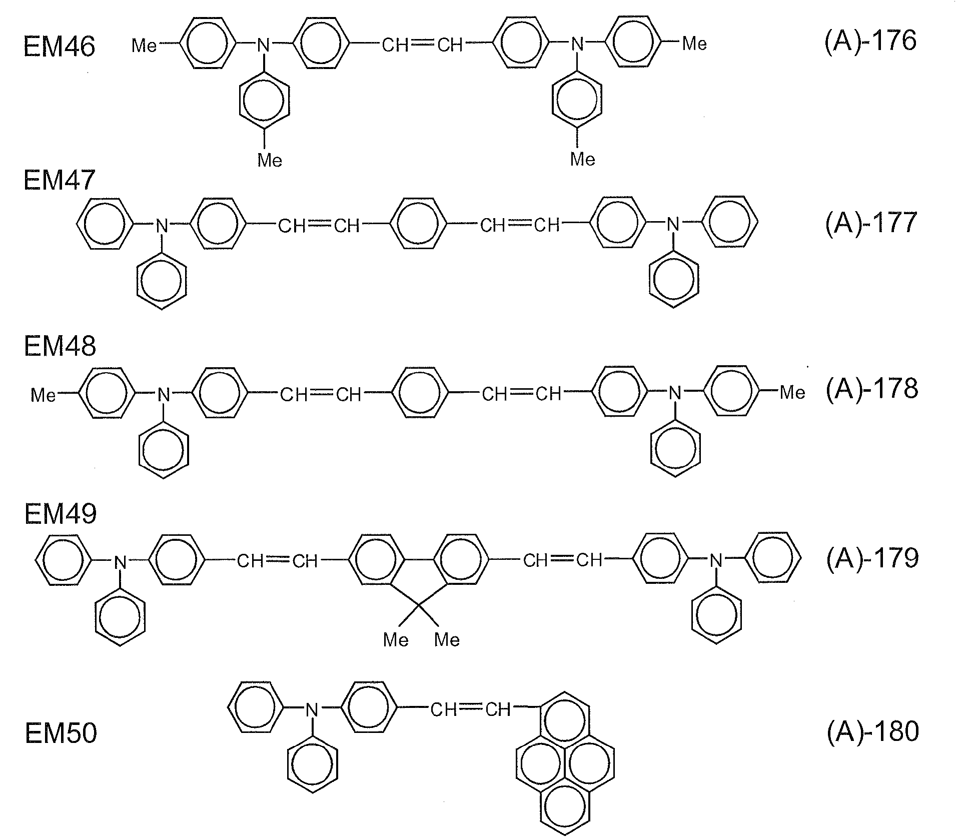

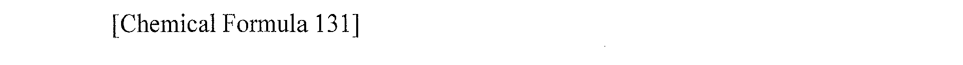

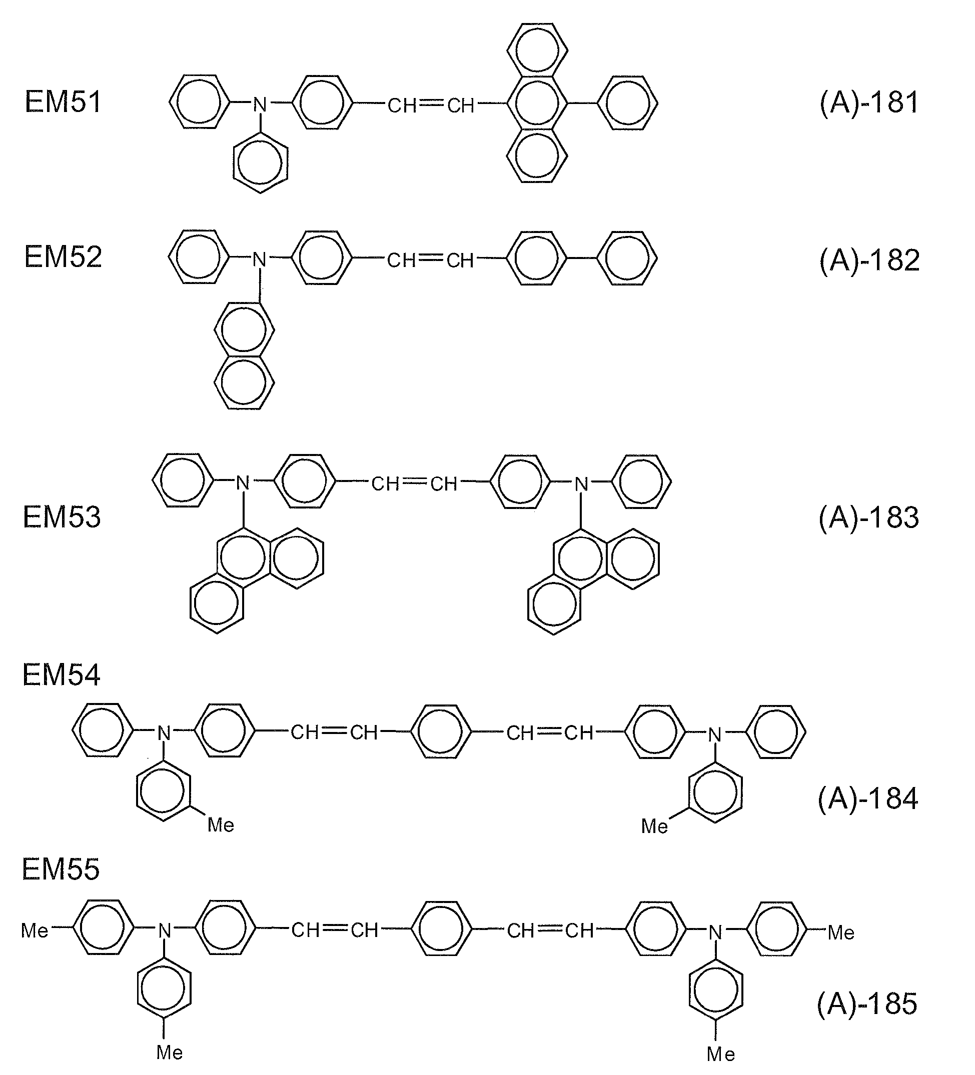

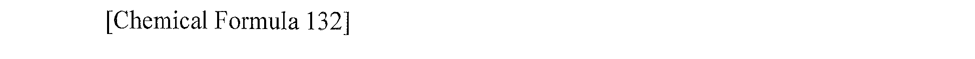

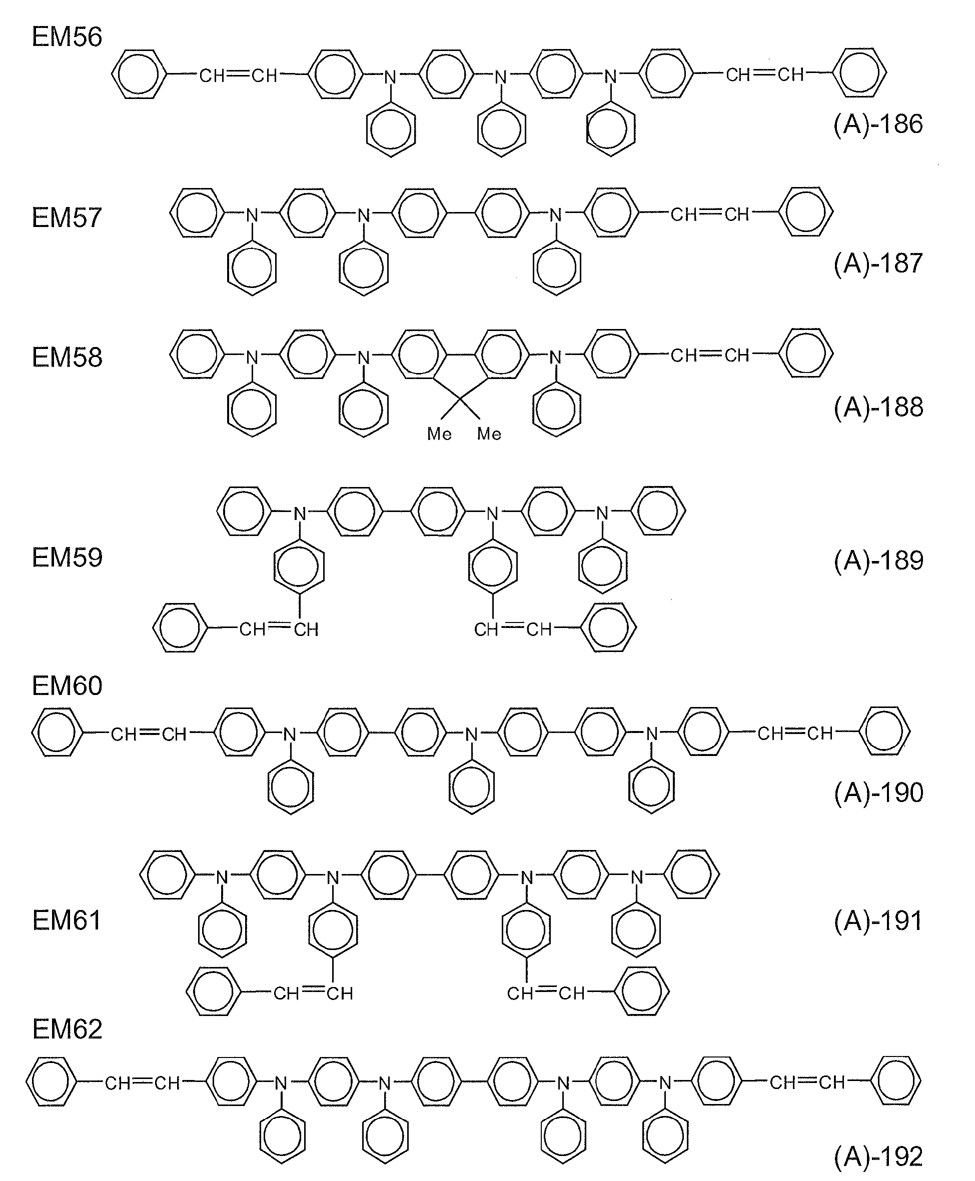

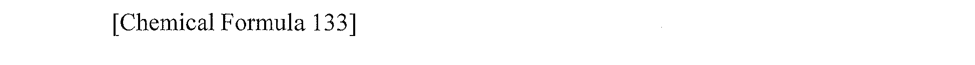

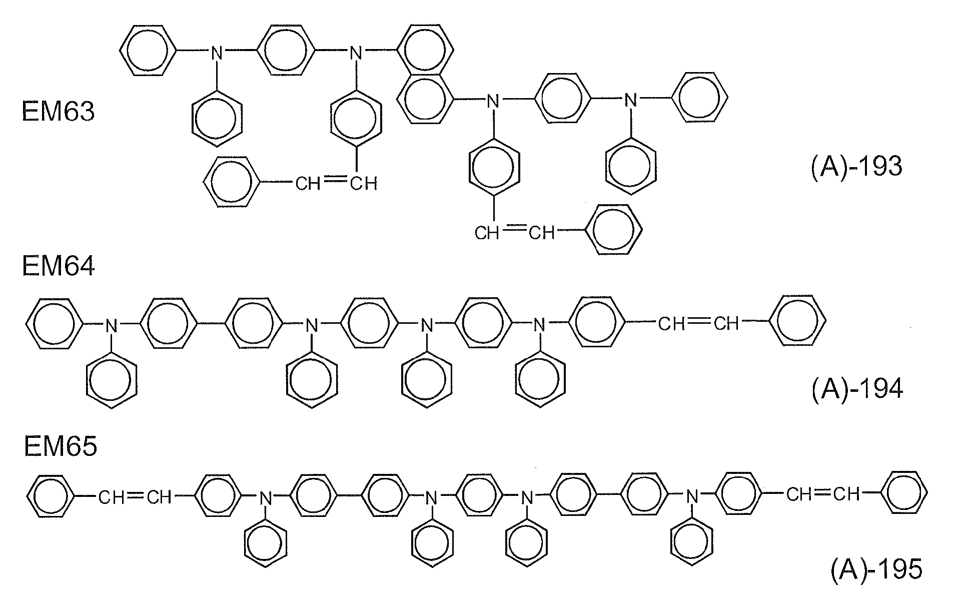

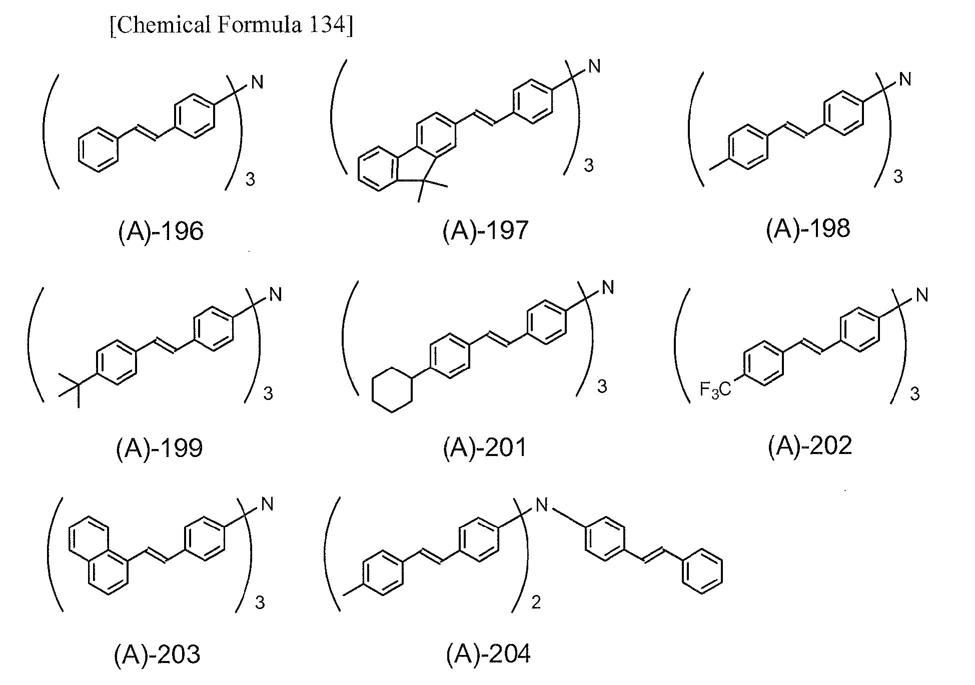

Compounds containing a carbazole group such as those shown below may be used.

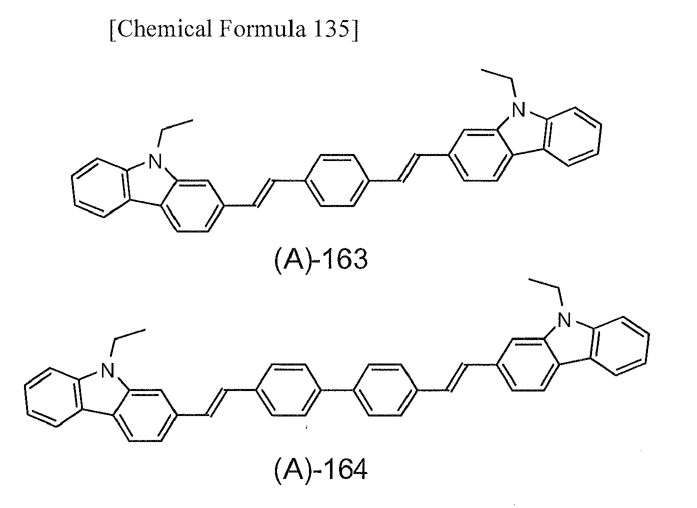

In the organic EL device according to the aspect of the invention, the fluorescent dopant is preferably a fluoranthene derivative represented by any one of the following formulae (8) to (11).

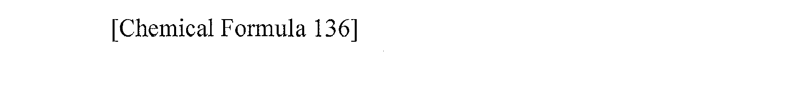

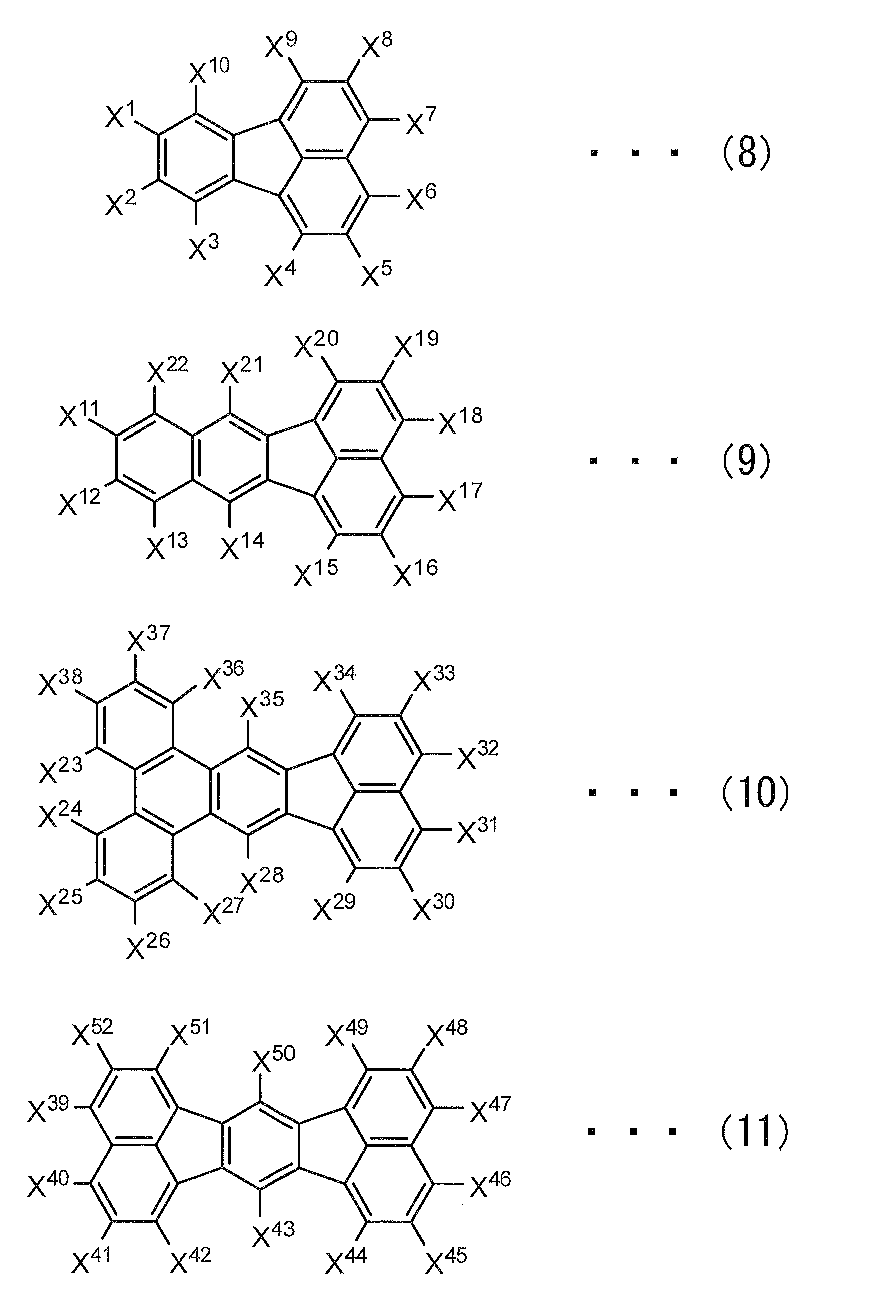

In the formulae (8) to (11), X¹ to X⁵² each independently represent a hydrogen atom, halogen atom, substituted or unsubstituted linear, branched or cyclic alkyl group having 1 to 30 carbon atoms, substituted or unsubstituted linear, branched or cyclic alkoxy group having 1 to 30 carbon atoms, substituted or unsubstituted linear, branched or cyclic alkylthio group having 1 to 30 carbon atoms, substituted or unsubstituted linear, branched or cyclic alkenyl group having 2 to 30 carbon atoms, substituted or unsubstituted linear, branched or cyclic alkenyloxy group having 2 to 30 carbon atoms, substituted or unsubstituted linear, branched or cyclic alkenylthio group having 2 to 30 carbon atoms, substituted or unsubstituted aralkyl group having 7 to 30 carbon atoms, substituted or unsubstituted aralkyloxy group having 7 to 30 carbon atoms, substituted or unsubstituted aralkylthio group having 7 to 30 carbon atoms, substituted or unsubstituted aryl group having 6 to 20 carbon atoms, substituted or unsubstituted aryloxy group having 6 to 20 carbon atoms, substituted or unsubstituted arylthio having 6 to 20 carbon atoms, substituted or unsubstituted amino group having 2 to 30 carbon atoms, cyano group, silyl group, hydroxyl group, -COOR^{1e} group (in which R^{1e} represents a hydrogen atom, substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms or substituted or unsubstituted aryl group having 6 to 30 carbon atoms), -COR^{2e} group (in which R^{2e} represents a hydrogen atom, substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms, substituted or unsubstituted aryl group having 6 to 30 carbon atoms or amino group), or -OCOR^{3e} group (in which R^{3e} represents a substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms, or substituted or unsubstituted aryl group having 6 to 30 carbon atoms). Further, adjacent groups and adjacent substituents of X¹ to X⁵² may be bonded together to form a substituted or unsubstituted carbocycle.

Examples of the fluoranthene derivative are those represented by the following formulae.

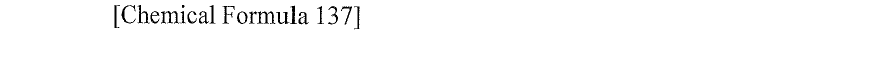

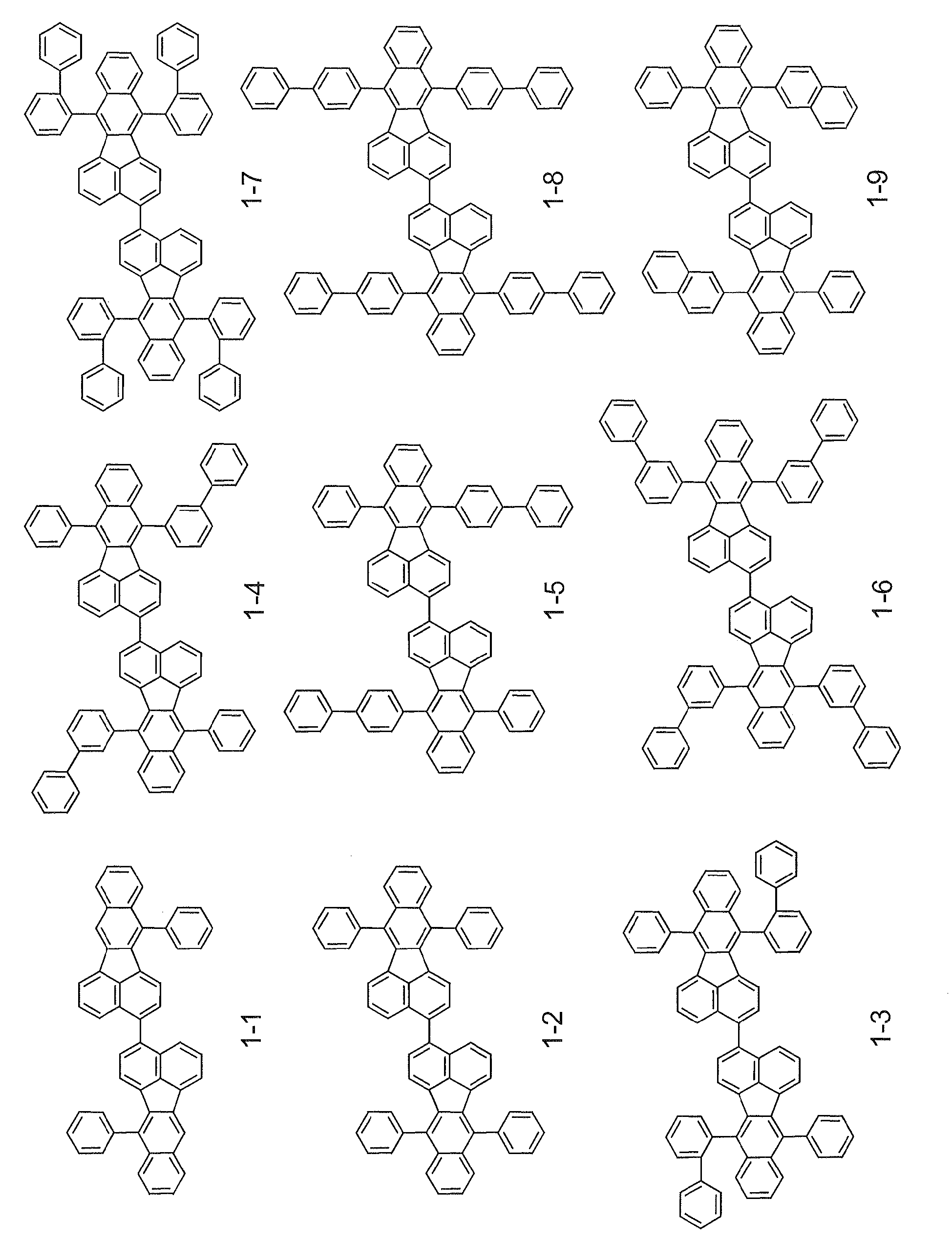

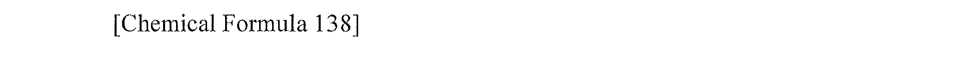

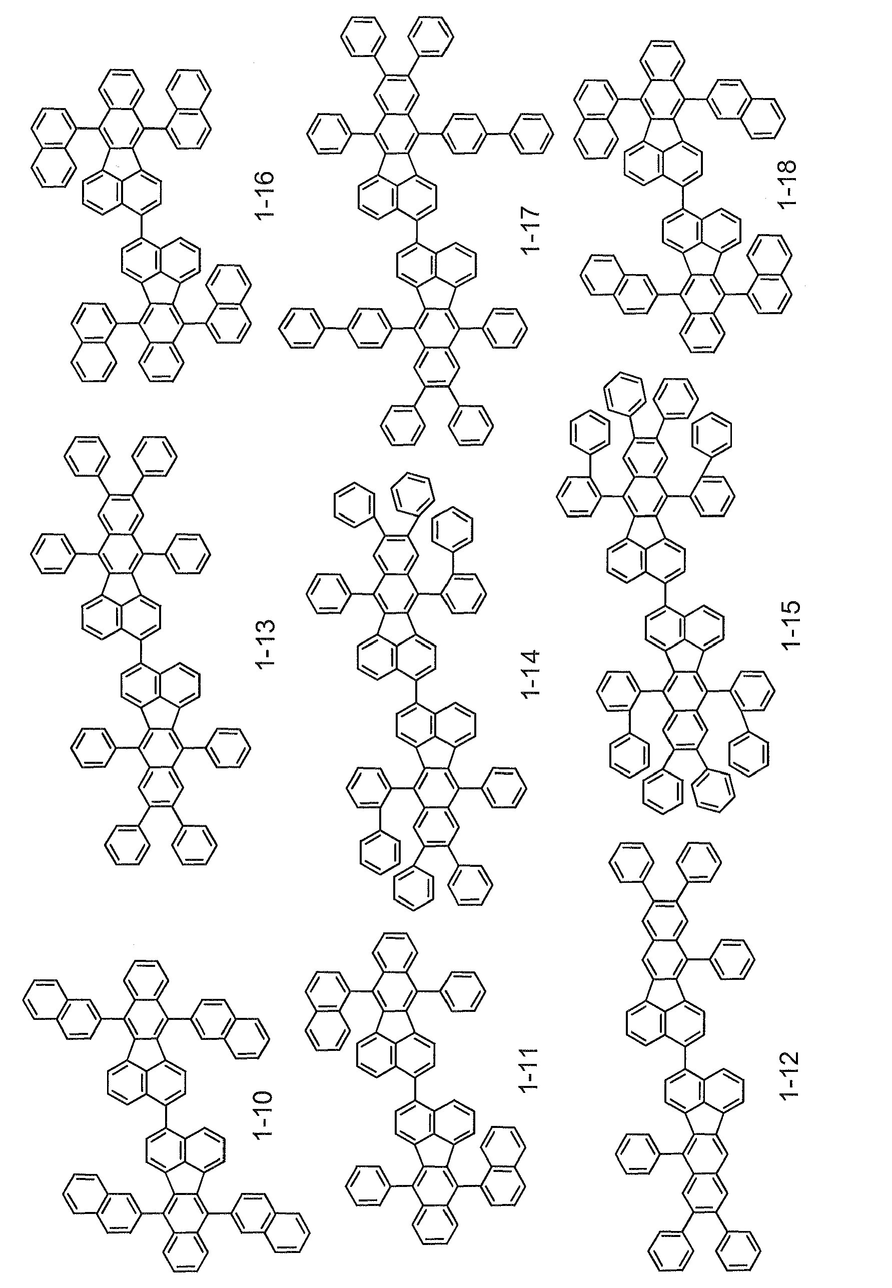

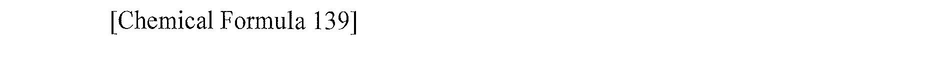

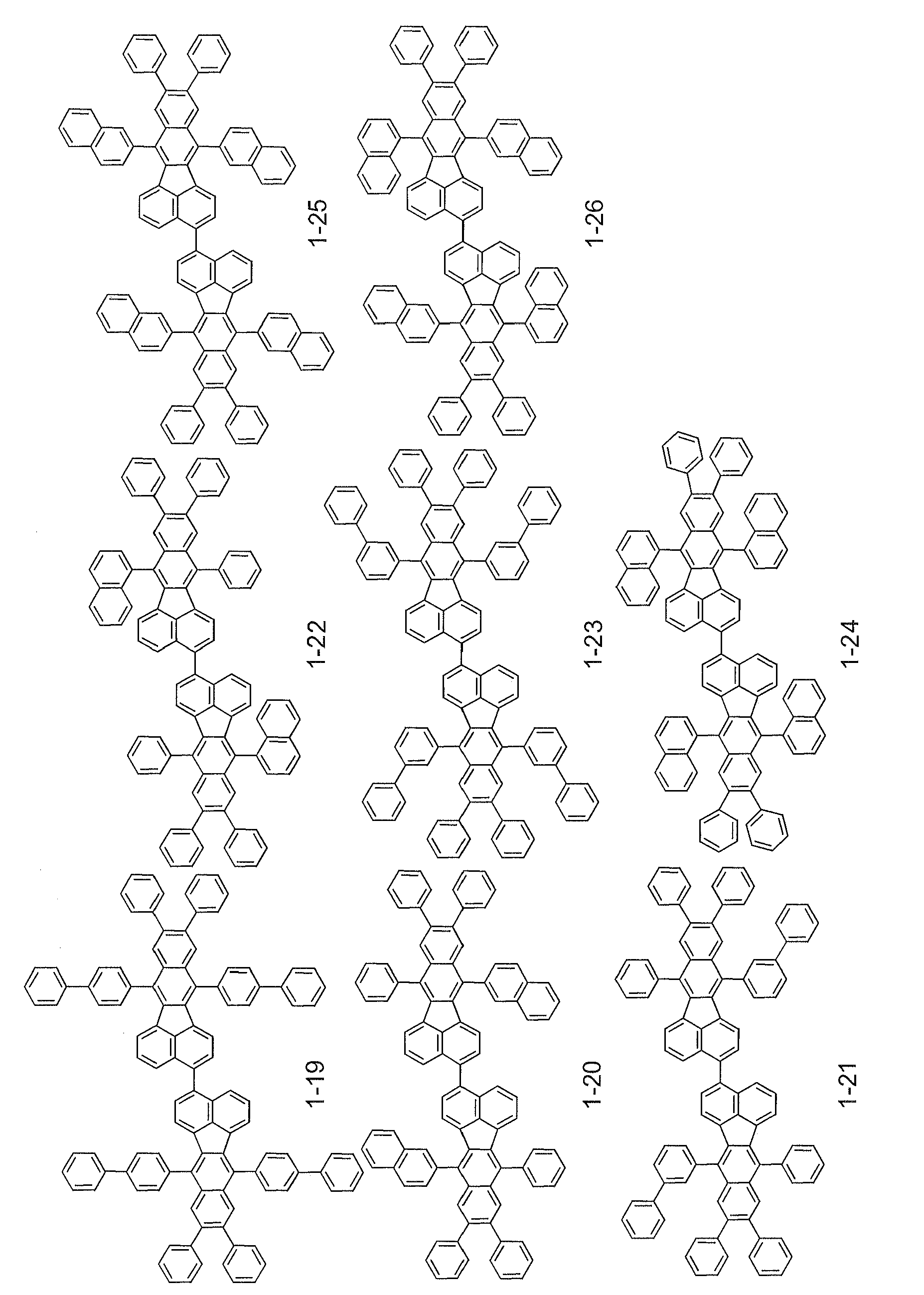

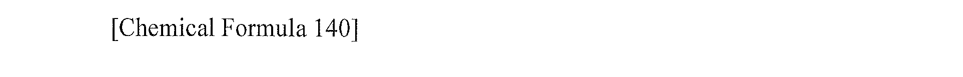

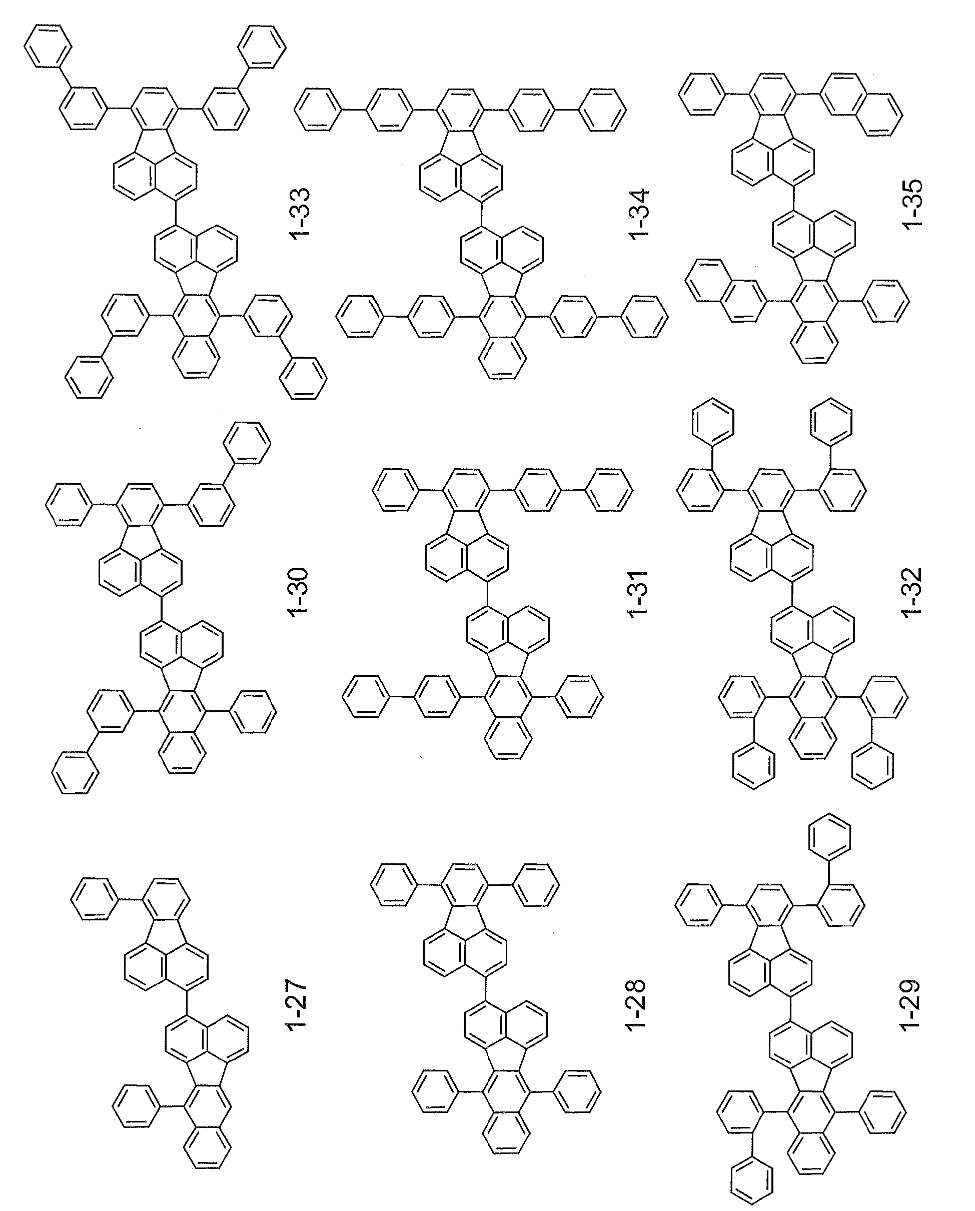

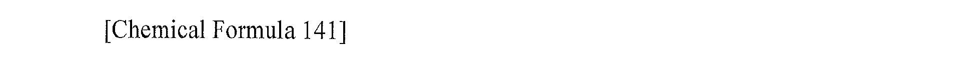

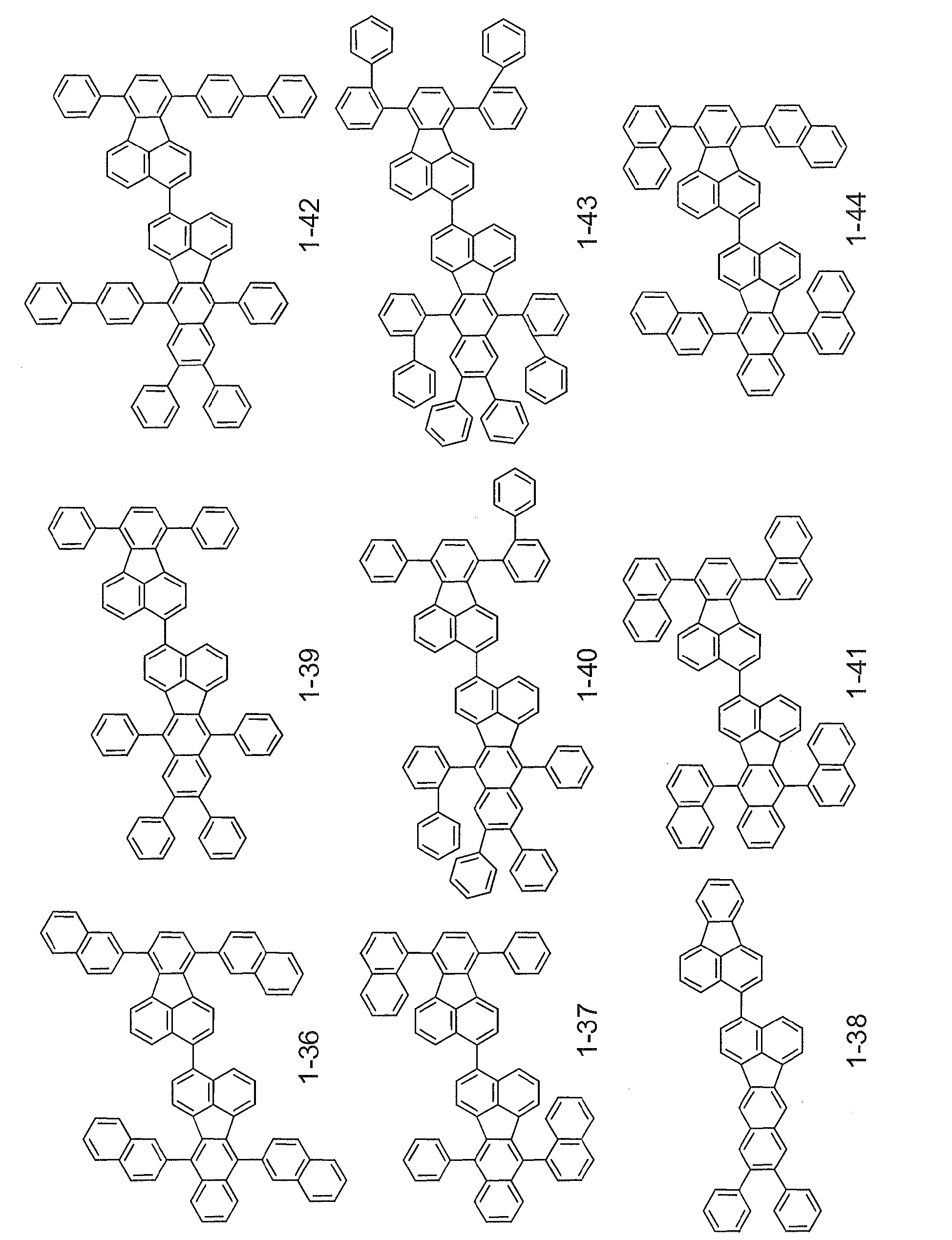

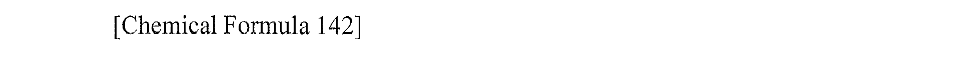

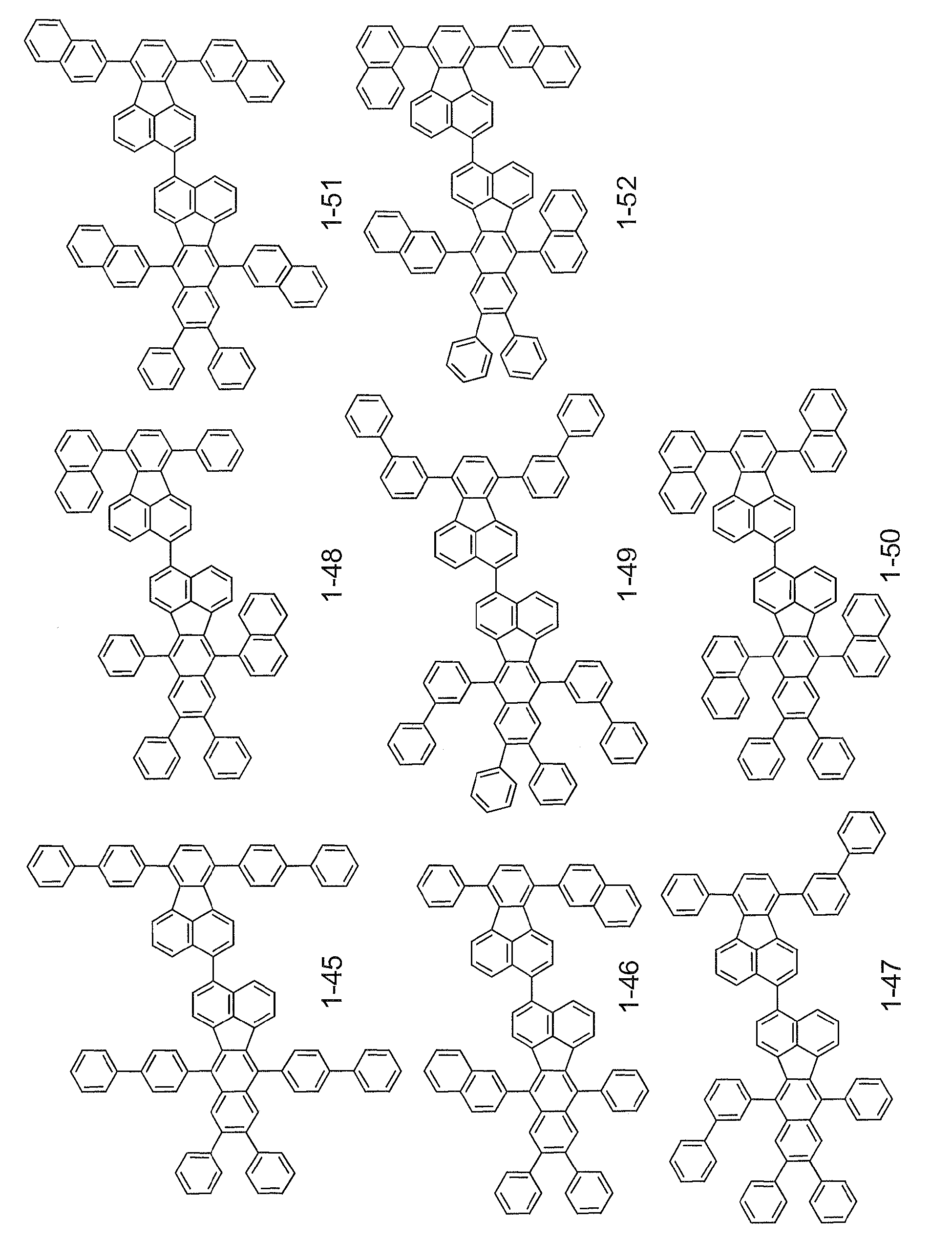

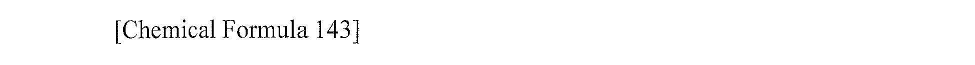

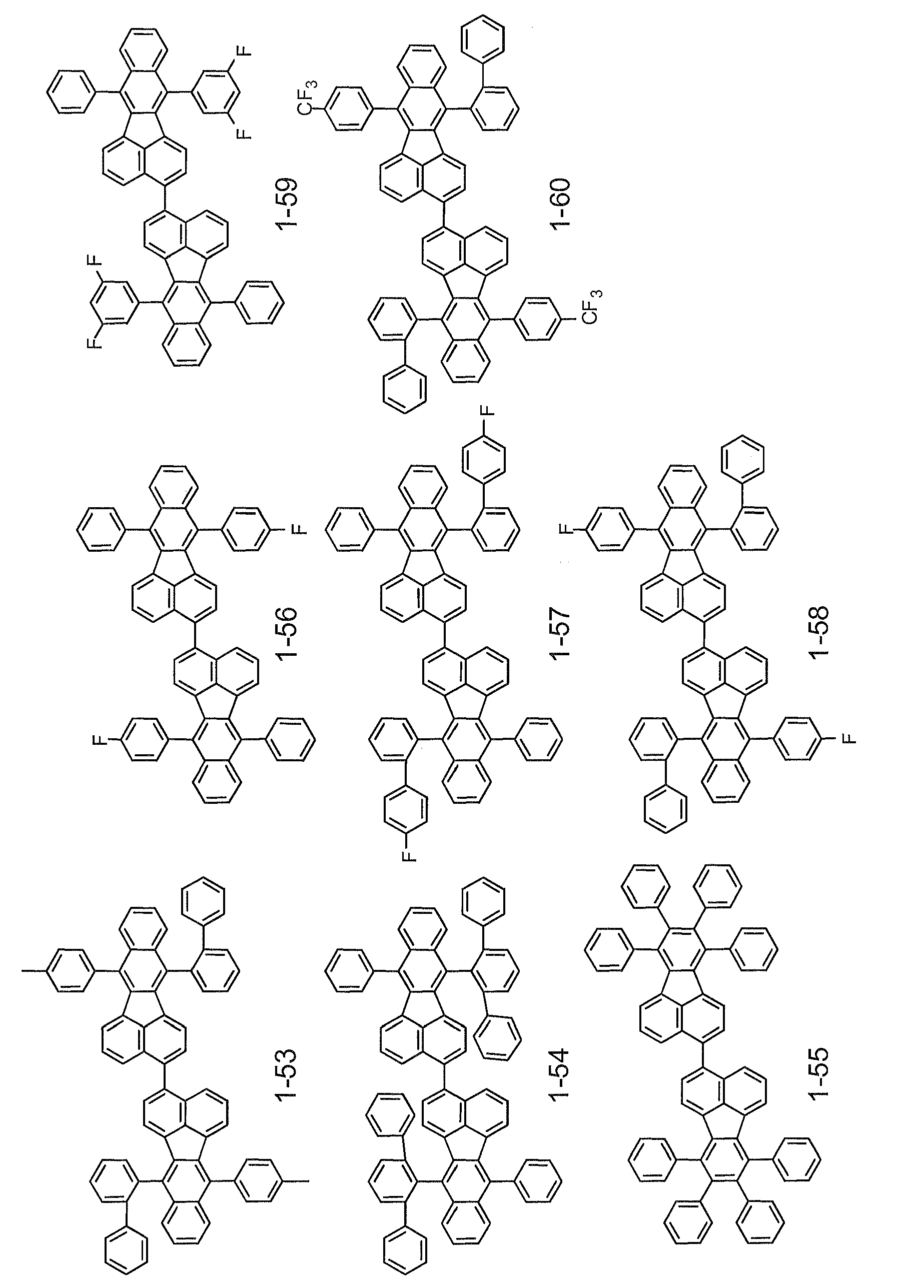

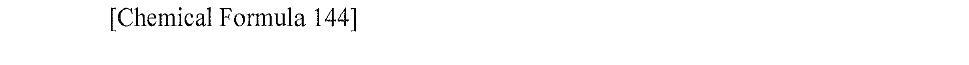

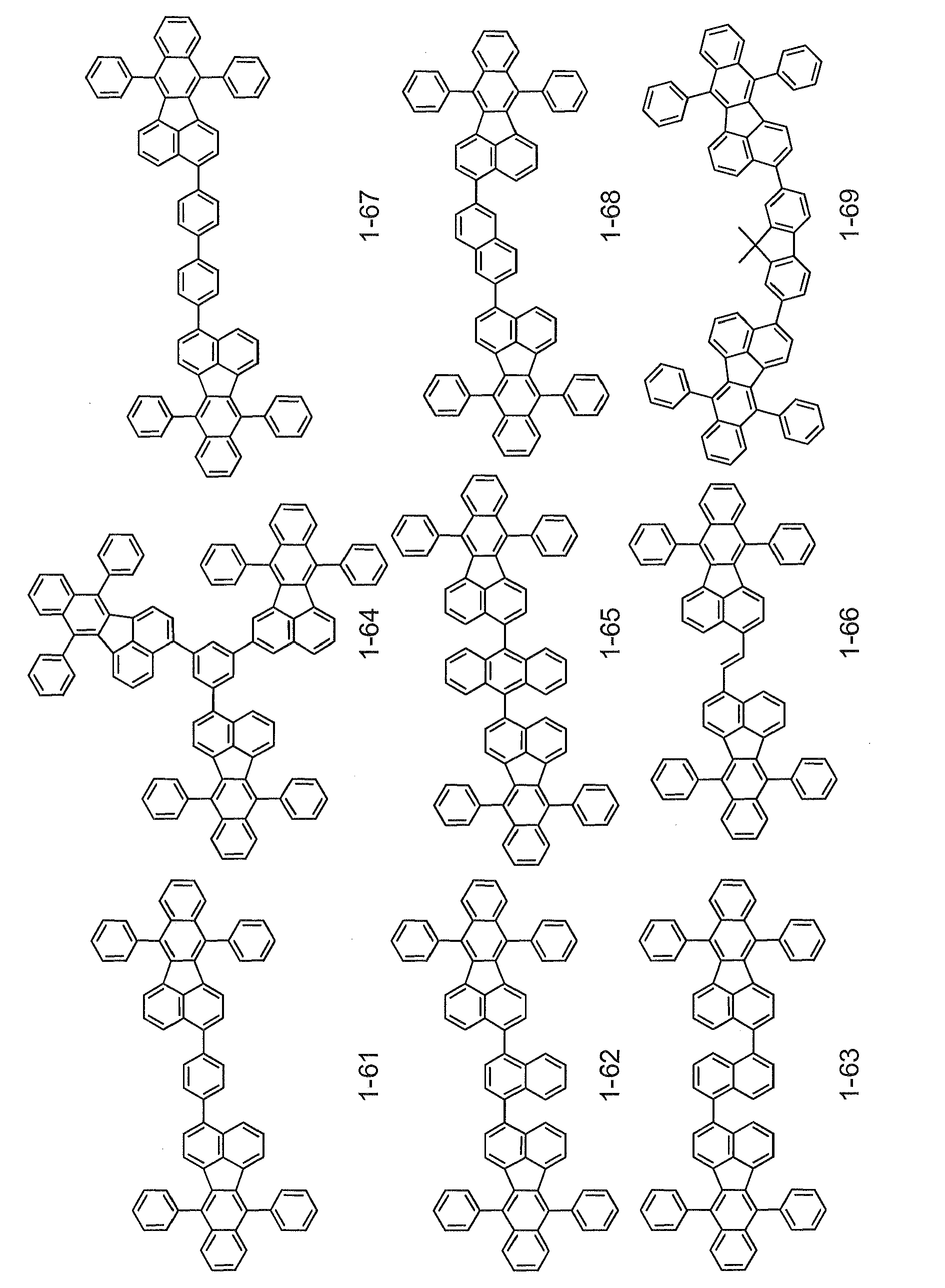

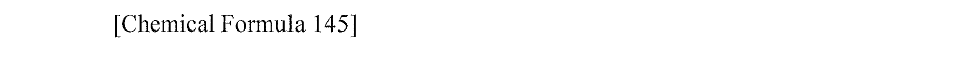

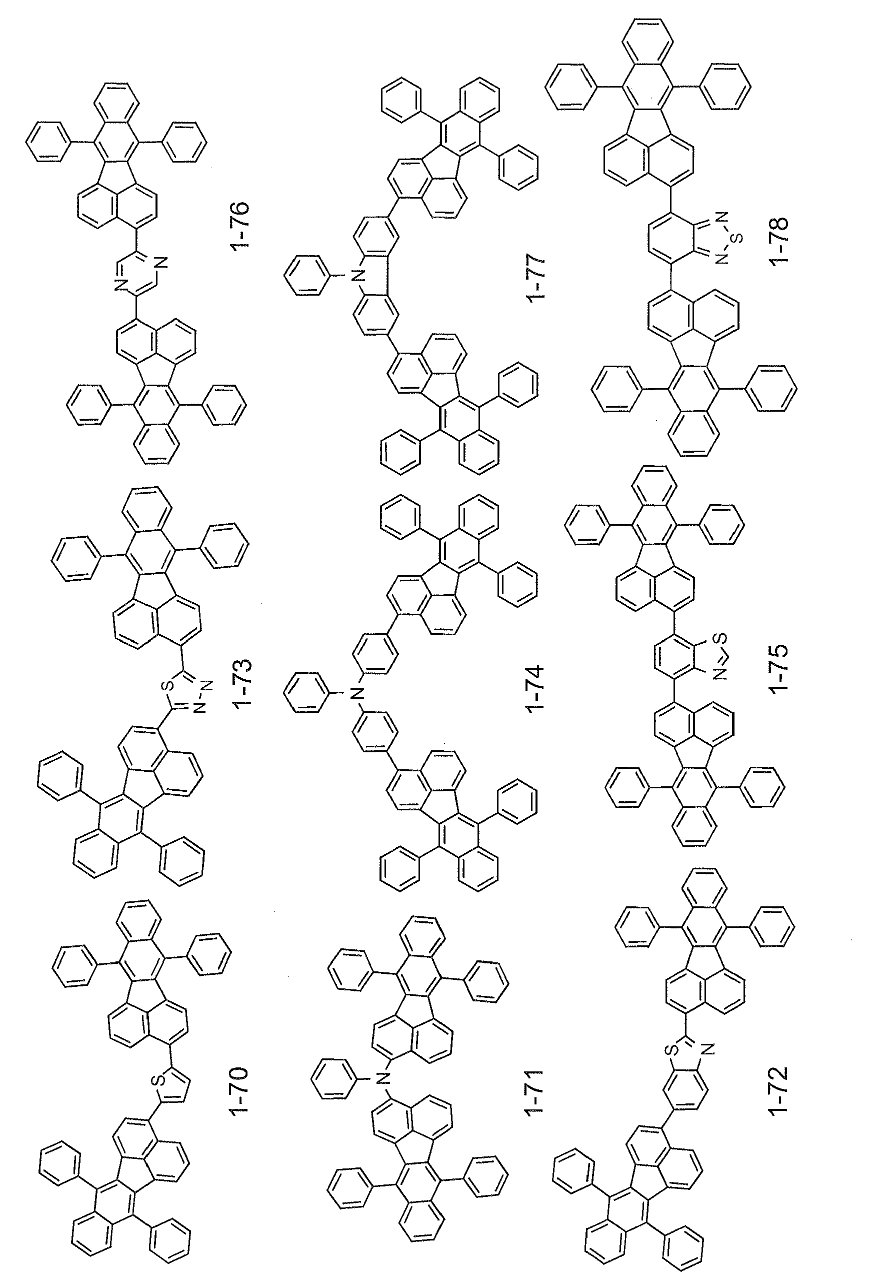

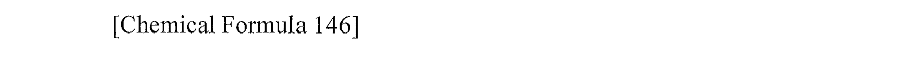

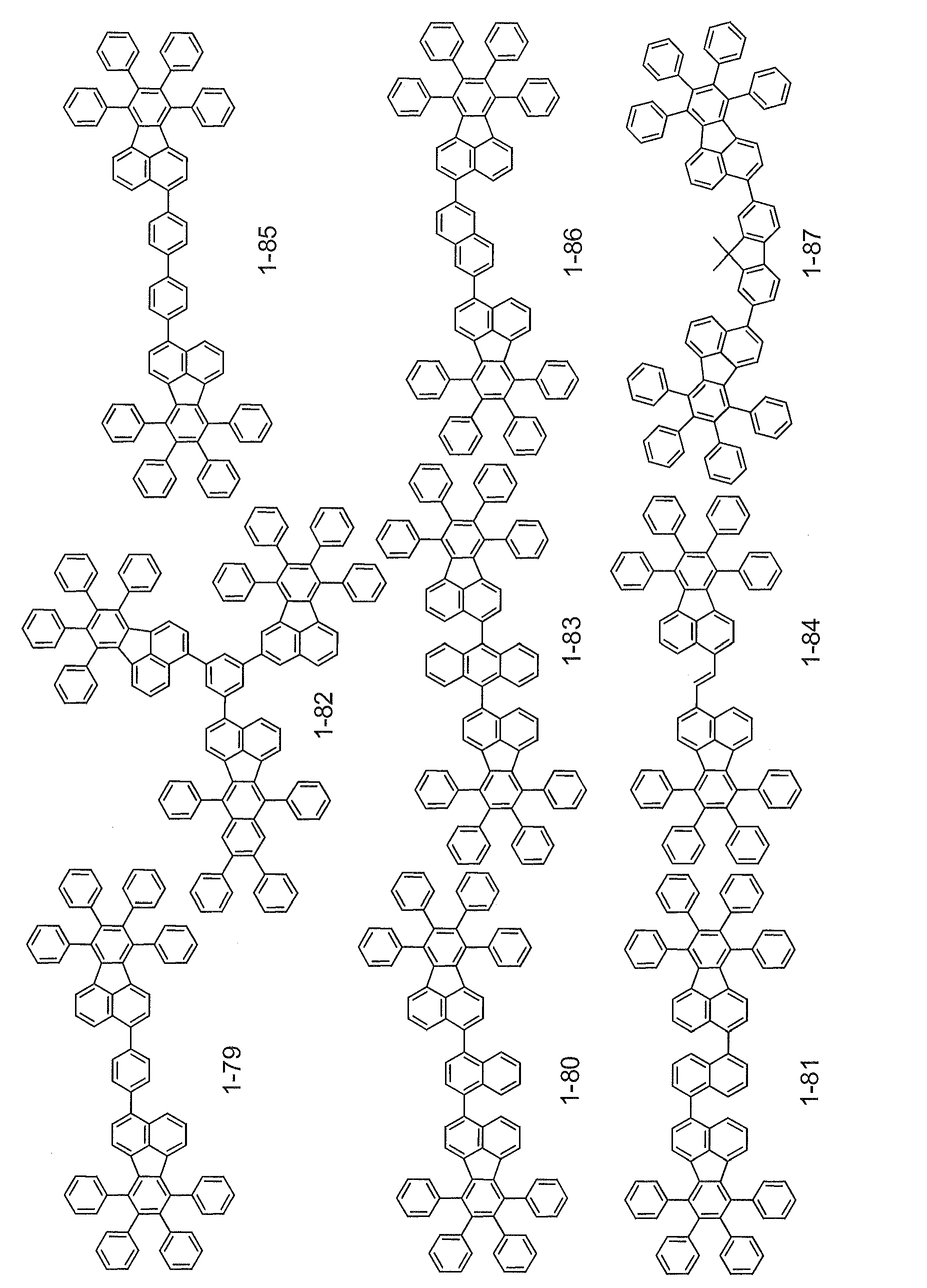

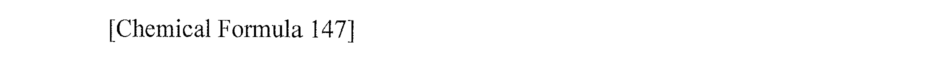

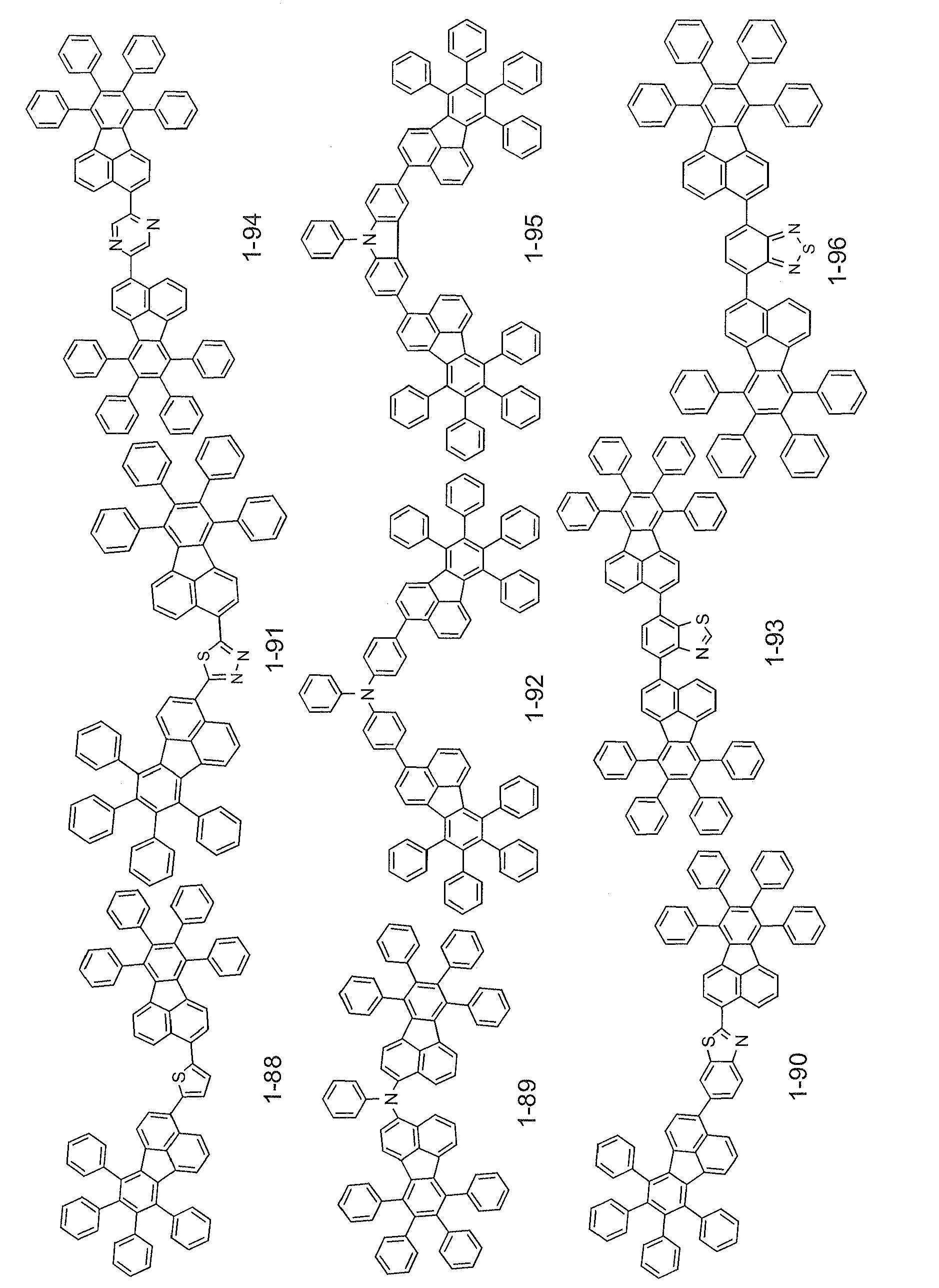

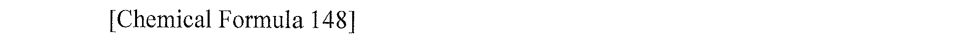

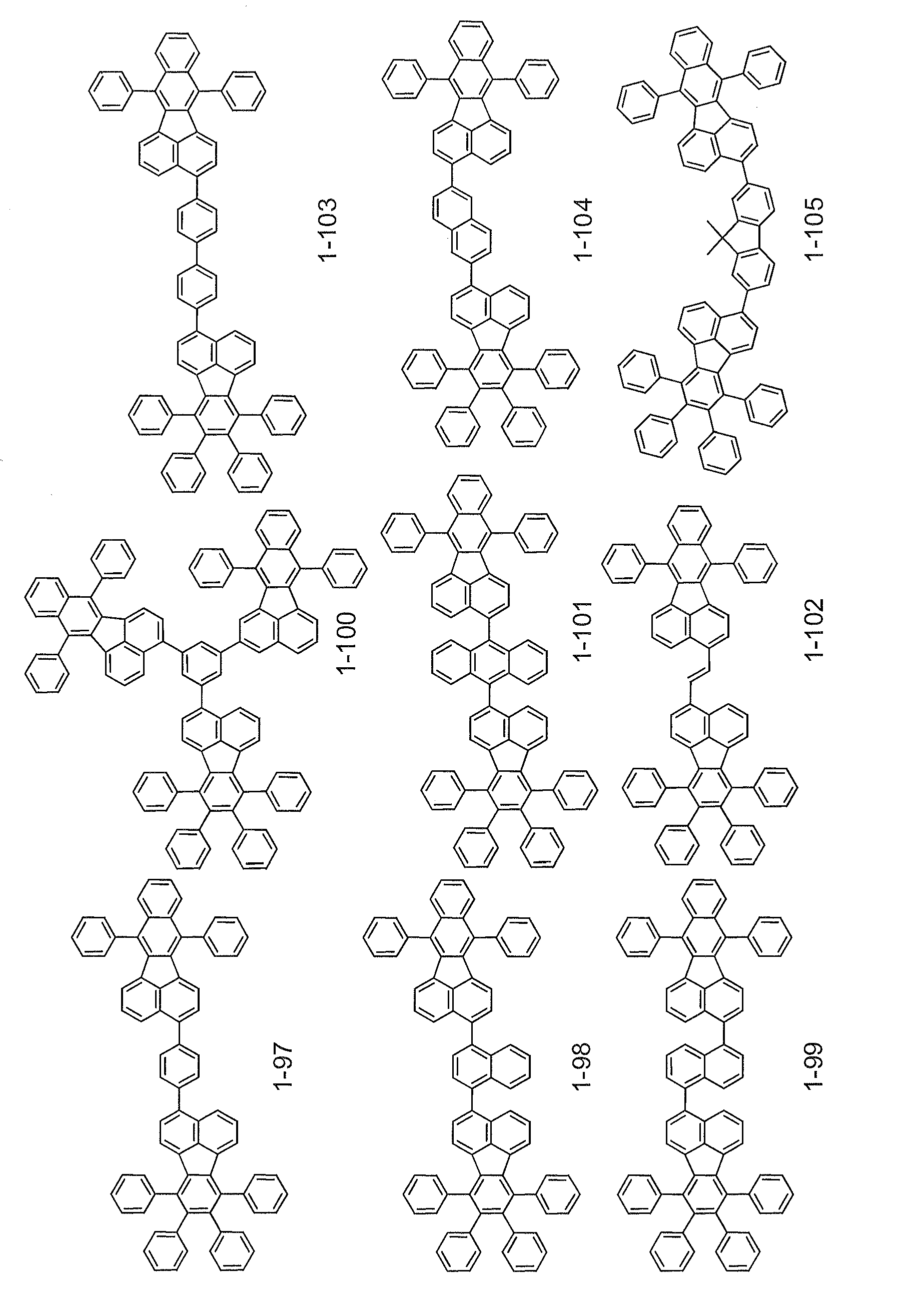

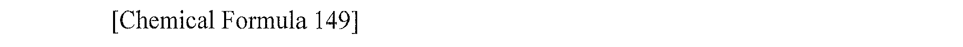

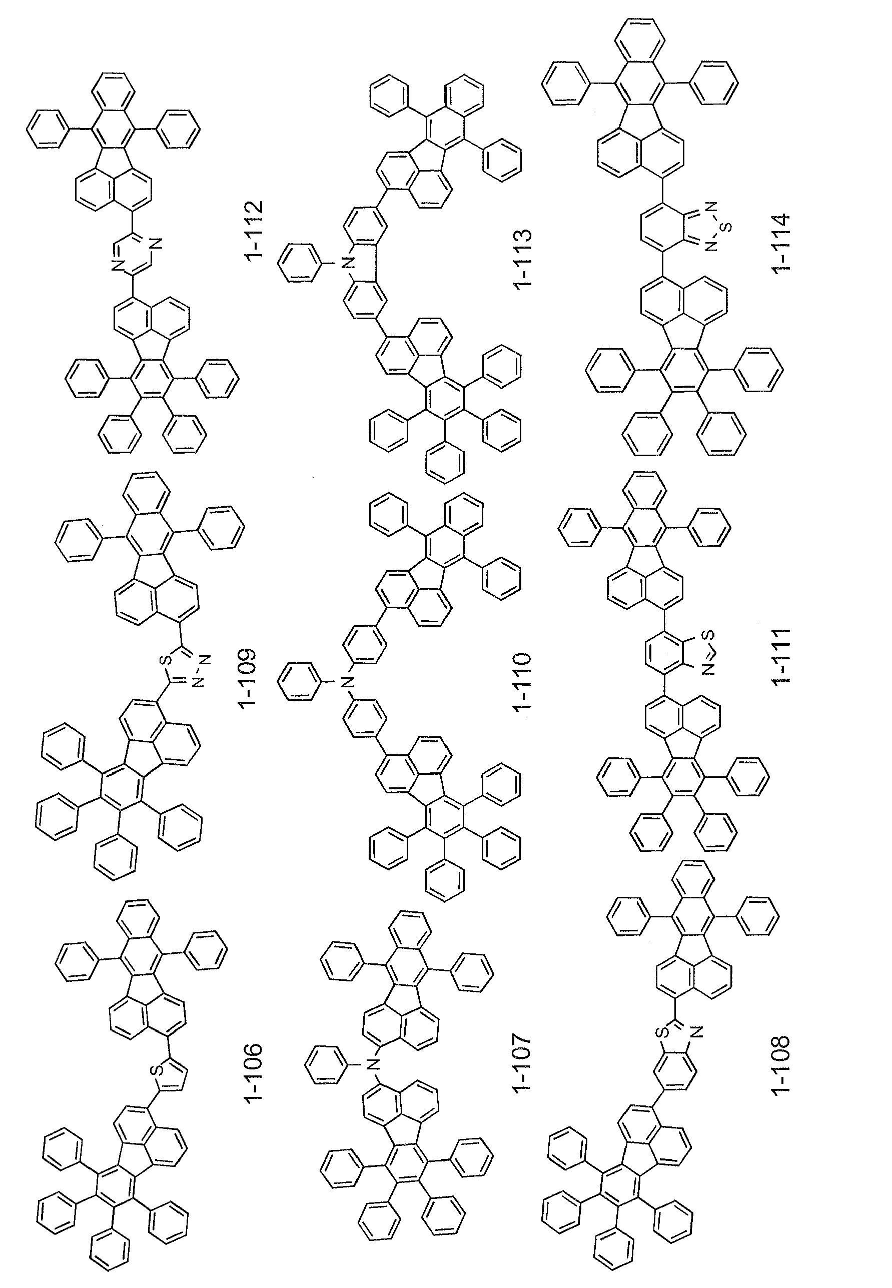

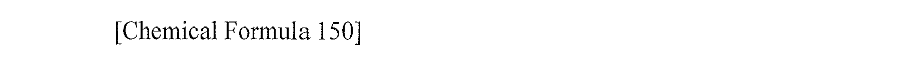

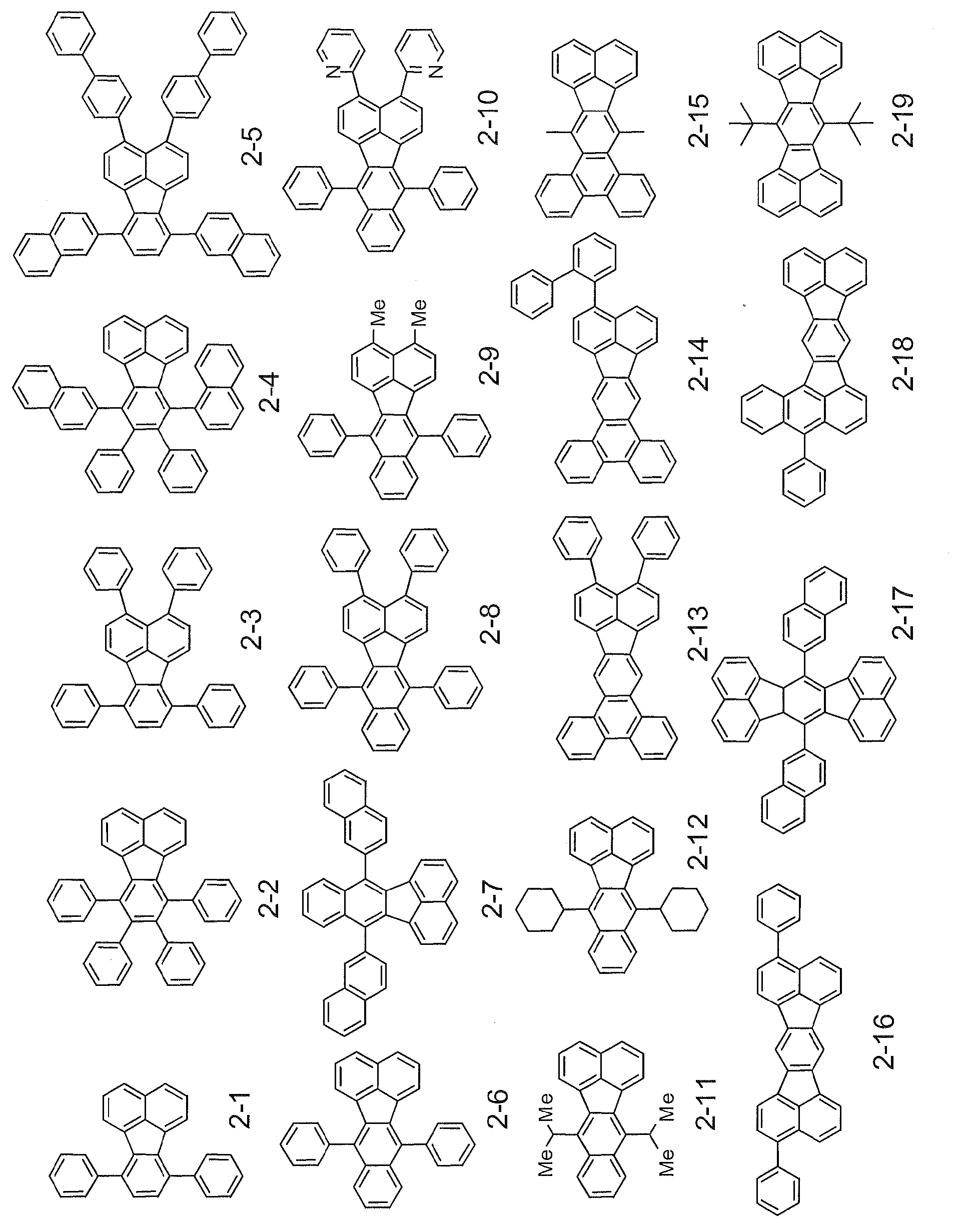

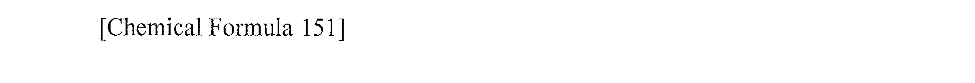

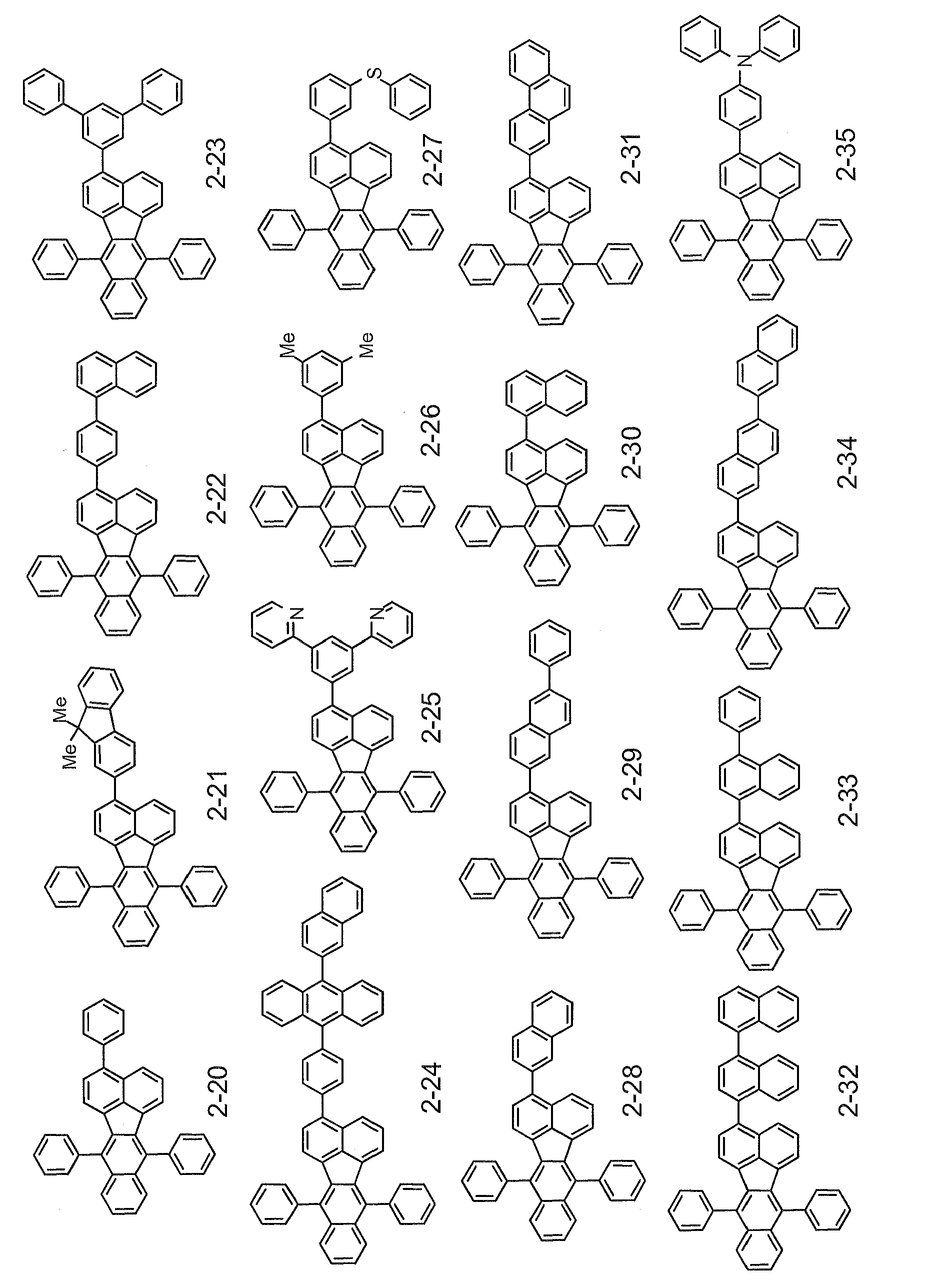

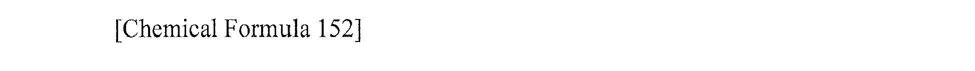

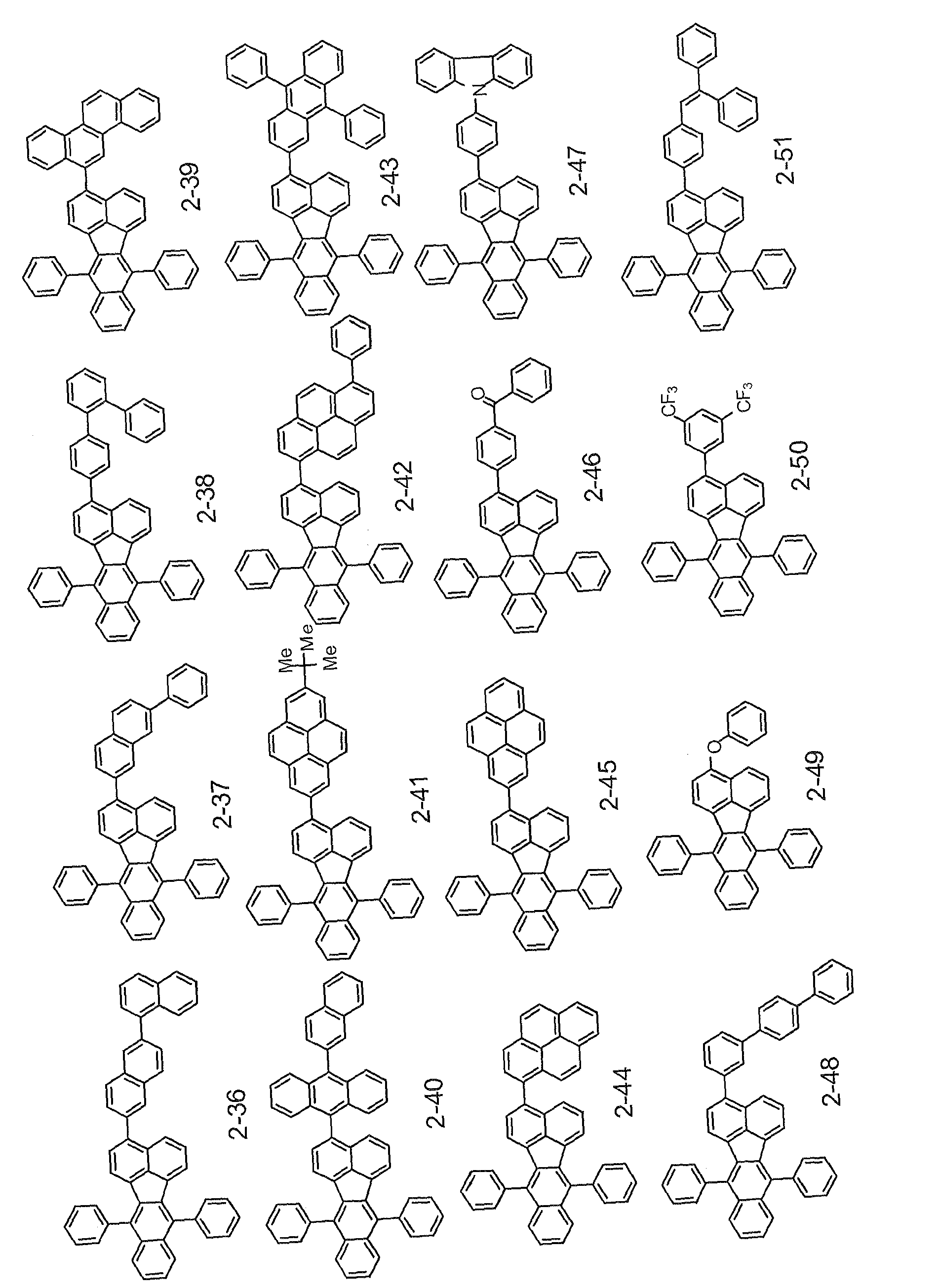

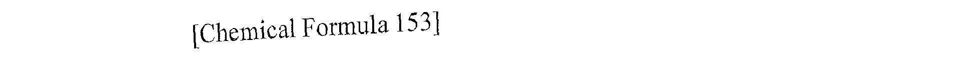

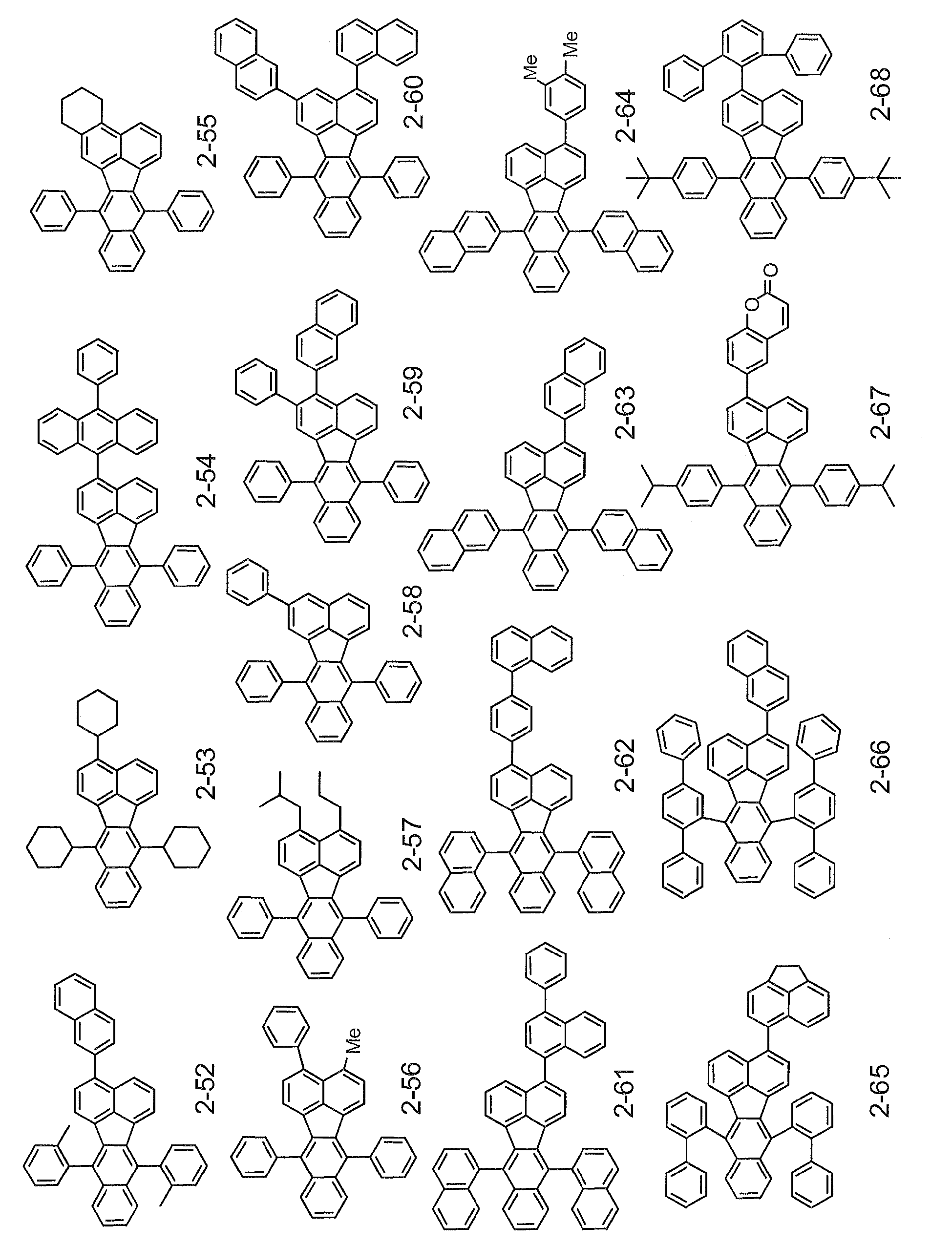

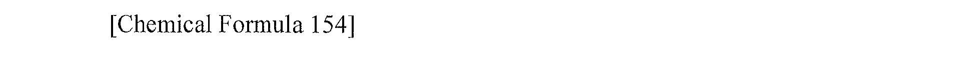

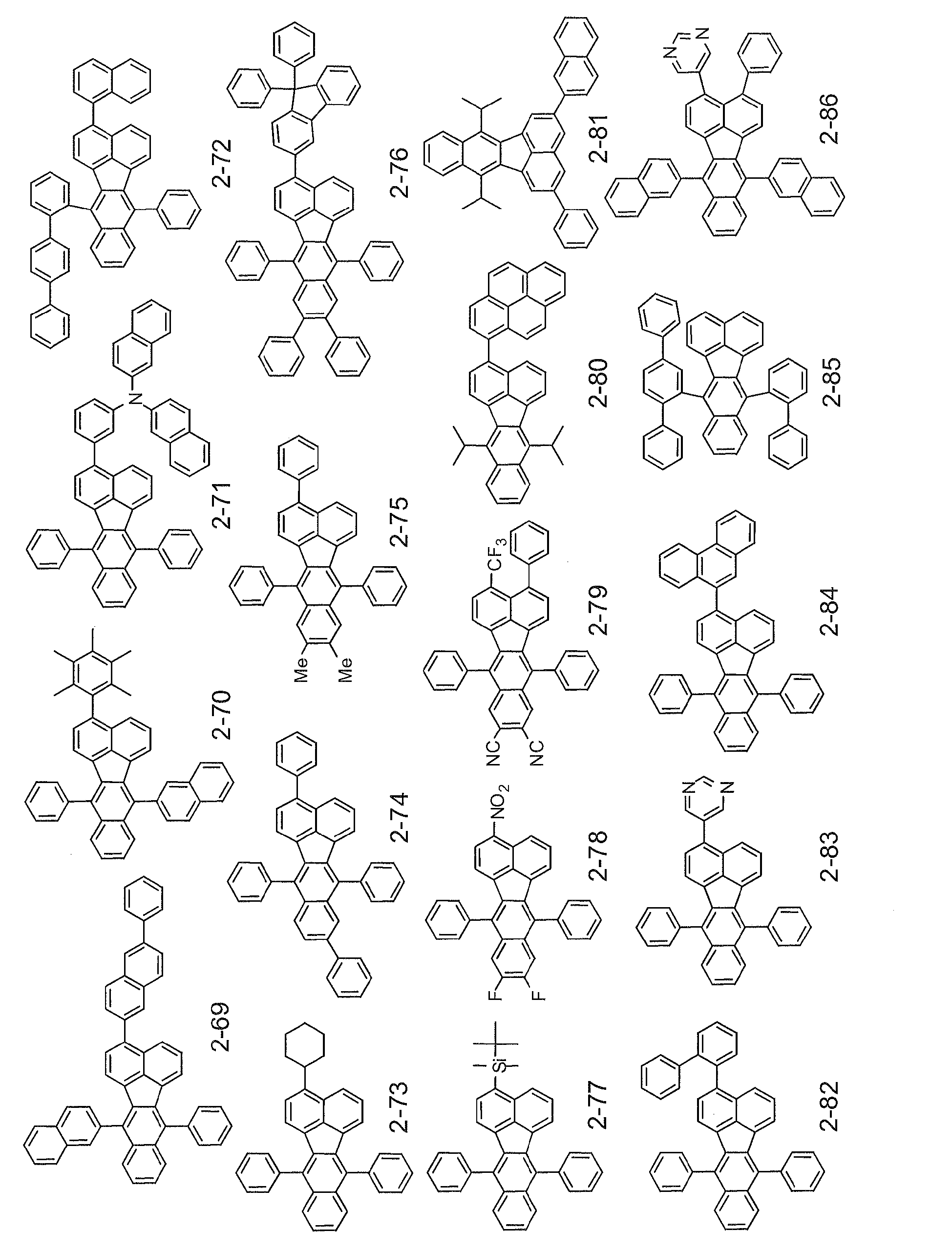

The fluorescent dopant according to the aspect of the invention may be represented by a formula (12) below.

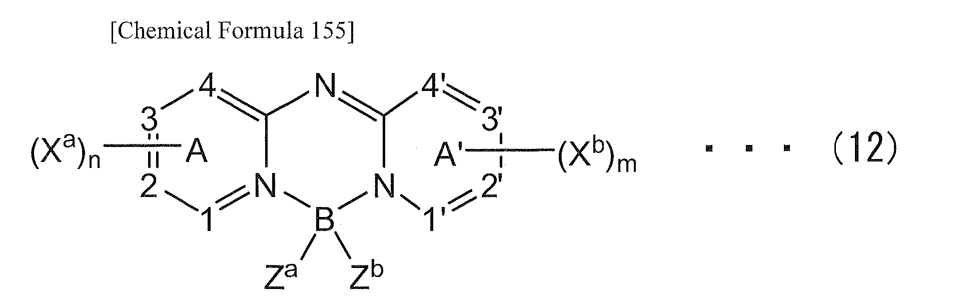

In the formula (12), A and A' each represent an independent azine ring system corresponding to a six-membered aromatic ring containing one or more nitrogen. X^{a} and X^{b} represent independently-selected substituents capable of being bonded together to form a fused ring with respect to A or A'. m and n each independently represent 0 to 4. Z^{a} and Z^{b} represent independently-selected substituents. 1, 2, 3, 4, 1', 2', 3' and 4' are each independently selected from a carbon atom and nitrogen atom.

The azine ring is preferably a quinolinyl ring or isoquinolinyl ring in which: all of 1, 2, 3, 4, 1', 2', 3' and 4' are carbon atoms; m and n each are 2 or more; and X^{a} and X^{b} represent 2 or more carbon-substituted groups bonded to form an aromatic ring. Z^{a} and Z^{b} are preferably fluorine atoms.

A fluorescent dopant of one preferable embodiment is structured such that: the two fused ring systems are quinoline or isoquinoline systems; aryl or heteroaryl substituents are phenyl groups; at least two X^{a} groups and two X^{b} groups are present to form 6-6 fused rings by bonding together; the fused ring systems each are fused in 1-2 position, 3-4 position, 1'-2' position or 3'-4' position; and at least either one of the fused rings is substituted by a phenyl group. The fluorescent dopant is represented by the following formula (121), (122) or (123).

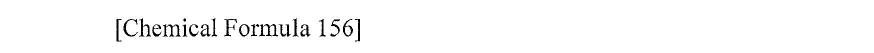

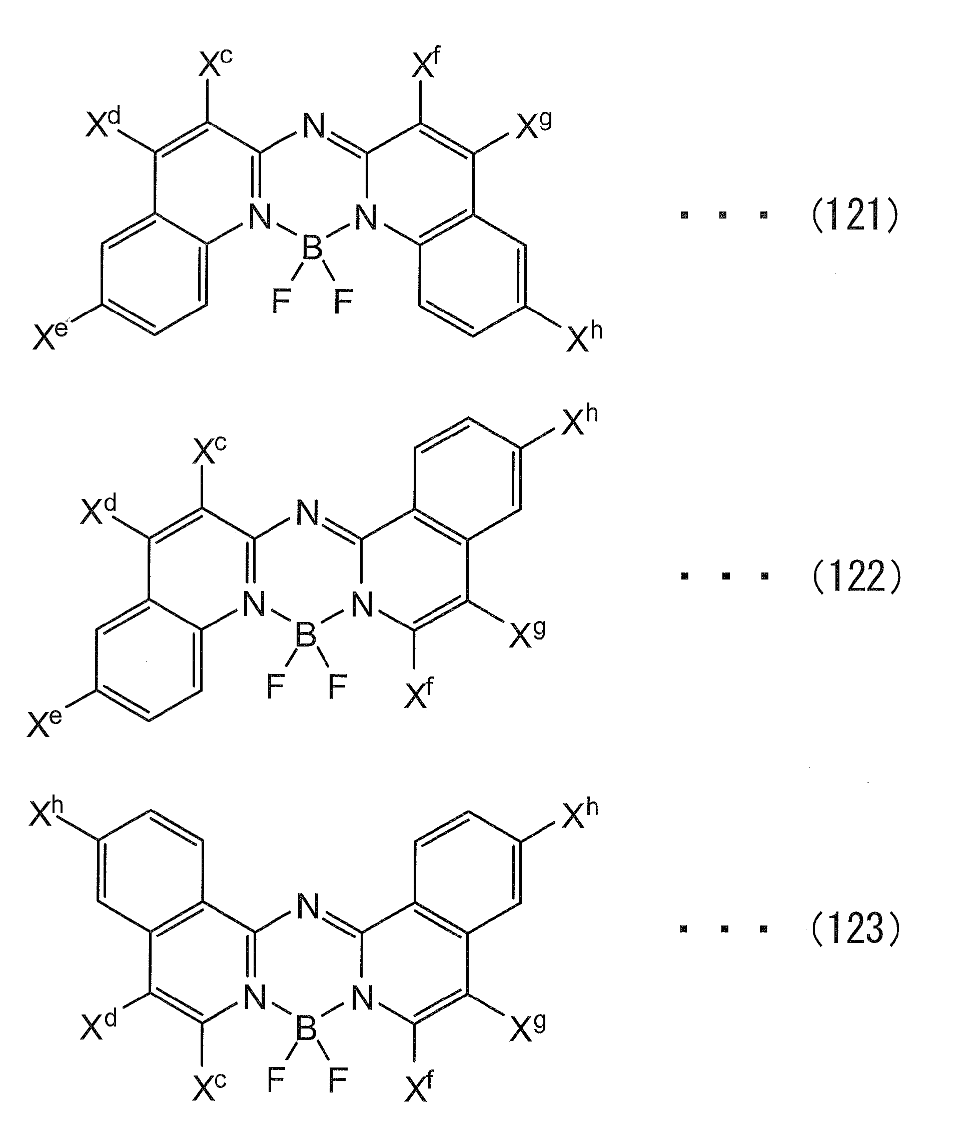

In the formulae (121) to (123), each of X^{c}, X^{d}, X^{e}, X^{f}, X^{g} and X^{h} represents a hydrogen atom or an independently-selected substituent. One of them must represent an aryl group or heteroaryl group.

The azine ring is preferably a quinolinyl ring or isoquinolinyl ring in which: all of 1, 2, 3, 4, 1', 2', 3' and 4' are carbon atoms; m and n each are 2 or more; X^{a} and X^{b} represent 2 or more carbon-substituted groups bonded to form an aromatic ring; and one of X^{a} and X^{b} represents an aryl group or substituted aryl group. Z^{a} and Z^{b} are preferably fluorine atoms.

A boron compound usable in the aspect of the invention will be exemplified below. The boron compound is complexated by two ring nitrogen atoms of deprotonated bis(azinyl)amine ligand, and the two ring nitrogen atoms are parts of different 6,6 fused ring systems. At least either one of the 6,6 fused ring systems contains an aryl or heteroaryl substituent.

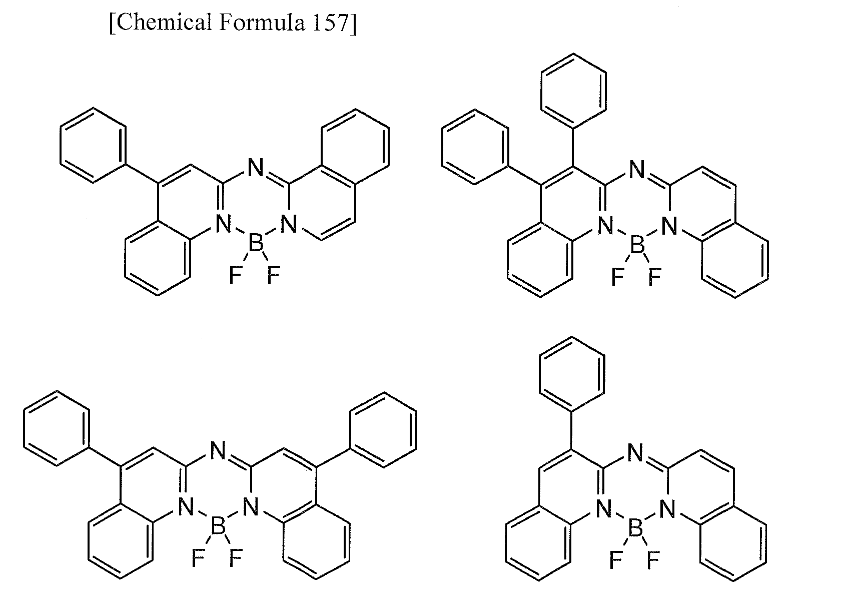

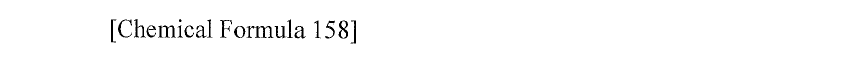

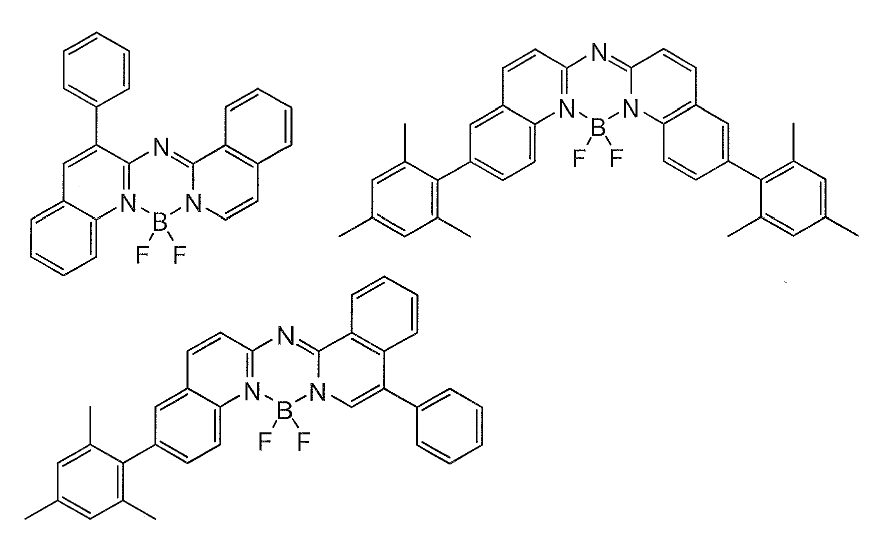

In the organic EL device according to the aspect of the invention, the emission wavelength of the fluorescent-emitting layer is shorter than that of the phosphorescent-emitting layer. Preferably, the fluorescent-emitting layer provides emission at the wavelength of 410 to 580 nm while the phosphorescent-emitting layer provides emission at the wavelength of 500 to 700 nm.
When the fluorescent-emitting layer is of single-layered structure that only includes a blue fluorescent-emitting layer, the fluorescent-emitting layer provides emission at the wavelength of 410 to 500 nm, and the phosphorescent-emitting layer provides emission at the wavelength of 500 to 700 nm.
Alternatively, when the fluorescent-emitting layer is of two-layered structure that includes a blue fluorescent-emitting layer and a green fluorescent-emitting layer, the fluorescent-emitting layer provides emission at the wavelength of 410 to 580 nm, and the phosphorescent-emitting layer provides emission at the wavelength of 580 to 700.
Further alternatively, when the fluorescent-emitting layer is of single-layered structure that includes only a green fluorescent-emitting layer, the fluorescent-emitting layer provides emission at the wavelength of 500 to 580 nm, and the phosphorescent-emitting layer provides emission at the wavelength of 580 to 700 nm.

Preferably in the organic EL device according to the aspect of the invention, the phosphorescent-emitting layer provides emission at the wavelength of 580 to 700 nm.
Preferably in the organic EL device according to the aspect of the invention, the fluorescent-emitting layer is a blue emitting layer, and the phosphorescent-emitting layer is a red phosphorescent-emitting layer for providing red emission.

The organic EL device includes the phosphorescent-emitting layer and the fluorescent-emitting layer provided between the anode and the cathode. The fluorescent-emitting layer may be located closer to the anode than the phosphorescent-emitting layer, or may be located closer to the cathode than the phosphorescent-emitting layer. For instance, the anode, the phosphorescent-emitting layer, the fluorescent-emitting layer and the cathode may be layered in this order. Preferably in such an organic EL device, a hole injecting/transporting layer is provided between the anode and the phosphorescent-emitting layer, and an electron injecting/transporting layer is provided between the cathode and the fluorescent-emitting layer.
As long as the organic EL device provides mixed-color emission by the fluorescent-emitting layer and the phosphorescent-emitting layer, the color mixture pattern may be variously modified.
For instance, the fluorescent-emitting layer may contain a blue fluorescent dopant while the phosphorescent-emitting layer contains a red phosphorescent dopant. The fluorescent-emitting layer may alternatively contain a blue fluorescent dopant and a green fluorescent dopant while the phosphorescent-emitting layer contains a red phosphorescent dopant. Further alternatively, the fluorescent-emitting layer may contain a blue fluorescent dopant while the phosphorescent-emitting layer contains a green phosphorescent dopant and a red phosphorescent dopant.

The thickness of the fluorescent-emitting layer is determined in view of the balance between the chromaticity and the lifetime. The thickness is preferably 5 to 50 nm. In order to obtain favorable chromaticity, the thickness of the fluorescent-emitting layer (i.e., less efficient emitting layer) needs to be increased. On the other hand, in order to obtain long lifetime, the thickness of the phosphorescent-emitting layer (i.e., emitting layer of shorter lifetime) needs to be increased. More preferably, the fluorescent-emitting layer is thicker than the other. However, an excessively-thick emitting layer requires high voltage, so that the total thickness of the emitting layer is preferably 100 nm or less, more preferably 80 nm or less. The phosphorescent dopant concentration is preferably 10% or less. When the phosphorescent dopant concentration is more than 10%, the phosphorescent emission becomes too strong. On the other hand, an excessively-small phosphorescent dopant concentration invites reduction in the lifetime. Thus, the phosphorescent dopant concentration is so determined as not to reduce the lifetime.
A layer containing Balq or CBP (components having large Eg(T)) may be provided for prevention of Eg(T) transfer from the phosphorescent-emitting layer.

When the phosphorescent-emitting layer is located closer to the anode than the fluorescent-emitting layer, the phosphorescent host preferably exhibits large hole mobility. With this arrangement, the injection of holes into the fluorescent-emitting layer (i.e., exciton generating layer) through the phosphorescent-emitting layer can be facilitated, and a probability of the charge recombination can be increased. At this time, the hole mobility of the phosphorescent host is preferably 1×10⁻⁵cm²/Vs or more in an electric field of 1.0×10⁴ to 1.0×10⁶V/cm. The hole mobility is more preferably 10⁻⁴cm²/Vs or more, much more preferably 10⁻³cm²/Vs.
On the other hand, when the phosphorescent-emitting layer is located closer to the cathode than the fluorescent-emitting layer, the phosphorescent host preferably exhibits large electron mobility. With this arrangement, the injection of electrons into the fluorescent-emitting layer (i.e., exciton generating layer) through the phosphorescent-emitting layer can be facilitated, and a probability of the charge recombination can be increased. At this time, the electron mobility of the phosphorescent host is preferably 1×10⁻⁵cm²/Vs or more in an electric field of 1.0×10⁴ to 1.0×10⁶V/cm. The electron mobility is more preferably 10⁻⁴cm²/Vs or more, much more preferably 10⁻³cm²/Vs.
Mobility of carriers (holes, electrons) is measurable in the following manner.
A glass substrate (size: 25mm×75mm×1.1mm) having an ITO transparent electrode (manufactured by Asahi Glass Co., Ltd) is ultrasonic-cleaned in isopropyl alcohol for five minutes, and then UV/ozone-cleaned for 30 minutes. The cleaned glass substrate is then mounted on a substrate holder of a vacuum deposition apparatus. Subsequently, a measurement material is layered on the ITO transparent substrate electrode by resistance-heating deposition to be 3 to 5 µm thick. Thereafter, a metal (Al) is deposited on the film to be 10 nm thick, and a translucent electrode is obtained.
In the produced device, the mobility of carriers (holes, electrons) at electric intensity of 10⁴ to 10⁶ V/cm is measured with a time-of-flight measurement system TOF-401 manufactured by Optel Corporation. The excited light utilizes light due to nitrogen laser of 337 nm.
The curve of photocurrent (I) to time (t) is plotted by double logarithm. Then, using the obtained folding point tr, the mobility µ is obtained as a result of an equation: mobility µ=L²/(tr×V). In the equation, L is a thickness of a sample, and V is applied voltage.

### Brief Description of Drawings

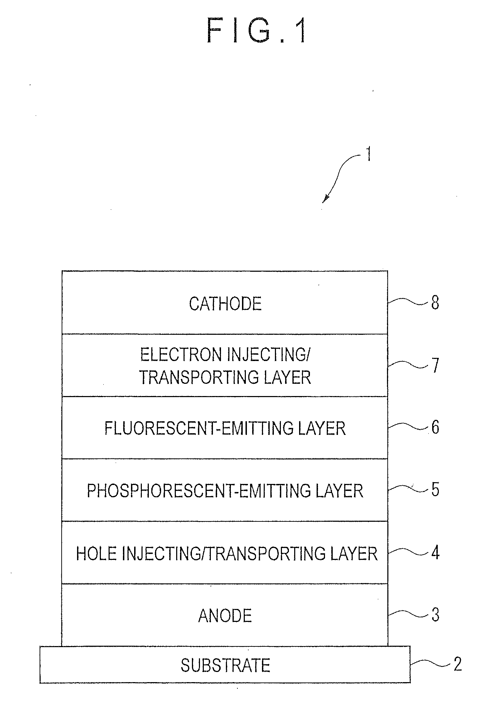

Fig. 1 shows an arrangement of an organic EL device according to an exemplary embodiment.

### Explanation of Codes

- 1: organic EL device
- 2: substrate
- 3: anode
- 4: hole injecting/transporting layer
- 5: phosphorescent-emitting layer
- 6: fluorescent-emitting layer
- 7: electron injecting/transporting layer
- 8: cathode

### Best Mode for Carrying Out the Invention

Embodiment(s) of the present invention will be described.

### (Arrangement of Organic EL Device)

Arrangement(s) of an organic EL device will be described below.
(1) Arrangement of Organic EL Device
   Fig. 1 schematically shows an arrangement of an organic EL device according to this exemplary embodiment.
   An organic EL device 1 includes: a transparent substrate 2; an anode 3; a hole injecting/transporting layer 4; a phosphorescent-emitting layer 5; a fluorescent-emitting layer 6; an electron injecting/transporting layer 7; and a cathode 8.
   The hole injecting/transporting layer 4 and the electron injecting/transporting layer 7 may not be provided.
   In addition, an electron blocking layer may be provided to the phosphorescent-emitting layer 5 adjacently to the anode 3 while a hole blocking layer may be provided to the fluorescent-emitting layer 6 adjacently to the cathode 8. With this arrangement, electrons and holes can be trapped in the phosphorescent-emitting layer 5 and the fluorescent-emitting layer 6, thereby enhancing probability of exciton generation in the phosphorescent-emitting layer 5 and the fluorescent-emitting layer 6.

(2) Substrate 2
   The substrate 2, which supports the organic EL device, is preferably a smoothly-shaped substrate that transmits 50% or more of light in a visible region of 400 nm to 700 nm. An example of a material for the substrate 2 is a glass.

(3) Anode 3
   The anode 3 injects holes into the hole injecting/transporting layer 4 or the fluorescent-emitting layer 5. It is effective that the anode has a work function of 4.5 eV or more. Exemplary materials for the anode are indium-tin oxide (ITO), tin oxide (NESA), indium zinc oxide, gold, silver, platinum and copper.

(4) Hole Injecting/Transporting Layer 4
   The hole injecting/transporting layer 4 is provided between the phosphorescent-emitting layer 5 and the anode 3 for aiding the injection of holes into the phosphorescent-emitting layer 5 and transporting the holes to the emitting region. As the hole injecting/transporting layer 4, for instance, 4,4'-bis[N-(1-naphthyl)-N-phenylamino] biphenyl (hereinafter abbreviated as NPD) is usable.
   Other examples of the hole injecting/transporting material are a triazole derivative (see, for instance, the specification of US Patent No. 3,112,197), an oxadiazole derivative (see, for instance, the specification of US Patent No. 3,189,447), an imidazole derivative (see, for instance, JP-B-37-16096), a polyarylalkane derivative (see, for instance, the specifications of US Patent No. 3,615,402, No.3,820,989 and No. 3,542,544, JP-B-45-555, JP-B-51-10983, JP-A-51-93224, JP-A-55-17105, JP-A-56-4148, JP-A-55-108667, JP-A-55-156953, and JP-A-56-36656), a pyrazoline derivative and a pyrazolone derivative (see, for instance, the specifications of US Patent No. 3,180,729 and No. 4,278,746, JP-A-55-88064, JP-A-55-88065, JP-49-105537, JP-A-55-51086, JP-A-56-80051, JP-A-56-88141, JP-A-57-45545, JP-A-54-112637 and JP-A-55-74546), a phenylenediamine derivative (see, for instance, the specification of US Patent No. 3,615,404, JP-B-51-10105, JP-B-46-3712, JP-B-47-25336, JP-A-54-53435, JP-A-54-110536 and JP-A-54-119925), an arylamine derivative (see, for instance, the specifications of US Patent No. 3,567,450, No. 3,180,703, No. 3,240,597, No. 3,658,520, No. 4,232,103, No. 4,175,961 and No. 4,012,376, JP-B-49-35702, JP-B-39-27577, JP-A-55-144250, JP-A-56-119132 and JP-A-56-22437 and the specification of West Germany Patent No. 1,110,518), an amino-substituted chalcone derivative (see, for instance, the specification of US Patent No. 3,526,501), an oxazole derivative (disclosed in, for instance, the specification of US Patent No. 3,257,203), a styrylanthracene derivative (see, for instance, JP-A-56-46234), a fluorenone derivative (see, for instance, JP-A-54-110837), a hydrazone derivative (see, for instance, the specification of US Patent No. 3,717,462 and JP-A-54-59143, JP-A-55-52063, JP-A-55-52064, JP-A-55-46760, JP-A-55-85495, JP-A-57-11350, JP-A-57-148749 and JP-A-02-311591), a stilbene derivative (see, for instance, JP-A-61-210363, JP-A-61-228451, JP-A-61-14642, JP-A-61-72255, JP-A-62-47646, JP-A-62-36674, JP-A-62-10652, JP-A-62-30255, JP-A-60-93455, JP-A-60-94462, JP-A-60-174749 and JP-A-60-175052), a silazane derivative (see the specification of US Patent No. 4,950,950), a polysilane type (see JP-A-02-204996), an aniline-based copolymer (see JP-A-02-282263), and a conductive polymer oligomer (particularly, thiophene oligomer) disclosed in JP-A-01-211399.

The hole-injectable material, examples of which are as listed above, is preferably a porphyrin compound (disclosed in JP-A-63-295695 etc.), an aromatic tertiary amine compound or a styrylamine compound (see, for instance, the specification of US Patent No. 4,127,412, JP-A-53-27033, JP-A-54-58445, JP-A-54-149634, JP-A-54-64299, JP-A-55-79450, JP-A-55-144250, JP-A-56-119132, JP-A-61-295558, JP-A-61-98353 or JP-A-63-295695), particularly preferably an aromatic tertiary amine compound.
In addition, 4,4'-bis(N-(1-naphthyl)-N-phenylamino)biphenyl (hereinafter, abbreviated as NPD) having in the molecule two fused aromatic rings disclosed in US Patent No. 5,061,569, 4,4',4"-tris(N-(3-methylphenyl)-N-phenylamino) triphenylamine (hereinafter, abbreviated as MTDATA) in which three triphenylamine units disclosed in JP-A-04-308688 are bonded in a starbust form and the like may also be used.
Alternatively, inorganic compounds such as p-type Si and p-type SiC can also be used as the hole-injecting material. Further, a hexaazatriphenylene derivative disclosed in Japanese Patent No. 3614405 and No. 3571977 and US Patent No. 4,780,536 may also preferably be used as the hole-injecting material.

The hole injecting/transporting layer 4 may be a separately-prepared hole injecting layer and hole transporting layer.
The hole injecting layer and the hole transporting layer, which aids the injection of the holes into the emitting layer and transports the holes to the emitting region, exhibits large hole mobility while typically exhibiting as small ionization energy as 5.5 eV or less. Materials for the hole injecting layer and the hole transporting layer are preferably capable of transporting the holes to the emitting layer at lower electric field intensity. In addition, the hole mobility thereof is preferably 10⁻⁴ cm²/V·sec when applied with an electric field of, for instance, 10⁴ to 10⁶ V/cm.
The materials for the hole injecting layer and the hole transporting layer are not specifically limited, and may be suitably selected among those widely used as hole charge transporting materials in photoconductive materials and those typically used in hole injecting layers and hole transporting layers of organic EL devices.

For the hole injecting layer and the hole transporting layer, for instance, an aromatic amine derivative represented by the following formula is usable.

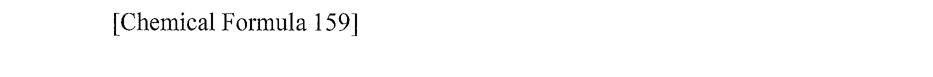

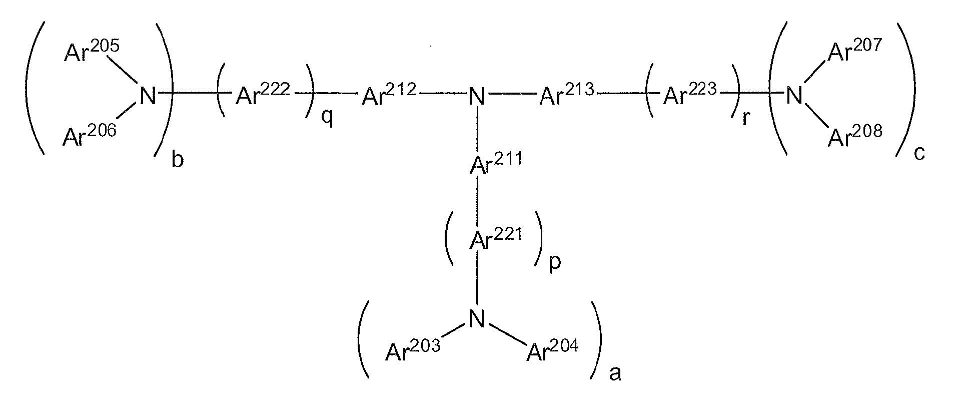

In the formula, Ar²¹¹ to Ar²¹³ and Ar¹²¹ to Ar²²³ each represent a substituted or unsubstituted arylene group having 6 to 50 ring carbon atoms or a substituted or unsubstituted heteroarylene group having 5 to 50 ring atoms. Ar²⁰³ to Ar²⁰⁸ each represent a substituted or unsubstituted aryl group having 6 to 50 ring carbon atoms or a substituted or unsubstituted heteroaryl group having 5 to 50 ring atoms. a to c and p to r each represent an integer of 0 to 3. Ar²⁰³ and Ar²⁰⁴, Ar²⁰⁵ and Ar²⁰⁶, and Ar²⁰⁷ and Ar²⁰⁸ may be respectively linked together to form saturated or unsaturated rings.

Examples of the substituted or unsubstituted aryl group having 6 to 50 ring carbon atoms are a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group and 4"-t-butyl-p-terphenyl4-yl group.

Examples of the substituted or unsubstituted arylene group having 6 to 50 ring carbon atoms are groups obtained by eliminating one hydrogen atom from the above aryl groups.

Examples of the substituted or unsubstituted heteroaryl group having 5 to 50 ring atoms are a 1-pyroryl group, 2-pyroryl group, 3-pyroryl group, pyrazinyl group, 2-pyridiny group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthrydinyl group, 2-phenanthrydinyl group, 3-phenanthrydinyl group, 4-phenanthrydinyl group, 6-phenanthrydinyl group, 7-phenanthrydinyl group, 8-phenanthrydinyl group, 9-phenanthrydinyl group, 10-phenanthrydinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrole-1-yl group, 2-methylpyrrole-3-yl group, 2-methylpyrrole-4-yl group, 2-methylpyrrole-5-yl group, 3-methylpyrrole-1-yl group, 3-methylpyrrole-2-yl group, 3-methylpyrrole-4-yl group, 3-methylpyrrole-5-yl group, 2-t-butylpyrrole-3-yl group, 3-(2-phenylpropyl)pyrrole-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group and the like.

Examples of the substituted or unsubstituted heteroarylene group having 6 to 50 ring carbon atoms are groups obtained by eliminating one hydrogen atom from the above heteroaryl groups.

Further, the hole injecting layer and the hole transporting layer may contain a compound represented by the following formula.

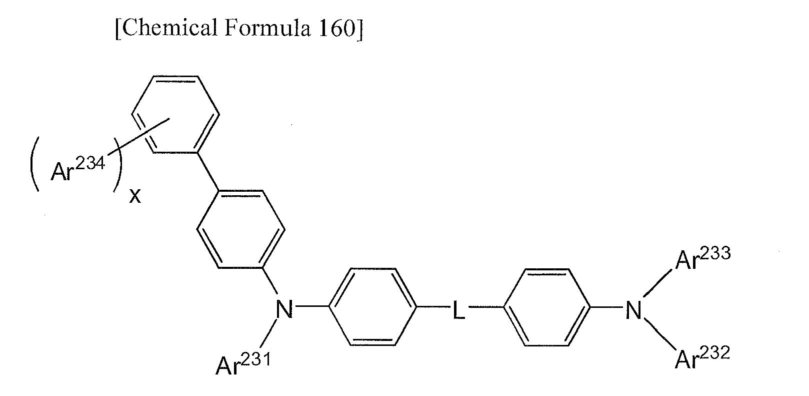

In the formula, Ar²³¹ to Ar²³⁴ each represent a substituted or unsubstituted aryl group having 6 to 50 ring carbon atoms or a substituted or unsubstituted heteroaryl group having 5 to 50 ring atoms. L represents a single bond, a substituted or unsubstituted arylene group having 6 to 50 ring carbon atoms or a substituted or unsubstituted heteroarylene group having 5 to 50 ring atoms. x is an integer of 0 to 5.
Ar²³² and Ar²³³ may be linked together to form saturated or unsaturated ring. Examples of the substituted or unsubstituted aryl group and arylene group having 6 to 50 ring carbon atoms, and of the substituted or unsubstituted heteroaryl group and heteroarylene group having 5 to 50 ring atoms are the same as enumerated above.

Examples of the materials for the hole injecting layer and the hole transporting layer are triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline copolymers and conductive polymer oligomers (particularly thiophene oligomer).

While the above materials are usable for the hole injecting layer and the hole transporting layer, porphyrin compounds, aromatic tertiary amine compounds and styrylamine compounds are preferable, among which aromatic tertiary amine compounds are particularly preferable.

Further usable examples are compounds having two fused aromatic rings in their molecules such as NPD and 4,4',4"-tris(N-(3-methylphenyl)-N-phenylamino) triphenylamine in which three units of triphenylamine are linked together in a starburst form (hereinafter abbreviated as MTDATA).

In addition, a nitrogen-containing heterocyclic derivative represented by the following formula is also usable.

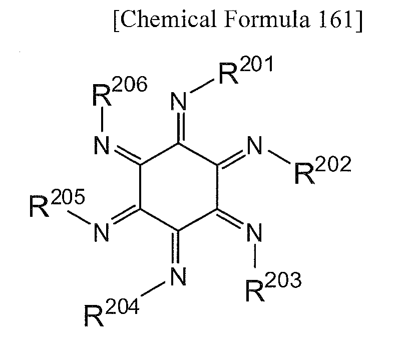

In the formula, R²⁰¹ to R²⁰⁶ each represent any one of a substituted or unsubstituted alkyl group having 1 to 50 carbon atoms, substituted or unsubstituted aryl group having 6 to 50 ring carbon atoms, substituted or unsubstituted aralkyl group having 7 to 50 carbon atoms and substituted or unsubstituted heterocyclic group having 5 to 50 ring atoms. R²⁰¹ and R²⁰², R²⁰³ and R²⁰⁴, R²⁰⁵ and R²⁰⁶, R²⁰¹ and R²⁰⁶, R²⁰² and R²⁰³ or R²⁰⁴ and R²⁰⁵ may form a fused ring.

Further, the compound represented by the following formula is also usable.

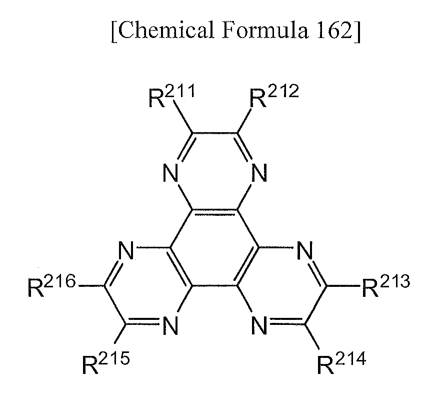

R²¹¹ to R²¹⁶ each represent a substituent, preferably an electron absorbing group such as cyano group, nitro group, sulfonyl group, carbonyl group, trifluoromethyl group and halogen.

The compound represented by the following formula is also preferable for the hole injecting layer.

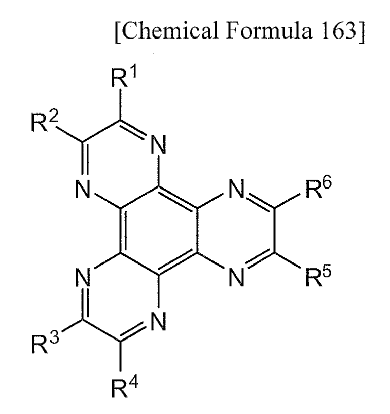

In the formula, R₁ to R₆ each represent halogen, a cyano group, nitro group, alkyl group or trifluoromethyl group. R₁ to R₆ may be mutually the same or different. Preferably, R₁ to R⁶ represent a cyano group.

Alternatively, inorganic compounds such as p-type Si and p-type SiC are also usable for the hole injecting layer and the hole transporting layer. The hole injecting layer and the hole transporting layer can be formed by thinly layering the above-described compound by a known method such as vacuum deposition, spin coating, casting and LB method.
The thickness of the hole injecting layer and the hole transporting layer is not particularly limited. Typically, the thickness is 5 nm to 5 µm. The hole injecting layer and the hole transporting layer may be a single-layered layer made of the single one of the above materials or a combinations of two or more of the above materials. Alternatively, the hole injecting layer and the hole transporting layer may be a multilayer layer in which a plurality of hole injecting layers and hole transporting layers made of different materials are layered.

(5) Phosphorescent-Emitting Layer 5
   The phosphorescent-emitting layer 5 is a red phosphorescent-emitting layer for providing red emission, and contains a red phosphorescent host and red phosphorescent dopant for red phosphorescent emission.
   The phosphorescent-emitting layer 5 may include a red phosphorescent-emitting layer for providing red emission and a green phosphorescent-emitting layer for providing green emission. When the above structure is adopted, the red phosphorescent-emitting layer is located closer to the anode than the green phosphorescent-emitting layer, and contains a red phosphorescent host and red phosphorescent dopant for red phosphorescent emission. The green phosphorescent-emitting layer contains a green phosphorescent host and a green phosphorescent dopant for green phosphorescent emission.

The above materials are usable for the red phosphorescent host and the red phosphorescent dopant for use in the phosphorescent-emitting layer 5 (i.e., red phosphorescent-emitting layer).
For adjustment of the emission chromaticity, an intermediate layer containing no phosphorescent material may be provided between the phosphorescent-emitting layer and the fluorescent-emitting layer.

(6) Fluorescent-Emitting Layer 6
   The fluorescent-emitting layer 6 contains a fluorescent host and a fluorescent dopant for blue fluorescent emission. The above-described materials are usable for the fluorescent host and the fluorescent dopant.

(7) Electron Injecting/Transporting Layer 7
   The electron injecting/transporting layer 7 aids the injection and transfer of the electrons into the fluorescent-emitting layer 6. The electron injecting/transporting layer 7 may be a separately-prepared electron injecting layer and electron transporting layer.
   The electron injecting layer preferably contains a nitrogen-containing cyclic derivative.
   With use of the nitrogen-containing cyclic derivative having high electron performance in the electron injecting/transporting layer, the driving voltage can be lowered.

As a material for the electron injecting layer or the electron transporting layer, 8-hydroxyquinoline or a metal complex of its derivative, an oxadiazole derivative and a nitrogen-containing heterocyclic derivative are preferable. An example of the 8-hydroxyquinoline or the metal complex of its derivative is a metal chelate oxinoid compound containing a chelate of oxine (typically 8-quinolinol or 8-hydroxyquinoline). For instance, tris(8-quinolinol) aluminum can be used. Examples of the oxadiazole derivative are electron transport compounds represented by the following general formulae.

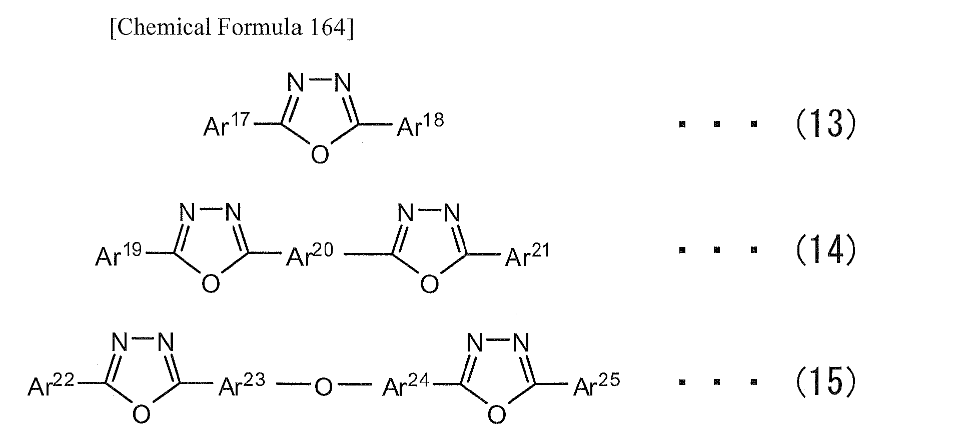

In the formula, Ar¹⁷, Ar¹⁸, Ar¹⁹, Ar²¹, Ar²² and Ar²⁵ each represent a substituted or unsubstituted arylene group. Ar¹⁷, Ar¹⁹ and Ar²² may be the same as or different from Ar¹⁸, Ar²¹ and Ar²⁵ respectively. Ar²⁰, Ar²³ and Ar²⁴ each represent a substituted or unsubstituted arylene group. Ar²³ and Ar²⁴ may be mutually the same or different.
Examples of the aryl group in the general formulae (13) to (15) are a phenyl group, biphenyl group, anthranil group, perylenyl group and pyrenyl group. Examples of the arylene group are a phenylene group, naphthylene group, biphenylene group, anthranylene group, perylenylene group and pyrenylene group.
Examples of the substituent therefor are an alkyl group having 1 to 10 carbon atoms, alkoxy group having 1 to 10 carbon atoms and cyano group.
Such an electron transport compound is preferably an electron transport compound that can be favorably formed into a thin film(s).
Examples of the electron transport compounds are as follows.

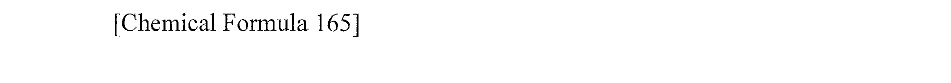

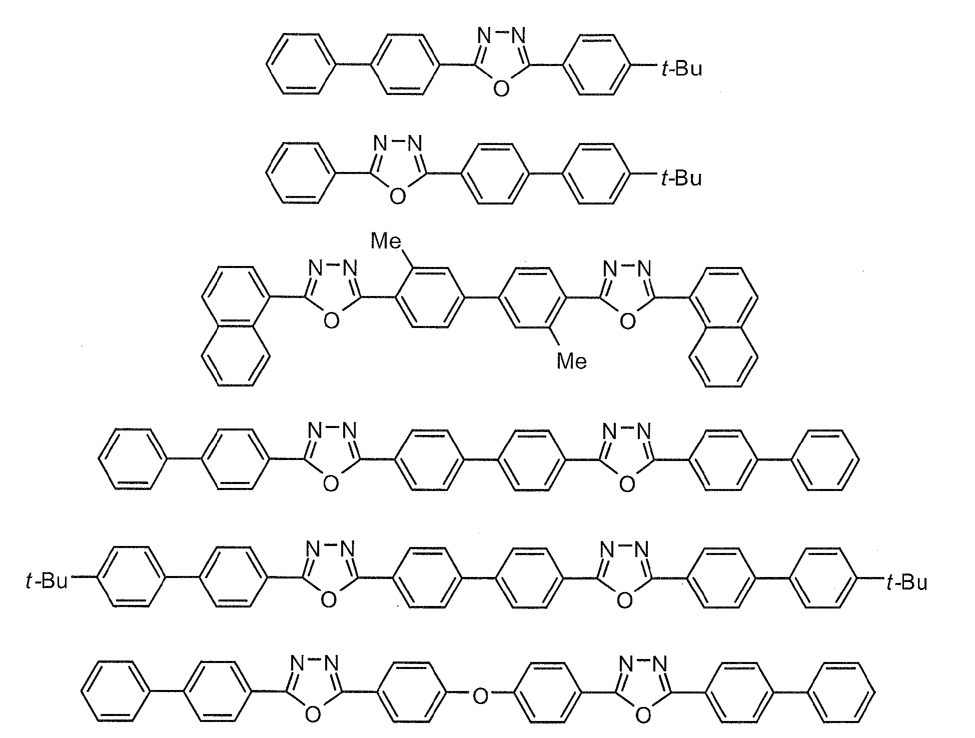

An example of the nitrogen-containing heterocyclic derivative is a nitrogen-containing compound that is not a metal complex, the derivative being formed of an organic compound represented by any one of the following general formulae.

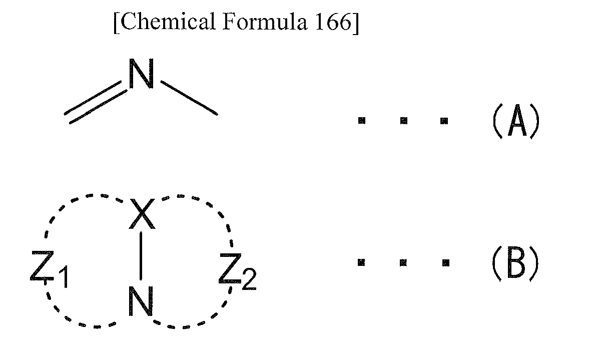

In the formula, X represents a carbon atom or a nitrogen atom. Z₁ and Z₂ each independently represent an atom group capable of forming a nitrogen-containing heterocycle.

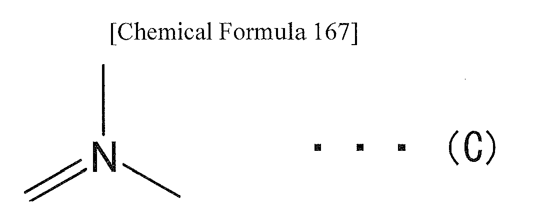

The nitrogen-containing heterocyclic derivative is preferably an organic compound having a nitrogen-containing five-membered or six-membered aromatic polycyclic group. When the number of the nitrogen atoms is plural, the nitrogen atoms bonded to the skeleton thereof in non-adjacent positions. When the nitrogen-containing heterocyclic derivative includes such nitrogen-containing aromatic polycyclic series having plural nitrogen atoms, the nitrogen-containing heterocyclic derivative may be a nitrogen-containing aromatic polycyclic organic compound having a skeleton formed by a combination of the skeletons respectively represented by the formulae (A) and (B), or by a combination of the skeletons respectively represented by the formulae (A) and (C).

A nitrogen-containing group of the nitrogen-containing organic compound is selected from nitrogen-containing heterocyclic groups respectively represented by the following general formulae.

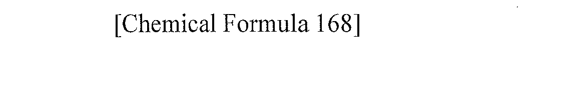

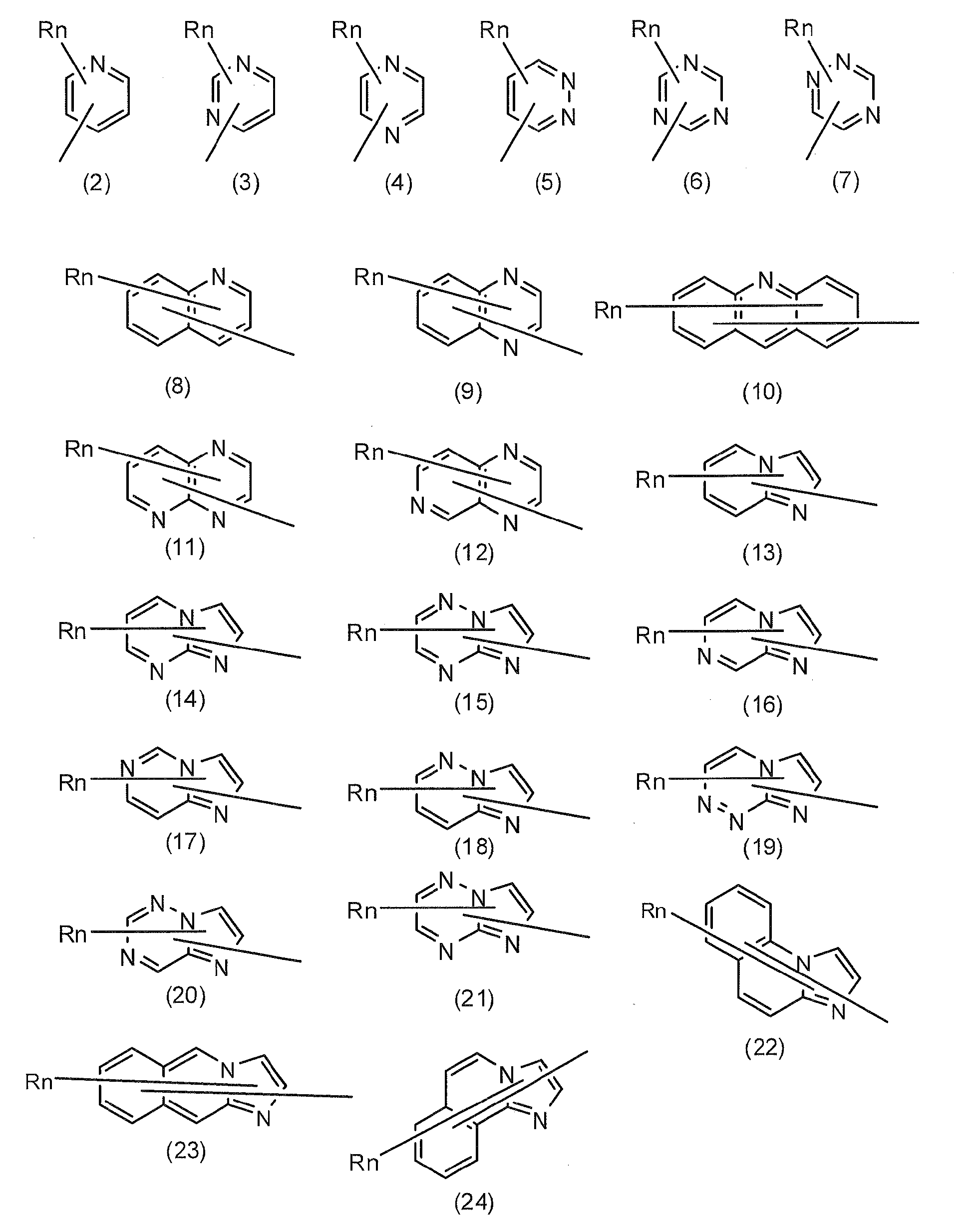

In the formulae: R represents an aryl group having 6 to 40 carbon atoms, heteroaryl group having 3 to 40 carbon atoms, alkyl group having 1 to 20 carbon atoms or alkoxy group having 1 to 20 carbon atoms; and n represents an integer in a range of 0 to 5. When n is an integer of 2 or more, plural R may be mutually the same or different.
A preferable specific compound is a nitrogen-containing heterocyclic derivative represented by the following formula.

[Chemical Formula 169] Har-L¹-Ar¹-Ar²

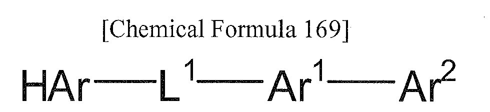

In the formula, HAr represents a substituted or unsubstituted nitrogen-containing heterocycle having 3 to 40 carbon atoms; L¹ represents a single bond, substituted or unsubstituted arylene group having 6 to 40 carbon atoms or substituted or unsubstituted heteroarylene group having 3 to 40 carbon atoms; Ar¹ represents a substituted or unsubstituted divalent aromatic hydrocarbon group having 6 to 40 carbon atoms; and Ar² represents a substituted or unsubstituted aryl group having 6 to 40 carbon atoms or substituted or unsubstituted heteroaryl group having 3 to 40 carbon atoms.

HAr is exemplarily selected from the following group.

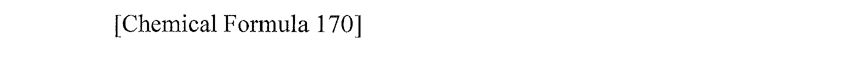

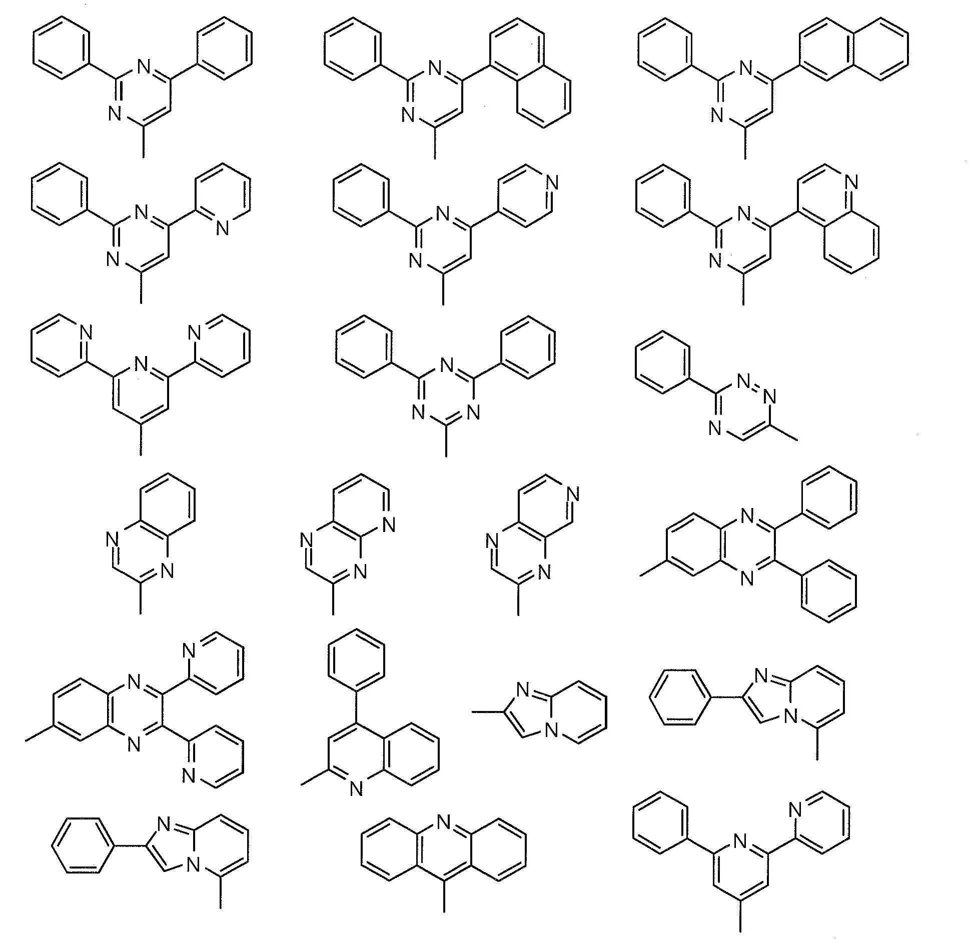

L¹ is exemplarily selected from the following group.

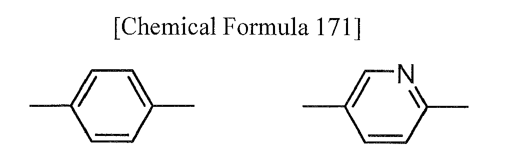

Ar² is exemplarily selected from the following group.

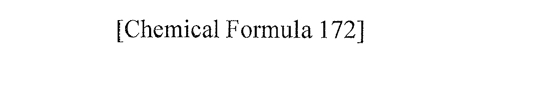

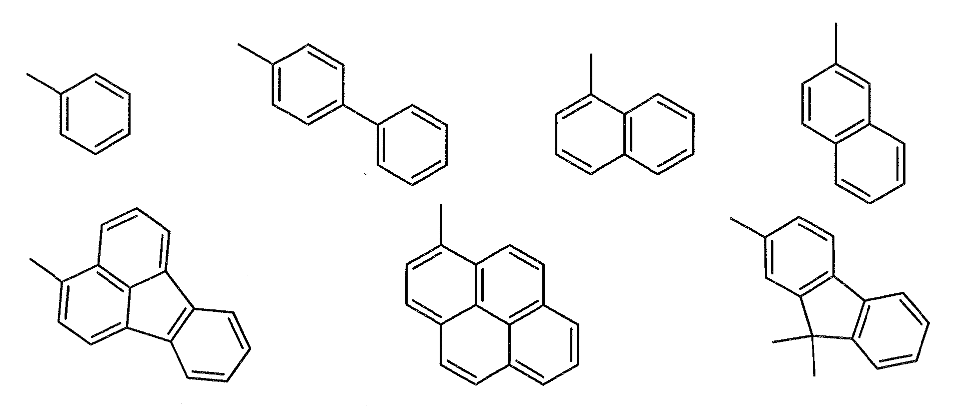

Ar¹ is exemplarily selected from the following arylanthranil groups.

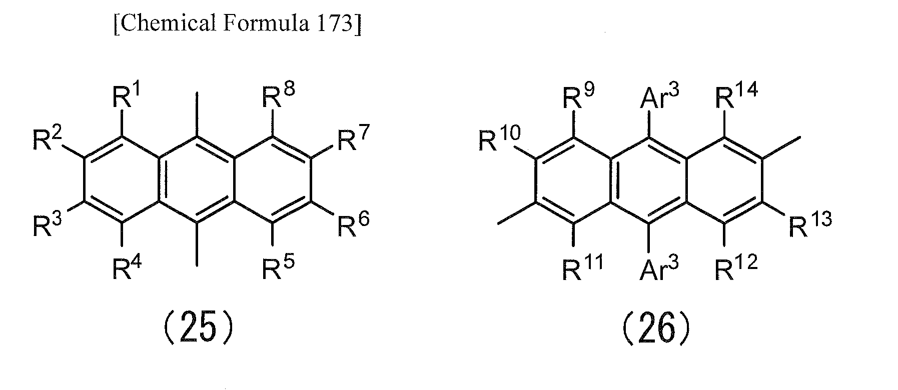

In the formula, R¹ to R¹⁴ each independently represent a hydrogen atom, halogen atom, alkyl group having 1 to 20 carbon atoms, alkoxy group having 1 to 20 carbon atoms, aryloxy group having 6 to 40 carbon atoms, substituted or unsubstituted aryl group having 6 to 40 carbon atoms or heteroaryl group having 3 to 40 carbon atoms. Ar³ represents a substituted or unsubstituted aryl group having 6 to 40 carbon atoms or heteroaryl group having 3 to 40 carbon atoms.

The nitrogen-containing heterocyclic derivative may be a nitrogen-containing heterocyclic derivative in which R¹ to R⁸ in the structure of Ar¹ represented by the above formula each represent a hydrogen atom.

Other than the above, the following compound (see JP-A-9-3448) can be favorably used.

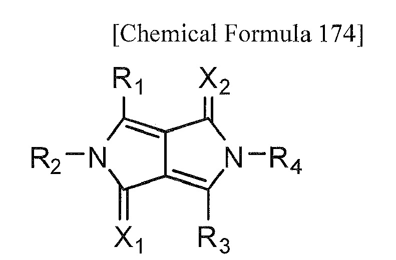

In the formula, R₁ to R₄ each independently represent a hydrogen atom, a substituted or unsubstituted aliphatic group, a substituted or unsubstituted alicyclic group, a substituted or unsubstituted carbocyclic aromatic ring group, or substituted or unsubstituted heterocyclic group. X₁ and X₂ each independently represent an oxygen atom, a sulfur atom or a dicyanomethylene group.
Alternatively, the following compound (see JP-A-2000-173774) can also be favorably used.

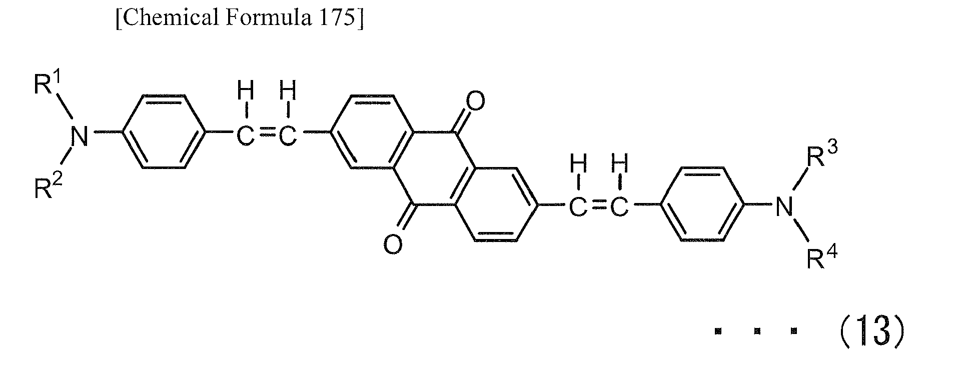

In the formula, R¹, R², R³ and R⁴, which may be mutually the same or different, each represent an aryl group represented by the following formula.

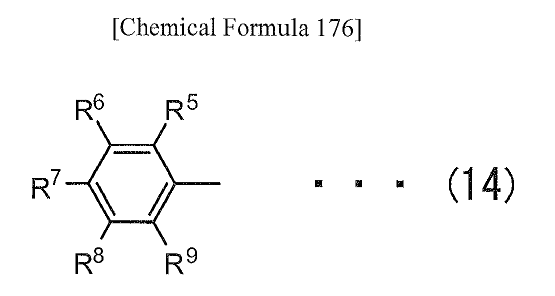

In the formula, R⁵, R⁶, R⁷, R⁸ and R⁹, which may be mutually the same or different, each represent a hydrogen atom, a saturated or unsaturated alkoxyl group, an alkyl group, an amino group or an alkylamino group. At least one of R⁵, R⁶, R⁷, R⁸ and R⁹ represents a saturated or unsaturated alkoxyl group, an alkyl group, an amino group or an alkylamino group.

A polymer compound containing the nitrogen-containing heterocyclic group or a nitrogen-containing heterocyclic derivative may be used.

Although thickness of the electron injecting layer or the electron transporting layer is not specifically limited, the thickness is preferably 1 to 100 nm.

In the organic EL device according to the aspect of the invention, a reduction-causing dopant may be preferably contained in an interfacial region between the cathode and the organic thin-film layer.
With this arrangement, the organic EL device can emit light with enhanced luminance intensity and have a longer lifetime.
The reduction-causing dopant is defined as a substance capable of reducing an electron-transporting compound. Accordingly, as long as the substance has reducibility of a predetermined level, various substances may be usable. For instance, at least one substance selected from a group consisting of alkali metal, alkali earth metal, rare-earth metal, oxide of alkali metal, halide of alkali metal, oxide of alkali earth metal, halide of alkali earth metal, oxide of rare-earth metal, halide of rare-earth metal, organic complex of alkali metal, organic complex of alkali earth metal and organic complex of rare-earth metal can be favorably used.

Specifically, a preferable reduction-causing dopant is at least one alkali metal selected from a group consisting of Li (work function: 2.9 eV), Na (work function: 2.36 eV), K(work function: 2.28 eV), Rb(work function: 2.16 eV) and Cs(work function: 1.95 eV), or at least one alkali earth metal selected from a group consisting of Ca(work function: 2.9 eV), Sr(work function: 2.0 to 2.5 eV) and Ba(work function: 2.52 eV). A substance having work function of 2.9 eV or less is particularly preferable. Among the above, a more preferable reduction-causing dopant is at least one alkali metal selected from a group consisting of K, Rb and Cs. A further more preferable reduction-causing dopant is Rb or Cs. The most preferable reduction-causing dopant is Cs. Since the above alkali metals have particularly high reducibility, addition of a relatively small amount of these alkali metals to an electron injecting zone can enhance luminance intensity and lifetime of the organic EL device. As a reduction-causing dopant having work function of 2.9 eV or less, a combination of two or more of the alkali metals is also preferable. Particularly, a combination including Cs (e.g., Cs and Na, Cs and K, Cs and Rb, or Cs, Na and K) is preferable. A reduction-causing dopant containing Cs in a combining manner can efficiently exhibit reducibility. Addition of the reduction-causing dopant to the electron injecting zone can enhance luminance intensity and lifetime of the organic EL device.

(8) Cathode 8
   An example of the cathode is aluminum.

### (Manufacturing Method of Organic EL Device)

By using the above-exemplified materials, the anode 3, the hole injecting/transporting layer 4, the phosphorescent-emitting layer 5, the fluorescent-emitting layer 6, the electron injecting/transporting layer 7 and the cathode 8 are formed on the substrate 2, through which the organic EL device 1 can be manufactured. Alternatively, the organic EL device can be also manufactured in the reverse order of the above (i.e., from the cathode to the anode). Manufacturing examples will be described below.

In manufacturing the organic EL device 1, a thin film made of anode material is initially formed on a suitable transparent substrate 2 to be 1 µm thick or less, more preferably 10 to 200 nm thick, by a method such as vapor deposition or sputtering, through which an anode 3 is manufactured.
Then, a hole injecting/transporting layer 4 is provided on the anode 3. The hole injecting/transporting layer 4 can be formed by a method such as vacuum deposition, spin coating, casting and LB method. The thickness of the hole injecting/transporting layer 4 may be suitably determined preferably in a range of 5 nm to 5 µm.

Next, a phosphorescent-emitting layer 5, which is to be formed on the hole injecting/transporting layer 4, can be formed by forming a desirable organic emitting material into film by dry processing (representative example: vacuum deposition) or by wet processing such as spin coating or casting.

A fluorescent-emitting layer 6 is subsequently provided on the phosphorescent-emitting layer 5. The fluorescent-emitting layer 6 is formed by the same method as the phosphorescent-emitting layer 5.

An electron injecting/transporting layer 7 is subsequently provided on the fluorescent-emitting layer 6. The electron injecting/transporting layer 7 is formed by the same method as the hole injecting/transporting layer 4.

Lastly, a cathode 8 is laminated thereon, and the organic EL device 1 is obtained.
The cathode 8 is formed of metal by vapor deposition or sputtering. However, in order to protect the underlying organic layer from damages at the time of film forming, vacuum deposition is preferable.

A method of forming each of the layers in the organic EL device 1 is not particularly limited.
Conventionally-known methods such as vacuum deposition and spin coating are usable. Specifically, the organic thin-film layer may be formed by a conventional coating method such as vacuum deposition, molecular beam epitaxy (MBE method) and coating methods using a solution such as a dipping, spin coating, casting, bar coating, roll coating and ink jetting.
Although the thickness of each organic layer of the organic EL device 1 is not particularly limited, the thickness is typically preferably in a range of several nanometers to 1 µm because an excessively-thinned film is likely to entail defects such as a pin hole while an excessively-thickened film requires high voltage to be applied and deteriorates efficiency.

### (Modifications of Exemplary Embodiment)

It should be noted that the invention is not limited to the above exemplary embodiment but may include any modification and improvement as long as such modification and improvement are compatible with the invention.

In the above exemplary embodiment, the organic EL device includes the red phosphorescent-emitting layer containing a red phosphorescent material and the blue fluorescent-emitting layer. However, the arrangement is not limited thereto. For instance, a green phosphorescent-emitting layer containing a green phosphorescent material may be provided between the red phosphorescent emitting layer and the blue fluorescent-emitting layer. With such as structure, the organic EL device can provide white emission as the device includes the red phosphorescent-emitting layer, the green phosphorescent-emitting layer and the blue fluorescent-emitting layer.

Further, the materials and treatments for practicing the invention may be altered to other materials and treatments as long as such other materials and treatments are compatible with the invention.

### Examples

Next, the invention will be described in further detail by exemplifying Example(s) and Comparative(s). However, the invention is not limited by the description of Example(s).

### [Example 1]

A glass substrate (size: 25mm×75mm×1.1mm thick) having an ITO transparent electrode (manufactured by Geomatec Co., Ltd.) was ultrasonic-cleaned in isopropyl alcohol for five minutes, and then UV/ozone-cleaned for 30 minutes.
After the glass substrate having the transparent electrode line was cleaned, the glass substrate was mounted on a substrate holder of a vacuum deposition apparatus. Then, 55-nm thick film of 4,4'-bis[N-(1-naphthyl)-N-phenylamino] biphenyl (hereinafter abbreviated as "NPD film") was initially formed by resistance heating deposition onto a surface of the glass substrate where the transparent electrode line was provided in a manner of covering the transparent electrode. The NPD film served as the hole injecting/transporting layer.
A 5-nm thick film of the following compound (FH1), which was used as the red phosphorescent host, was formed on the NPD film by resistance heating deposition. At the same time, the following compound (PD), which was used as the red phosphorescent dopant, was deposited at a content of 5% (mass ratio) of the compound (FH1). This film served as the phosphorescent emitting layer.
Then, a 10-nm thick film of CBP, which was used as the green phosphorescent host, was formed on the red phosphorescent-emitting layer by resistance heating deposition. At the same time, Ir(ppy)₃; which was used as the green phosphorescent dopant, was deposited at a content of 5% (mass ratio) of the CBP. This film served as the green phosphorescent-emitting layer.
Next, a 30-nm thick film of the following compound (AD1), which was used as the fluorescent host, was formed on the green phosphorescent-emitting layer by resistance heating deposition. At the same time, the following compound (BD1), which was used as the blue fluorescent dopant, was deposited at a content of 5% (mass ratio) of the CBP. This film served as the fluorescent-emitting layer.
The red phosphorescent-emitting layer, the green phosphorescent-emitting layer and the fluorescent-emitting layer, as a whole, served as an emitting layer for white emission.
A 10-nm thick film of the following compound (HB) was formed on this film.
This film served as a hole blocking layer.
Further, 20-nm thick film of tris(8-quinolinol) aluminum (Alq) complex was formed on this film. This film served as an electron injecting layer.
After that, LiF was formed into 1-nm thick film. Metal (A1) was vapor-deposited on the LiF film to form a 150-nm thick metal cathode, thereby providing the organic EL device.

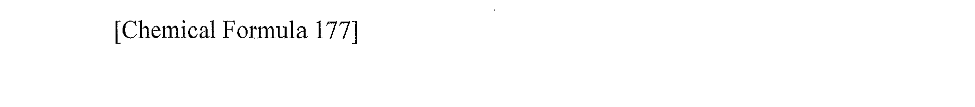

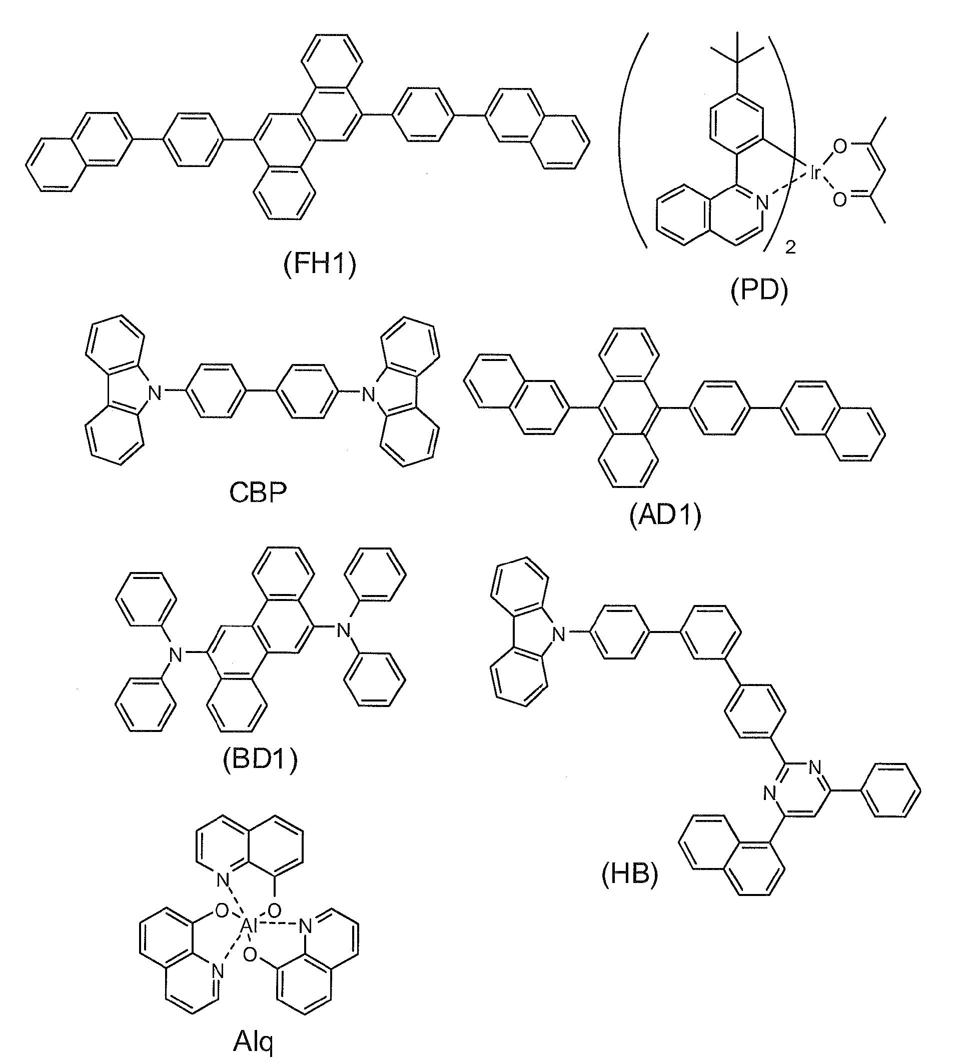

### [Example 2]

The organic EL device of Example 2 was manufactured in the same manner as Example 1, except that: an intermediate layer made solely of CBP was provided between the red phosphorescent-emitting layer and the green phosphorescent-emitting layer; and an intermediate layer made solely of NPD was provided between the green phosphorescent-emitting layer and the fluorescent-emitting layer.

### [Example 3]

Except that the following compound (FH2) was used as the red phosphorescent host in place of the compound (FH1), the organic EL device of Example 3 was manufactured in the same manner as Example 2.

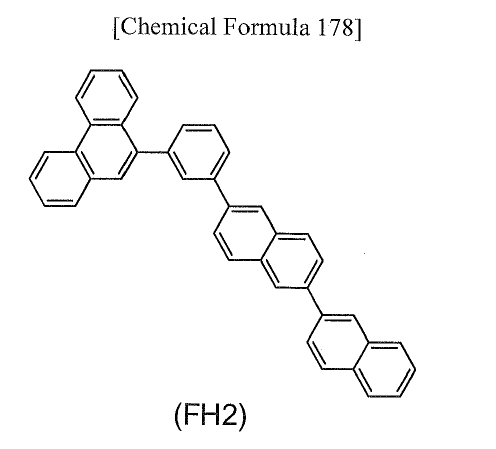

### [Example 4]

Except that the following compound (FH3) was used as the red phosphorescent host in place of the compound (FH1), the organic EL device of Example 4 was manufactured in the same manner as Example 2.

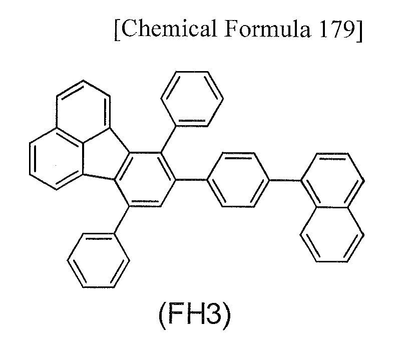

### [Example 5]

Except that the following compound (AD2) was used as the fluorescent host in place of the compound (AD1), the organic EL device of Example 5 was manufactured in the same manner as Example 2.

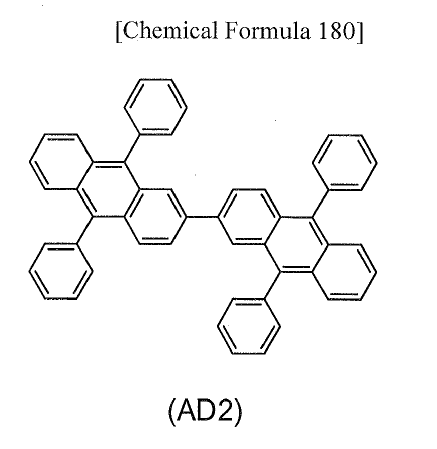

### [Example 6]

Except that the following compound (AD3) was used as the fluorescent host in place of the compound (AD1), the organic EL device of Example 5 was manufactured in the same manner as Example 2.

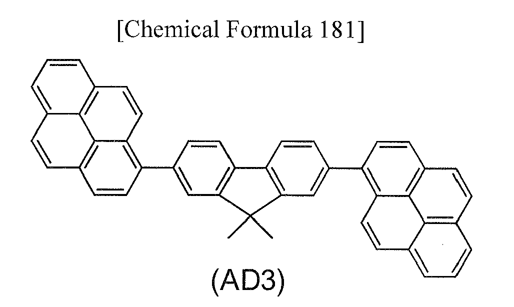

### [Example 7]

Except that the following compound (BD2) was used as the fluorescent dopant in place of the compound (BD1), the organic EL device of Example 7 was manufactured in the same manner as Example 2.

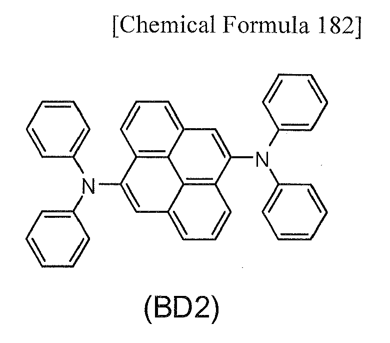

### [Example 8]

Except that the following compound (BD3) was used as the fluorescent dopant in place of the compound (BD1), the organic EL device of Example 8 was manufactured in the same manner as Example 2.

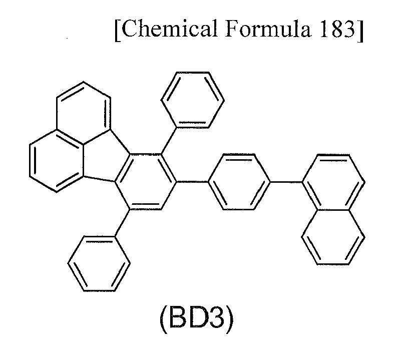

### [Example 9]

Except that the following compound (BD4) was used as the fluorescent dopant in place of the compound (BD1), the organic EL device of Example 9 was manufactured in the same manner as Example 2.

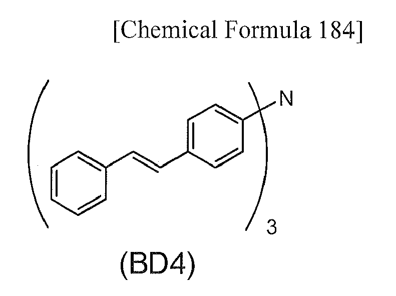

### [Example 10]

An intermediate layer made solely of NPD in place of CBP was provided on the red phosphorescent-emitting layer of Example 2, and a 30-nm thick film of the compound (AD1) was deposited by resistance heating deposition to serve as the green fluorescent host. At the same time, the compound (BD1), which was used as the green fluorescent dopant, was deposited at a content of 5% (mass ratio) of the compound (AD1).
Next, a 30-nm thick film of the compound (AD1), which was used as the fluorescent host, was formed on the green phosphorescent-emitting layer by resistance heating deposition. At the same time, the following compound (GD), which was used as the blue fluorescent dopant, was deposited at a content of 5% (mass ratio) of the compound (AD 1).
The components to be layered on and above the fluorescent-emitting layer were provided in the same manner as Example 2.

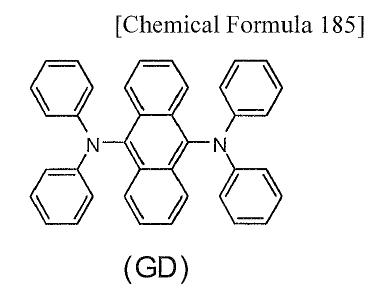

### [Example 11]

Except that the compound (AD3) was used as the green fluorescent host in place of the compound (AD1) in the green fluorescent-emitting layer, the organic EL device of Example 11 was manufactured in the same manner as Example 10.

### [Example 12]

Except that the layering order of the red phosphorescent-emitting layer, green phosphorescent-emitting layer and blue fluorescent-emitting layer was changed to the following order, the organic EL device according to Example 12 was manufactured in the same manner as Example 2.
The blue fluorescent-emitting layer, an intermediate layer made of Balq, the green phosphorescent-emitting layer and the red phosphorescent-emitting layer were layered in this order.

### [Example 13]

The layering order of the red phosphorescent-emitting layer, green fluorescent-emitting layer and blue fluorescent-emitting layer was changed to the following order. Additionally, in the blue fluorescent-emitting layer, NPD was used as the fluorescent host material while the compound (GD) was used as the blue fluorescent dopant. The organic EL device was manufactured in the same manner as Example 10.
The green fluorescent-emitting layer, the blue fluorescent-emitting layer, an intermediate layer made of the red phosphorescent host and the red phosphorescent-emitting layer were layered in this order.

### [Example 14]

Except that the following compound (E) was used as the electron injecting material in place of Alq, the organic EL device of Example 14 was manufactured in the same manner as the Example 2.

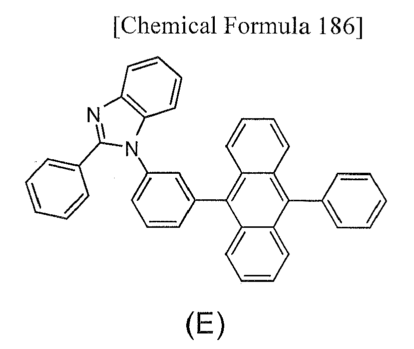

### [Example 15]

Except that no green phosphorescent-emitting layer was provided, the device according to Example 15 was manufactured in the same manner as Example 1.

### [Example 16]

Except that: the following compound (FH4) was used in place of CBP; and the following compound Ir(Ph-ppy)₃ was used in place of Ir(ppy)₃, the organic EL device of Example 16 was manufactured in the same manner as Example 3.

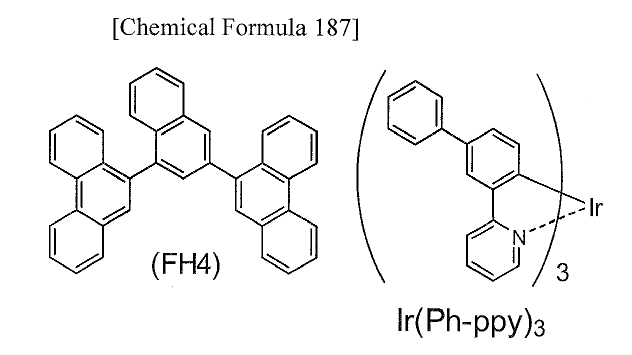

### [Comparative 1]

Except that: CBP was used as the phosphorescent host in place of the compound (FH1); TBADN(2-tert-butyl-9,10-bis-(β-naphthyl)-anthracene) was used as the fluorescent host in place of the compound (AD1); and TBP(2,5,8,11-tetrakis(1,1-dimethylethyl)perylene) was used as the fluorescent dopant in place of the compound (BD1), the organic EL device was manufactured in the same manner as Example 2.

### [Evaluation of Organic EL Device]

The organic EL devices each manufactured as described above were driven by direct-current electricity of 1 mA/cm² to emit light, and then emission chromaticity, the luminance (L) and voltage were measured. Based on the measurement, the external quantum efficiency EQE(%) was obtained. In addition, by conducting a direct-current continuous current test with the initial luminance intensity being set at 5000 cd/m² for each organic EL device, time elapsed until the initial luminance intensity was reduced to the half (i.e., time until half-life) was measured for each organic EL device.
The results of the evaluation are shown in Table 1.

**Table 1**

| | EQE | Time until Half-Life |
|---|---|---|
| | % | @5000nit(h) |
| Example 1 | 5.3 | 2000 |
| Example 2 | 6.5 | 2300 |
| Example 3 | 6.8 | 2150 |
| Example 4 | 6.3 | 2000 |
| Example 5 | 6.5 | 2000 |
| Example 6 | 6.5 | 1800 |
| Example 7 | 6.4 | 1500 |
| Example 8 | 6.4 | 1500 |
| Example 9 | 6.2 | 1500 |
| Example 10 | 5.8 | 3000 |
| Example 11 | 6.0 | 2800 |
| Example 12 | 5.9 | 1800 |
| Example 13 | 5.5 | 1350 |
| Example 14 | 6.9 | 2500 |
| Example 15 | 5.4 | 1800 |
| Example 16 | 6.8 | 2800 |
| Comparative 1 | 3.8 | 300 |

As appreciated from Table 1, the organic EL devices of Examples 1 to 14, in which the phosphorescent host material, phosphorescent dopant, fluorescent host material and fluorescent dopant according to the aspect of the invention were used, exhibited long lifetime and high efficiency.
In contrast, the organic EL device of Comparative 1, in which: CBP (i.e., known host material) was solely used as the phosphorescent host material; TBADN was used as the fluorescent host material; and TBP was used as the fluorescent dopant, exhibited short lifetime.

It should be noted that a "fluorescent host" and a "phosphorescent host" herein respectively mean a host combined with a fluorescent dopant and a host combined with a phosphorescent dopant, and that a distinction between the fluorescent host and phosphorescent host is not unambiguously derived only from a molecular structure of the host in a limited manner.
In other words, the fluorescent host herein means a material for forming a fluorescent-emitting layer containing a fluorescent dopant, and does not mean a host that is only usable as a host of a fluorescent material.
Likewise, the phosphorescent host herein means a material for forming a phosphorescent-emitting layer containing a phosphorescent dopant, and does not mean a host that is only usable as a host of a phosphorescent material.

### Industrial Applicability

The invention is applicable as an organic EL device including a fluorescent-emitting layer and a phosphorescent-emitting layer.

## Claims

1. An organic EL device, comprising:
an anode for injecting holes;
a phosphorescent-emitting layer;
a fluorescent-emitting layer; and
a cathode for injecting electrons,
the phosphorescent-emitting layer containing a phosphorescent host and a phosphorescent dopant for phosphorescent emission,
the fluorescent-emitting layer containing a fluorescent host and a fluorescent dopant for fluorescent emission,
the phosphorescent host having a substituted or unsubstituted polycyclic fused aromatic skeleton and having a triplet energy gap of 2.1 eV to 3.0 eV.

2. The organic EL device according to claim 1, wherein the polycyclic fused aromatic skeleton is present as a divalent or multivalent group in a chemical structure formula.

3. The organic EL device according to claim 1, wherein
the polycyclic fused aromatic skeleton has a substituent, and
the substituent is a substituted or unsubstituted aryl group or heteroaryl group.

4. The organic EL device according to claim 2, wherein the polycyclic fused aromatic skeleton is selected from a group consisting of substituted or unsubstituted naphthalene-diyl, phenanthrene-diyl, chrysene-diyl, fluoranthene-diyl and triphenylene-diyl.

5. The organic EL device according to claim 4, wherein the polycyclic fused aromatic skeleton is substituted by a group containing naphthalene, phenanthrene, chrysene, fluoranthene or triphenylene.

6. The organic EL device according to claim 1, wherein the polycyclic fused aromatic skeleton is represented by any one of formulae (1) to (4) below, 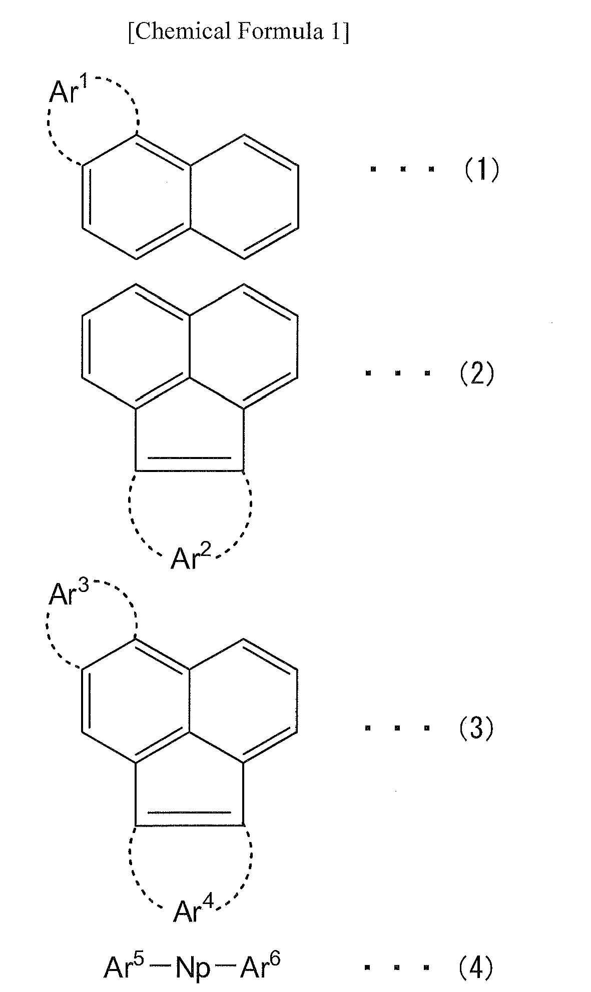 in the formulae (1) to (3), Ar¹ to Ar⁴ each representing a substituted or unsubstituted fused ring structure having 4 to 10 ring carbon atoms,
in the formula (4), Np representing substituted or unsubstituted naphthalene, and Ar⁵ and Ar⁶ each independently representing a substituent formed solely of a substituted or unsubstituted aryl group having 5 to 14 carbon atoms or a substituent formed of a combination of a plurality thereof, on a condition that Ar⁵ or Ar⁶ has no anthracene.

7. The organic EL device according to any one of claims 2 to 6, wherein
the phosphorescent host has a triplet energy gap of 2.1 eV to 2.7 eV, and
the polycyclic fused aromatic skeleton has 14 to 30 ring atoms.

8. The organic EL device according to any one of claims 2 to 6, wherein
the fluorescent host has a triplet energy gap of 2.1 eV to 2.7 eV, and
the polycyclic fused aromatic skeleton has 14 to 30 ring atoms.

9. The organic EL device according to claim 7 or 8, wherein the polycyclic fused aromatic skeleton has no substituent that has a carbazole skeleton.

10. The organic EL device according to any one of claims 1 to 9, wherein the phosphorescent dopant contains a metal complex having: a metal selected from the group consisting of Ir, Pt, Os, Au, Cu, Re and Ru; and a ligand.

11. The organic EL device according to any one of claims 1 to 10, wherein the fluorescent host is at least one selected from the group consisting of an anthracene derivative represented by a formula (5) below and a pyrene derivative represented by a formula (6) below, 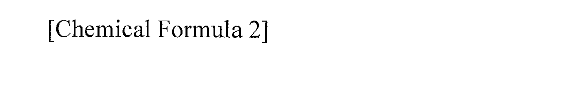 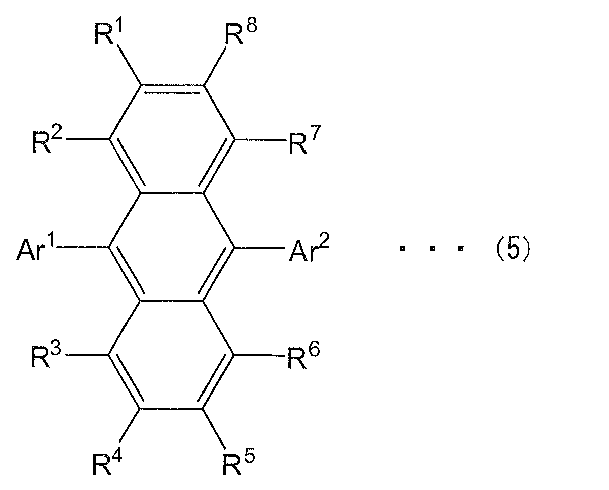 where: Ar¹ and Ar² each independently represent a group induced from a substituted or unsubstituted aromatic ring having 6 to 20 ring carbon atoms; the aromatic ring is substituted by one or more substituent(s) or unsubstituted; the substituent(s) is selected from the group consisting of a substituted or unsubstituted aryl group having 6 to 50 ring carbon atoms, substituted or unsubstituted alkyl group having 1 to 50 carbon atoms, substituted or unsubstituted cycloalkyl group having 3 to 50 carbon atoms, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group; when the aromatic ring is substituted by two or more substituents, the substituents are allowed to be the same or different; an adjacent set of the substituents is allowed be bonded together to form a saturated or unsaturated cyclic structure;
R¹ to R⁸ each are selected from the group consisting of a hydrogen atom, substituted or unsubstituted aryl group having 6 to 50 ring carbon atoms, substituted or unsubstituted heteroaryl group having 5 to 50 ring atoms, substituted or unsubstituted alkyl group having 1 to 50 carbon atoms, substituted or unsubstituted cycloalkyl group having 3 to 50 carbon atoms, substituted or unsubstituted alkoxy group having 1 to 50 carbon atoms, substituted or unsubstituted aralkyl group having 6 to 50 ring carbon atoms, substituted or unsubstituted aryloxy group having 5 to 50 ring atoms, substituted or unsubstituted arylthio group having 5 to 50 ring atoms, substituted or unsubstituted alkoxycarbonyl group having 1 to 50 carbon atoms, substituted or unsubstituted silyl group, carboxyl group, halogen atom, cyano group, nitro group and hydroxy group; and an adjacent set of substituents is allowed to be bonded together to form a saturated or unsaturated cyclic structure, 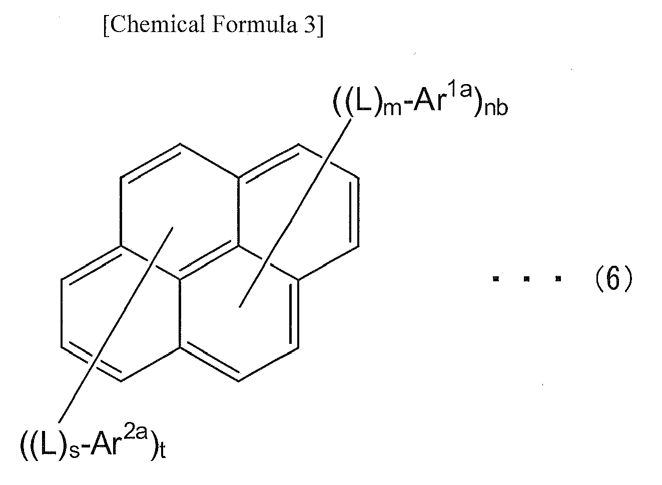 where: Ar^{1a} and Ar^{2a} each represent a substituted or unsubstituted aromatic ring group having 6 to 50 ring carbon atoms;
L each represent a substituted or unsubstituted phenylene group, substituted or unsubstituted naphthalenylene, substituted or unsubstituted fluorenylene or substituted or unsubstituted dibenzo-sylolylene group;
m is an integer of 0 to 2, nb is an integer of 1 to 4, s is an integer of 0 to 2 and t is an integer of 0 to 4;
L or Ar^{1a} is bonded to pyrene in any one of 1st to 5th positions, and L or Ar^{2a} is bonded to pyrene in any one of 6th to 10t positions;
when nb+t is even, Ar^{1a}, Ar^{2a} and L satisfy the following (1) or (2), (1) Ar^{1a}≠Ar^{2a}, wherein ≠ means that Ar^{1a} and Ar^{2a} are group of different structures,
(2) when Ar^{1a}=Ar^{2a},
(2-1) m≠s and/or nb≠t or
(2-2) when m=s and nb=t and,
(2-2-1) L or the pyrene is bonded in a different bonding position on Ar^{1a} and Ar^{2a}, or
(2-2-2) L or the pyrene is bonded in the same bonding position on Ar^{1a} and Ar^{2a},
substituting positions of L or Ar^{1a} and Ar^{2a} in the pyrene are not 1st and 6th positions or 2nd and 7th positions.

12. The organic EL device according to any one of claims 1 to 11, wherein the fluorescent dopant is an amine compound represented by a formula (7) below, 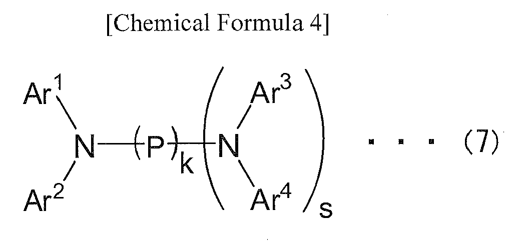 where: P represents a substituted or unsubstituted aromatic hydrocarbon group having 6 to 40 ring carbon atoms, a substituted or unsubstituted heterocyclic group having 3 to 40 ring atoms, or a substituted or unsubstituted styryl group; k is an integer of 1 to 3;
Ar¹ to Ar⁴ each independently represents a substituted or unsubstituted aromatic hydrocarbon group having 6 to 40 ring carbon atoms or a substituted or unsubstituted heterocyclic group having 3 to 40 ring atoms; s is an integer of 0 to 4;
an adjacent set of substituents for suitably-selected two of Ar¹, Ar² and P is allowed to be bonded together to form a ring; when k is 2 or more, P are allowed to be mutually the same or different.

13. The organic EL device according to any one of claims 1 to 11, wherein the fluorescent dopant is a fluoranthene derivative represented by any one of formulae (8) to (11) below, 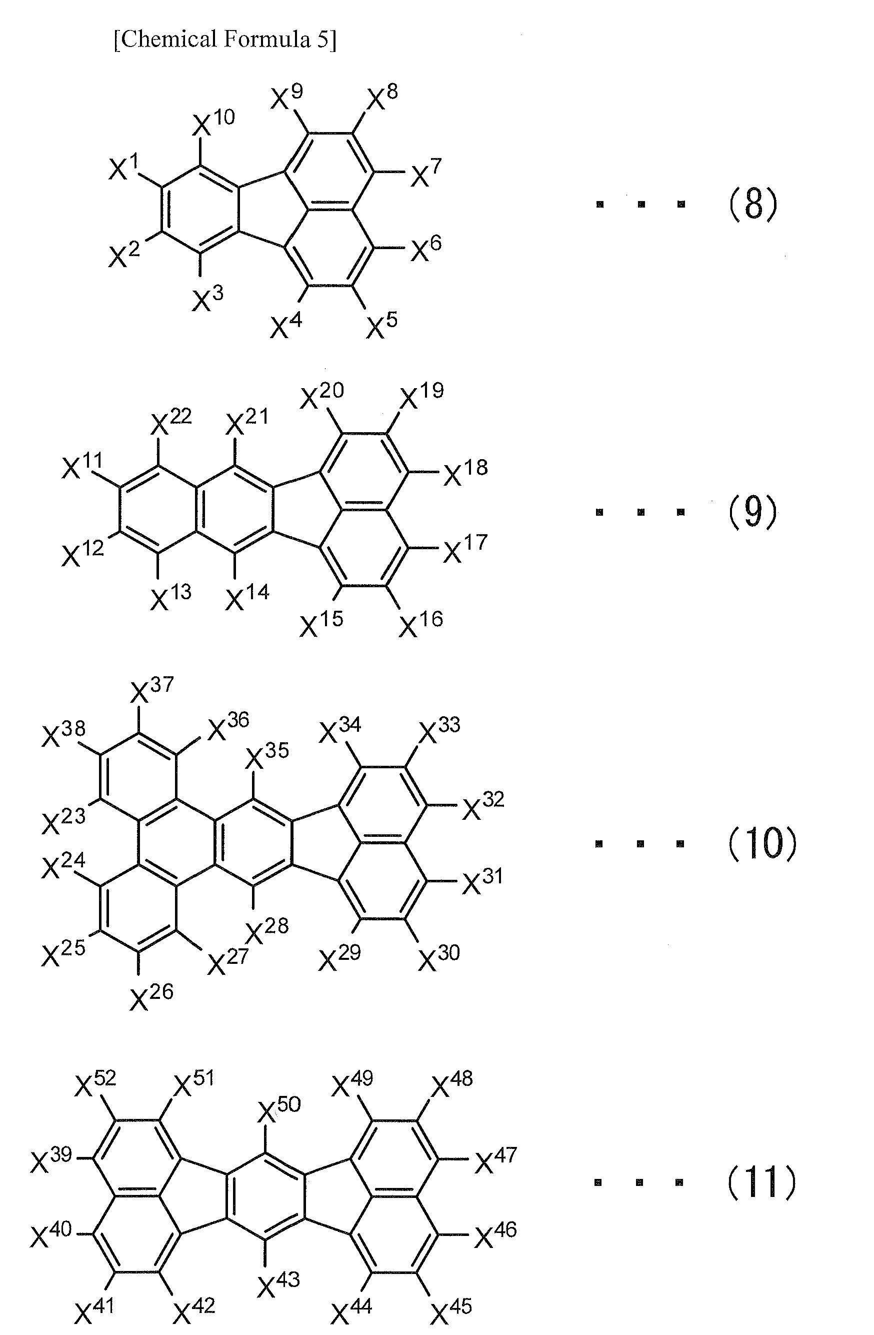 where: X¹ to X⁵² each independently represent a hydrogen atom, halogen atom, substituted or unsubstituted linear, branched or cyclic alkyl group having 1 to 30 carbon atoms, substituted or unsubstituted linear, branched or cyclic alkoxy group having 1 to 30 carbon atoms, substituted or unsubstituted linear, branched or cyclic alkylthio group having 1 to 30 carbon atoms, substituted or unsubstituted linear, branched or cyclic alkenyl group having 2 to 30 carbon atoms, substituted or unsubstituted linear, branched or cyclic alkenyloxy group having 2 to 30 carbon atoms, substituted or unsubstituted linear, branched or cyclic alkenylthio group having 2 to 30 carbon atoms, substituted or unsubstituted aralkyl group having 7 to 30 carbon atoms, substituted or unsubstituted aralkyloxy group having 7 to 30 carbon atoms, substituted or unsubstituted aralkylthio group having 7 to 30 carbon atoms, substituted or unsubstituted aryl group having 6 to 20 carbon atoms, substituted or unsubstituted aryloxy group having 6 to 20 carbon atoms, substituted or unsubstituted arylthio having 6 to 20 carbon atoms, substituted or unsubstituted amino group having 2 to 30 carbon atoms, cyano group, silyl group, hydroxyl group, -COOR^{1e} group wherein R^{1e} represents a hydrogen atom, substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms or substituted or unsubstituted aryl group having 6 to 30 carbon atoms, -COR^{2e} group wherein R^{2e} represents a hydrogen atom, substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms, substituted or unsubstituted aryl group having 6 to 30 carbon atoms or amino group, or -OCOR^{3e} group wherein R^{3e} represents a substituted or unsubstituted linear, branched or cyclic alkyl group having 1 to 30 carbon atoms, substituted or unsubstituted linear, branched or cyclic alkenyl group having 2 to 30 carbon atoms, substituted or unsubstituted aralkyl group having 7 to 30 carbon atoms, or substituted or unsubstituted aryl group having 6 to 30 carbon atoms; an adjacent set of groups of X¹ to X⁵² and an adjacent set of substituents of X¹ to X⁵² are allowed be bonded together to form a substituted or unsubstituted carbocycle.

14. The organic EL device according to any one of claims 1 to 11, wherein the fluorescent dopant is represented by a formula (12) below, 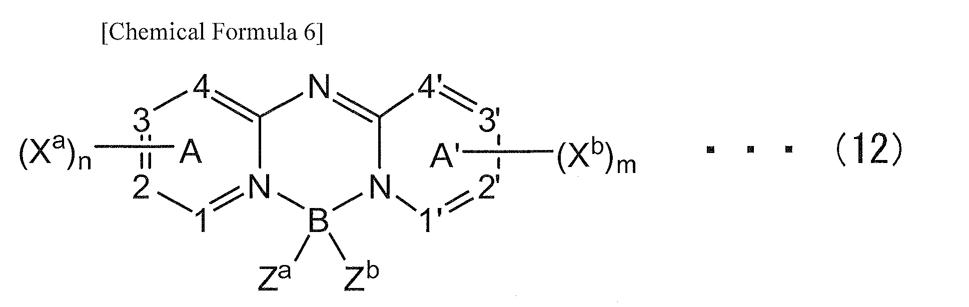 where: A and A' each represent an independent azine ring system corresponding to a six-membered aromatic ring containing one nitrogen or more;
X^{a} and X^{b} represent independently-selected substituents capable of being bonded together to form a fused ring with respect to A or A';
m and n each independently represent an integer of 0 to 4;
Z^{a} and Z^{b} represent independently-selected substituents; and
1, 2, 3, 4, 1', 2', 3' and 4' are each independently selected from a carbon atom and nitrogen atom.

15. The organic EL device according to any one of claims 1 to 14, wherein
a wavelength of emission of the fluorescent-emitting layer is shorter than a wavelength of emission of the phosphorescent-emitting layer,
the fluorescent-emitting layer provides emission at a wavelength of 410 to 580 nm, and
the phosphorescent-emitting layer provides emission at a wavelength of 500 to 700 nm.

16. The organic EL device according to claim 15, wherein the phosphorescent-emitting layer provides emission at a wavelength of 580 to 700 nm.

17. The organic EL device according to Claim 15, wherein
the fluorescent-emitting layer is a blue emitting layer, and
the phosphorescent-emitting layer is a red phosphorescent-emitting layer for providing red emission.
